# EUROPEAN PATENT SPECIFICATION

(11) **EP 4 389 852 B1**
(45) Date of publication and mention of the grant of the patent: **02.04.2025**
(21) Application number: 23210396.0
(22) Date of filing: 16.11.2023
(51) Int. Cl.: C09K 11/06, C07F 15/00, H10K 85/10, H10K 85/60

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**
ORGANOMETALLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 19.12.2022 KR 20220178681
(43) Date of publication of application: 26.06.2024
(73) Proprietor: Samsung Electronics Co., Ltd., Suwon-si, Gyeonggi-do 16677 (KR)
(72) Inventor: BAE, Hyejin, 16678 Suwon-si (KR); PARK, Sangho, 16678 Suwon-si (KR); KIM, Hwang Suk, 16678 Suwon-si (KR); MIN, Minsik, 16678 Suwon-si (KR); CHOI, Hyesung, 16678 Suwon-si (KR); KANG, Hosuk, 16678 Suwon-si (KR); KIM, Jong Soo, 16678 Suwon-si (KR); KIM, Joonghyuk, 16678 Suwon-si (KR); SON, Youngmok, 16678 Suwon-si (KR); WON, Joonghee, 16678 Suwon-si (KR); JEONG, Daun, 18448 Hwaseong-si (KR); JUNG, Yongsik, 16678 Suwon-si (KR); CHWAE, Jun, 16678 Suwon-si (KR)
(74) Representative: Elkington and Fife LLP

(56) References cited:
- CN-A- 114 933 616
- US-A1- 2022 399 517

## Description

### FIELD OF THE INVENTION

The present subject matter relates to an organometallic compound, an organic light-emitting device including the same, and an electronic apparatus including the organic light-emitting device.

### BACKGROUND OF THE INVENTION

Organic light-emitting devices (OLEDs) are self-emissive devices, which have improved characteristics in terms of viewing angles, response time, brightness, driving voltage, and response speed. In addition, OLED can also produce full-color images.

In an example, an organic light-emitting device includes an anode, a cathode, and an organic layer located or arranged between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. The excitons may transition from an excited state to a ground state, thus generating light.

OLEDs comprising metal complexes similar to those of the invention are disclosed in US2022399517 and CN114933616.

### SUMMARY OF THE INVENTION

Provided are an organometallic compound, an organic light-emitting device including the same, and an electronic apparatus including the organic light-emitting device.

According to an aspect, provided is an organometallic compound represented by Formula 1: 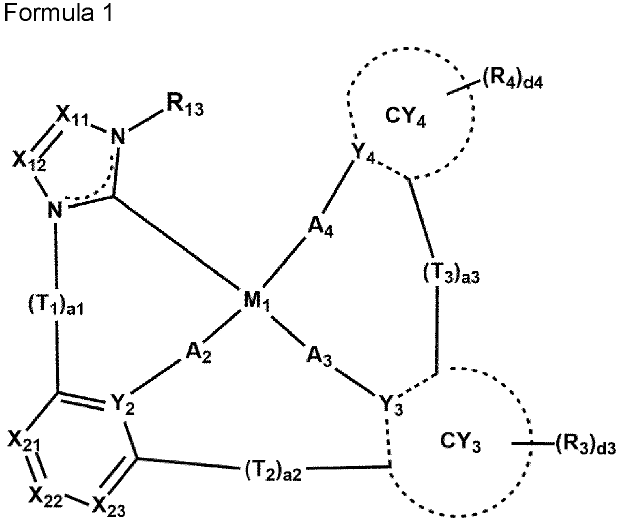 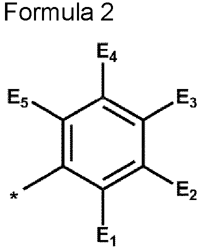 wherein, in Formulae 1 and 2,
M₁ is a transition metal,
X₁₁ is N or C(R₁₁),
X₁₂ is N or C(R₁₂),
X₂₁ is N or C(R₂₁),
X₂₂ is N or C(R₂₂),
X₂₃ is N or C(R₂₃),
at least one of X₂₁ and X₂₂ is N,
Y₂ to Y₄ are each independently C or N,
A₂ to A₄ are each independently a chemical bond, O, or S,
ring CY₃ and ring CY₄ are each independently a C₅-C₃₀ carbocyclic group or a C₁-C₃₀ heterocyclic group,
T₁ is a single bond, a double bond, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C≡C-*',
T₂ is a single bond, a double bond, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*', or *-C≡C-*',
T₃ is a single bond, a double bond, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', ***-**S(=O)-*', *-S(=O)₂-*', *-C(R₃ₐ)=*', *=C(R₃ₐ)-*', *-C(R₃ₐ)=C(R_{3b})-*', *-C(=S)-*', or *-C≡C-*',
* and *' each indicate a binding site to a neighboring atom,
a1 is an integer from 1 to 3, and when a1 is 2 or greater, two or more of T₁ are identical to or different from each other,
a2 is an integer from 1 to 3, and when a2 is 2 or greater, two or more of T₂ are identical to or different from each other,
a3 is an integer from 1 to 3, and when a3 is 2 or greater, two or more of T₃ are identical to or different from each other,
L₁ to L₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b1 to b3 are each independently an integer from 1 to 3,
R₁₃ is a group represented by Formula 2,
R₁ₐ, R_{1b}, R₂ₐ, R_{2b}, R₃ₐ, R_{3b}, R₃, R₄, R₁₁, R₁₂, R₂₁ to R₂₃, and E₁ to E₅ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - N(Q₄)(Q₅), -B(Q₆)(Q₇), -P(Q₈)(Q₉), or -P(=O)(Q₈)(Q₉),
neighboring two or more of R₁ₐ, R_{1b}, R₂ₐ, R_{2b}, R₃ₐ, R_{3b}, R₁₁, R₁₂, R₂₁ to R₂₃, and E₁ to E₅ are optionally bonded to each other to form a substituted or unsubstituted C₅-C₃₀ carbocyclic group or a substituted or unsubstituted C₁-C₃₀ heterocyclic group,
at least one of E₂ and E₄ is not hydrogen,
R₁₀ₐ is as described in connection with R₃,
d3 and d4 are each independently an integer from 0 to 20,
when d3 is 2 or greater, two or more of R₃ are identical to or different from each other, and when d4 is 2 or greater, two or more of R₄ are identical to or different from each other,
* in Formula 2 indicates a binding site to a neighboring atom,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
   deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), - N(Q₁₄)(Q₁₅), -B(Q₁₆)(Q₁₇), -P(Q₁₈)(Q₁₉), -P(=O)(Q₁₈)(Q₁₉), or a combination thereof,
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₃-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group,
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), - N(Q₂₄)(Q₂₅), -B(Q₂₆)(Q₂₇), -P(Q₂₈)(Q₂₉), -P(=O)(Q₂₈)(Q₂₉), or a combination thereof, or
   -Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉), and
   Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to another aspect, an organic light-emitting device includes a first electrode, a second electrode, and an organic layer arranged between the first electrode and the second electrode, wherein the organic layer includes an emission layer, and wherein the organic layer includes at least one organometallic compound represented by Formula 1.

According to another aspect, an electronic apparatus includes the organic light-emitting device.

Additional aspects will be set forth in part in the detailed description that follows and, in part, will be apparent from the detailed description, or may be learned by practice of the presented exemplary embodiments described herein.

### BRIEF DESCRIPTION OF THE DRAWINGS

The above and other aspects, features, and advantages of certain exemplary embodiments will be more apparent from the following detailed description taken in conjunction with the accompanying drawings, in which:
FIG. 1 is a schematic cross-sectional view of an organic light-emitting device 10 according to one or more embodiments; and
FIG. 2 is a graph of intensity (arbitrary units, a.u.) versus wavelength (nanometers, nm) and shows photoluminescence (PL) spectra of compounds according to Examples and Comparative Examples as described herein.

### DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figures, to explain certain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 electron Volts (eV)" of the vacuum level, while when the work function or the HOMO energy level is referred to be "shallow," "low," or "small," the work function or HOMO energy level has a small absolute value based on "0 eV" of the vacuum level.

Provided is an organometallic compound is represented by Formula 1:

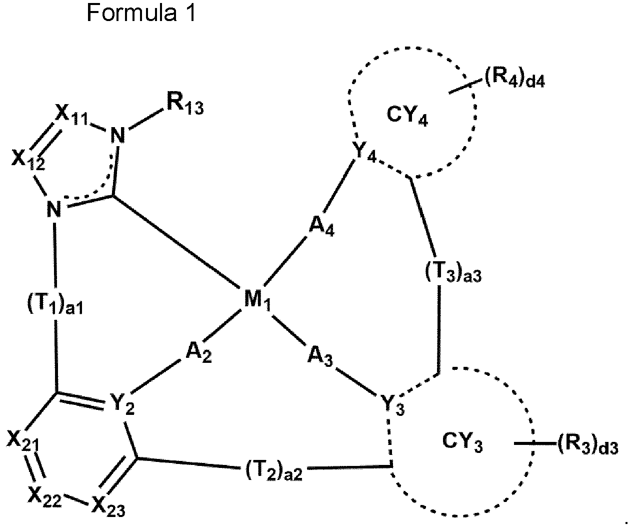

In Formula 1, M₁ is a transition metal.

In one or more embodiments, M₁ in Formula 1 may be a first-row transition metal of the Periodic Table of Elements, a second-row transition metal of the Periodic Table of Elements, or a third-row transition metal of the Periodic Table of Elements.

For example, in Formula 1, M₁ may be iridium, platinum, osmium, titanium, zirconium, hafnium, europium, terbium, thulium, rhodium, palladium, or gold.

In one or more embodiments, M₁ in Formula 1 may be platinum, palladium, or gold.

For example, M₁ in Formula 1 may be platinum.

In Formula 1, X₁₁ is N or C(R₁₁), and
X₁₂ may be N or C(R₁₂).

For example,
i) X₁₁ may be C(R₁₁), and X₁₂ may be C(R₁₂);
ii) X₁₁ may be N, and X₁₂ may be C(R₁₂);
iii) X₁₁ may be C(R₁₁), and X₁₂ may be N; or
iv) X₁₁ may be N, and X₁₂ may be N.

R₁₁ and R₁₂ are optionally bonded to each other to form a substituted or unsubstituted C₅-C₃₀ carbocyclic group (for example, a benzene group or the like) or a substituted or unsubstituted C₁-C₃₀ heterocyclic group (for example, a benzimidazole group or the like).

In Formula 1, X₂₁ is N or C(R₂₁),
X₂₂ is N or C(R₂₂),
X₂₃ is N or C(R₂₃), and
at least one of X₂₁ and X₂₂ is N.

In one or more embodiments, Formula 1 may satisfy one of Conditions 1-1 to 1-3:
Condition 1-1
   X₂₁ is N, and X₂₂ is C(R₂₂);
Condition 1-2
   X₂₁ is C(R₂₁), and X₂₂ is N; and
Condition 1-3
   X₂₁ is N, and X₂₂ is N.

In Conditions 1-1 and 1-2, R₂₁ and R₂₂ may each be as described herein.

Y₂ to Y₄ are each independently C or N.

In one or more embodiments, at least one of Y₂ to Y₄ may be N.

In one or more embodiments, Y₂ may be C, Y₃ may be C, and Y₄ may be N;
Y₂ may be N, Y₃ may be C, and Y₄ may be C;
Y₂ may be C, Y₃ may be N, and Y₄ may be C;
Y₂ may be N, Y₃ may be C, and Y₄ may be N;
Y₂ may be N, Y₃ may be N, and Y₄ may be C;
Y₂ may be C, Y₃ may be N, and Y₄ may be N; or
Y₂ may be N, Y₃ may be N, and Y₄ may be N.

A₂ to A₄ are each independently a chemical bond, O, or S.

The chemical bond may be a covalent bond, an ionic bond, or a coordinate bond, but embodiments are not limited thereto.

In Formula 1, ring CY₃ and ring CY₄ are each independently a C₅-C₃₀ carbocyclic group or a C₁-C₃₀ heterocyclic group.

In one or more embodiments, ring CY₃ and ring CY₄ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzotriazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In Formula 1, T₁ is a single bond, a double bond, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)2-*', *-C(R₁ₐ)=*', *=C(R₁ₐ)-*', *-C(R₁ₐ)=C(R_{1b})-*', *-C(=S)-*', or *-C≡C-*',
T₂ is a single bond, a double bond, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)2-*', *-C(R₂ₐ)=*', *=C(R₂ₐ)-*', *-C(R₂ₐ)=C(R_{2b})-*', *-C(=S)-*', or *-C=C-*', and
T₃ is a single bond, a double bond, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)2-*', *-C(R₃ₐ)=*', *=C(R₃ₐ)-*', *-C(R₃ₐ)=C(R_{3b})-*', *-C(=S)-*', or *-C≡C-*'.

a1 to a3 in Formula 1 each indicates the numbers of T₁ to T₃, respectively, and a1 to a3 are each independently an integer from 1 to 3 (for example, 1, 2, or 3). When a1 is two or greater, two or more of T₁ are identical to or different from each other, and when a2 is two or greater, two or more of T₂ are identical to or different from each other, and when a3 is two or greater, two or more of T₃ are identical to or different from each other.

In one or more embodiments, at least one of T₁ and T₃ may be a single bond.

For example, T₁ may be a single bond; T₃ may be a single bond; and/or T₁ and T₃ may be a single bond.

In one or more embodiments, T₂ may be *-N[(L₂)_{b2}-(R₂ₐ)]-*', *-S-*', *-Se-*', or *-O-*', and a2 may be 1.

In Formula 1, * and *' each indicate a binding site to a neighboring atom.

L₁ to L₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ.

b1 to b3 in Formula 1 each indicates the number of L₁ to L₃, respectively, and b1 to b3 are each independently an integer from 1 to 3 (for example, 1, 2, or 3.) When b1 is two or greater, two or more of L₁ are identical to or different from each other, and when b2 is two or greater, two or more of L₂ are identical to or different from each other, and when b3 is two or greater, two or more of L₃ are identical to or different from each other.

In Formula 1, R₁₃ is a group represented by Formula 2:

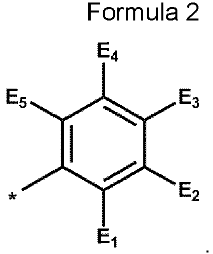

In Formulae 1 and 2, R₁ₐ, R_{1b}, R₂ₐ, R_{2b}, R₃ₐ, R_{3b}, R₃, R₄, R₁₁, R₁₂, R₂₁ to R₂₃, and E₁ to E₅ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅),-B(Q₆)(Q₇), -P(O₈)(O₉), or -P(=O)(Q₈)(Q₉),
neighboring two or more of R₁ₐ, R_{1b}, R₂ₐ, R_{2b}, R₃ₐ, R_{3b}, R₁₁, R₁₂, R₂₁ to R₂₃, and E₁ to E₅ are optionally bonded to each other to form a substituted or unsubstituted C₅-C₃₀ carbocyclic group or a substituted or unsubstituted C₁-C₃₀ heterocyclic group, and
at least one of E₂ and E₄ is not hydrogen.

In one or more embodiments, Formula 2 may satisfy at least one of Conditions 2-1 and 2-2:
Condition 2-1
   E₂ is not hydrogen; and
Condition 2-2
   E₂ and E₄ are not hydrogen.

d3 and d4 in Formula 1 each indicates the number of R₃ and R₄, respectively, and d3 and d4 are each independently an integer from 0 to 20 (for example, 0, 1, 2, 3, or 4.) When d3 is 2 or greater, two or more of R₃ are identical to or different from each other, and when d4 is 2 or greater, two or more R₄ are identical to or different from each other.

In Formula 1, R₁₀ₐ is as described herein in connection with R₃.

* in Formula 2 indicate a binding site to a neighboring atom.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), - N(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉), or a combination thereof; or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, R₁ₐ, R_{1b}, R₂ₐ, R_{2b}, R₃ₐ, R_{3b}, R₃, R₄, R₁₁, R₁₂, R₂₁ to R₂₃, and E₁ to E₅ may each independently be:
hydrogen, deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, a C₂-C₂₀ alkenyl group, a C₂-C₂₀ alkynyl group, a C₁-C₂₀ alkoxy group, or a C₁-C₂₀ alkylthio group;
a C₁-C₂₀ alkyl group, a C₂-C₂₀ alkenyl group, a C₂-C₂₀ alkynyl group, a C₁-C₂₀ alkoxy group, or a C₁-C₂₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si(Q₃₁)(Q₃₂)(Q₃₃), - Ge(Q₃₁)(Q₃₂)(Q₃₃), -N(Q₃₄)(Q₃₅), -B(Q₃₆)(Q₃₇), -P(Q₃₈)(Q₃₉), -P(=O)(Q₃₈)(Q₃₉), or a combination thereof; or
-Si(Q₁)(Q₂)(Q₃), -Ge(Q₁)(Q₂)(Q₃), -N(Q₄)(Q₅), -B(Q₆)(Q₇), -P(Q₈)(Q₉), or - P(=O)(Q₈)(Q₉), and
Q₁ to Q₉ and Q₃₁ to Q₃₉ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

In one or more embodiments, at least one of E₂ and E₄ may be:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₂-C₂₀ alkenyl group, a C₂-C₂₀ alkynyl group, a C₁-C₂₀ alkoxy group, a C₁-C₂₀ alkylthio group;
a C₁-C₂₀ alkyl group, a C₂-C₂₀ alkenyl group, a C₂-C₂₀ alkynyl group, a C₁-C₂₀ alkoxy group, or a C₁-C₂₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si(Q₃₁)(Q₃₂)(Q₃₃), - Ge(Q₃₁)(Q₃₂)(Q₃₃), -N(Q₃₄)(Q₃₅), -B(Q₃₆)(Q₃₇), -P(Q₃₈)(Q₃₉), -P(=O)(Q₃₈)(Q₃₉), or a combination thereof; or
-Si(Q₁)(Q₂)(Q₃), -Ge(Q₁)(Q₂)(Q₃), -N(Q₄)(Q₅), -B(Q₆)(Q₇), -P(Q₈)(Q₉), or - P(=O)(Q₈)(Q₉), and
Q₁ to Q₉ and Q₃₁ to Q₃₉ may each independently be:
   -CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

In one or more embodiments, R₁₁, R₁₂, R₂₁ to R₂₃, R₃, R₄, R₁ₐ, R_{1b}, R₂ₐ, R_{2b}, R₃ₐ, R_{3b}, and E₁ to E₅ may each independently be:
hydrogen, deuterium, -F, -Cl, -Br, -I, -SF₅, -CD₃, -CD₂H, -CDH₂, -CF₃, -CF₂H, -CFH₂, a cyano group, a C₁-C₂₀ alkyl group, a C₂-C₂₀ alkenyl group, a C₂-C₂₀ alkynyl group, a C₁-C₂₀ alkoxy group, or a C₁-C₂₀ alkylthio group;
a group represented by one of Formulae 9-1 to 9-61, 9-201 to 9-237, 10-1 to 10-129, or 10-201 to 10-355;
a group represented by one of Formulae 9-1 to 9-61, 9-201 to 9-237, 10-1 to 10-129, or 10-201 to 10-355 in which at least one hydrogen is substituted with at least one of deuterium, -F, or a cyano group; or
-Si(Q₁)(Q₂)(Q₃), -Ge(Q₁)(Q₂)(Q₃), or -N(Q₄)(Q₅), and
Q₁ to Q₅ may each be as described herein:

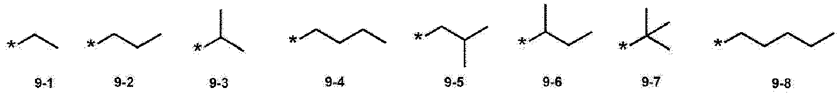

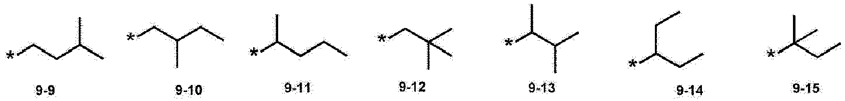

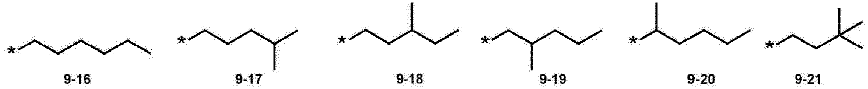

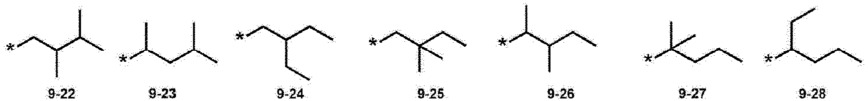

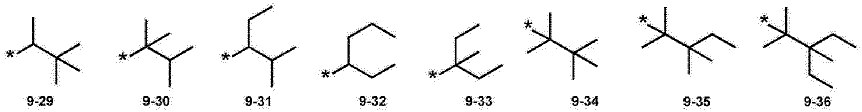

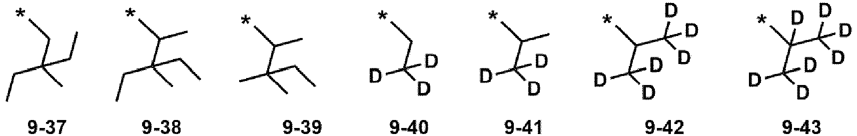

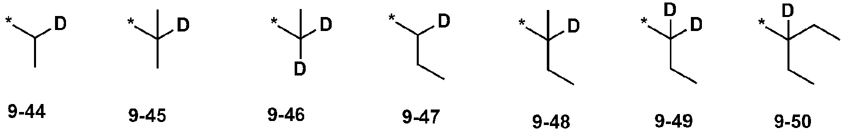

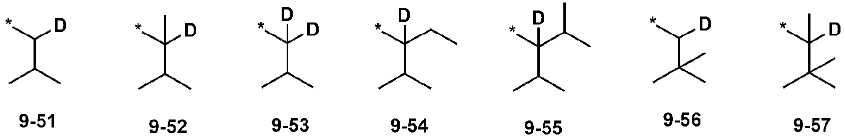

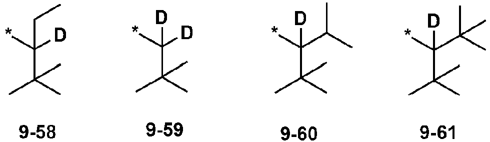

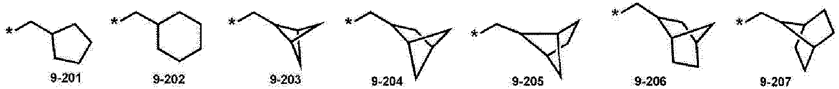

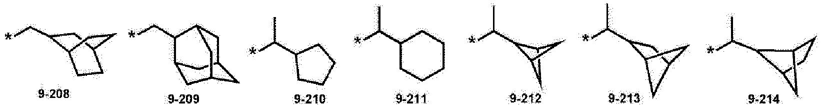

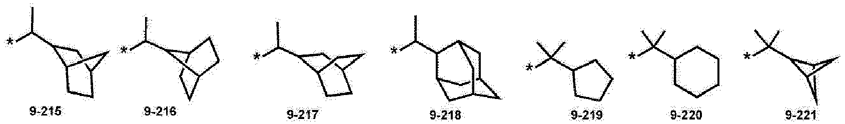

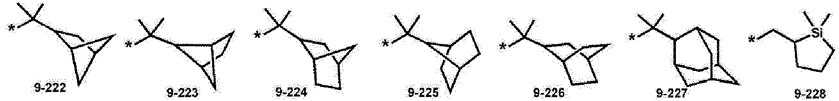

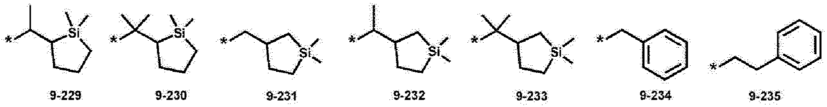

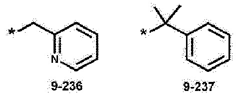

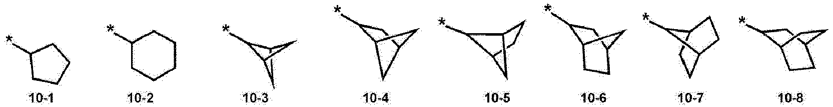

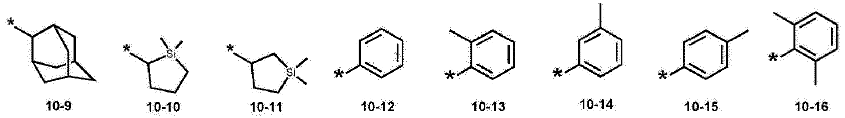

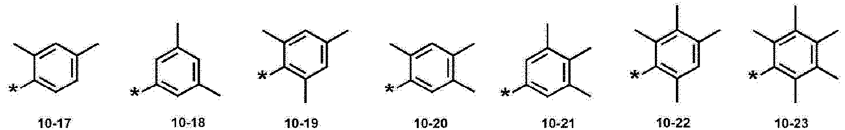

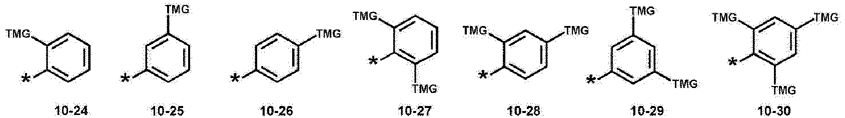

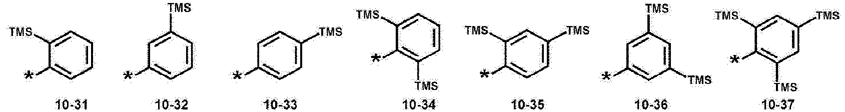

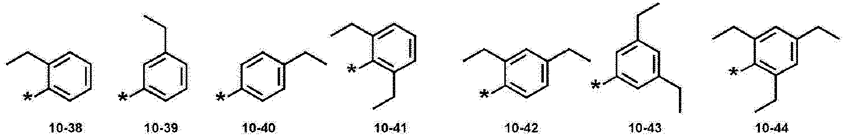

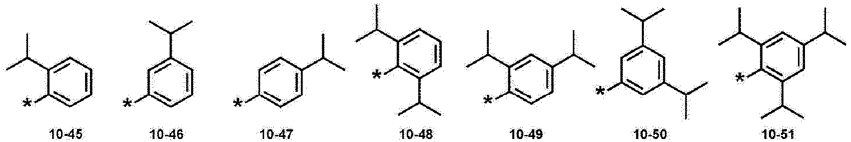

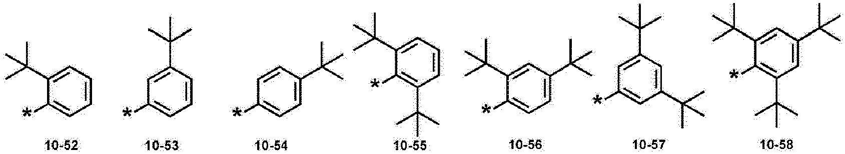

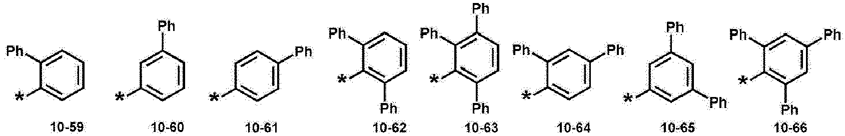

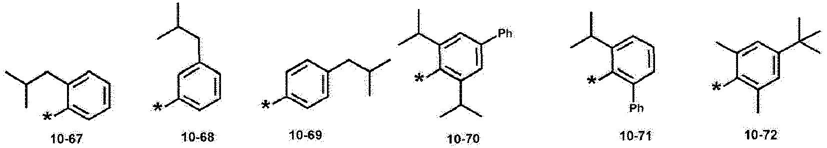

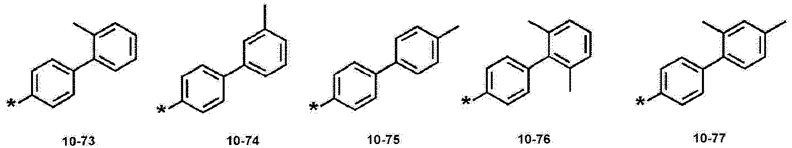

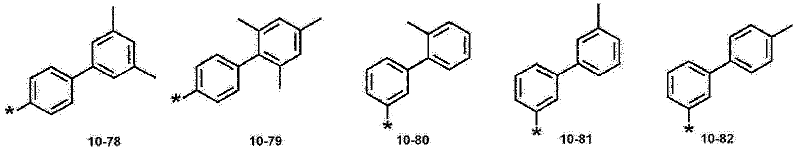

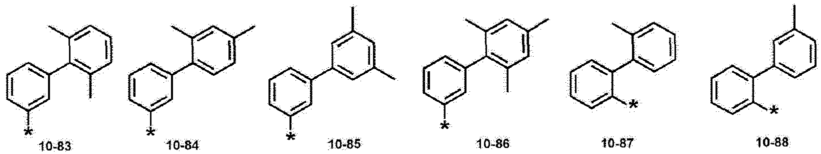

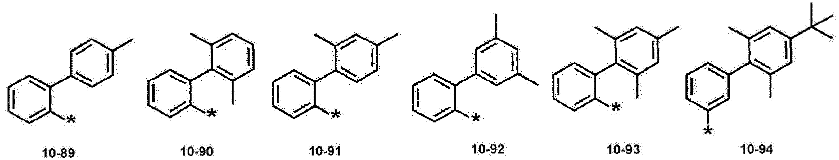

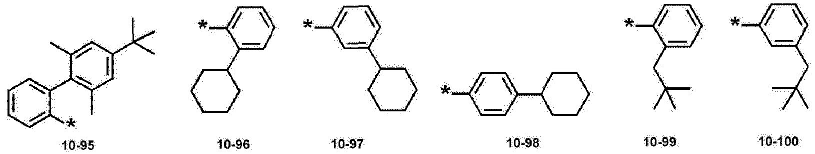

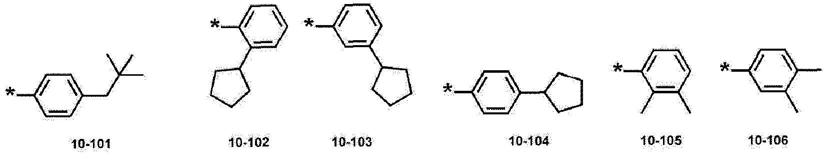

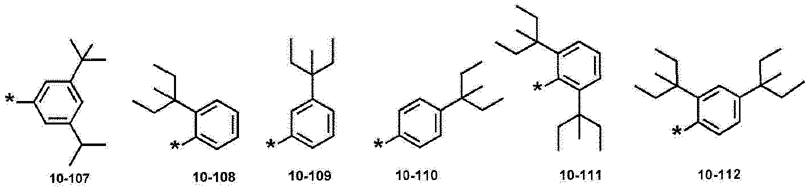

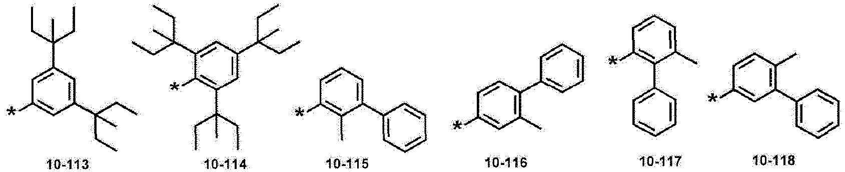

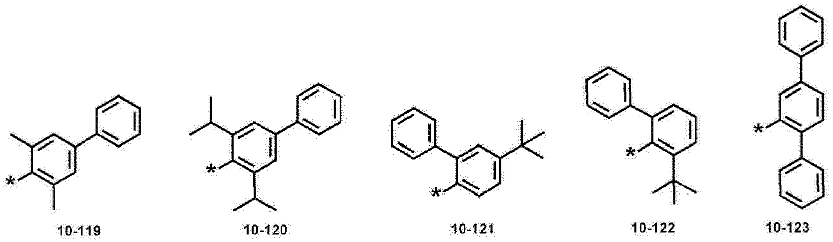

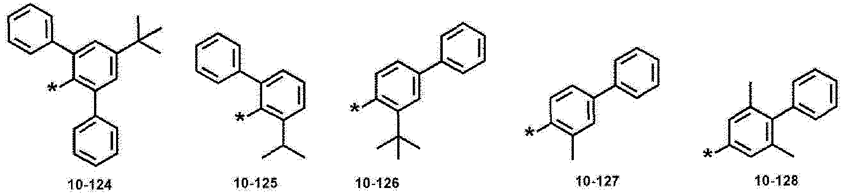

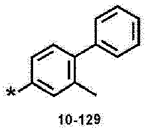

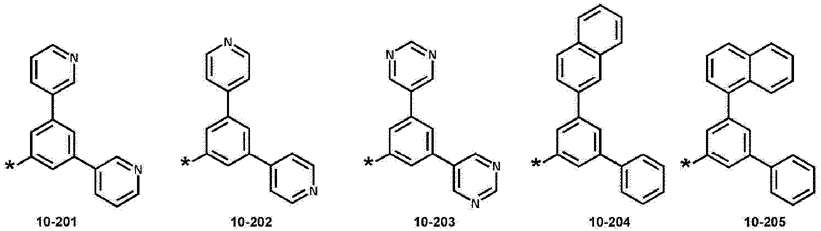

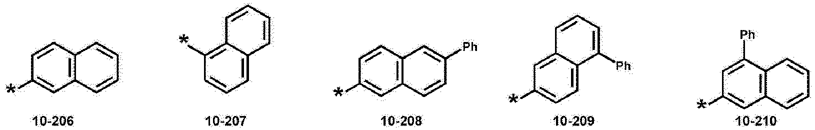

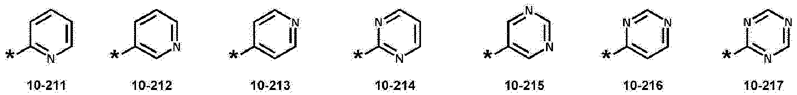

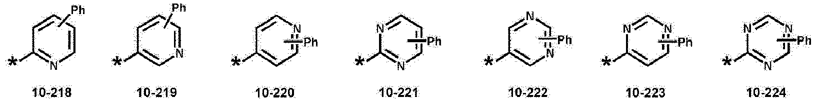

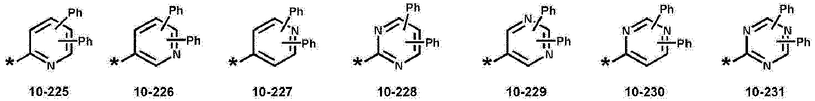

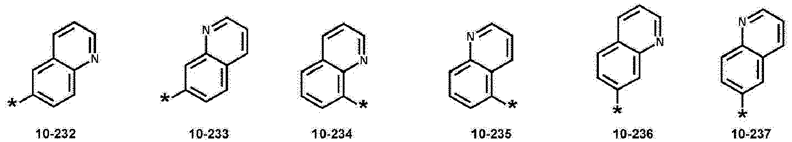

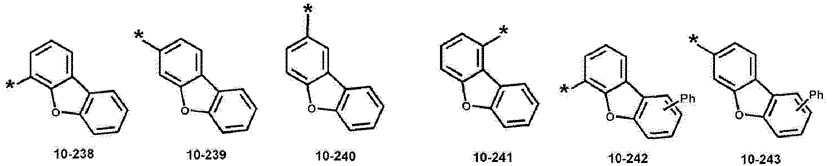

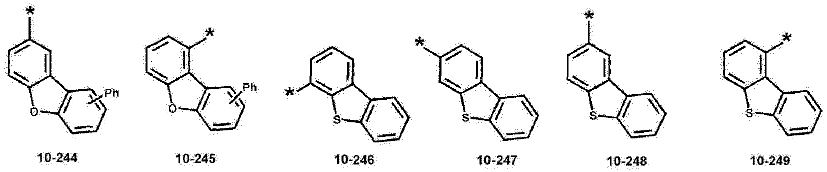

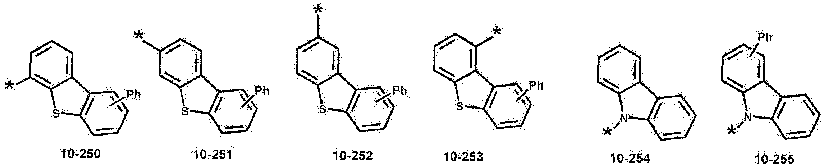

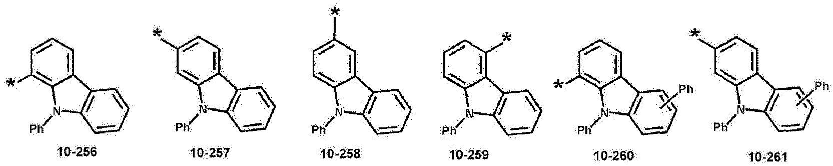

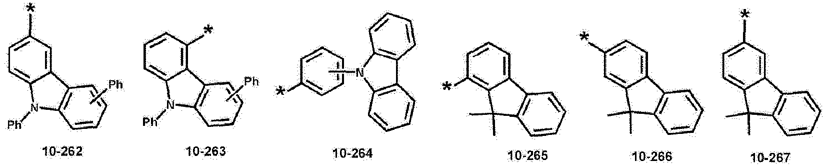

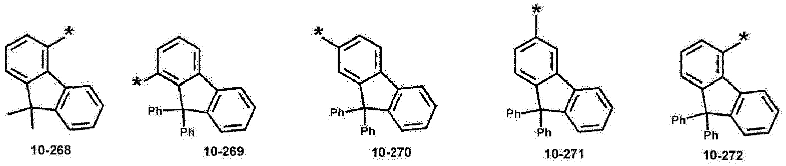

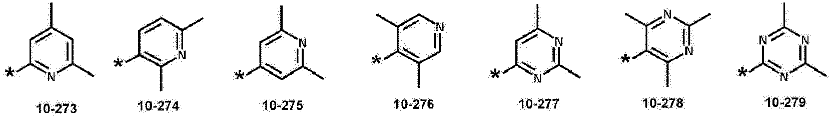

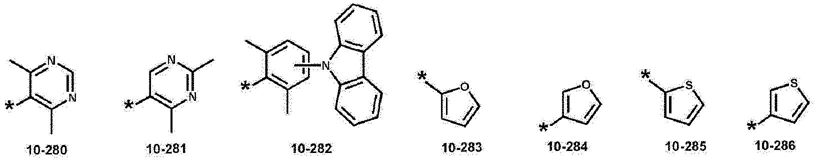

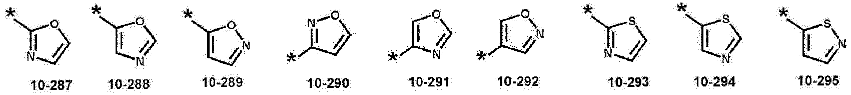

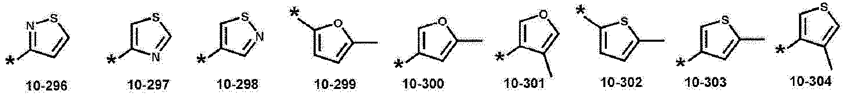

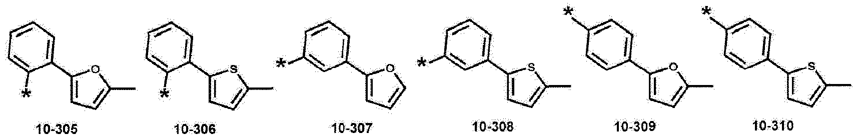

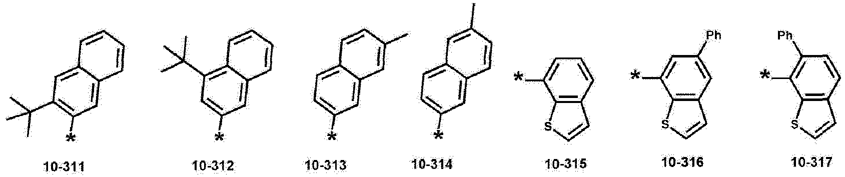

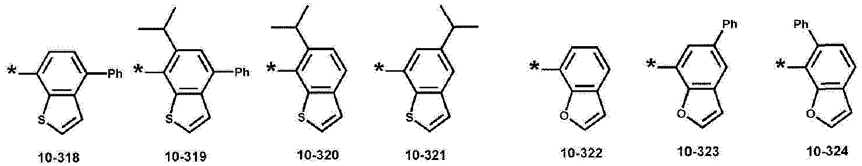

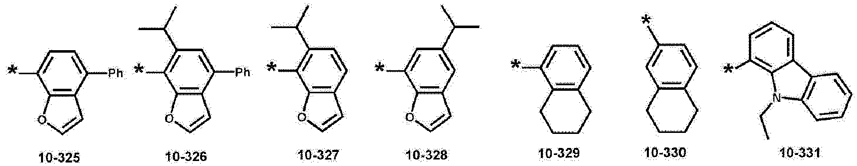

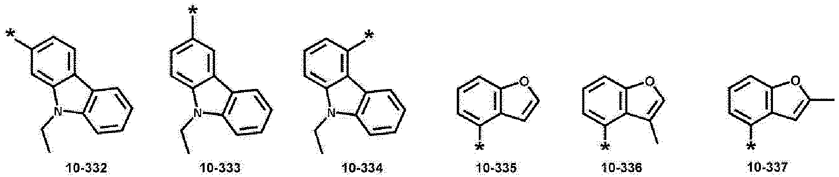

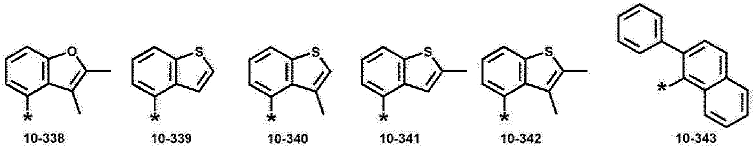

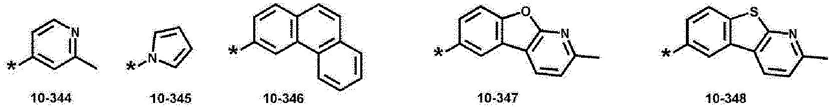

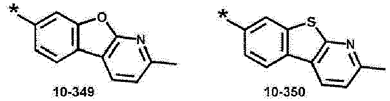

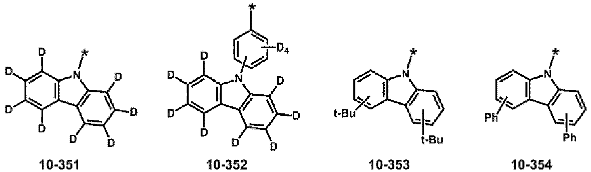

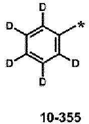

* in Formulae 9-1 to 9-61, 9-201 to 9-237, 10-1 to 10-129, and 10-201 to 10-355 indicates a binding site to a neighboring atom, "Ph" is a phenyl group, "TMS" is a trimethylsilyl group, "TMG" is a trimethylgermyl group, and "t-Bu" is a t-butyl group.

In one or more embodiments, at least one of E₂ and E₄ may be:
deuterium, -F, -Cl, -Br, -I, -SF₅, -CD₃, -CD₂H, -CDH₂, -CF₃, -CF₂H, -CFH₂, a cyano group, a C₁-C₂₀ alkyl group, a C₂-C₂₀ alkenyl group, a C₂-C₂₀ alkynyl group, a C₁-C₂₀ alkoxy group, or a C₁-C₂₀ alkylthio group;
a group represented by one of Formulae 9-1 to 9-61, 9-201 to 9-237, 10-1 to 10-129, or 10-201 to 10-355;
a group represented by one of Formulae 9-1 to 9-61, 9-201 to 9-237, 10-1 to 10-129, or 10-201 to 10-355 in which at least one hydrogen is substituted with at least one of deuterium, -F, or a cyano group; or
-Si(Q₁)(Q₂)(Q₃), -Ge(Q₁)(Q₂)(Q₃), or -N(Q₄)(Q₅), and
Q₁ to Q₅ may each be as described herein:

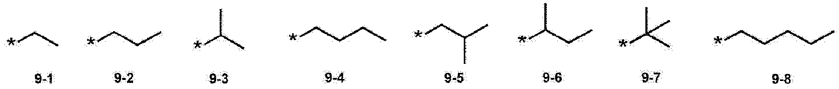

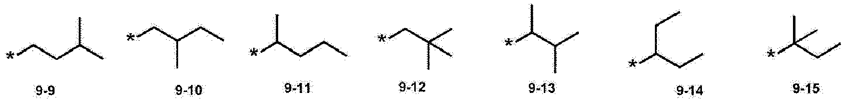

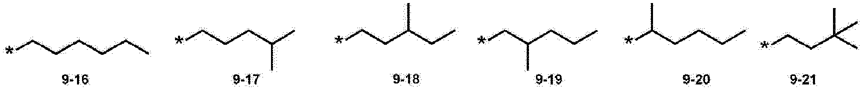

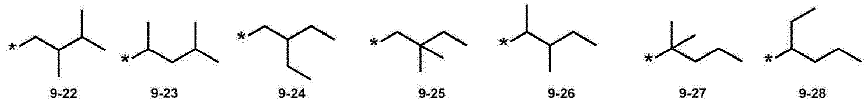

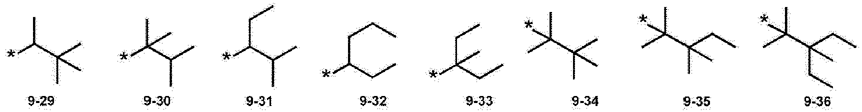

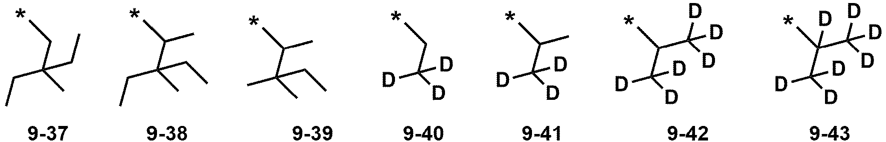

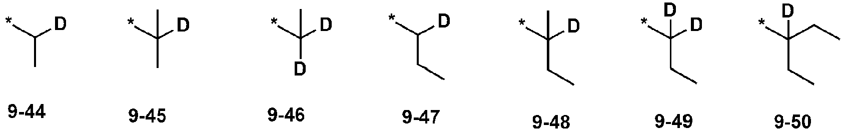

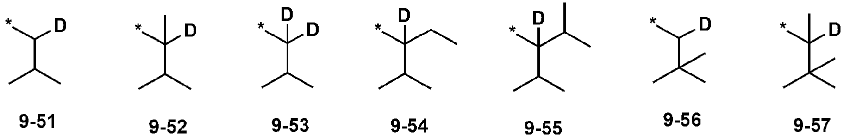

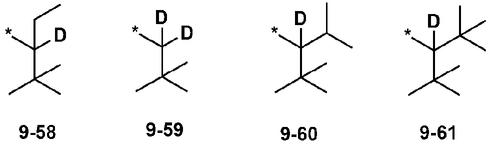

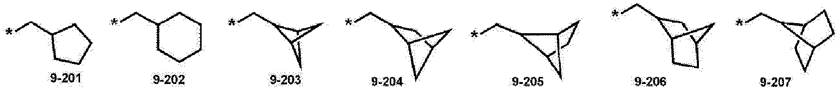

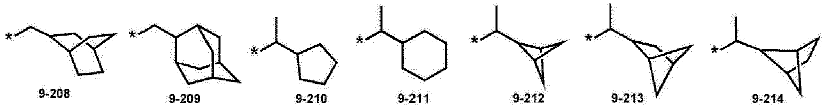

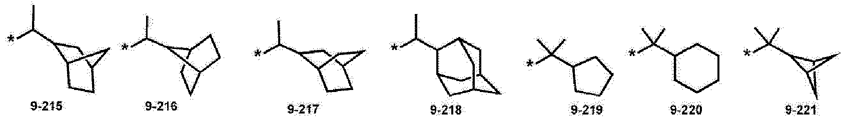

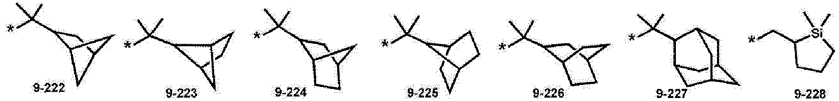

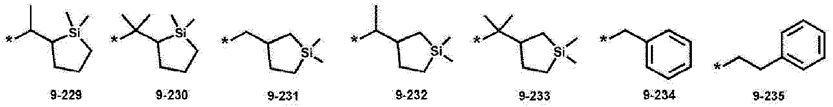

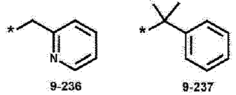

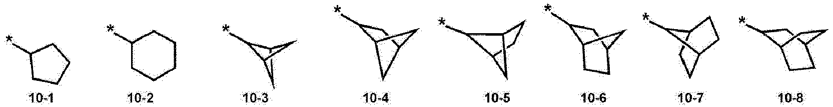

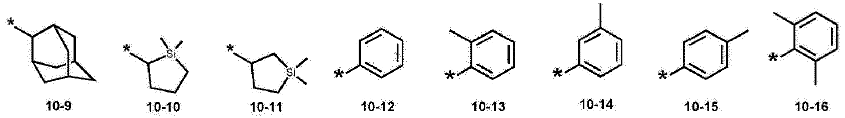

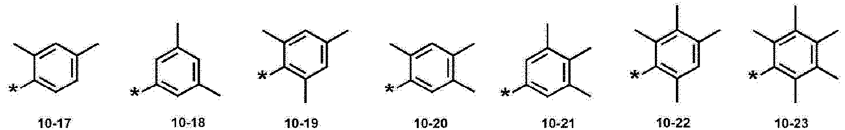

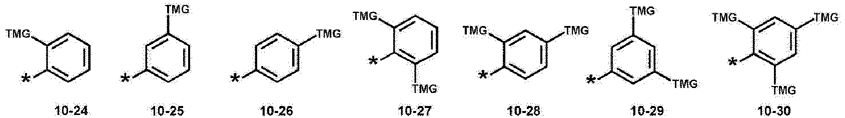

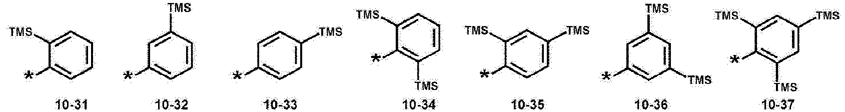

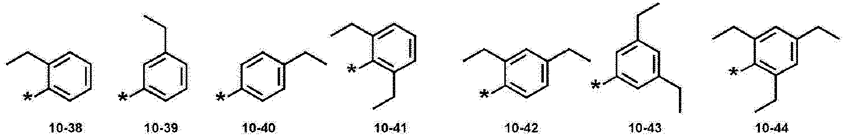

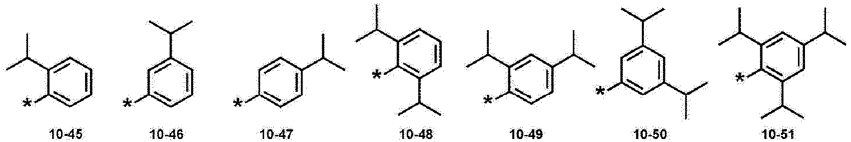

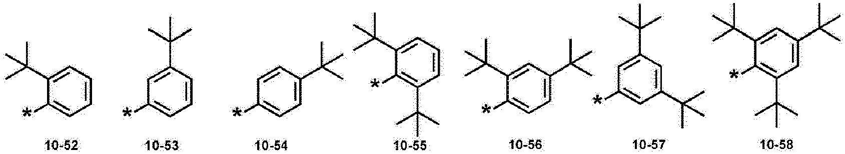

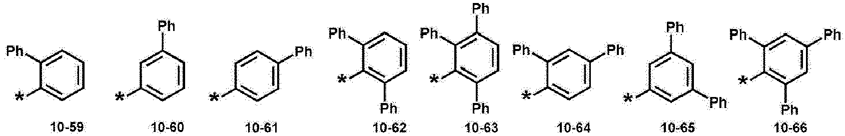

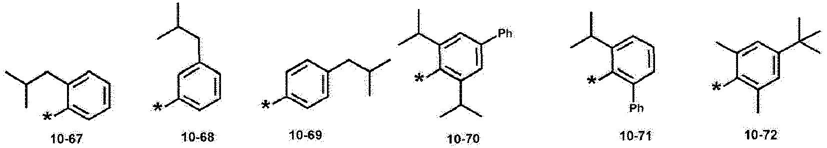

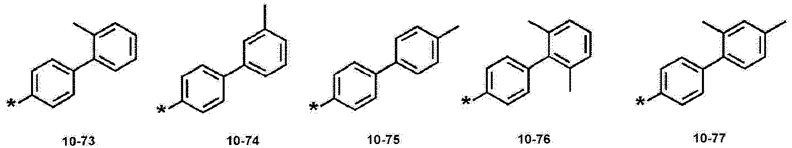

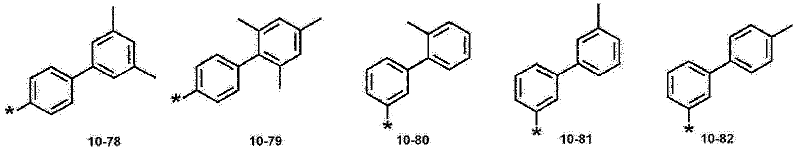

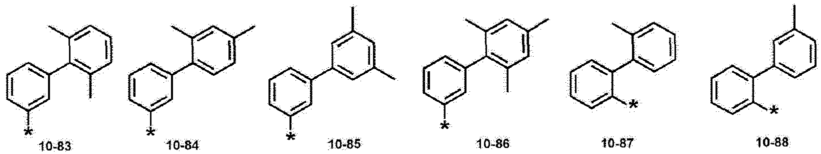

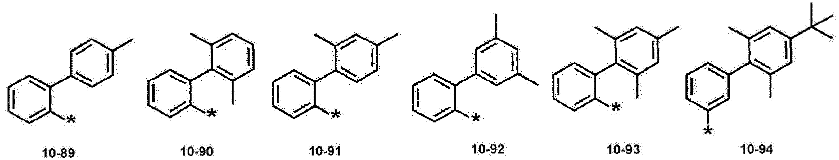

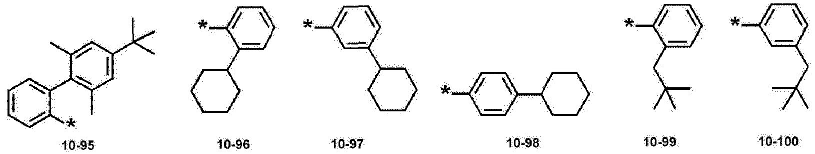

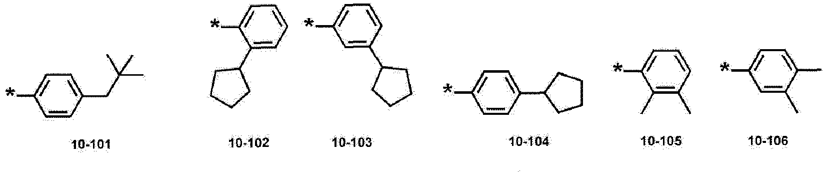

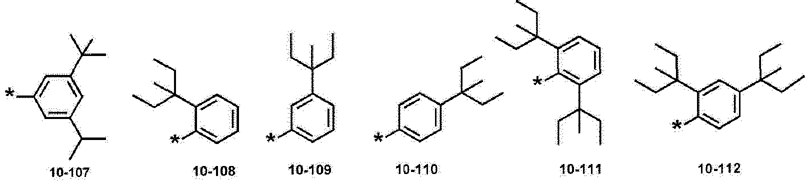

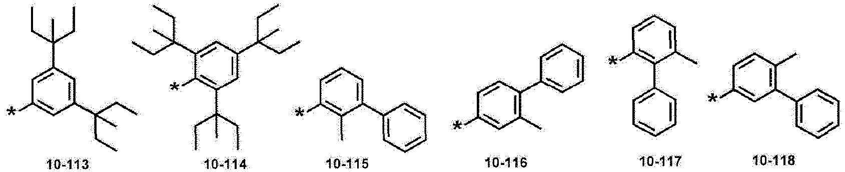

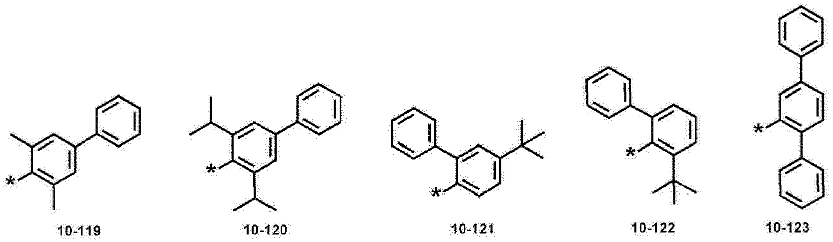

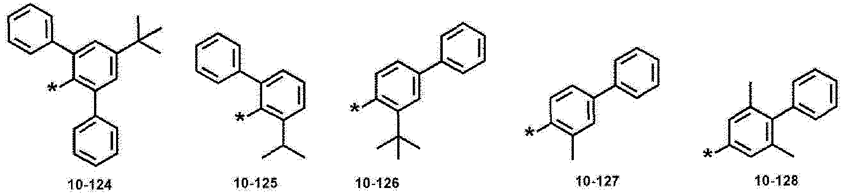

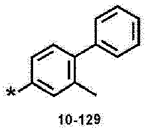

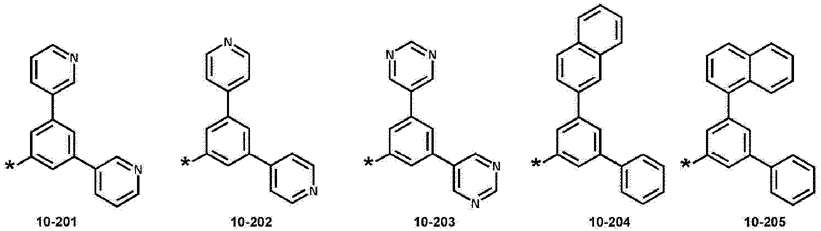

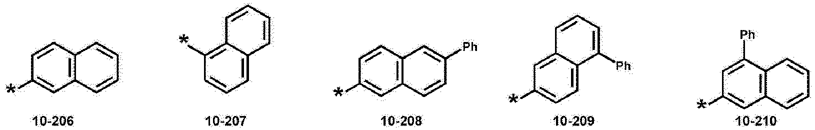

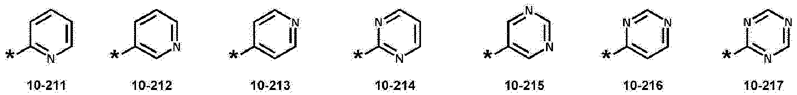

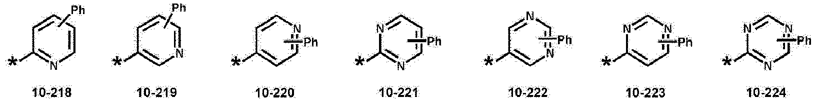

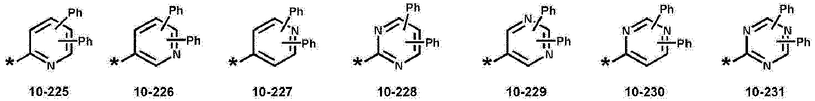

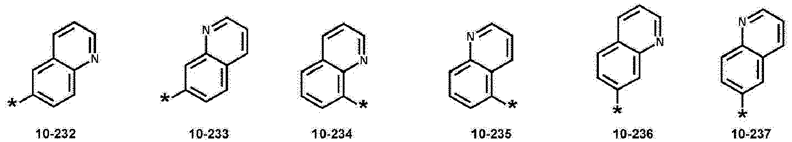

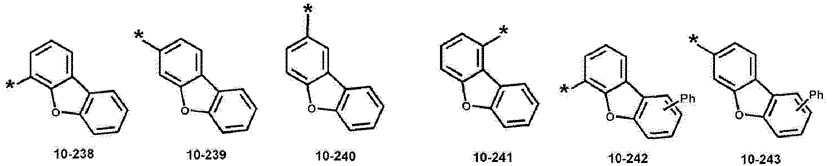

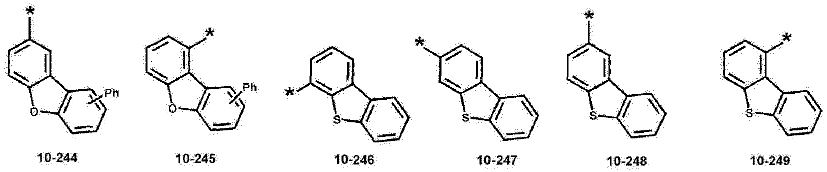

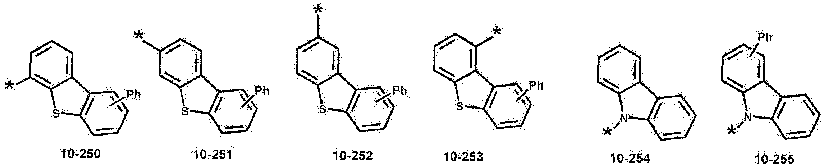

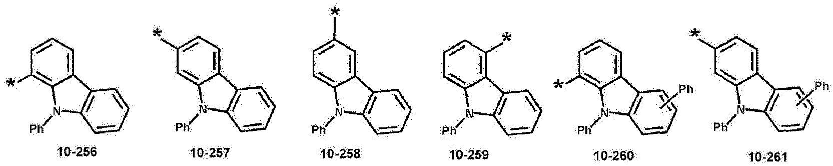

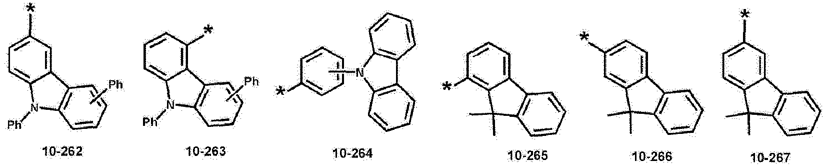

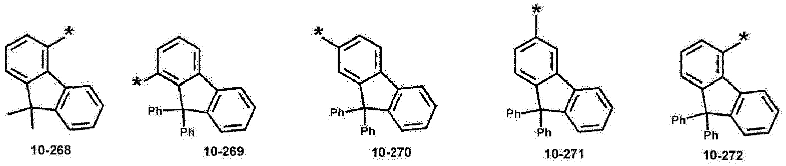

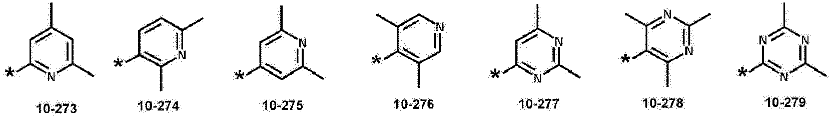

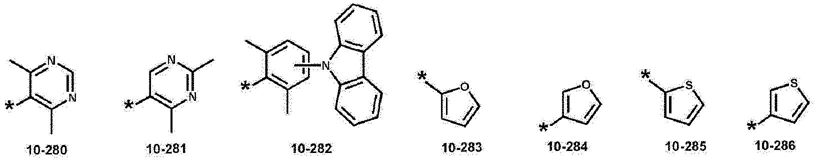

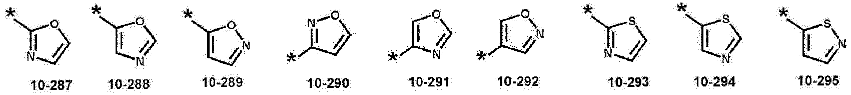

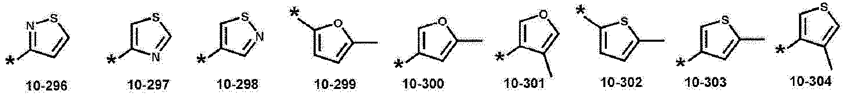

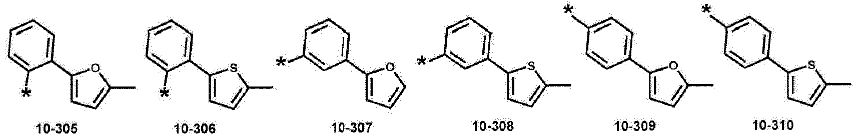

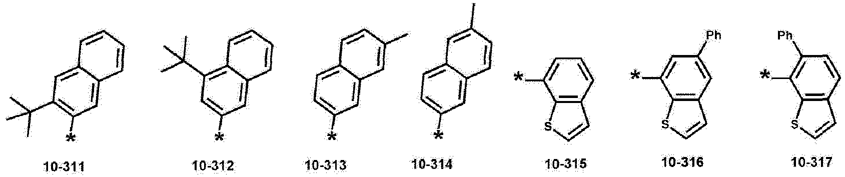

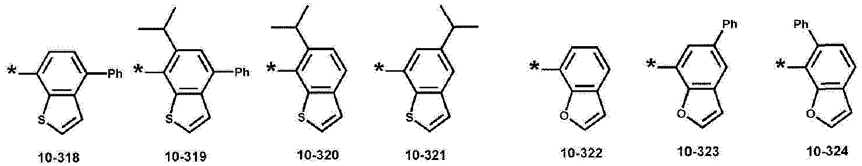

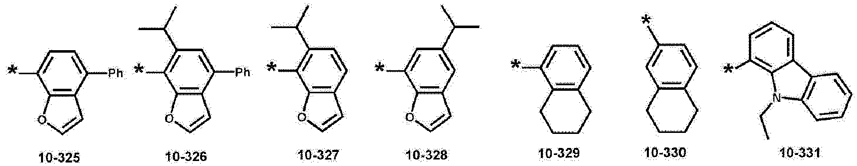

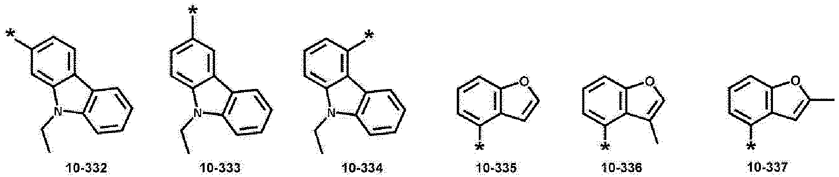

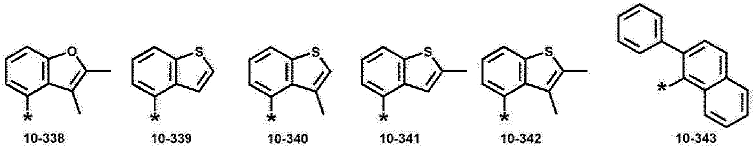

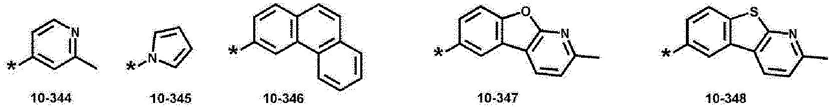

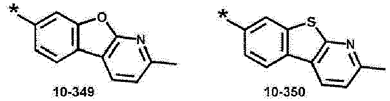

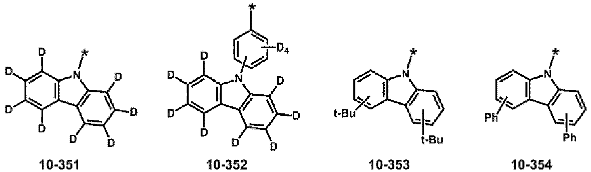

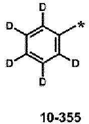

* in Formulae 9-1 to 9-61, 9-201 to 9-237, 10-1 to 10-129, and 10-201 to 10-355 indicates a binding site to a neighboring atom, "Ph" is a phenyl group, "TMS" is a trimethylsilyl group, "TMG" is a trimethylgermyl group, and "t-Bu" is a t-butyl group.

In one or more embodiments, a group represented by 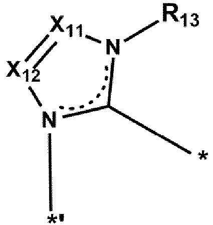 in Formula 1 may be a group represented by Formula CY1-1 or CY1-2: 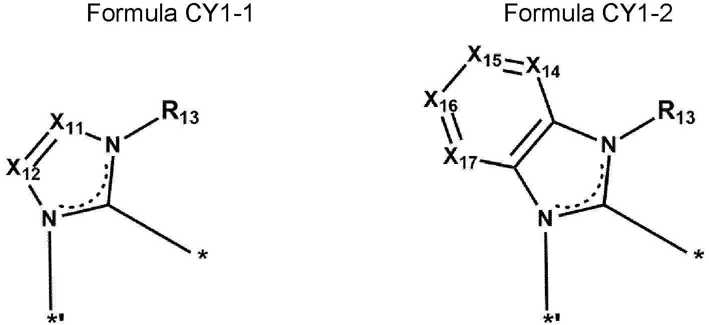 wherein, in Formulae CY1-1 and CY1-2,
X₁₁, X₁₂, and R₁₃ may each be as described herein,
X₁₄ may be N or C(R₁₄),
X₁₅ may be N or C(R₁₅),
X₁₆ may be N or C(R₁₆),
X₁₇ may be N or C(R₁₇),
R₁₄ to R₁₇ may each be as described herein in connection with R₁₁,
* indicates a binding site to M₁, and
*' indicates a binding site to T₁.

In one or more embodiments, a group represented by 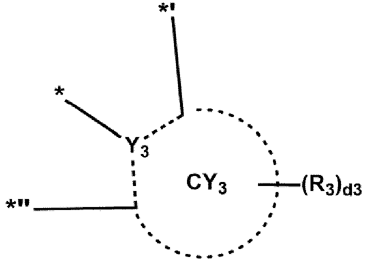 in Formula 1 may be a group represented by one of Formulae 3-1 to 3-3: 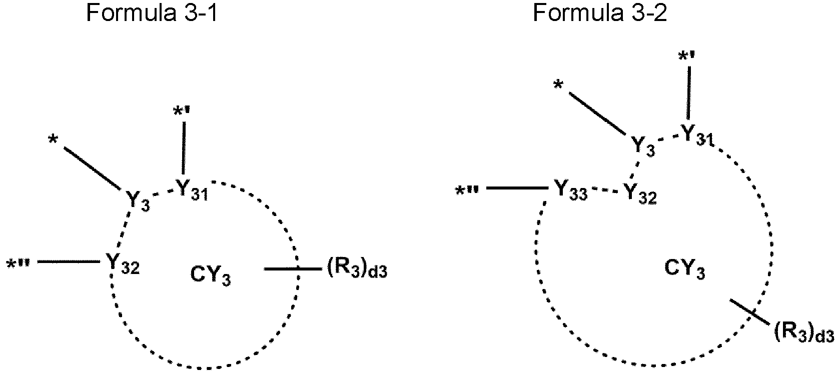 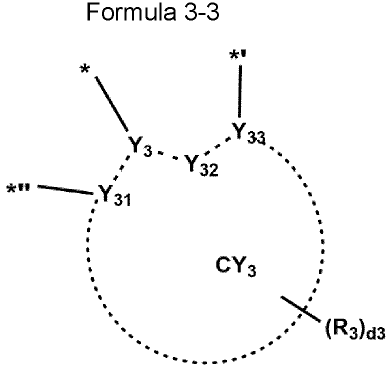 wherein, in Formulae 3-1 to 3-3,
Y₃₁ to Y₃₃ may each independently be C or N,
Y₃₁ and Y₃, Y₃ and Y₃₂, and Y₃₂ and Y₃₃ may be chemically bonded to each other,
*' may indicate a binding site to T₃, *" may indicate a binding site to T₂, * may indicate a binding site to A₃ or M₁, and
ring CY₃, Y₃, R₃, and d3 may each be as described herein.

In one or more embodiments, a group represented by 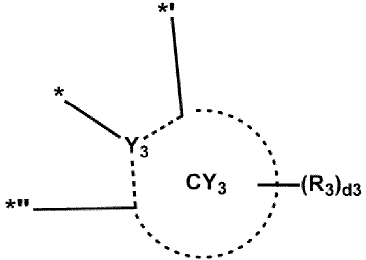 in Formula 1 may be a group represented by one of Formulae CY3-1 to CY3-27: 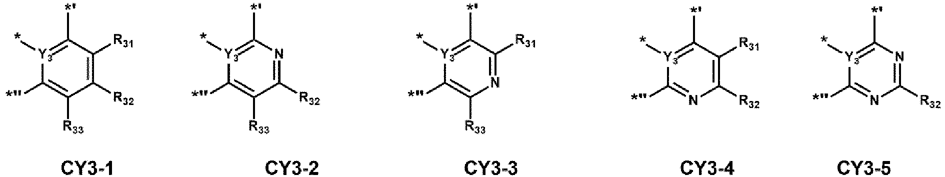 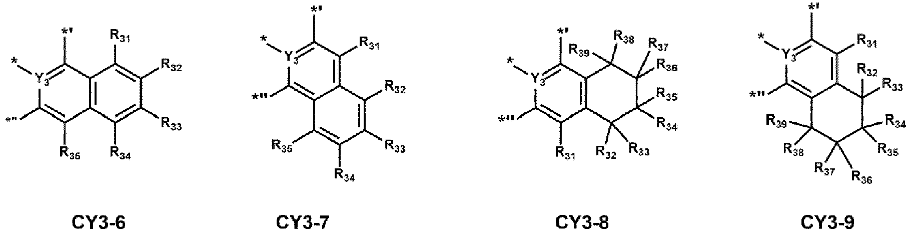 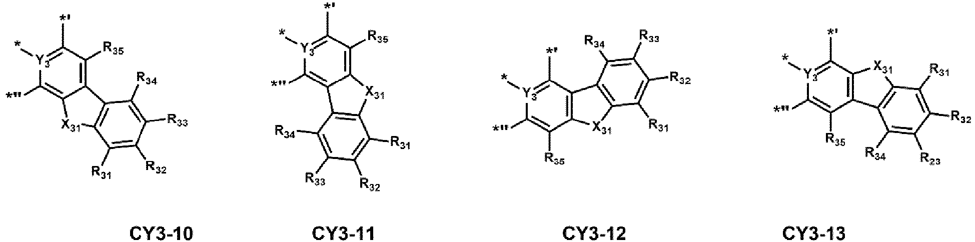 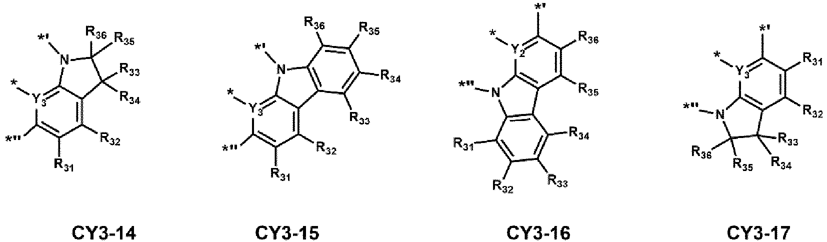 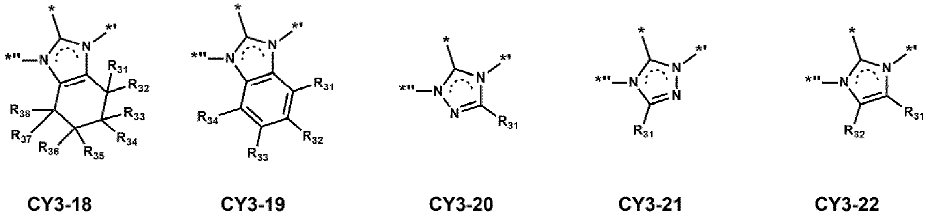 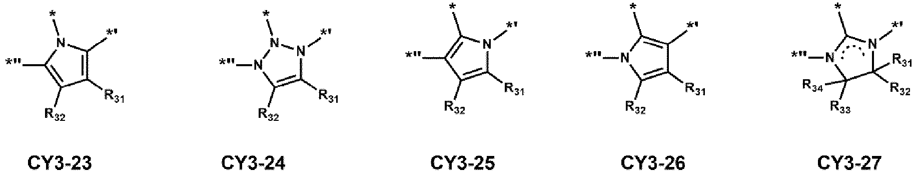 wherein, in Formulae CY3-1 to CY3-27,
Y₃ may be C or N,
X₃₁ may be N(R₃₁ₐ), O, Se, C(R₃₁ₐ)(R_{31b}), or Si(R₃₁ₐ)(R_{31b}),
R₃₁ to R₃₉, R₃₁ₐ, and R_{31b} may each be as described herein in connection with R₃,
* may indicate a binding site to M₁ or A₃, *' may indicate a binding site to T₃, and *" may indicate a binding site to T₂.

In one or more embodiments, a group represented by 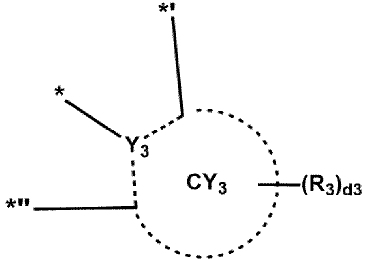 in Formula 1 may be a group represented by one of Formulae CY3-15-1 to CY3-15-9: 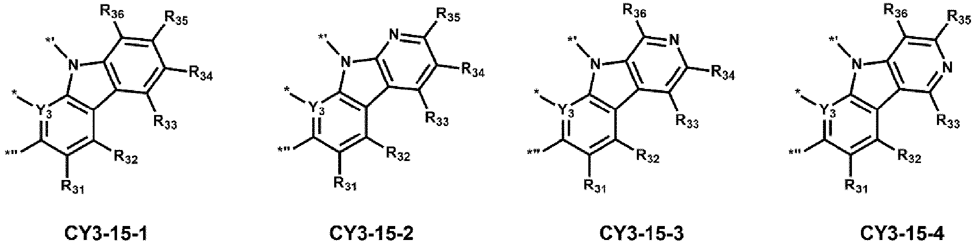 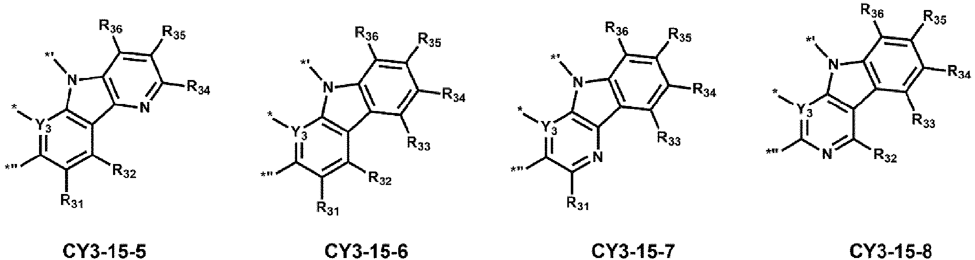 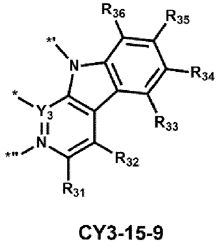 wherein, in Formulae CY3-15-1 to CY3-15-9,
Y₃ may be C or N,
R₃₁ to R₃₆ may each be as described herein in connection with R₃₁,
* may indicate a binding site to M₁ or A₃, *' may indicate a binding site to T₃, and *" may indicate a binding site to T₂.

In one or more embodiments, in Formulae CY3-15-1 to CY3-15-9, R₃₄ may not be hydrogen; however, embodiments are not limited thereto.

In one or more embodiments, a group represented by 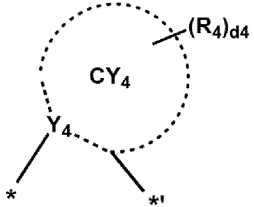 in Formula 1 may be a group represented by one of Formulae CY4-1 to CY4-18: 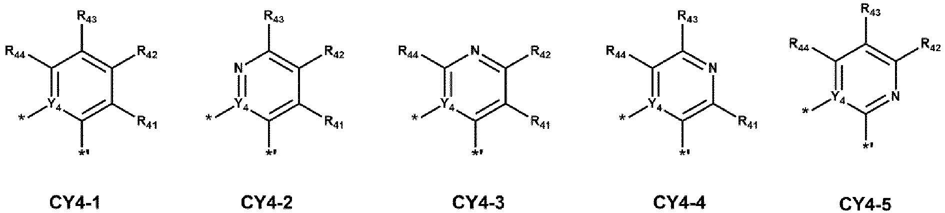 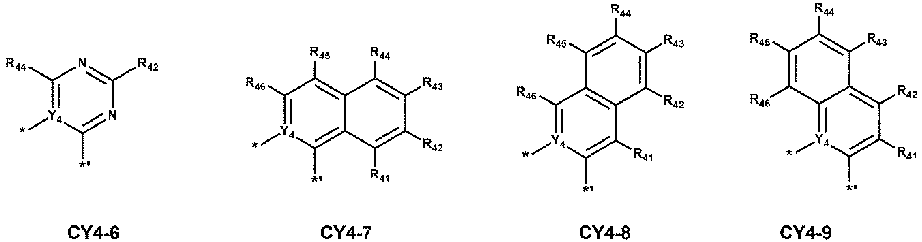 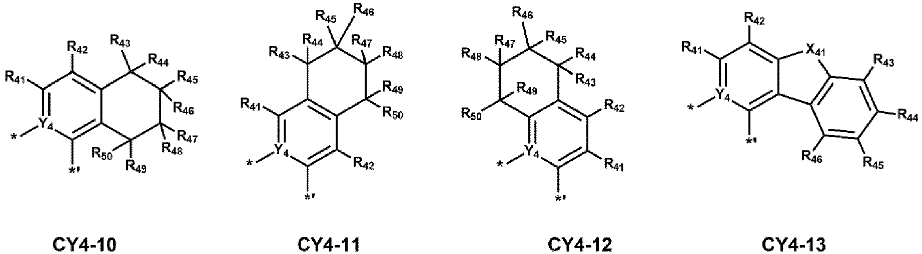 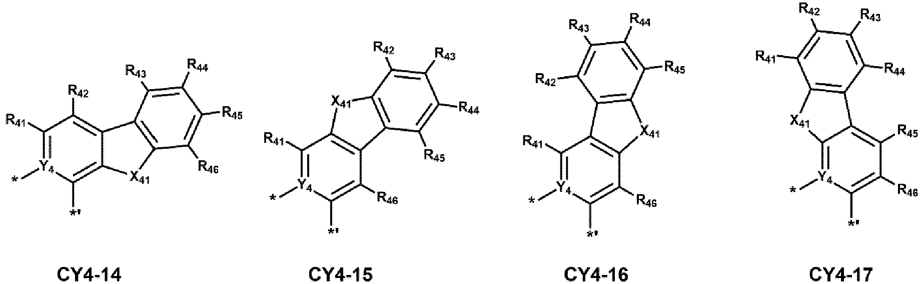 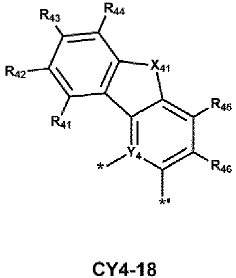 wherein, in Formulae CY4-1 to CY4-18,
Y₄ may be C or N,
X₄₁ may be N(R₄₁ₐ), O, Se, C(R₄₁ₐ)(R_{41b}), or Si(R₄₁ₐ)(R_{41b}),
R₄₁ to R₅₀, R₄₁ₐ, and R_{41b} may each be as described herein in connection with R₄,
* may indicate a binding site to M₁ or A₄, and *' may indicate a binding site to T₃.

In one or more embodiments, the organometallic compound represented by Formula 1 may be represented by one of Formulae 1-1 and 1-2:

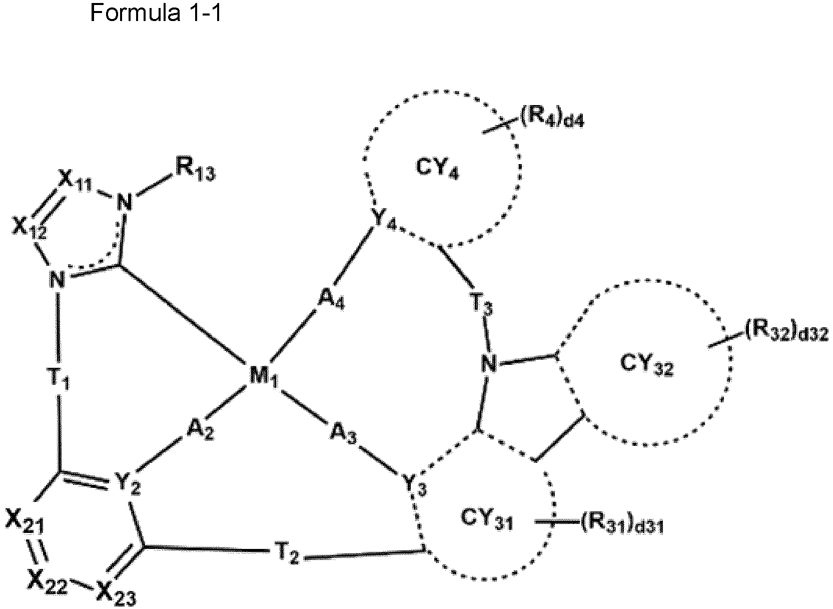

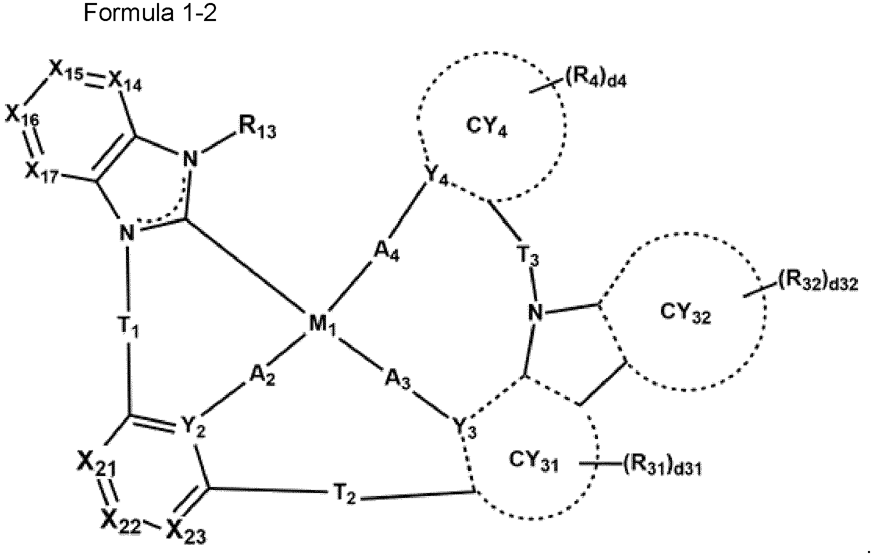

In Formulae 1-1 and 1-2,
ring CY₃₁ and ring CY₃₂ may each independently be a C₅-C₃₀(e.g., C₅-C₁₅) carbocyclic group or a C₁-C₃₀(e.g., C₅-C₁₅) heterocyclic group,
R₃₁ and R₃₂ may each be as described herein in connection with R₃,
d31 and d32 may each independently be an integer from 0 to 10,
X₁₄ may be N or C(R₁₄),
X₁₅ may be N or C(R₁₅),
X₁₆ may be N or C(R₁₆),
X₁₇ may be N or C(R₁₇),
R₁₄ to R₁₇ may each be as described herein in connection with R₁₁, and
M₁, ring CY₄, Y₂ to Y₄, A₂ to A₄, T₁ to T₃, X₁₁, X₁₂, X₂₁ to X₂₃, R₄, d4, and R₁₃ may each be as described herein.

In another embodiment, the organometallic compound represented by Formula 1 may be represented by one of Formulae 1-11 and 1-12: 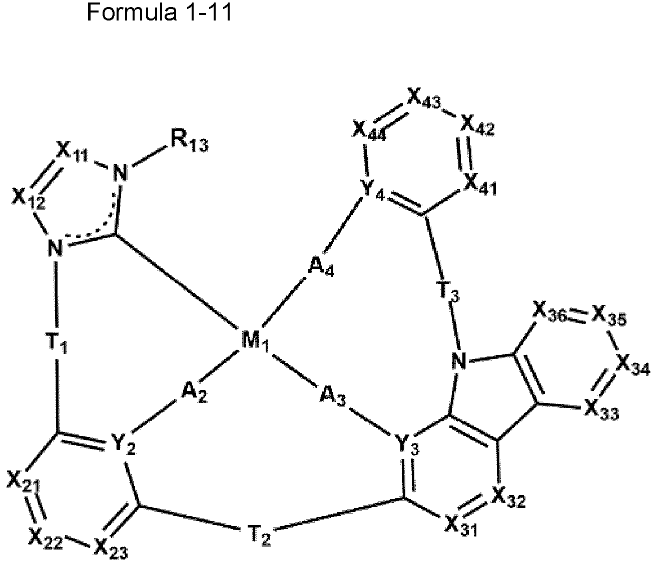 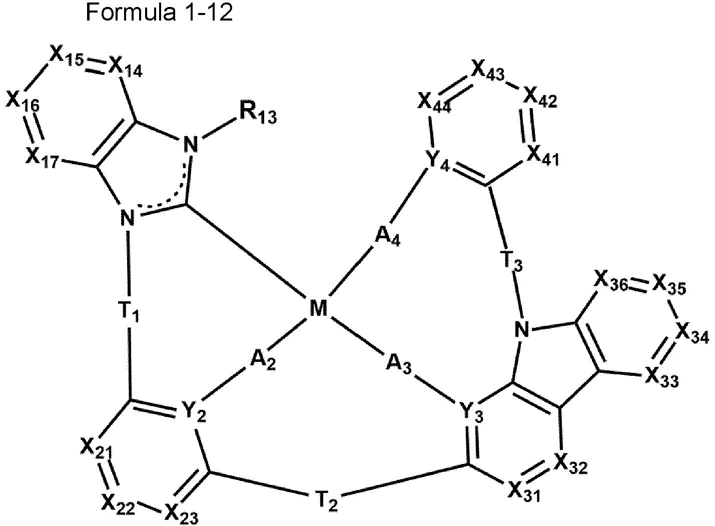 wherein, in Formulae 1-11 and 1-12,
X₁₄ may be N or C(R₁₄),
X₁₅ may be N or C(R₁₅),
X₁₆ may be N or C(R₁₆),
X₁₇ may be N or C(R₁₇),
X₃₁ may be C(R₃₁) or N, X₃₂ may be C(R₃₂) or N, X₃₃ may be C(R₃₃) or N, X₃₄ may be C(R₃₄) or N, X₃₅ may be C(R₃₅) or N, and X₃₆ may be C(R₃₆) or N,
X₄₁ may be C(R₄₁) or N, X₄₂ may be C(R₄₂) or N, X₄₃ may be C(R₄₃) or N, and X₄₄ may be C(R₄₄) or N,
R₁₄ to R₁₇ may each be as described herein in connection with R₁₁,
R₃₁ to R₃₆ may each be as described herein in connection with R₃,
R₄₁ to R₄₄ may each be as described herein in connection with R₄, and
M₁, Y₂ to Y₄, A₂ to A₄, T₁ to T₃, X₁₁, X₁₂, X₂₁ to X₂₃, and R₁₃ may each be as described herein.

In one or more embodiments, Formula 2 may be represented by one of Formulae 2-1 to 2-16: 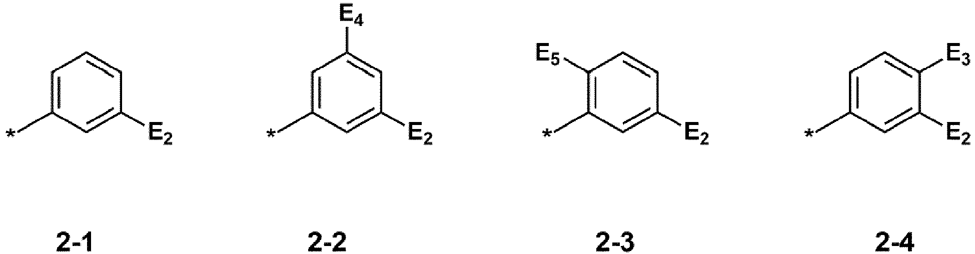 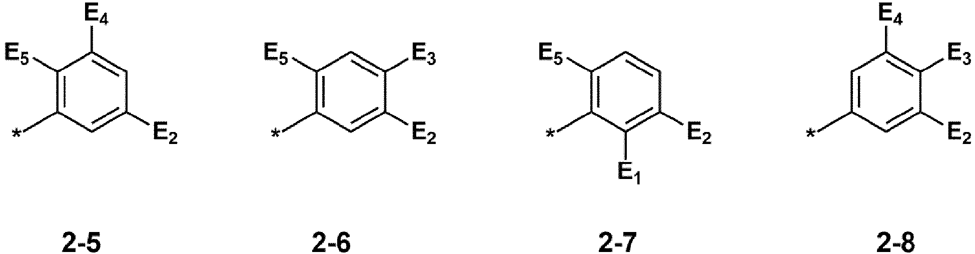 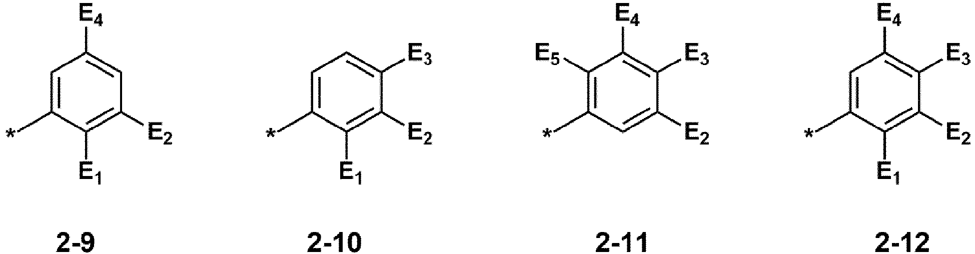 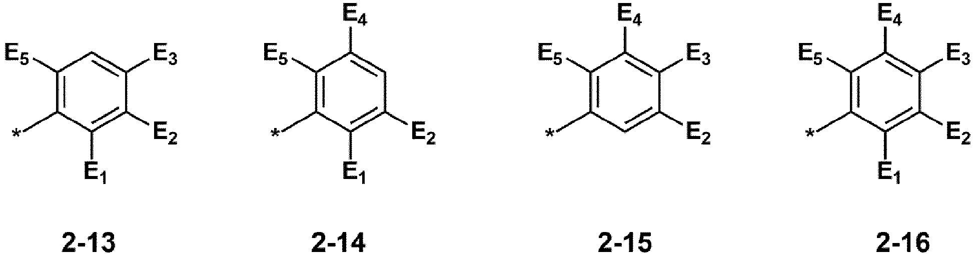 wherein, in Formulae 2-1 to 2-16,
E₁ to E₅ may each be as described herein, provided that each of E₁ to E₅ may not be hydrogen, and
* may indicate a binding site to a neighboring atom.

In one or more embodiments, the organometallic compound may be represented by one of Compounds 1 to 405, but embodiments are not limited thereto:

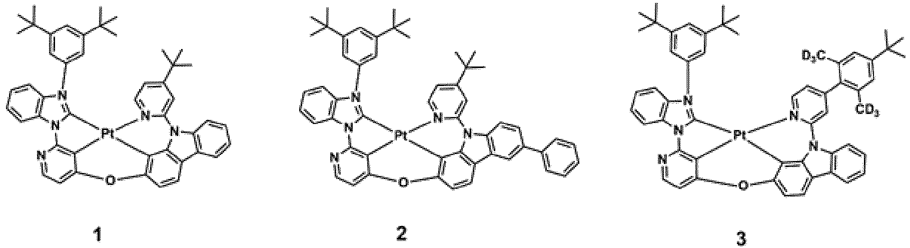

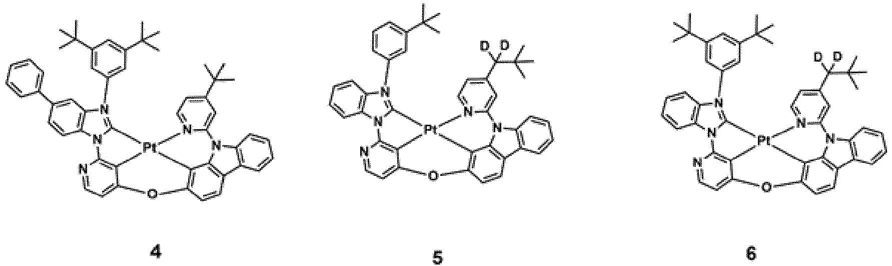

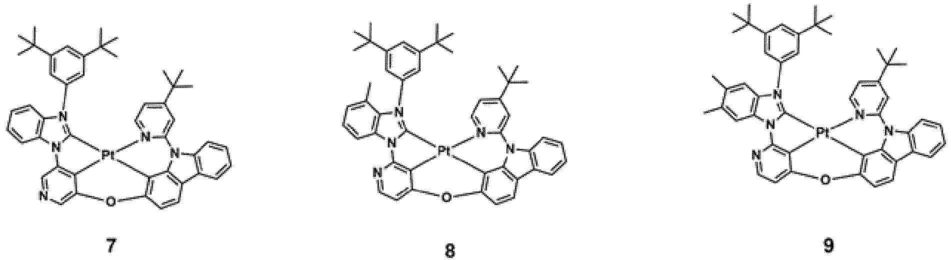

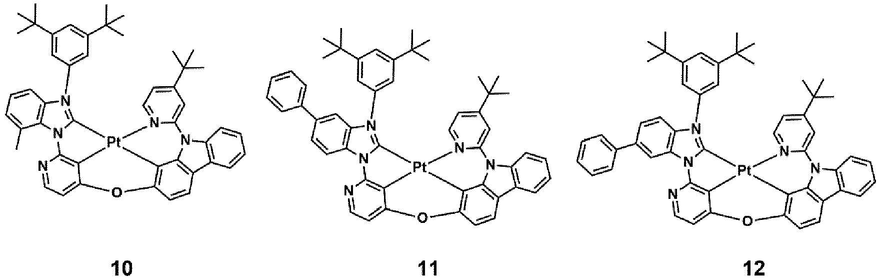

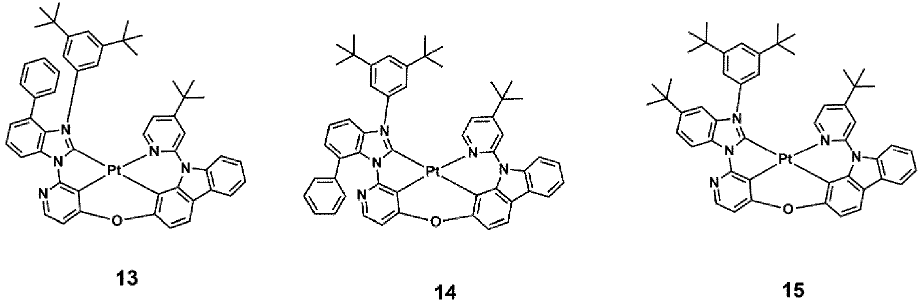

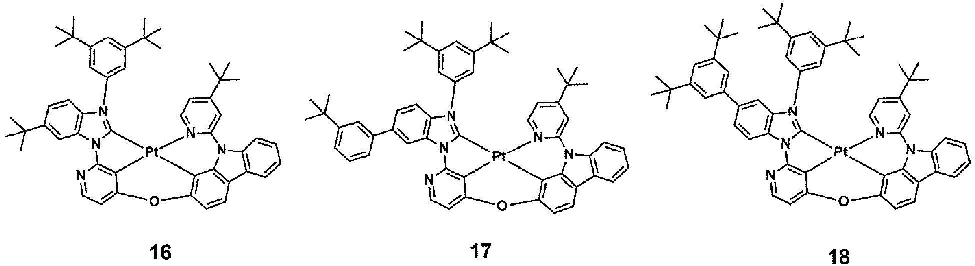

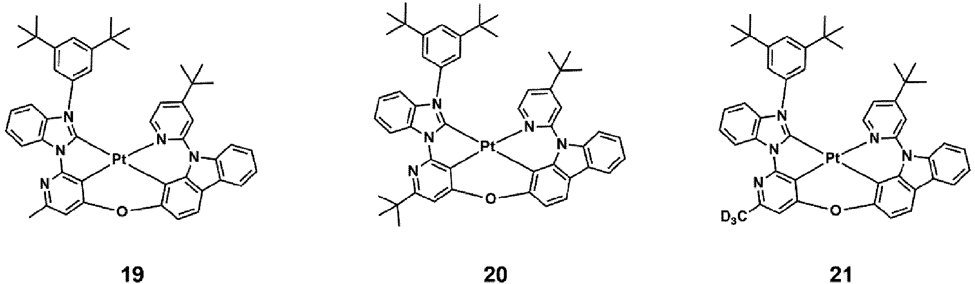

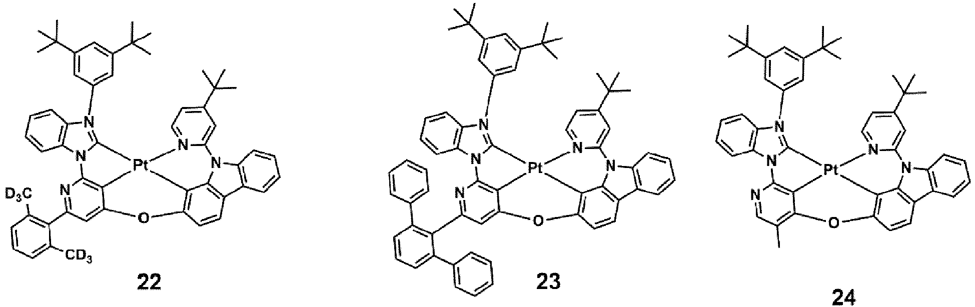

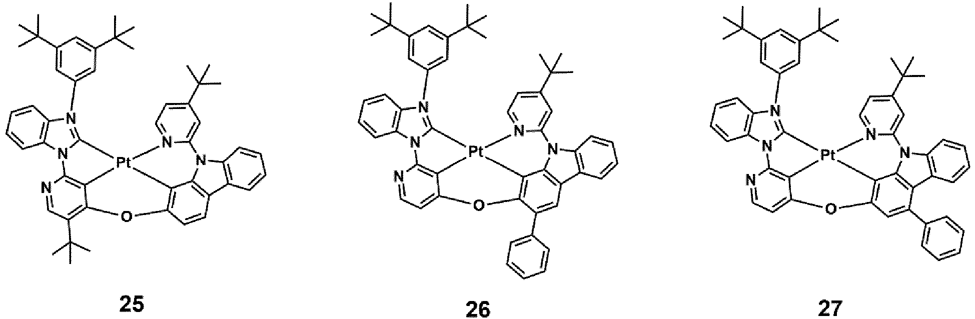

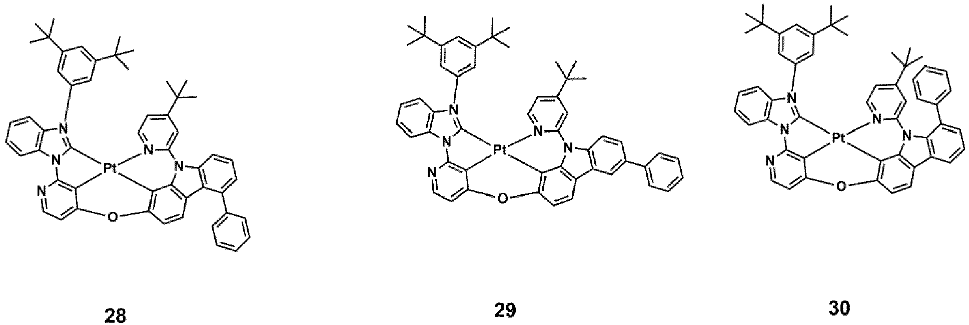

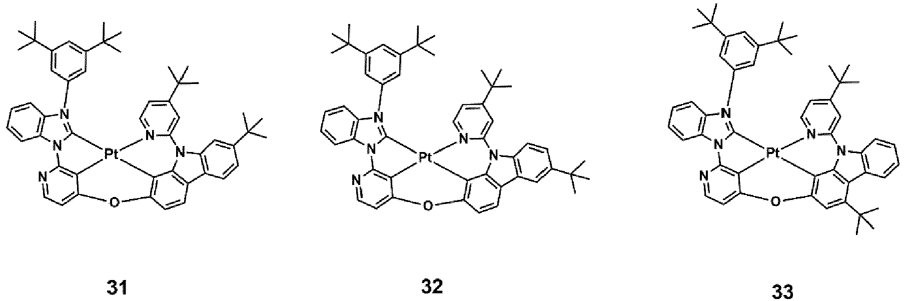

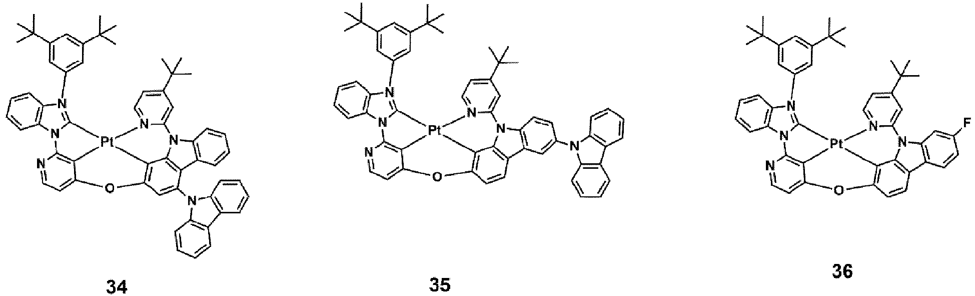

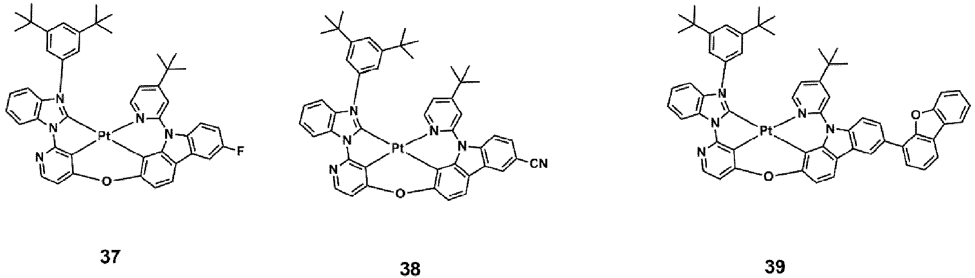

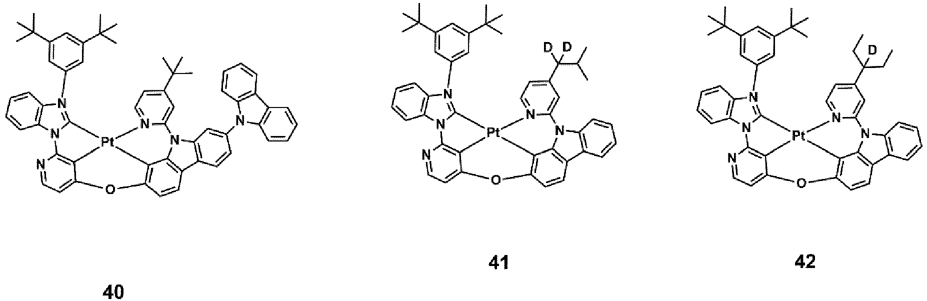

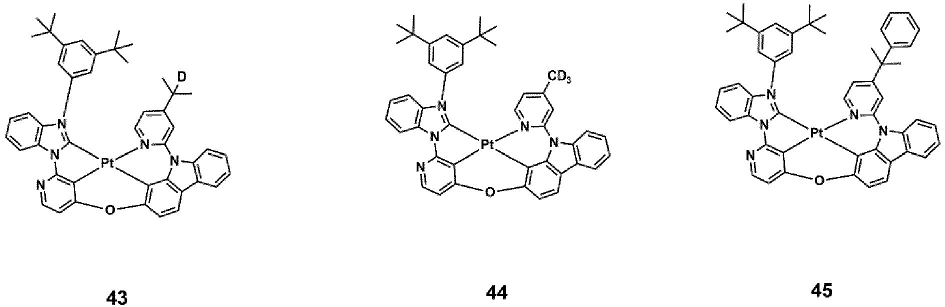

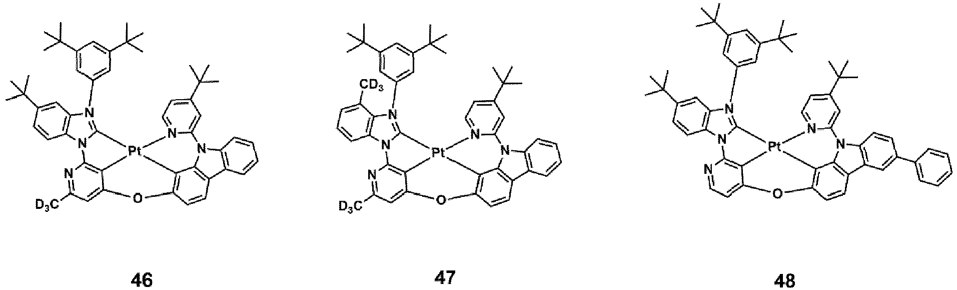

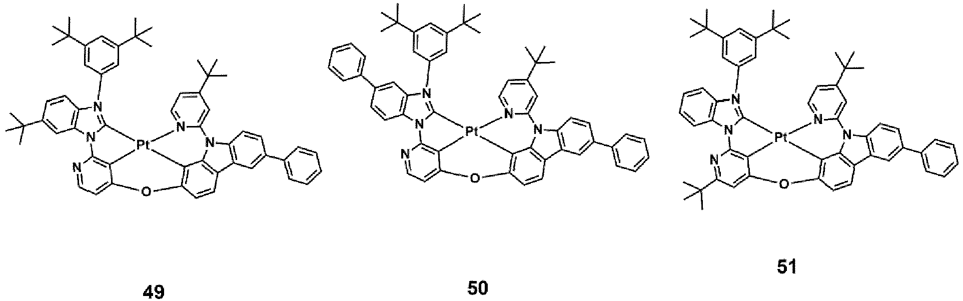

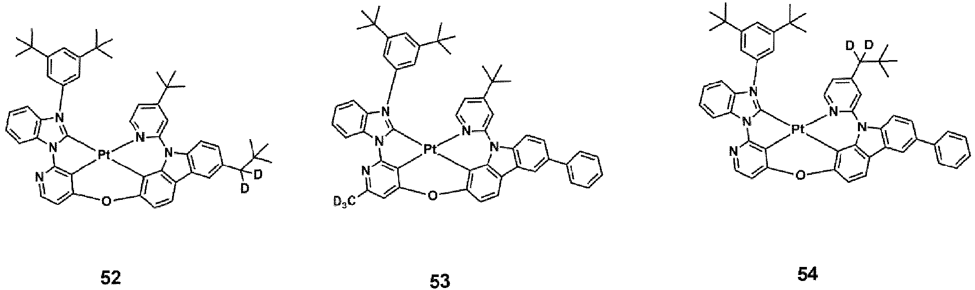

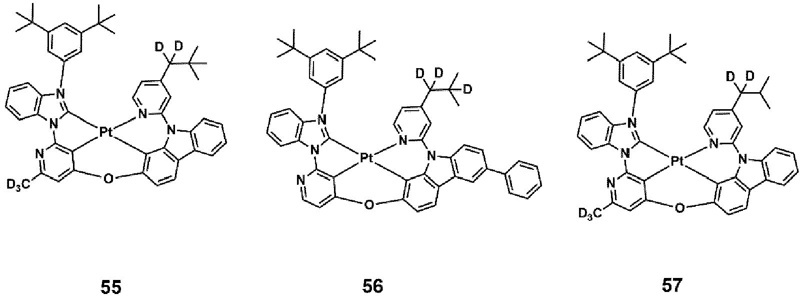

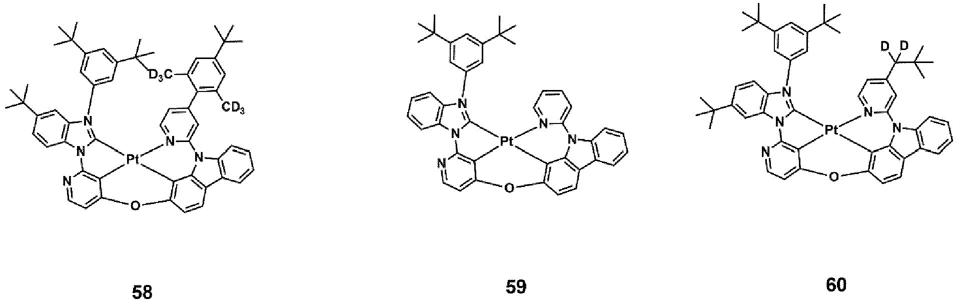

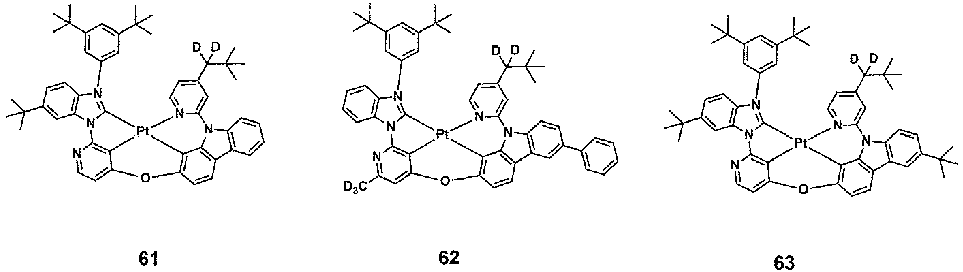

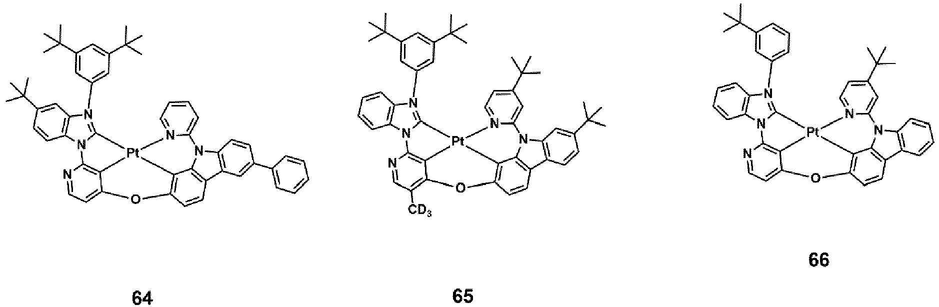

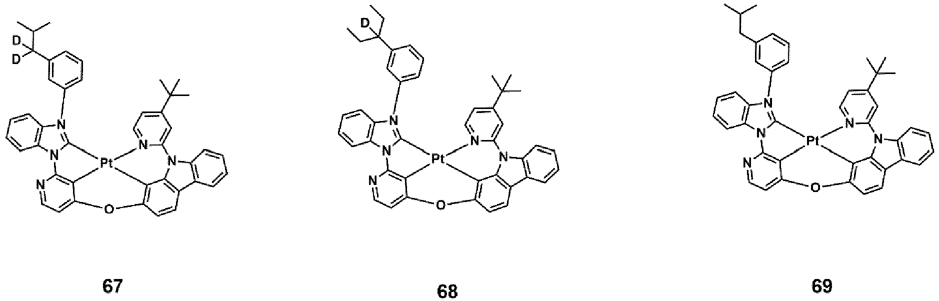

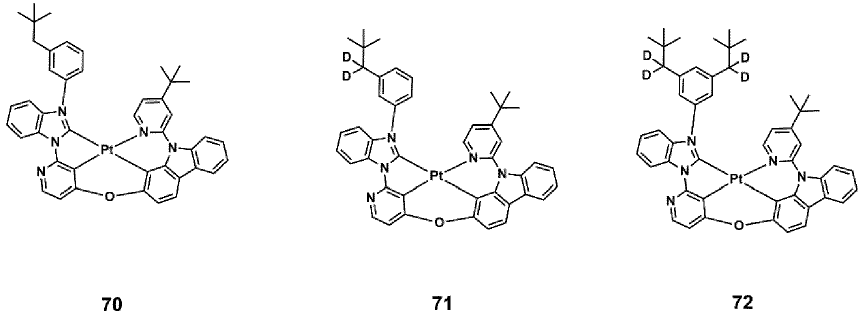

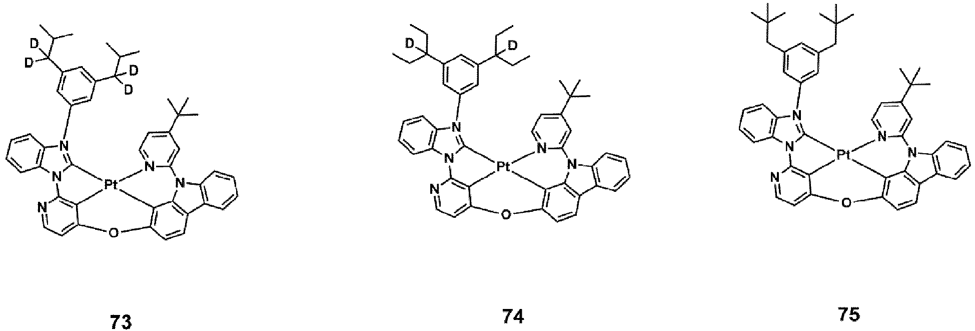

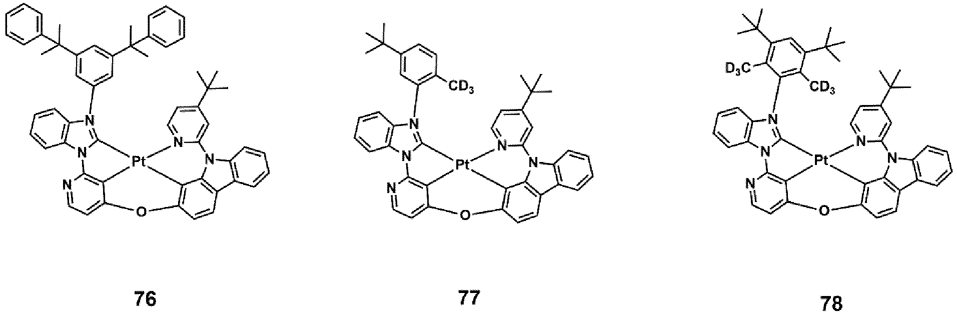

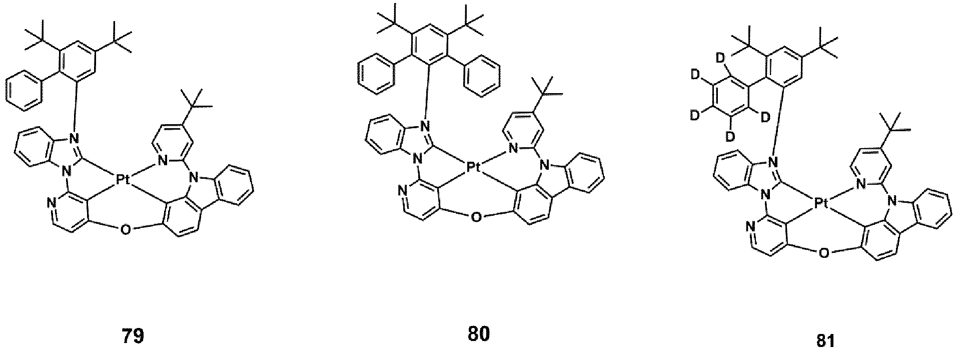

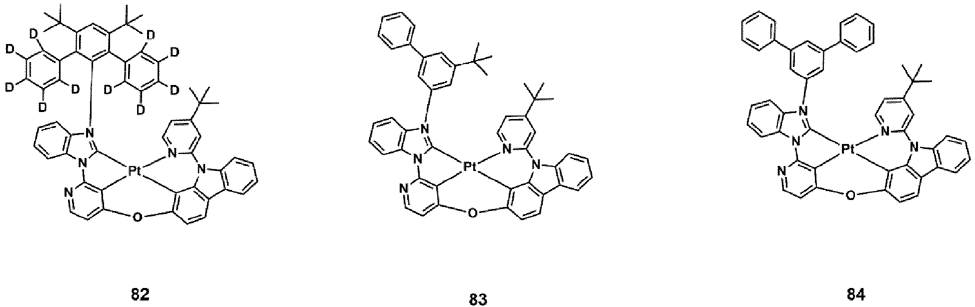

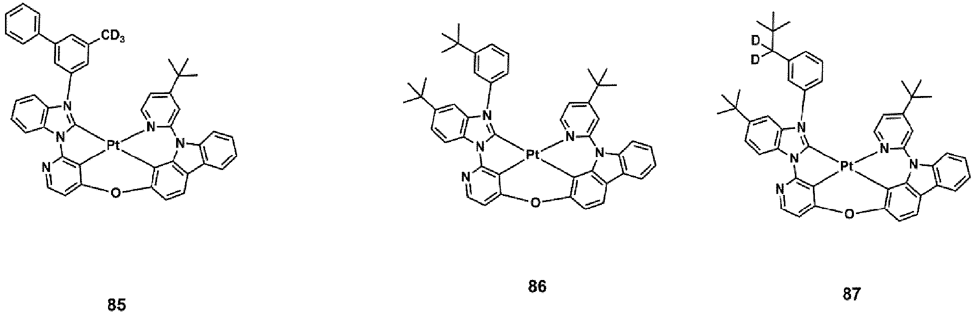

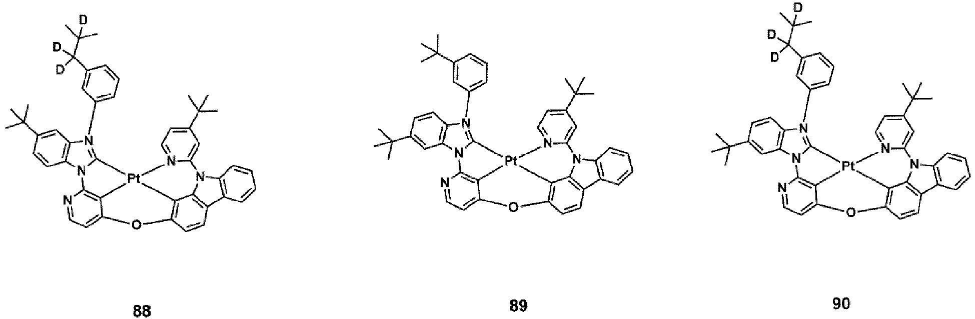

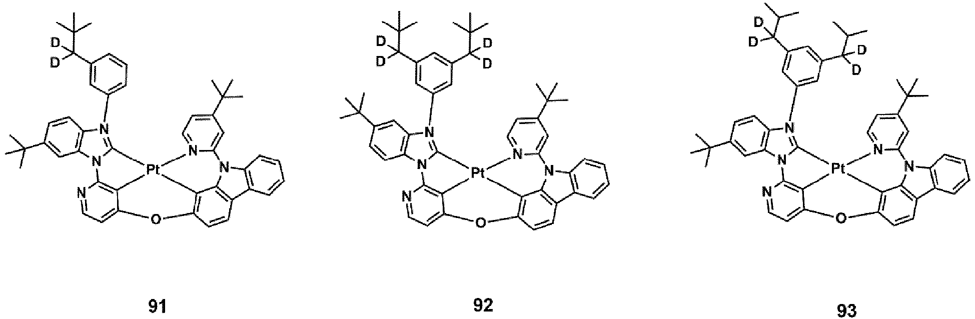

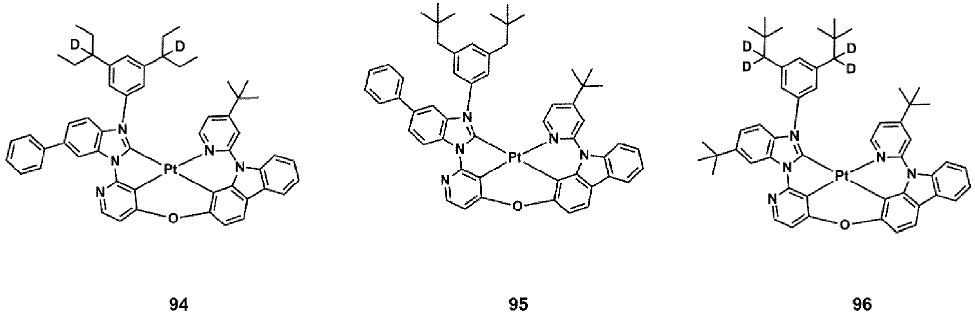

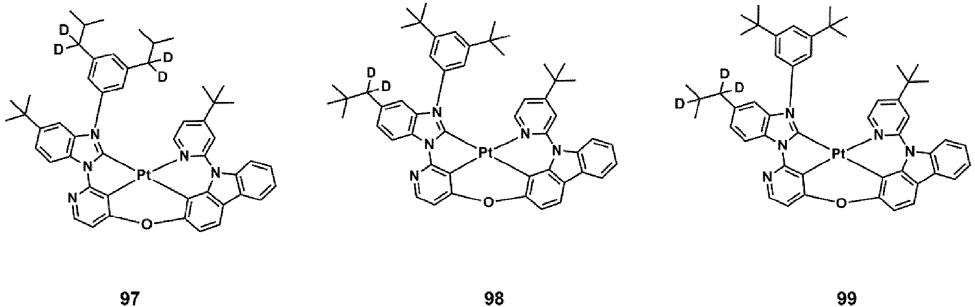

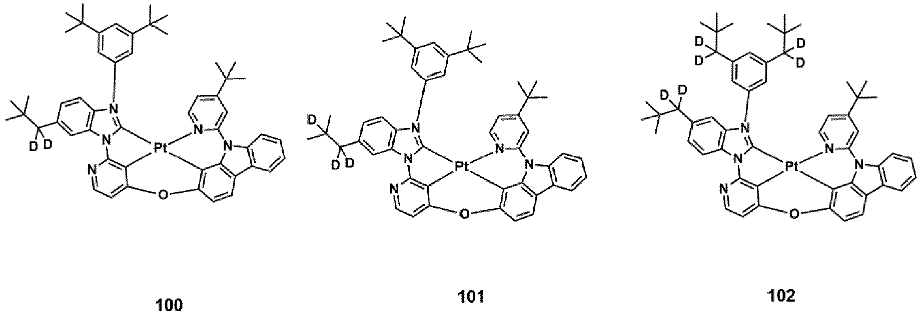

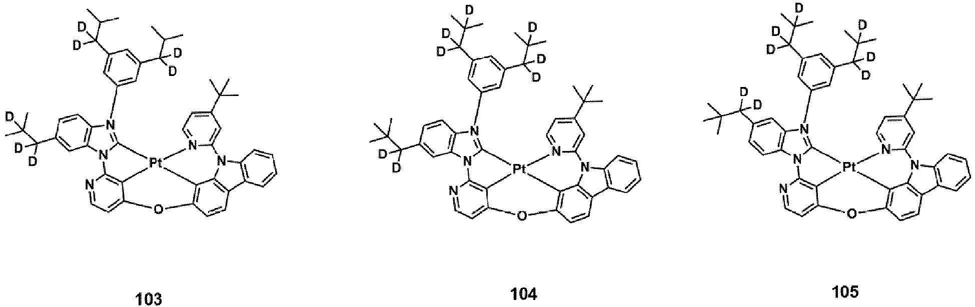

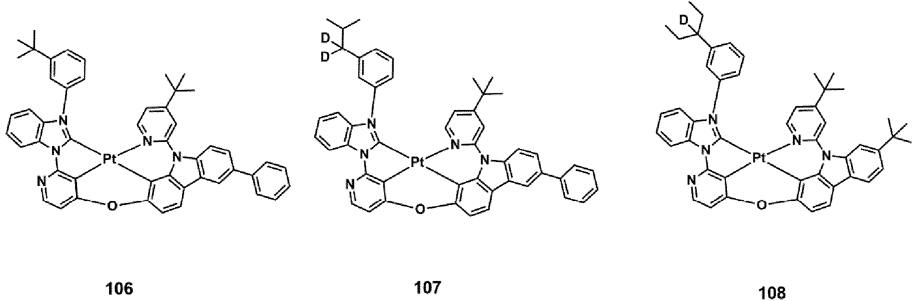

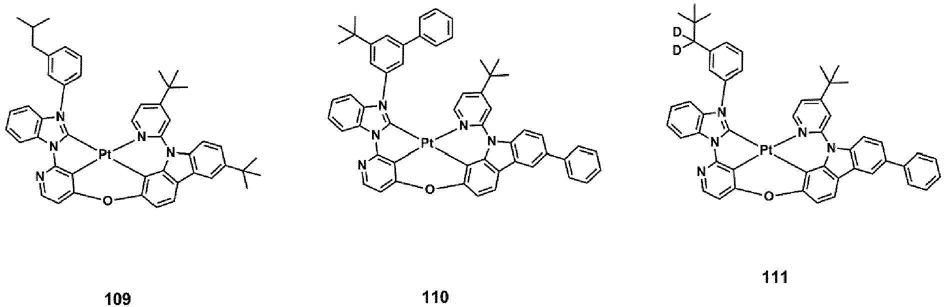

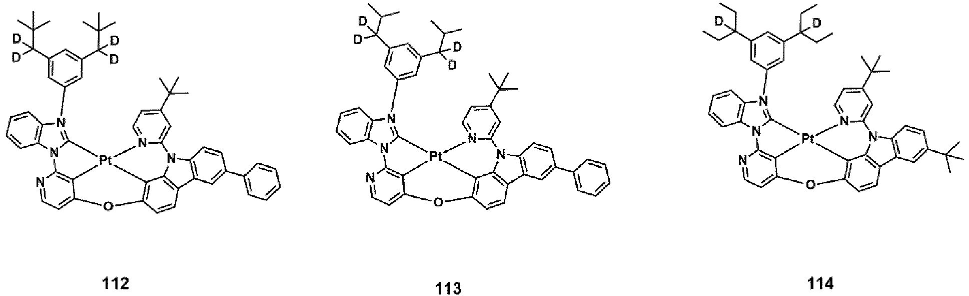

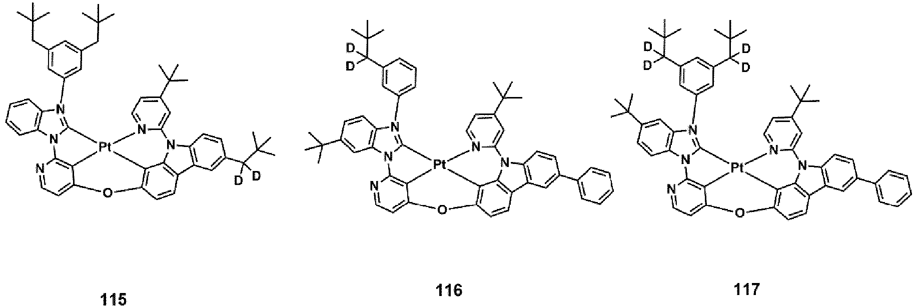

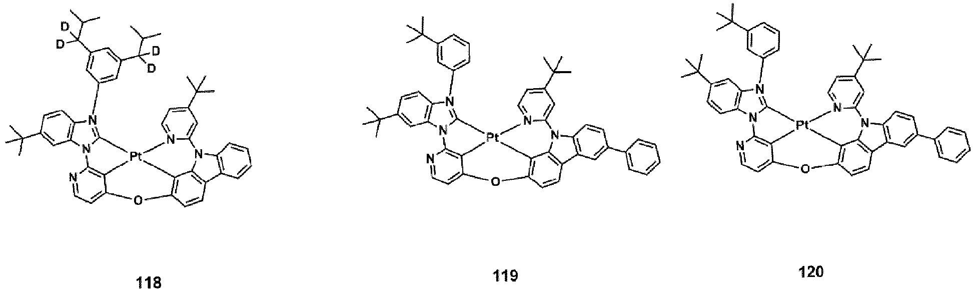

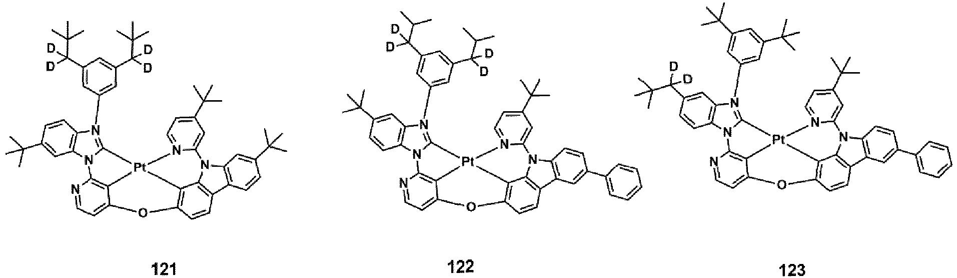

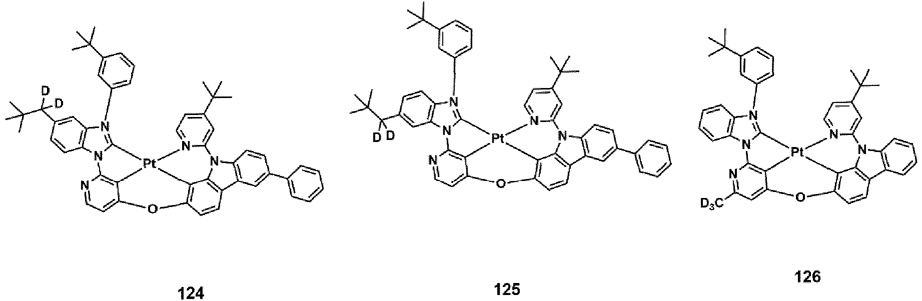

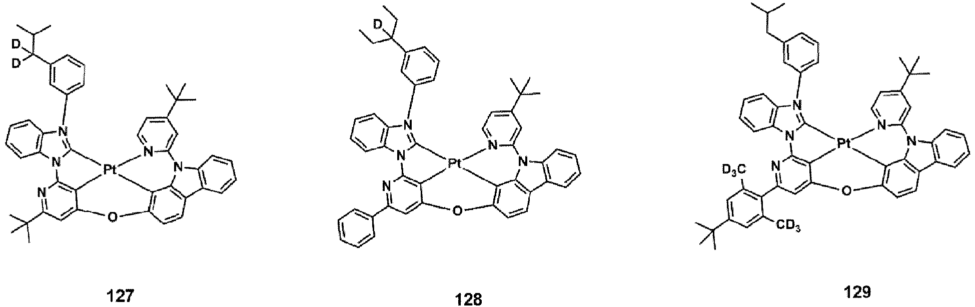

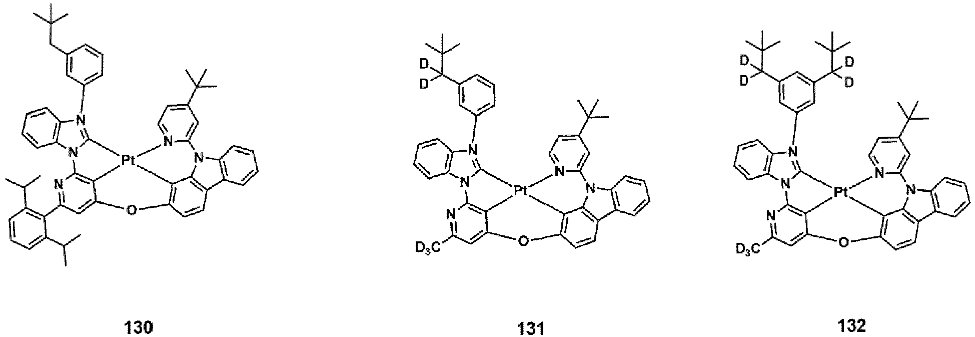

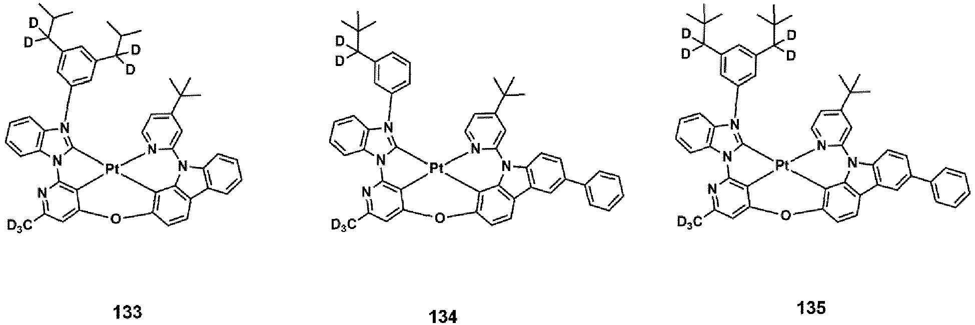

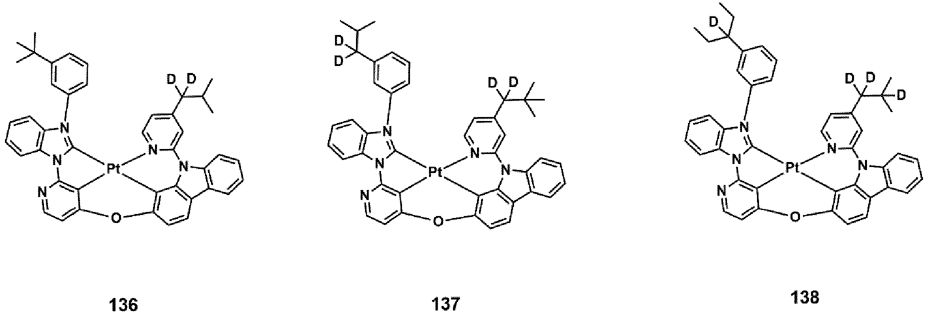

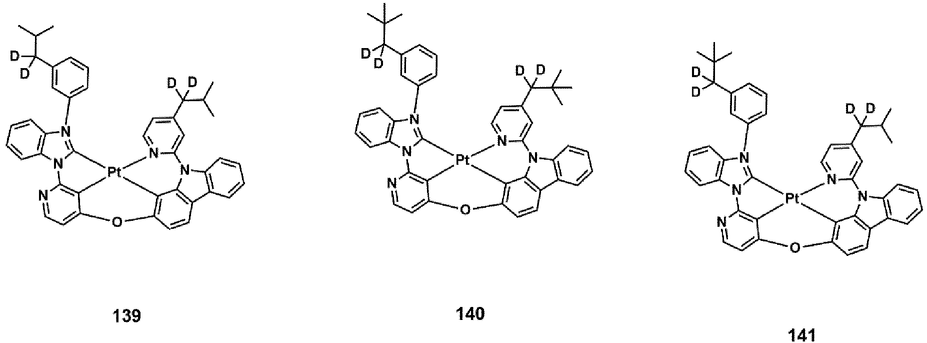

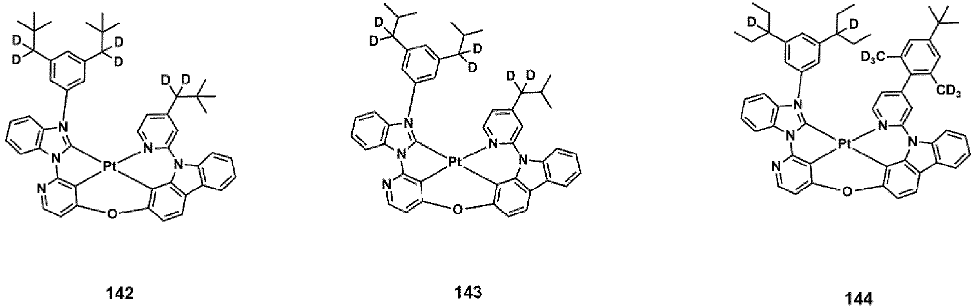

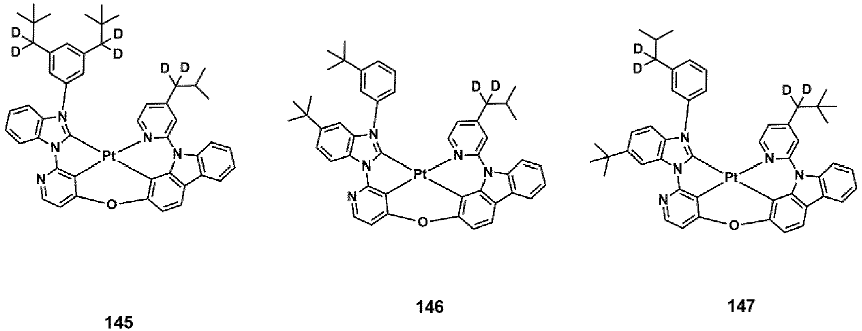

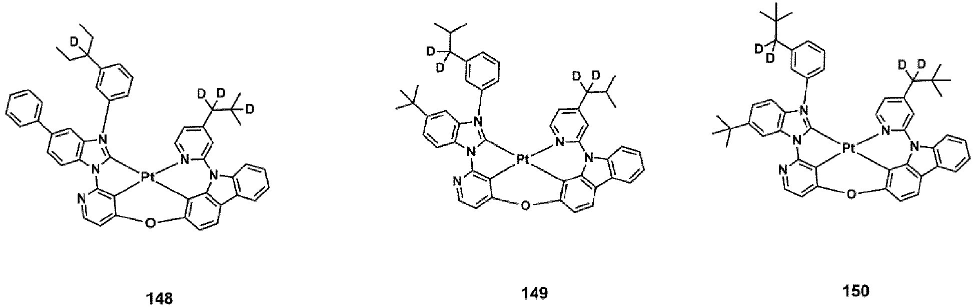

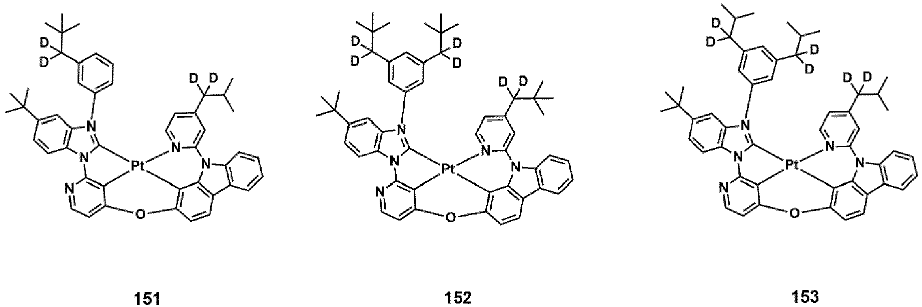

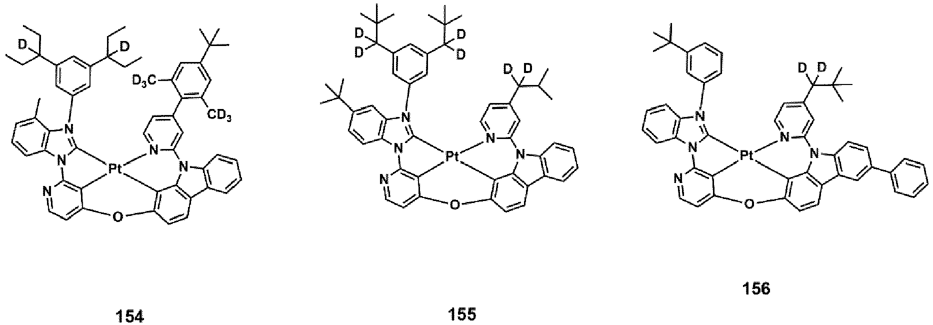

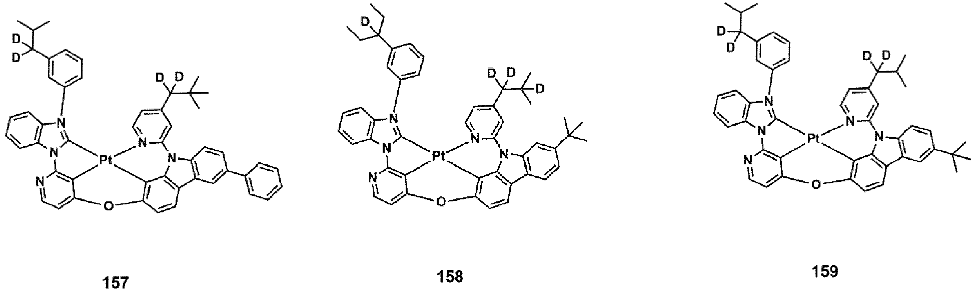

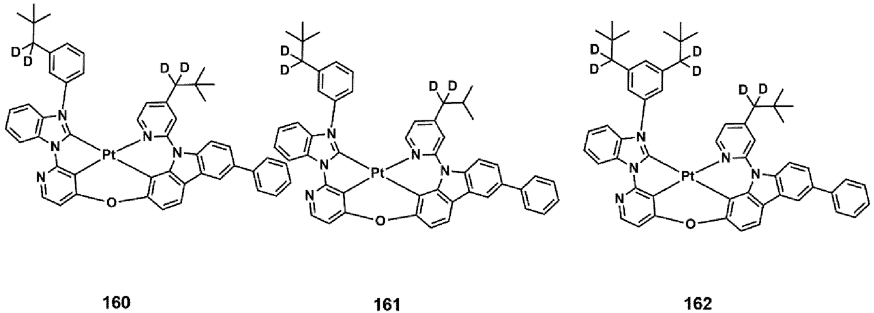

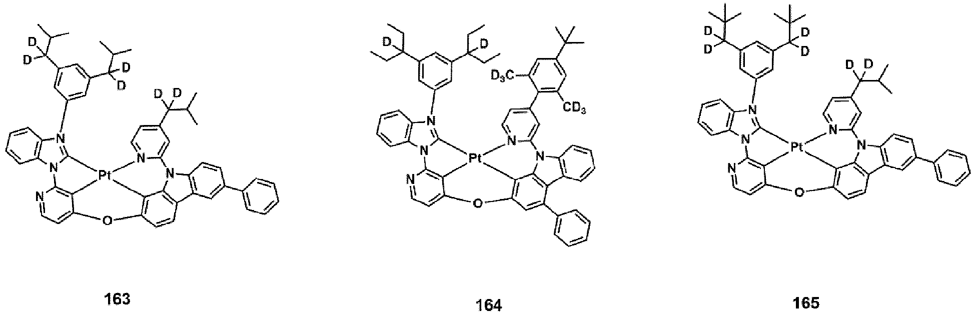

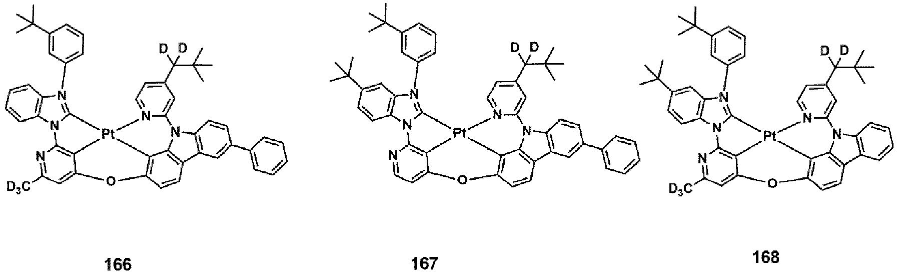

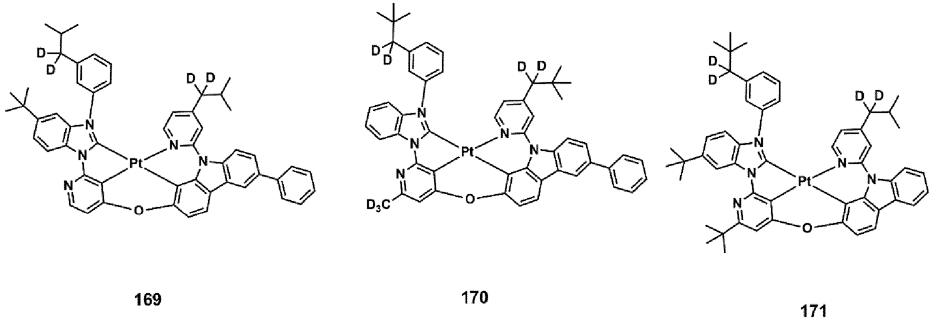

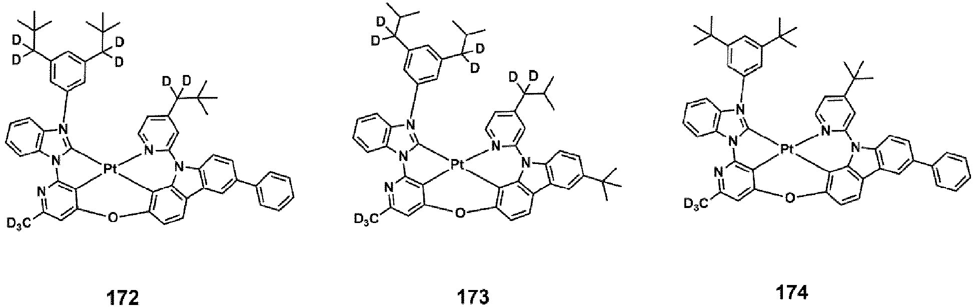

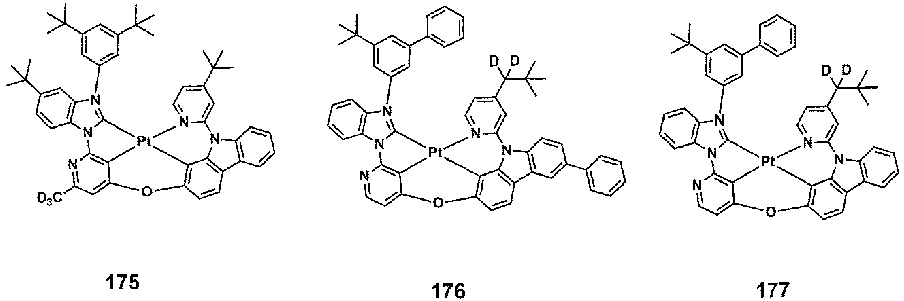

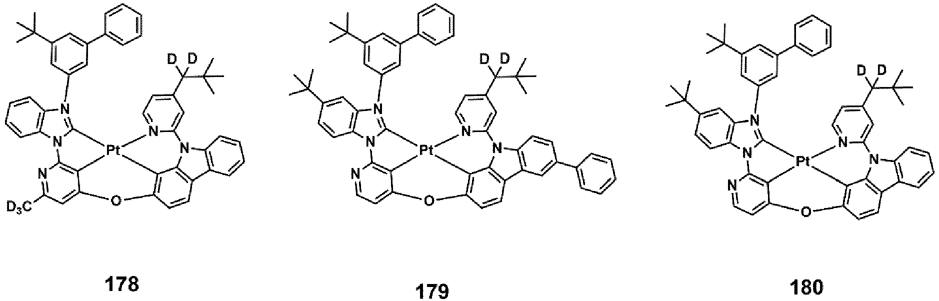

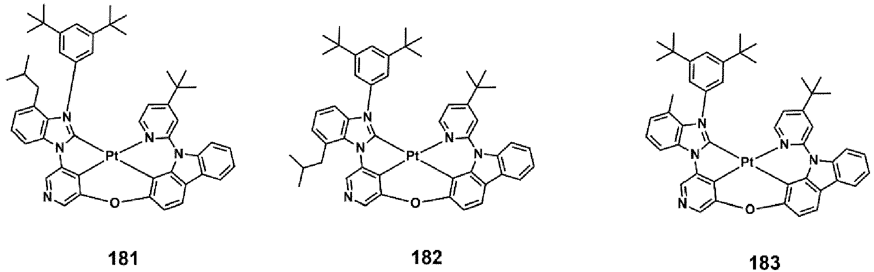

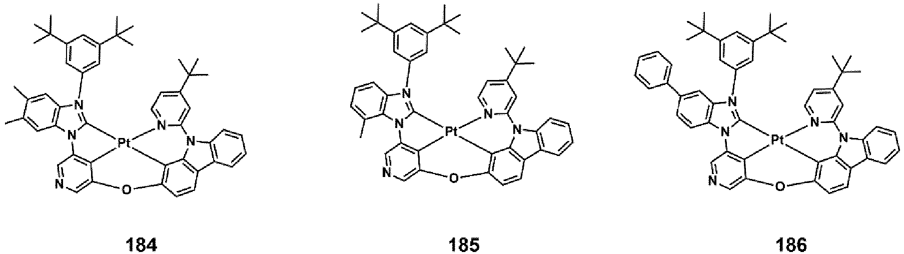

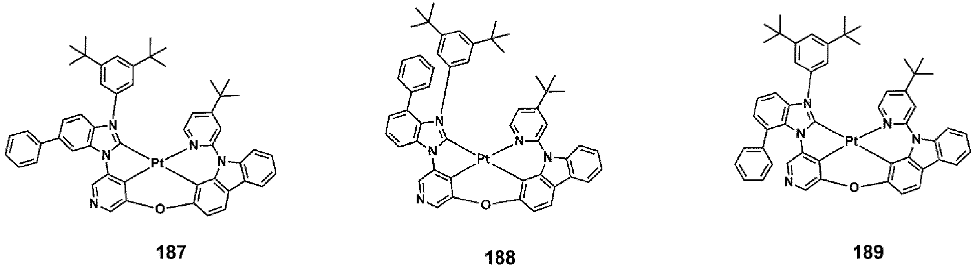

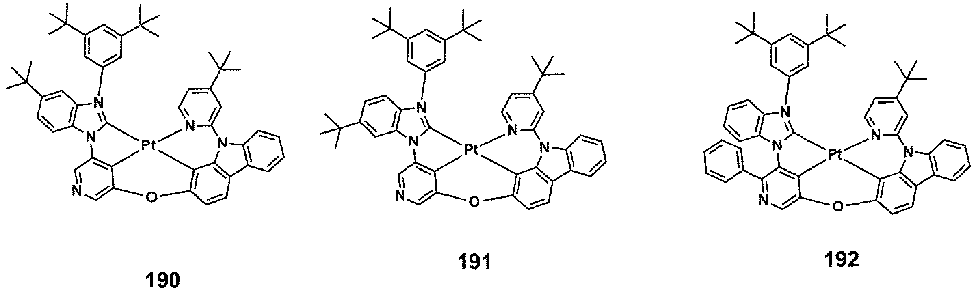

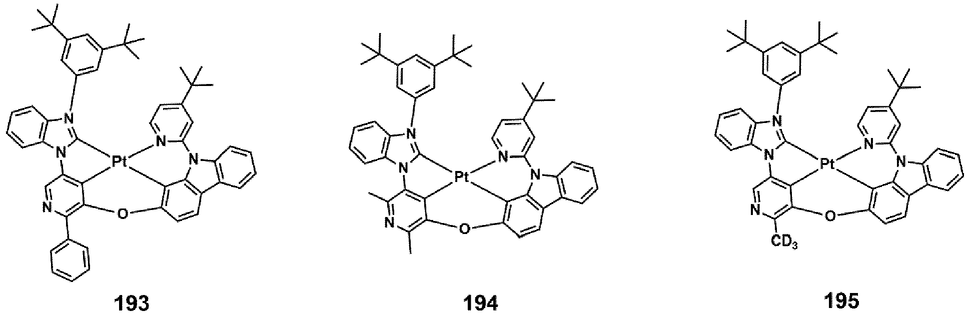

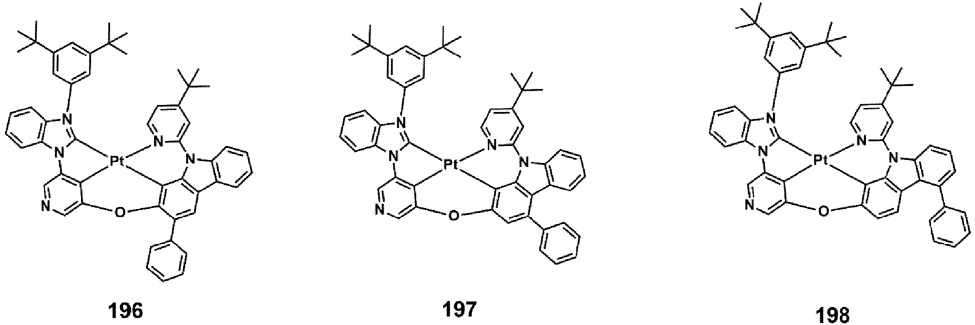

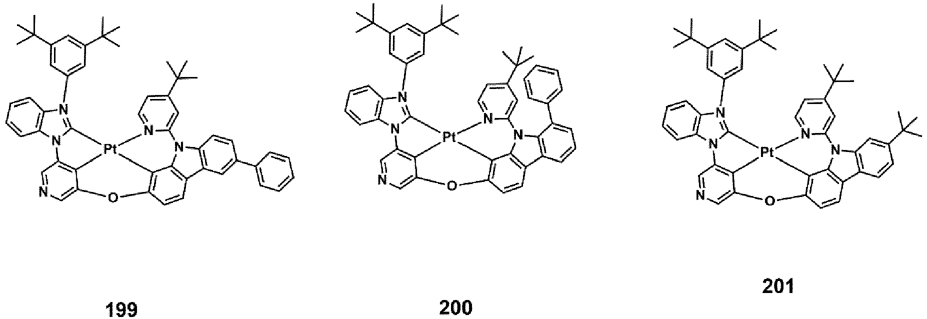

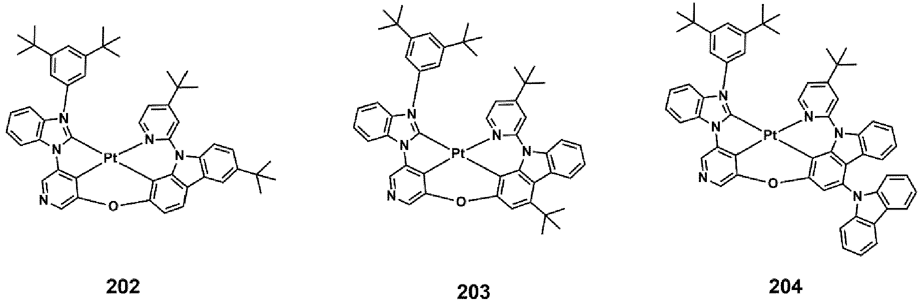

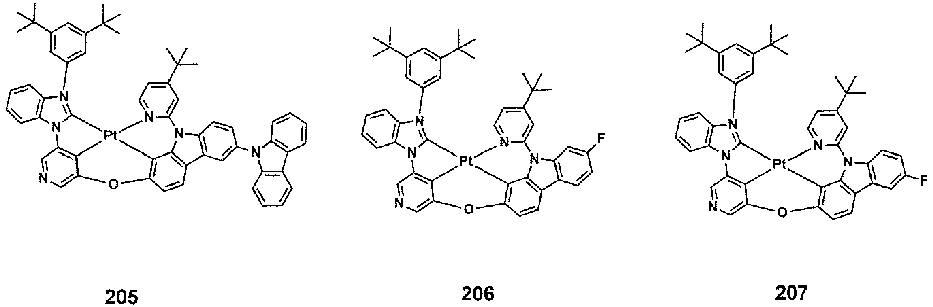

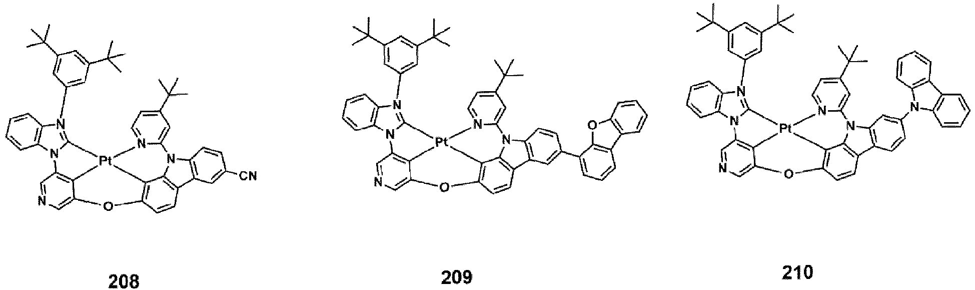

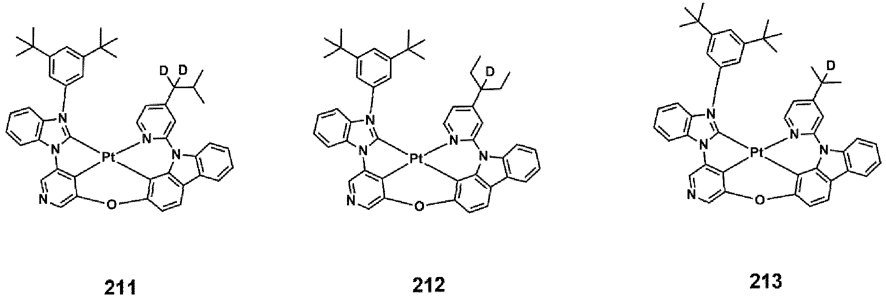

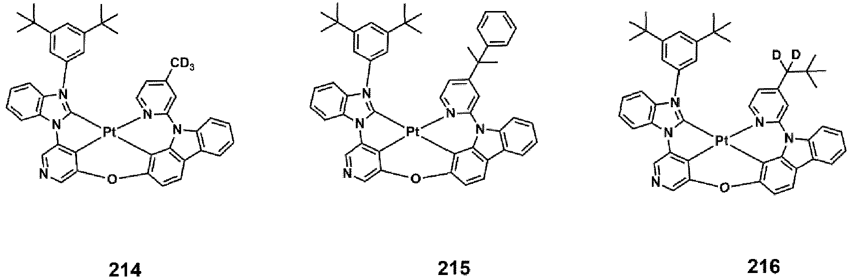

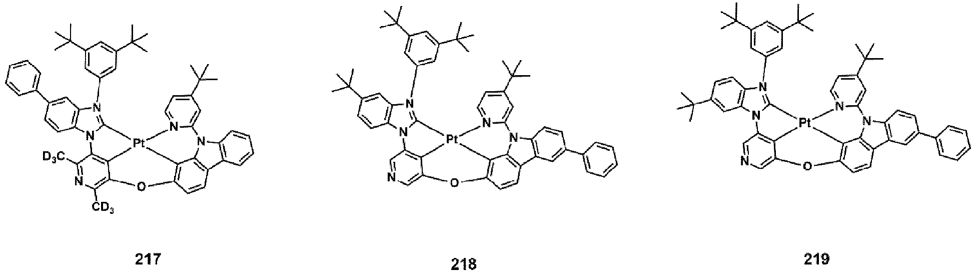

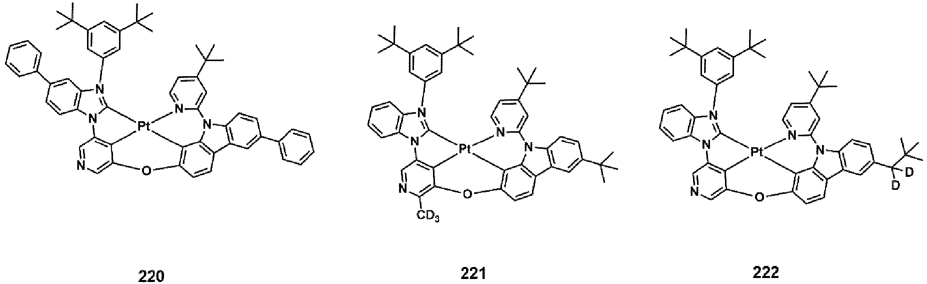

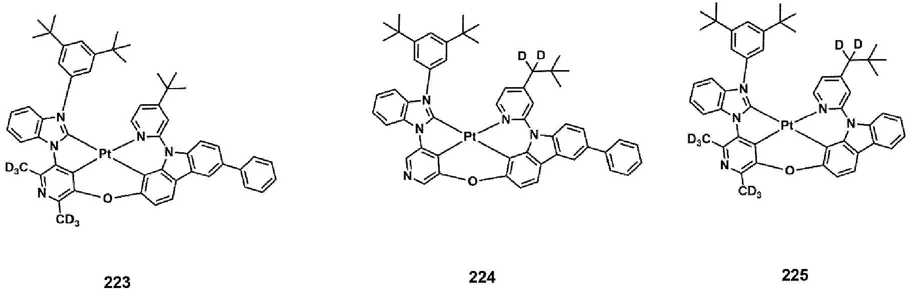

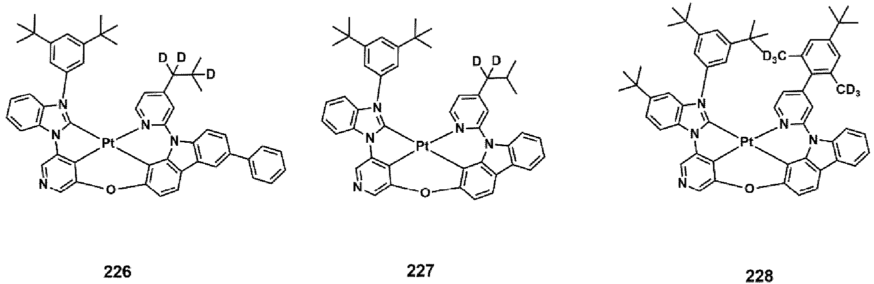

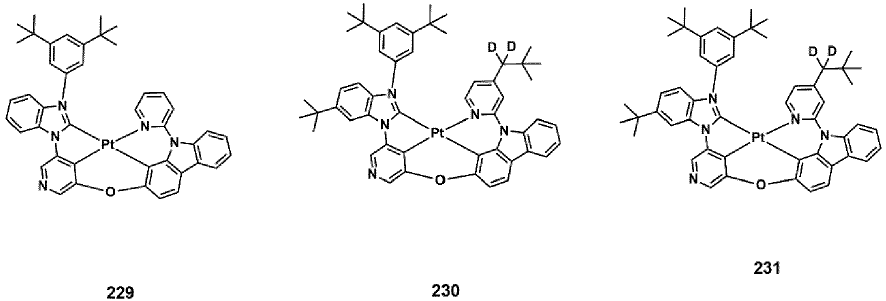

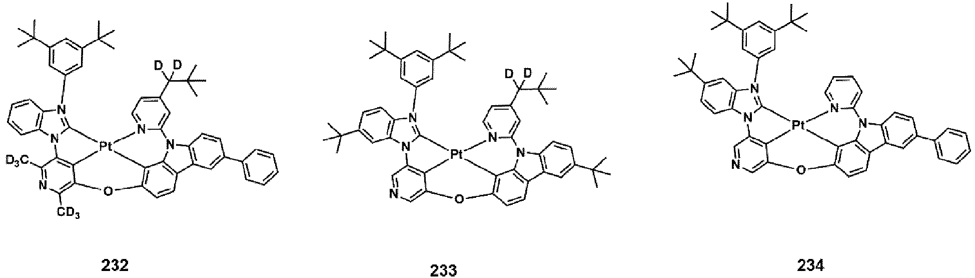

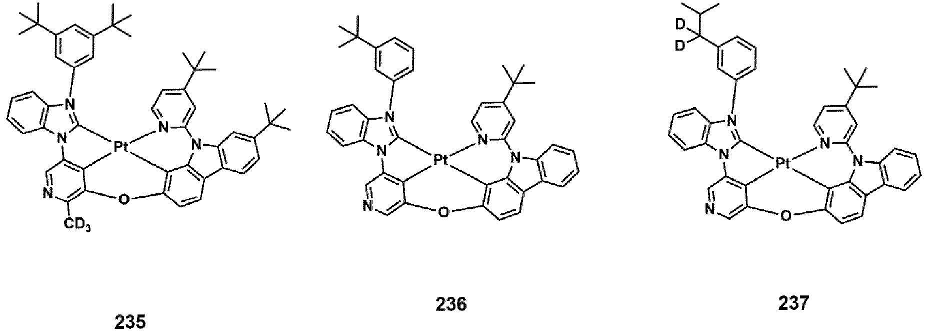

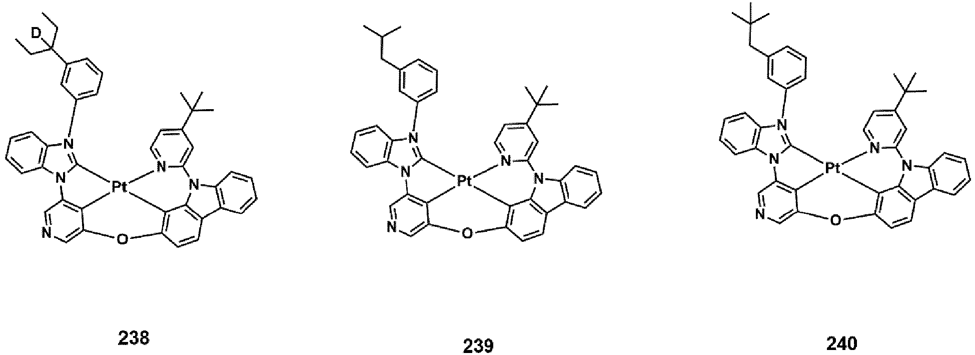

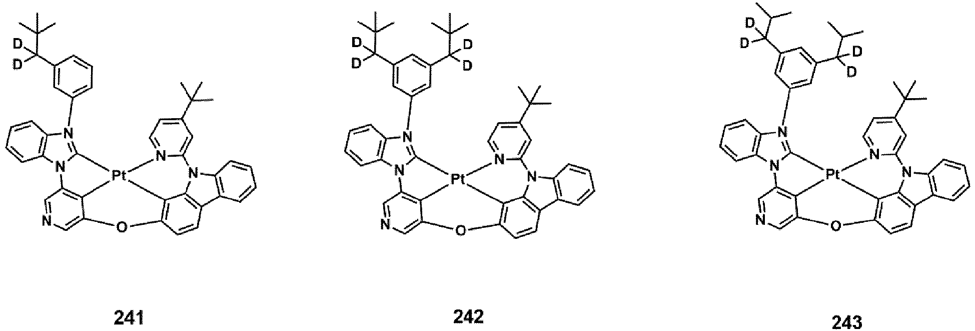

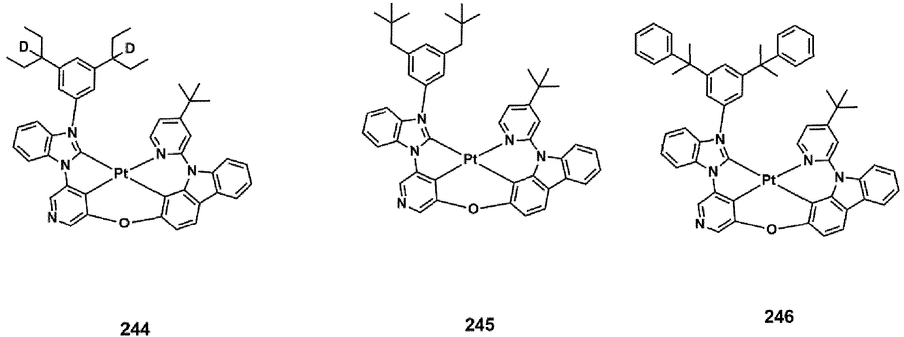

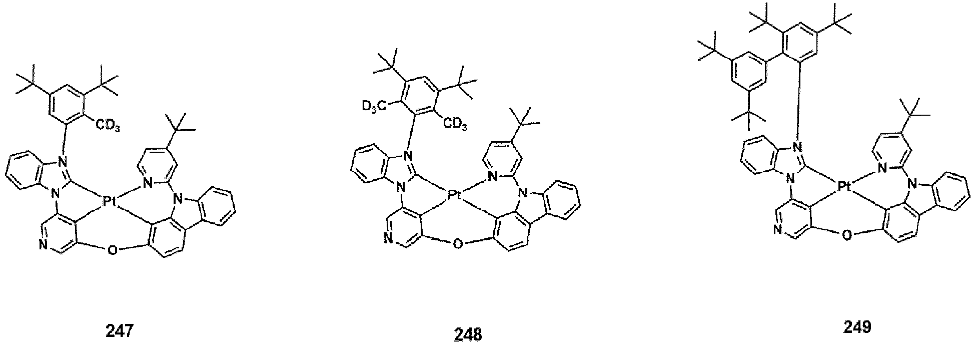

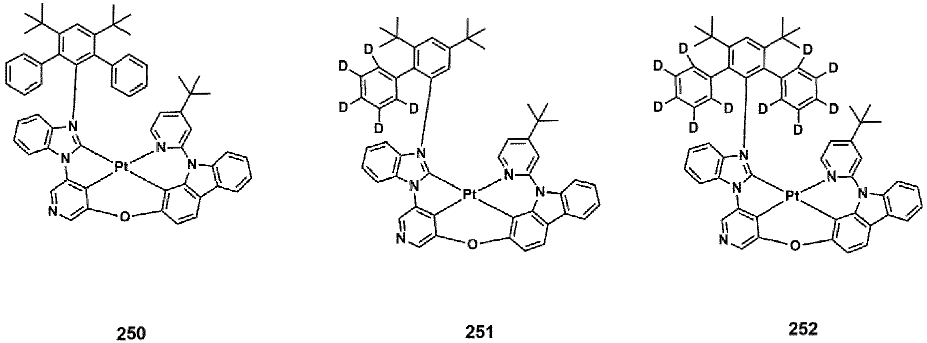

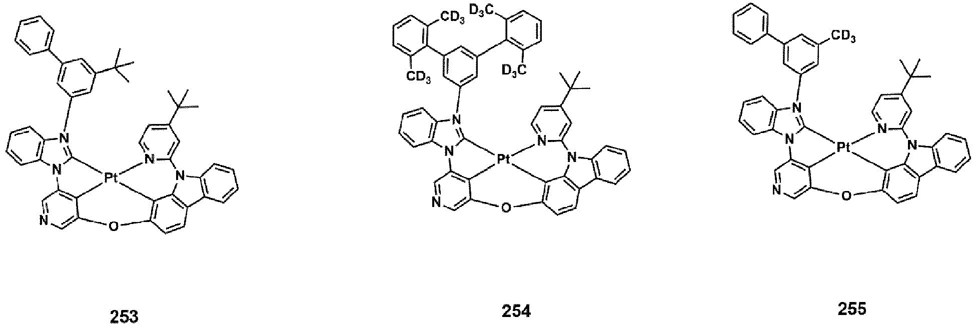

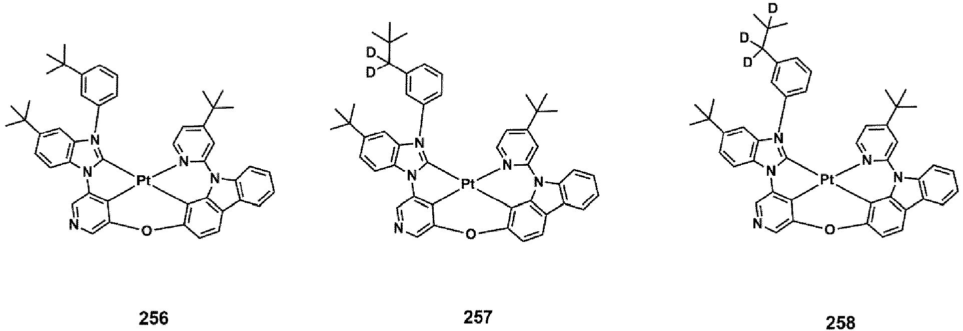

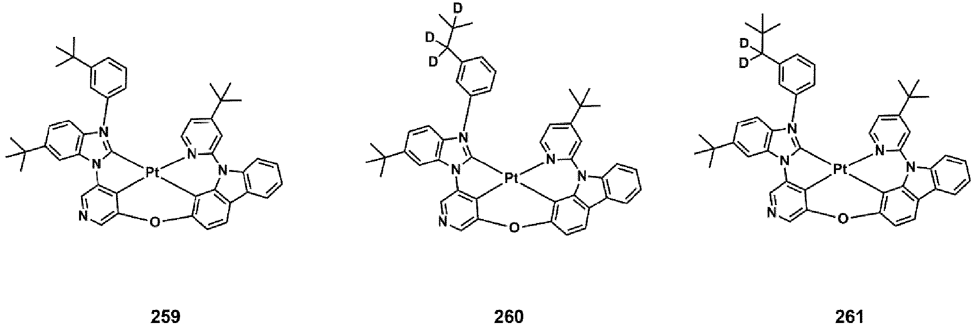

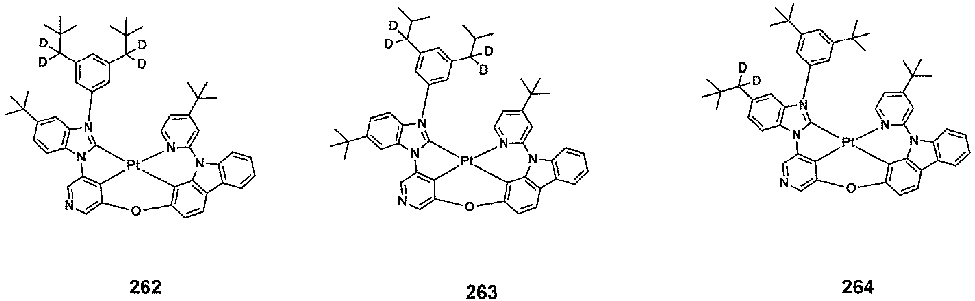

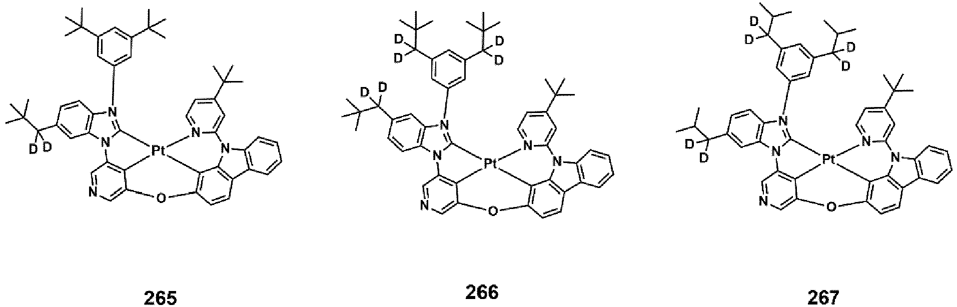

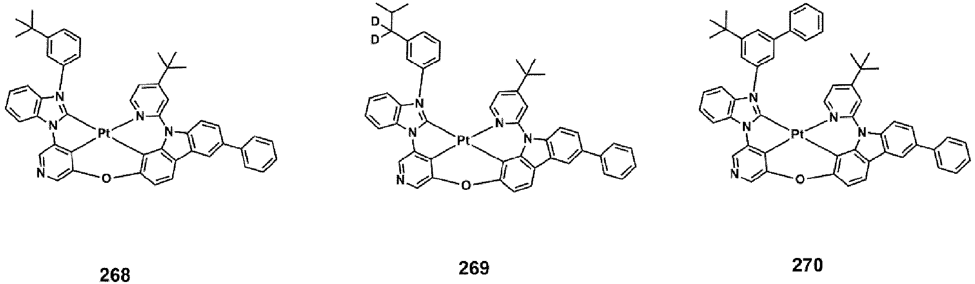

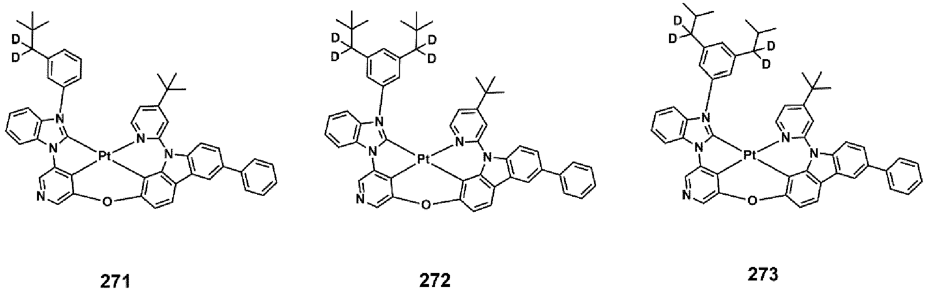

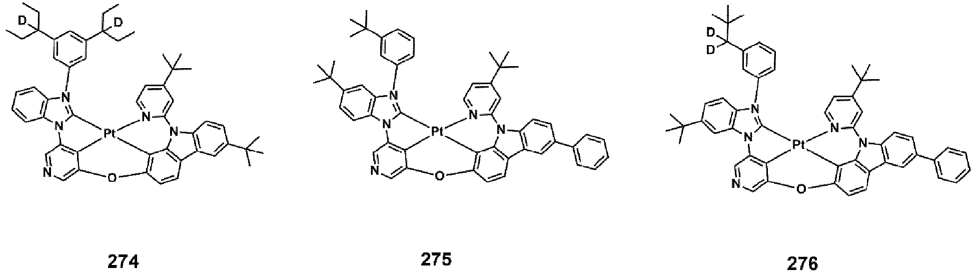

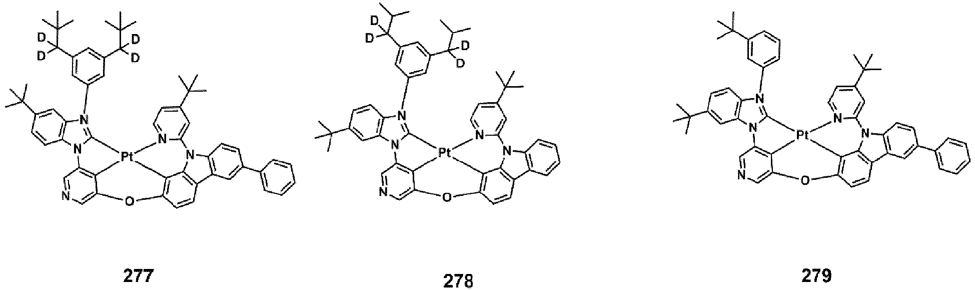

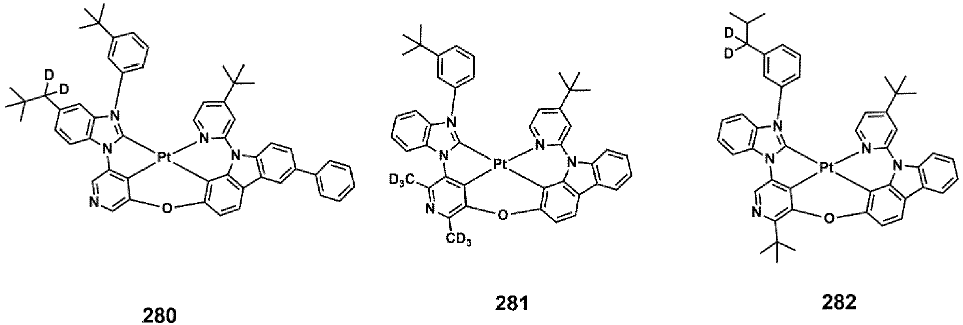

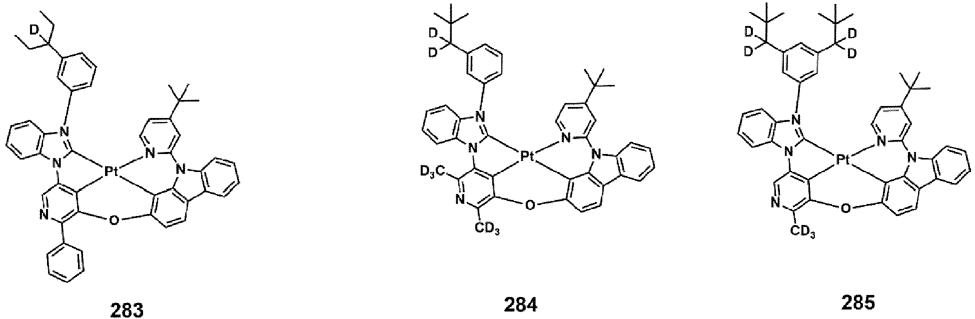

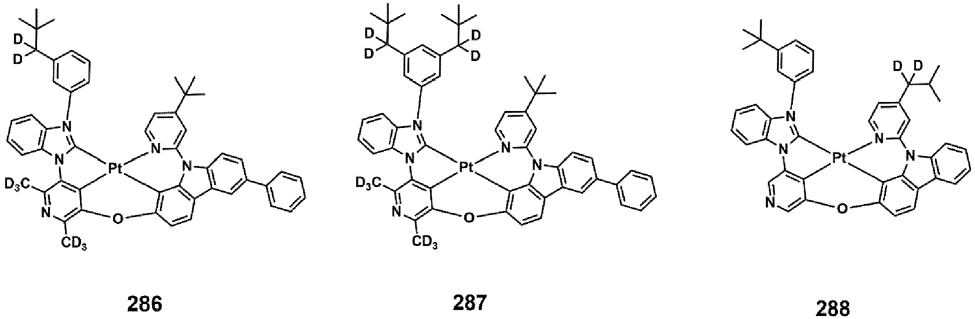

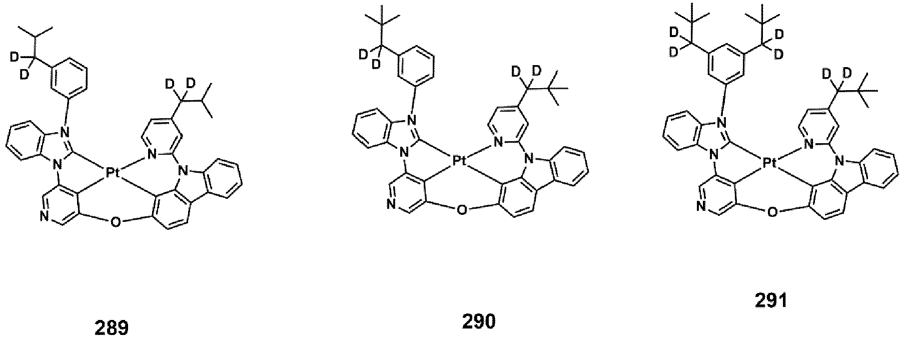

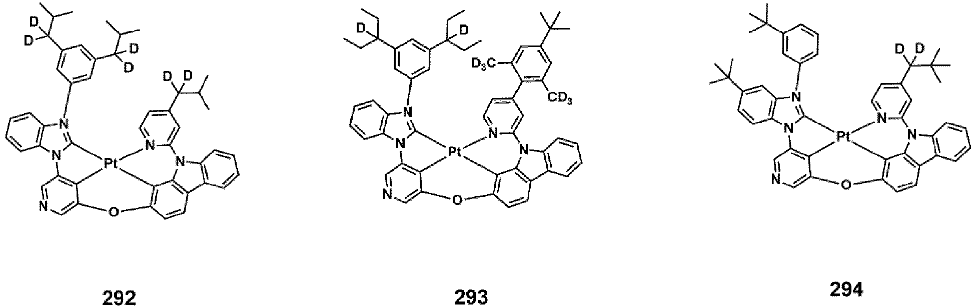

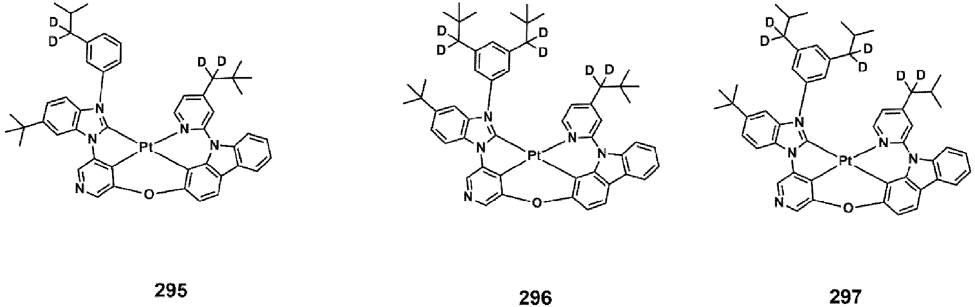

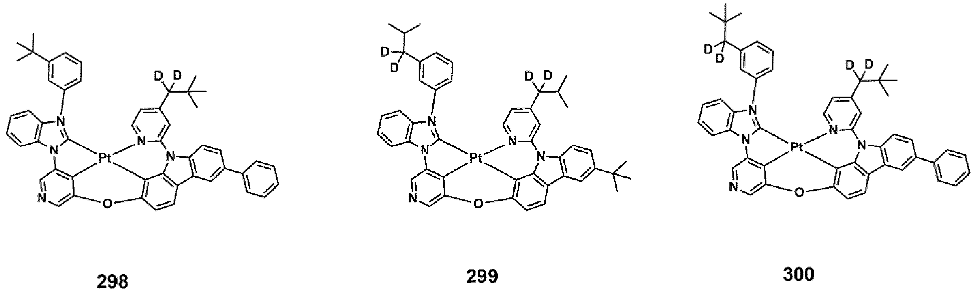

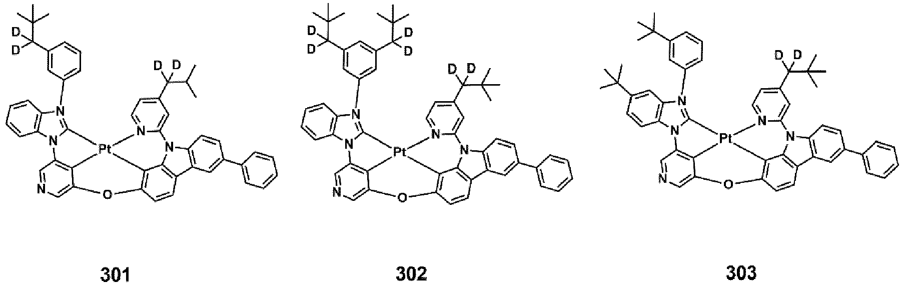

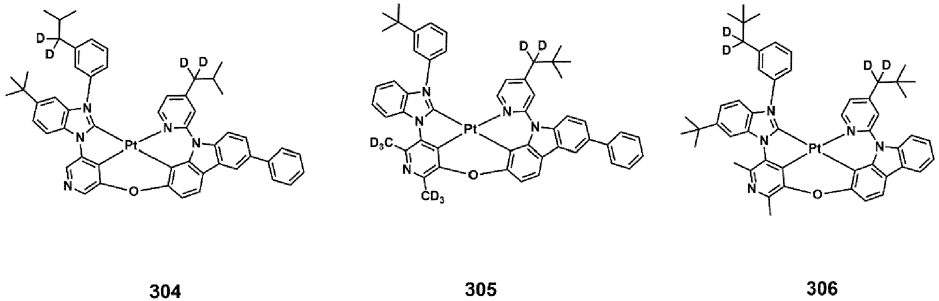

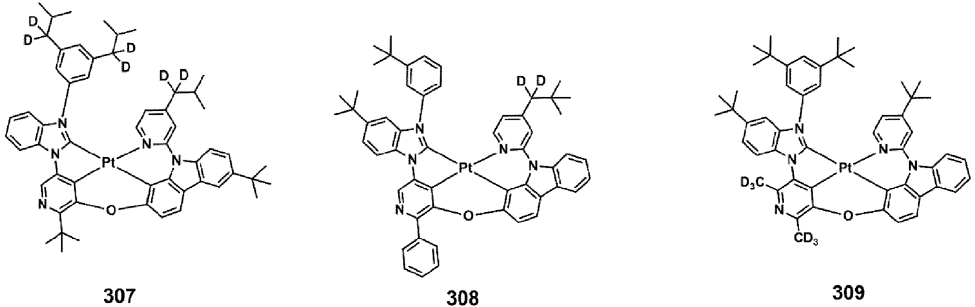

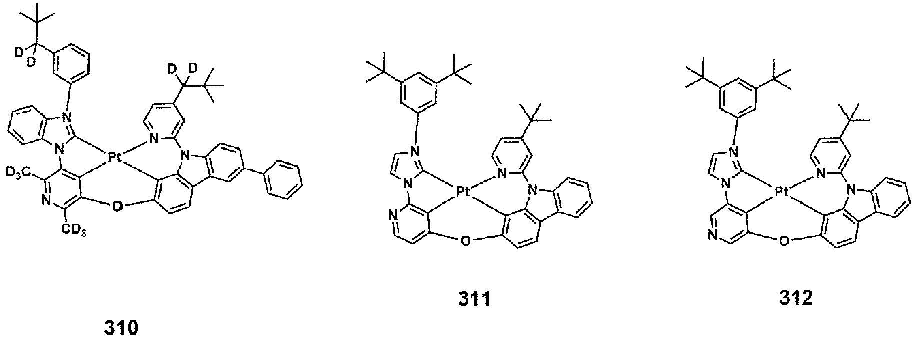

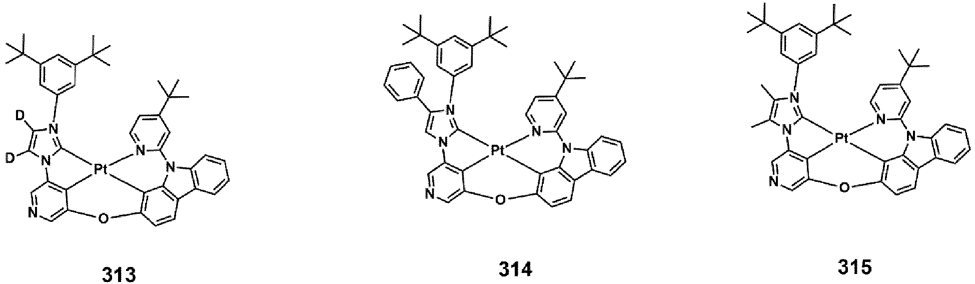

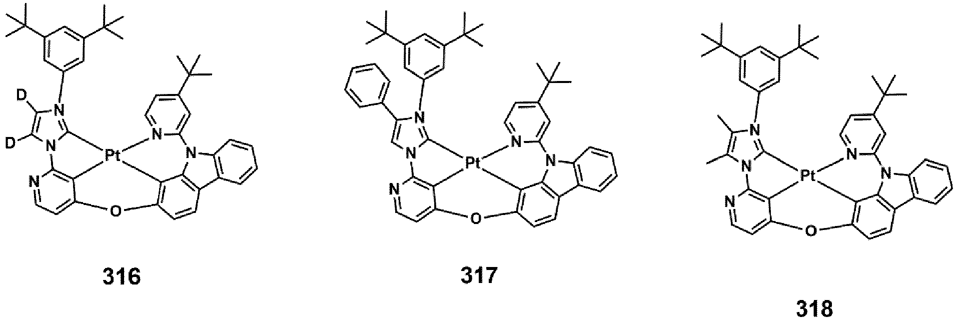

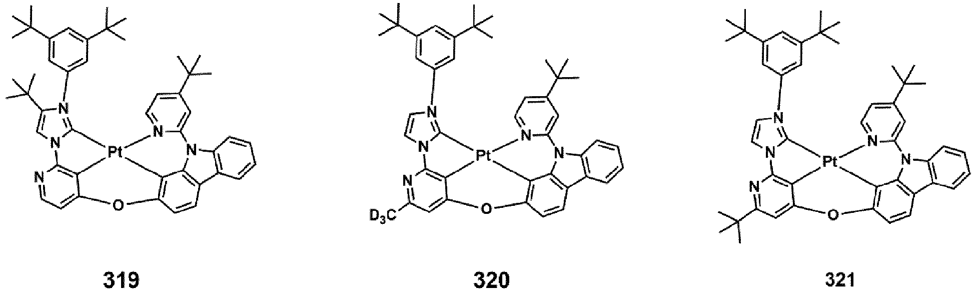

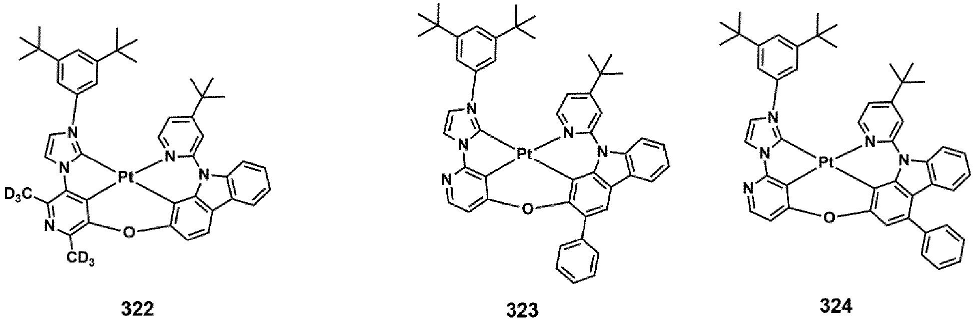

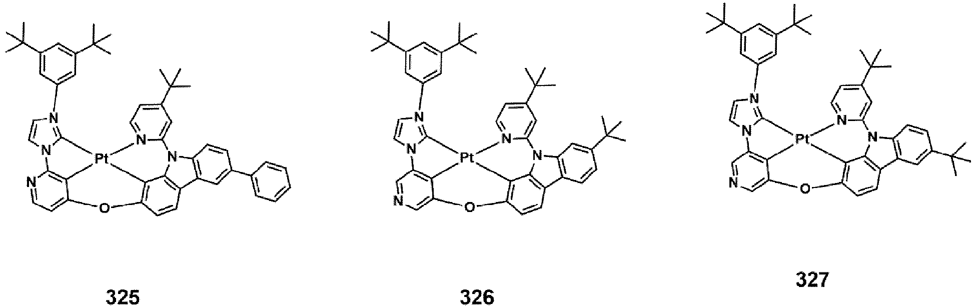

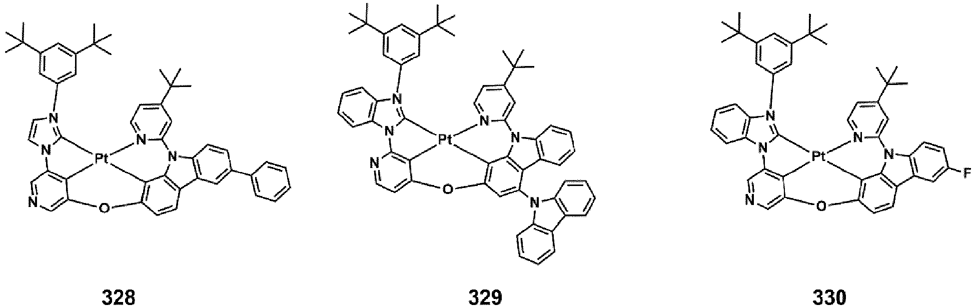

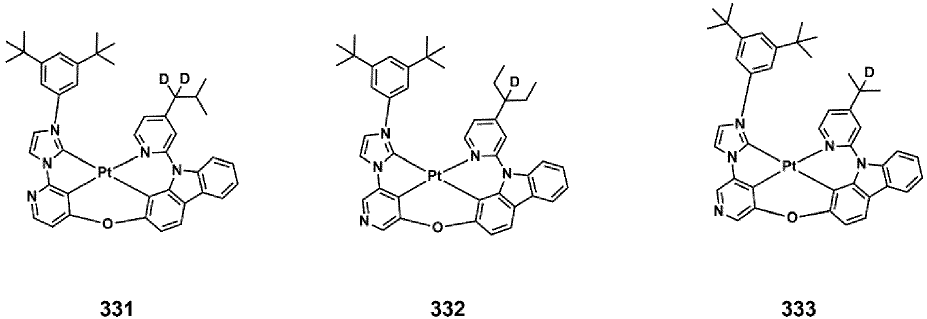

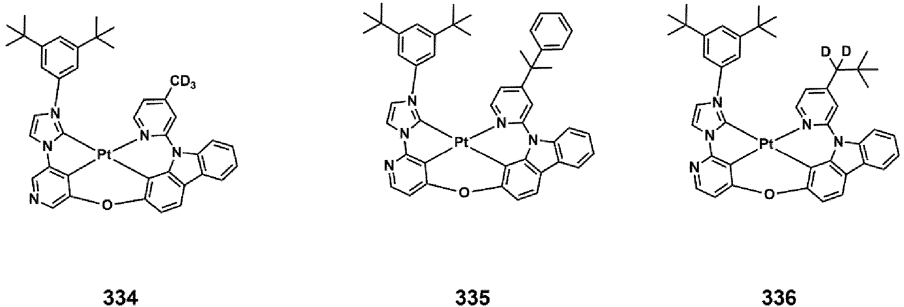

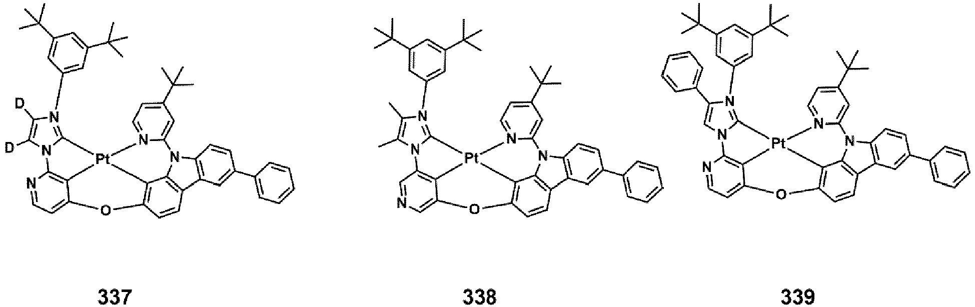

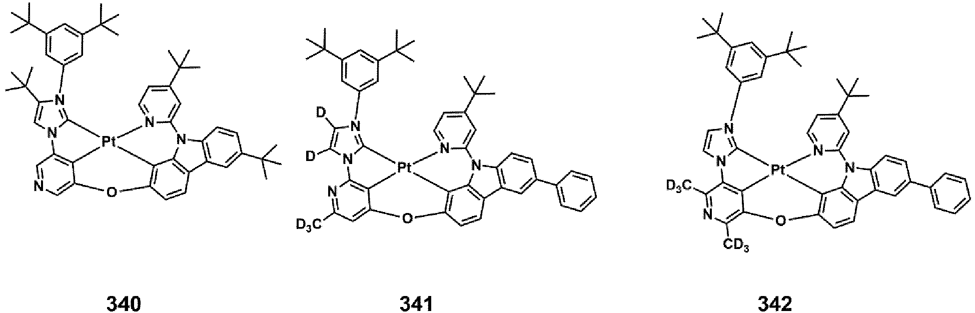

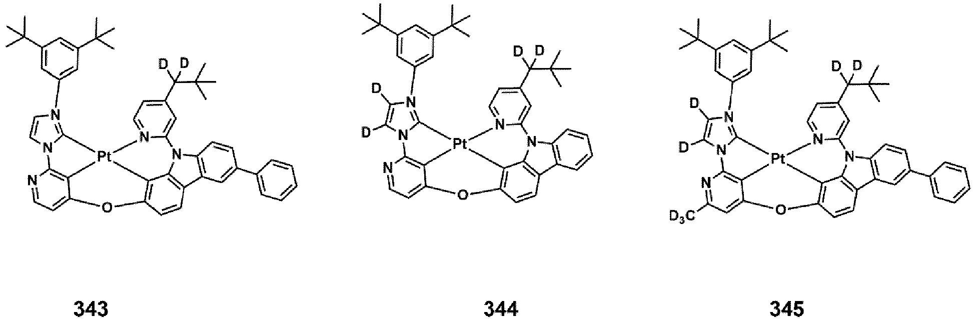

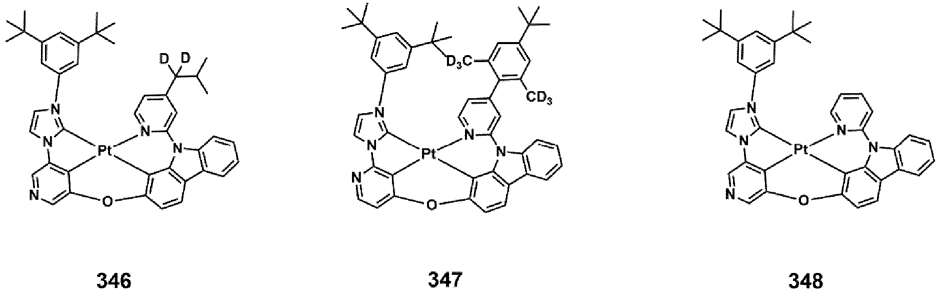

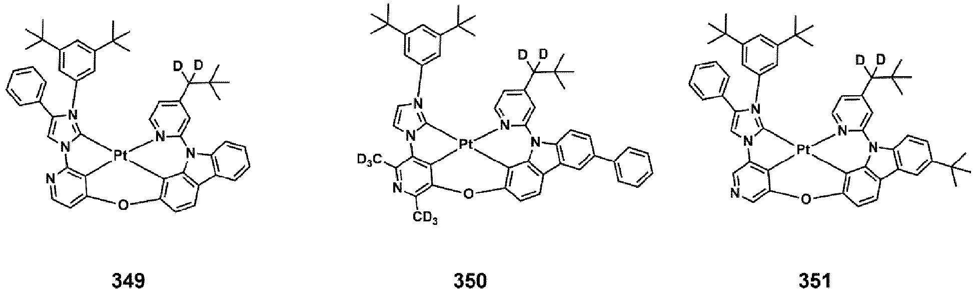

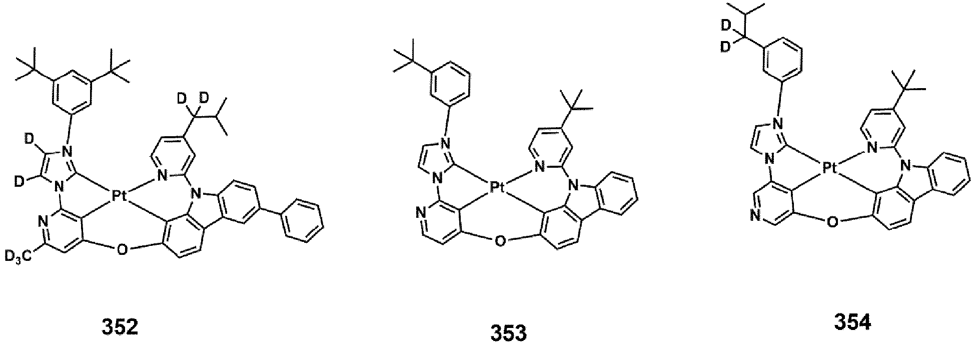

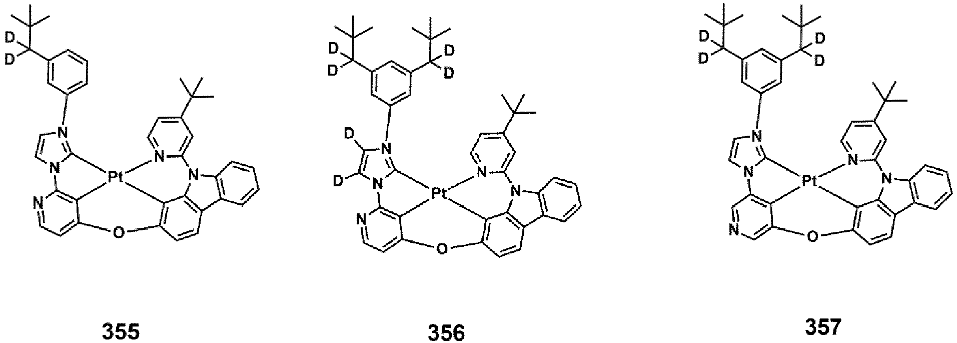

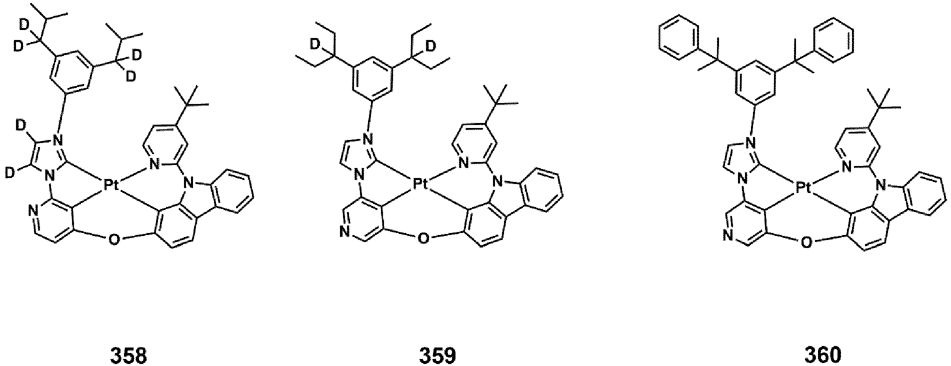

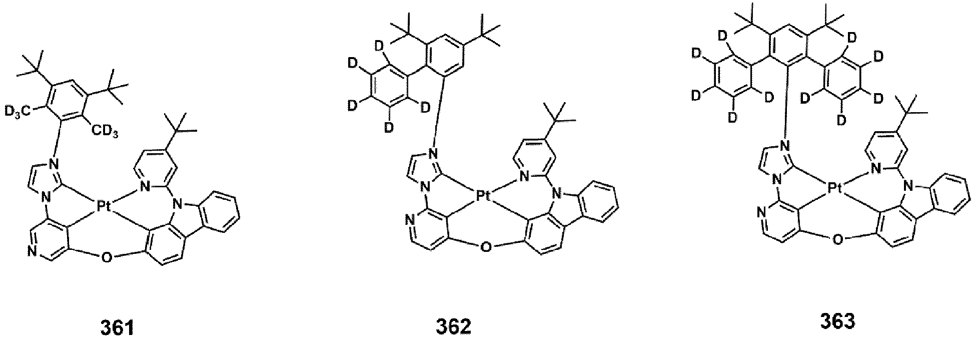

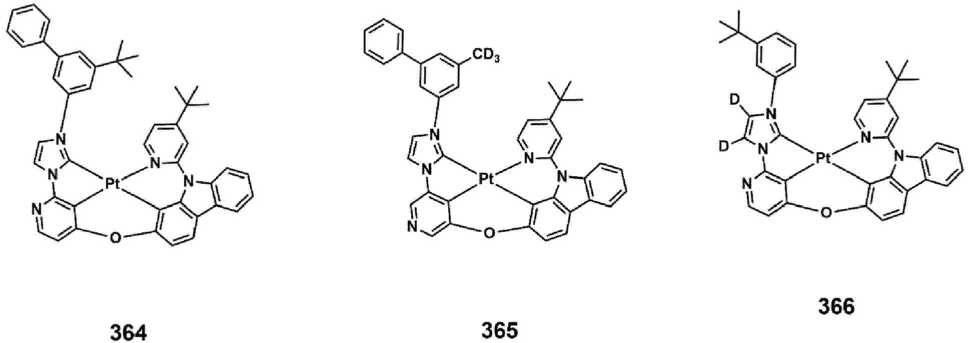

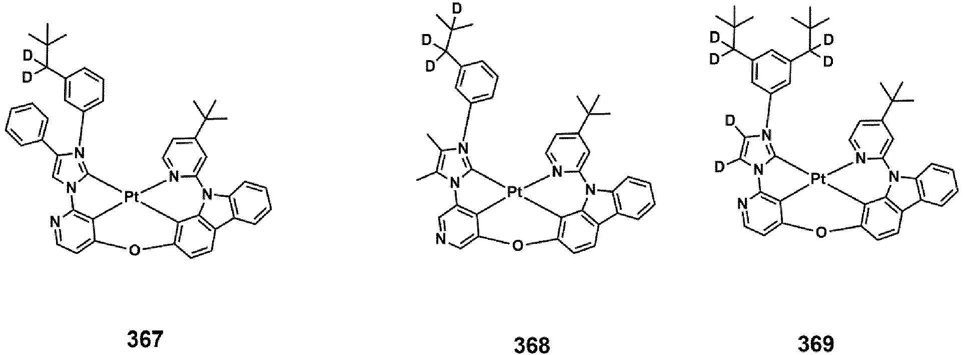

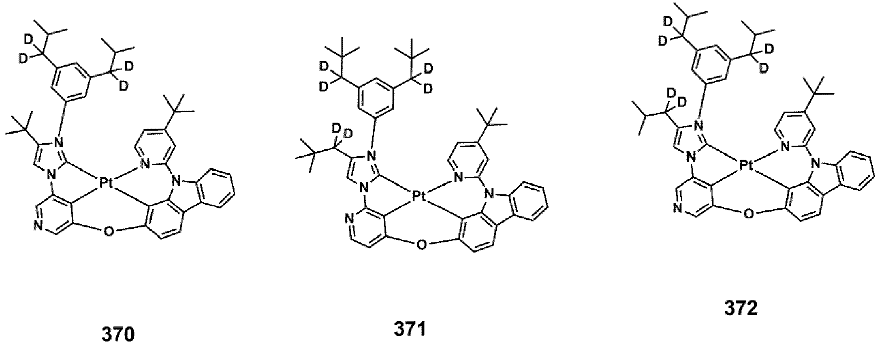

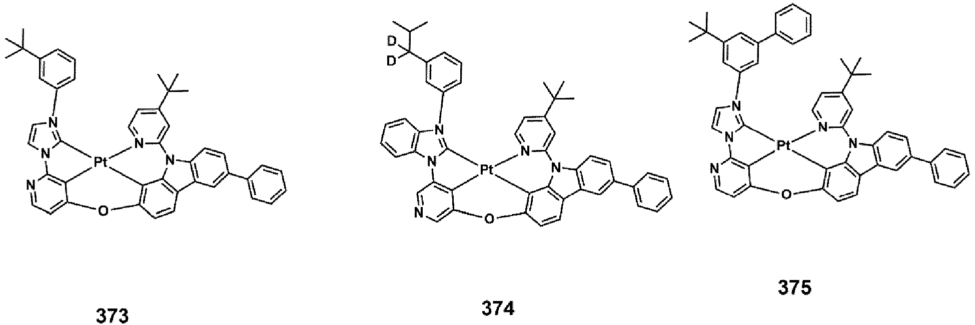

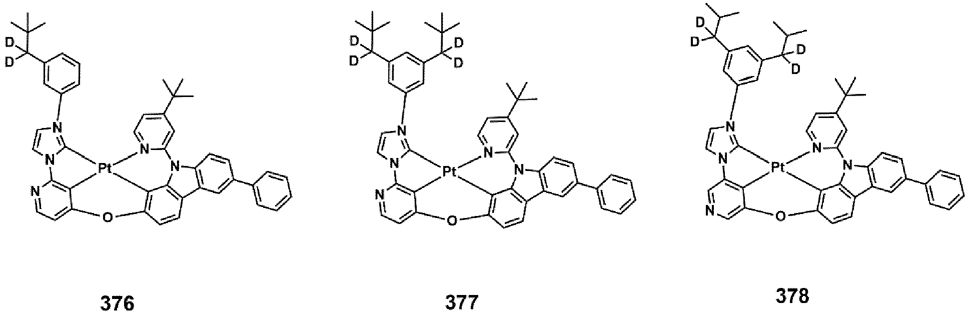

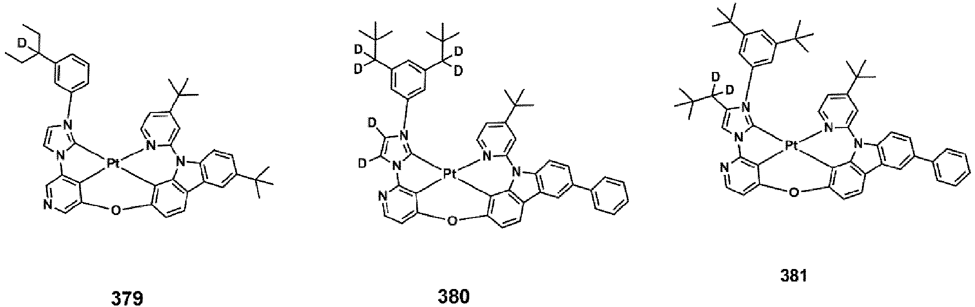

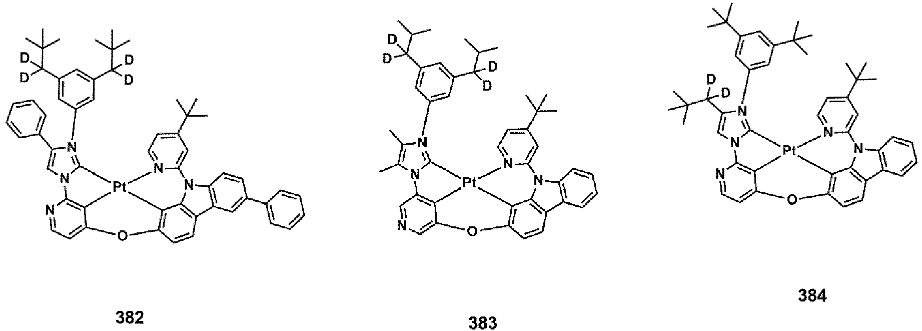

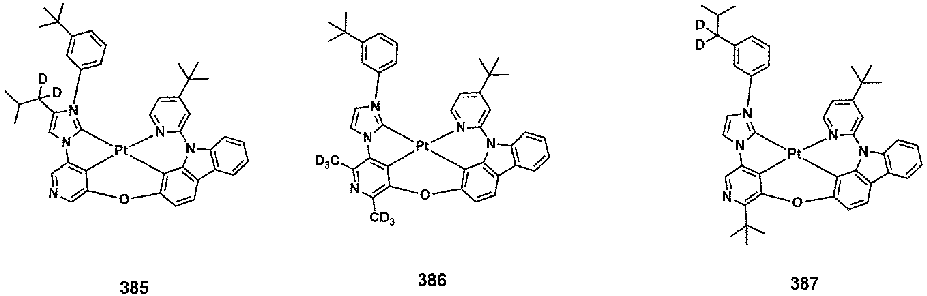

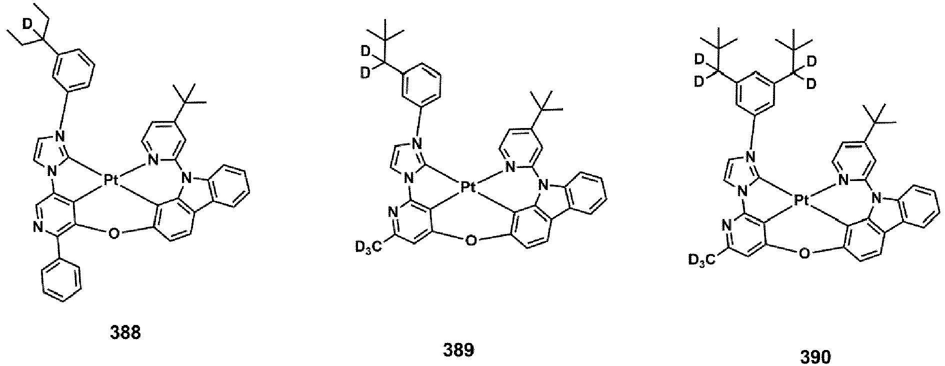

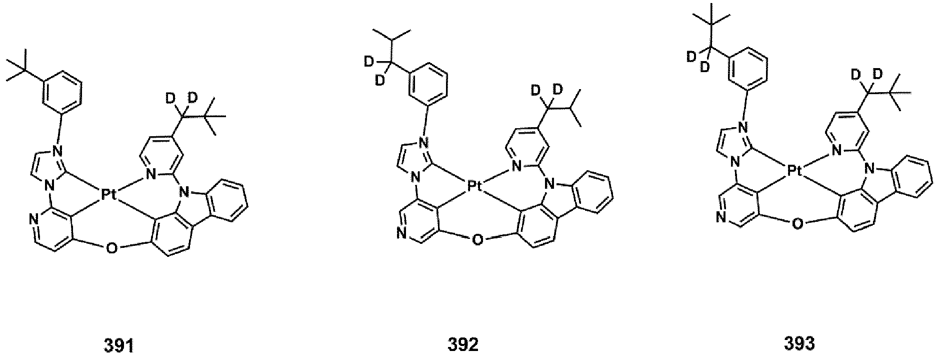

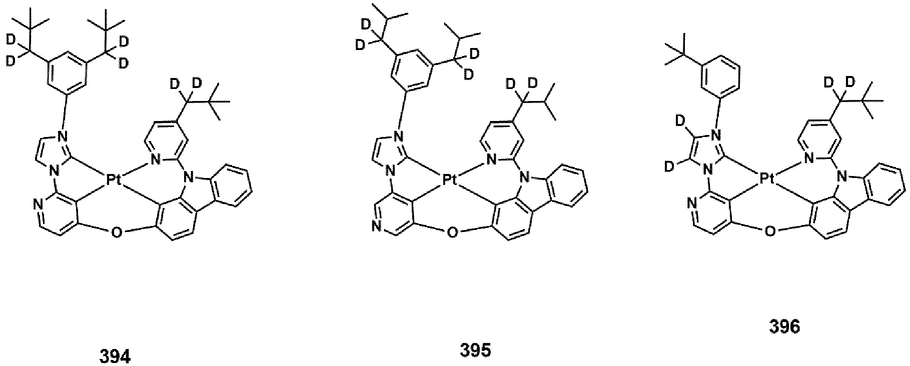

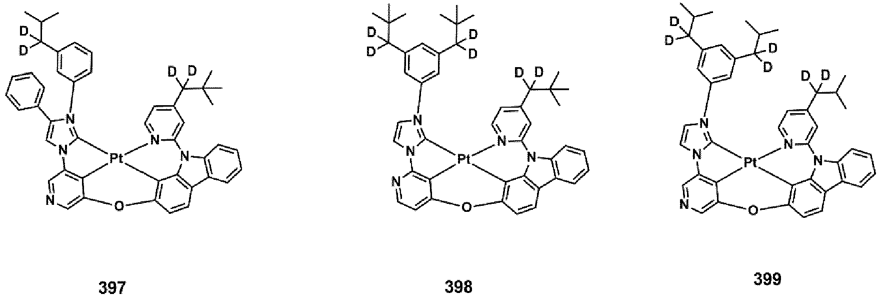

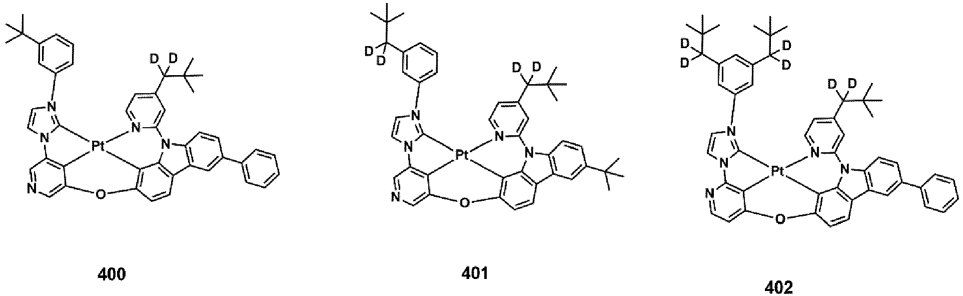

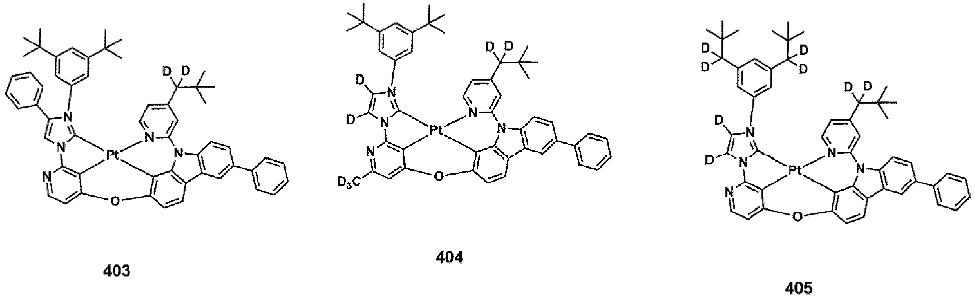

The organometallic compound represented by Formula 1 has a structure including a 5-membered moiety including a carbene structure substituted with a group represented by Formula 2 and a ligand including a benzene moiety including at least one nitrogen.

As the organometallic compound has a 5-membered moiety including a carbene structure substituted with a group represented by Formula 2, interaction with other molecules may be prevented, and efficiency by the electron-donating effect may be increased.

Moreover, as the organometallic compound includes a ligand including a benzene moiety including at least one nitrogen, the photoluminescence quantum yield (PLQY) may be increased, which leads to improved efficiency. Accordingly, by introducing nitrogen with great electronegativity while maintaining the deep blue emission area, the organometallic compound may have a deep highest occupied molecular orbital (HOMO) energy level, which facilitates the hole injection, and thus, may have a lower driving voltage. In addition, as the energy bandgap increases due to the introduction of nitrogen, the organometallic compound may have luminescence characteristics that make it suitable for use as a dopant of a blue organic light-emitting device.

Synthesis methods of the organometallic compound represented by Formula 1 may be recognizable by one of ordinary skill in the art and by referring to Synthesis Examples provided herein.

The highest occupied molecular orbital (HOMO) energy level, the lowest unoccupied molecular orbital (LUMO) energy level, and the lowest excitation triplet (T₁) energy level of selected organometallic compounds represented by Formula 1, and Comparative Compounds C1 to C3, were calculated using a density functional theory (DFT) method of the Gaussian 09 program with the molecular structure optimized at the B3LYP level, and results thereof are shown in Table 1. The energy levels are expressed in electron volts (eV).

**Table 1**

| Compound | HOMO (eV) | LUMO (eV) | T₁ (eV) |
|---|---|---|---|
| Compound C1 | -4.65 | -1.22 | 2.65 |
| Compound C2 | -4.61 | -1.19 | 2.63 |
| Compound C3 | -4.85 | -1.27 | 2.67 |
| Compound 1 | -4.88 | -1.27 | 2.69 |
| Compound 2 | -4.90 | -1.30 | 2.69 |
| Compound 3 | -4.89 | -1.32 | 2.68 |
| Compound 4 | -4.88 | -1.28 | 2.67 |
| Compound 5 | -4.88 | -1.28 | 2.67 |
| Compound 6 | -4.88 | -1.31 | 2.68 |
| Compound 7 | -4.89 | -1.31 | 2.68 |

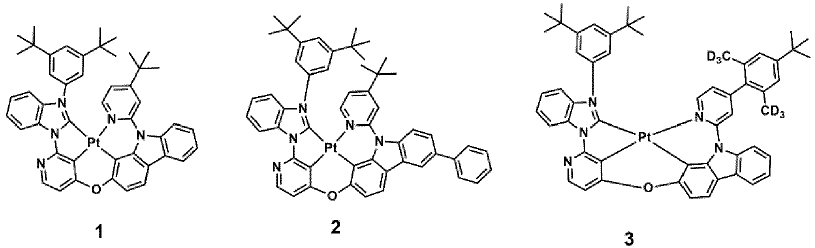

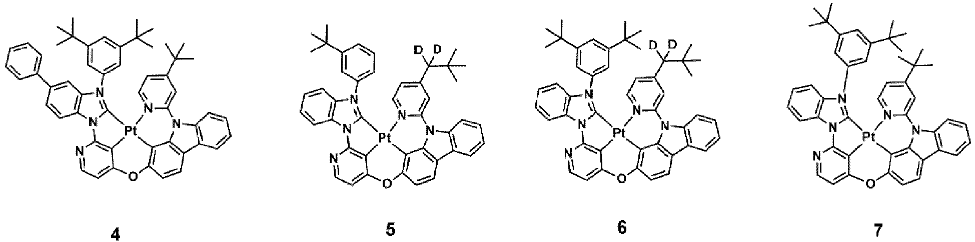

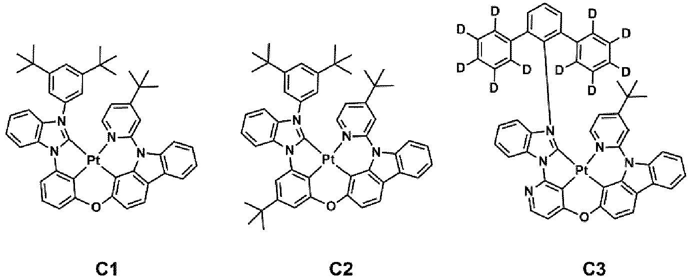

From Table 1, it was confirmed that the organometallic compound represented by Formula 1 according to one or more embodiments have a greater T₁ energy level than Comparative Compounds C1 to C3, and have a deeper HOMO energy level, and thus, have electrical characteristics suitable for use as a material for an organic light-emitting device, for example, as a dopant of an organic light-emitting device.

Accordingly, according to another aspect, also provided is an organic light-emitting device that may include a first electrode; a second electrode; and an organic layer arranged between the first electrode and the second electrode, wherein the organic layer includes an emission layer, and wherein the organic layer includes at least one organometallic compound represented by Formula 1 as described herein.

Since the organic light-emitting device has an organic layer including at least one of the organometallic compounds represented by Formula 1, the organic light-emitting device may have a low driving voltage, a high efficiency, a high luminance, a high quantum efficiency, and a long lifespan.

The expression "(an organic layer) includes at least one of the organometallic compound(s) represented by Formula 1" and the expression "(an organic layer) includes at least one organometallic compound represented by Formula 1" as used herein may include a case in which "(an organic layer) includes identical organometallic compounds represented by Formula 1" and a case in which "(an organic layer) includes two or more different organometallic compounds represented by Formula 1."

For example, the organic layer may include, as the at least one organometallic compound represented by Formula 1, only Compound 1. In this embodiment, Compound 1 may be included in the emission layer of the organic light-emitting device. In one or more embodiments, the organic layer may include, as the at least one organometallic compound represented by Formula 1, Compound 1 and Compound 2. In this regard, Compound 1 and Compound 2 may exist in an identical layer (for example, Compound 1 and Compound 2 both may be included in an emission layer).

In one or more embodiments, the at least one organometallic compound represented by Formula 1 may be included in the emission layer of the organic light-emitting device.

In the emission layer, the at least one organometallic compound represented by Formula 1 may serve as an emitter. In some embodiments, an emission layer including the at least one organometallic compound represented by Formula 1 may emit phosphorescence produced upon transition of triplet excitons to a ground state of the at least one organometallic compound represented by Formula 1.

In one or more embodiments, the emission layer of the organic light-emitting device may further include a host, and an amount of the host in the emission layer may be greater than an amount of the at least one organometallic compound represented Formula 1 based on their weights.

For example, the emission layer in the organic light-emitting device may include a host and a dopant, and the dopant may include the at least one organometallic compound represented by Formula 1. The host may be selected from any suitable hosts. That is, the organometallic compound represented by Formula 1 may act as a dopant.

In one or more embodiments, a full width at half maximum (FWHM) of an emission peak of an emission spectrum or electroluminescence spectrum of the organometallic compound represented by Formula 1 may be about 50 nanometers (nm) or less. For example, the FWHM of the emission peak of the emission spectrum or the electroluminescence spectrum of the organometallic compound may be from about 5 nm to about 50 nm, about 5 nm to about 40 nm, or about 5 nm to about 20 nm.

The emission layer may emit a light having a maximum emission wavelength from about 410 nm to about 490 nm, for example, from about 440 nm to about 480 nm, or from about 440 nm to about 470 nm. For example, the emission layer may emit a blue light, such as a blue light having a maximum emission wavelength from about 410 nm to about 490 nm, for example, from about 440 nm to about 480 nm, or from about 440 nm to about 470 nm.

In one or more embodiments, the emission layer may include a host and a dopant, the host may be any suitable host, and the dopant may include at least one organometallic compound represented by Formula 1, and the emission layer may further include a fluorescent dopant. The emission layer may emit fluorescent light that is generated by the transfer of the triplet excitons of the organometallic compound represented by Formula 1 to the fluorescent dopant, and then transition thereof.

The first electrode may be anode, which is a hole injection electrode, and the second electrode may be a cathode, which is an electron injection electrode. Alternatively, the first electrode may be a cathode, which is an electron injection electrode, and the second electrode may be an anode, which is a hole injection electrode.

In some embodiments, the first electrode may be an anode, the second electrode may be a cathode, and the organic layer may include a hole transport region arranged between the first electrode and the emission layer, and an electron transport region arranged between the emission layer and the second electrode, wherein the hole transport region may include a hole injection layer, a hole transport layer, an electron blocking layer, or a combination thereof, and the electron transport region may include a hole blocking layer, an electron transport layer, an electron injection layer, or a combination thereof.

For example, the organometallic compound represented by Formula 1 may be included in at least one of the hole transport region and the electron transport region.

According to another aspect, an electronic apparatus including the organic light-emitting device is provided.

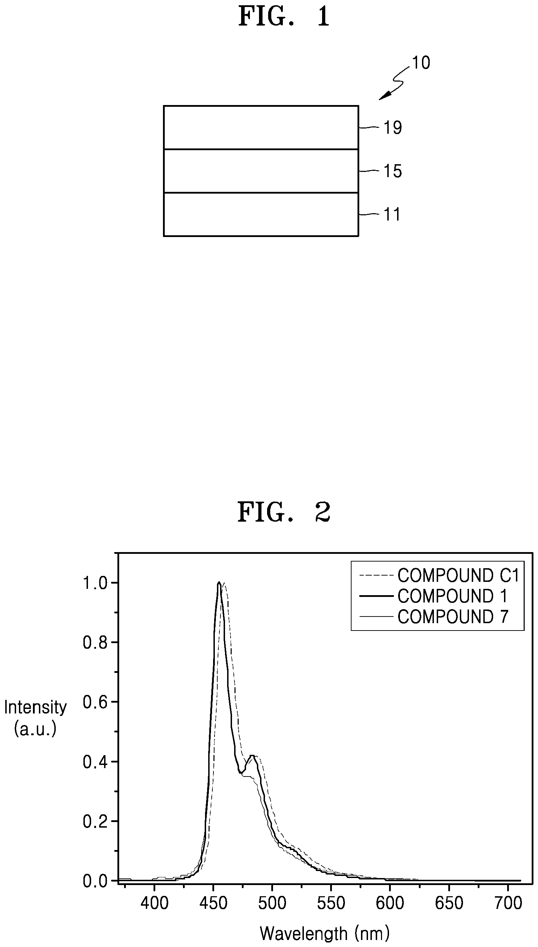

### Description of FIG. 1

FIG. 1 is a schematic cross-sectional view of an organic light-emitting device 10 according to one or more embodiments. Hereinafter, the structure and manufacturing method of the organic light-emitting device 10 according to one or more embodiments will be described in connection with FIG. 1, but embodiments are not limited thereto.

The organic light-emitting device 10 in FIG. 1 may include a first electrode 11, an organic layer 15, and a second electrode 19, which may be sequentially layered in this stated order.

A substrate may be additionally disposed under the first electrode 11 or on the second electrode 19. The substrate may be a conventional substrate that is commonly used in organic light-emitting devices, e.g., a glass substrate or a transparent plastic substrate, each having excellent mechanical strength, thermal stability, transparency, surface smoothness, ease of handling, and/or water repellency.

The first electrode 11 may be produced by depositing or sputtering, onto the substrate, a material for forming the first electrode 11. The first electrode 11 may be an anode. The material for forming the first electrode 11 may be selected from materials with a high work function for easy hole injection.

The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag), or the like, but embodiments are not limited thereto.

The first electrode 11 may have a single-layered structure or a multi-layered structure including a plurality of layers. For example, the first electrode 11 may have a three-layered structure of ITO/Ag/ITO, but the structure of the first electrode 11 is not limited thereto.

The organic layer 15 may be located on the first electrode 11.

The organic layer 15 may include a hole transport region, an emission layer, an electron transport region, or a combination thereof.

The hole transport region may be arranged between the first electrode 11 and the emission layer.

The hole transport region may include at least one of a hole injection layer, a hole transport layer, an electron blocking layer, a buffer layer, or a combination thereof.

The hole transport region may include only either a hole injection layer or a hole transport layer. In one or more embodiments, the hole transport region may have a hole injection layer/hole transport layer structure, or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, such as vacuum deposition, spin coating, casting, Langmuir-Blodgett (LB) deposition, or the like, but embodiments are not limited thereto.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure of about 10⁻⁸ torr to about 10⁻³ torr, and a deposition rate of about 0.01 angstroms per second (Å/sec) to about 100 Å/sec. However, the deposition conditions are not limited thereto.

When a hole injection layer is formed by spin coating, the spin coating may be performed at a rate in a range of about 2,000 revolutions per minute (rpm) to about 5,000 rpm and at a temperature of about 80°C to 200°C to facilitate removal of a solvent after the spin coating, though the conditions may vary depending on a compound used as a hole injection material and a structure and thermal properties of a desired hole injection layer, but embodiments are not limited thereto.

The conditions for forming the hole transport layer and the electron blocking layer may be similar to or the same as the conditions for forming the hole injection layer.

The hole transport region may include, for example, at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto:

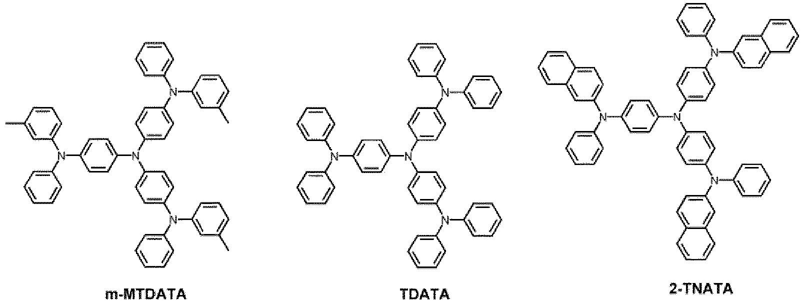

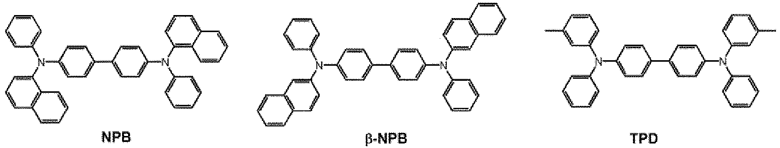

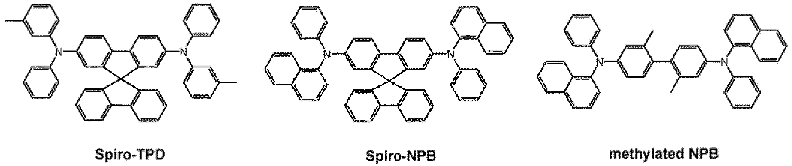

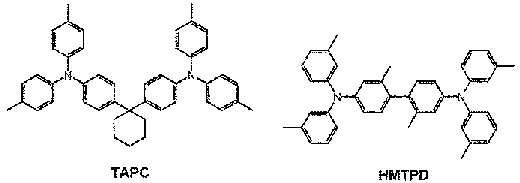

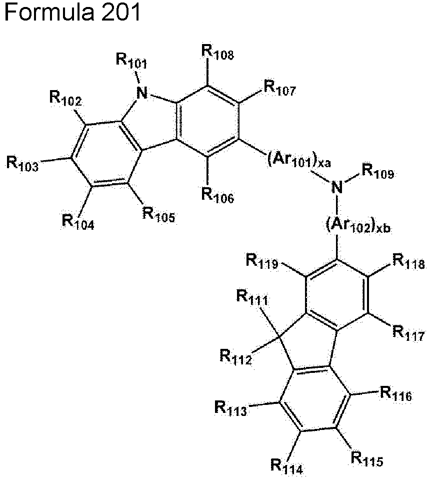

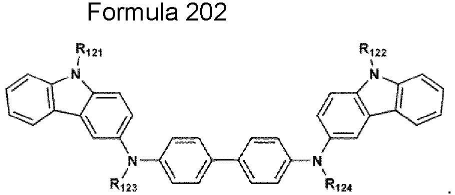

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0, but xa and xb are not limited thereto.

R₁₀₁ to R₁₀₈, R₁₁₁ to R₁₁₉ and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

In Formula 201, R₁₀₉ may be a phenyl group, a naphthyl group, an anthracenyl group, or a pyridinyl group, each unsubstituted or substituted with at least one of deuterium, -F, - Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one embodiment, the compound represented by Formula 201 may be represented by Formula 201A:

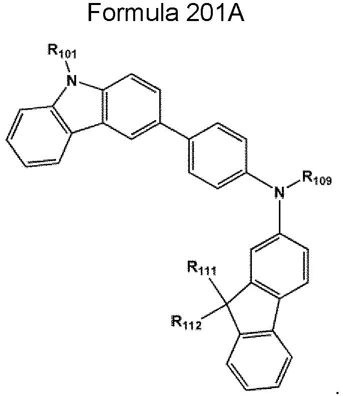

R₁₀₁, R₁₁₁, R₁₁₂, and R₁₀₉ in Formula 201A are each as described herein.

For example, the hole transport region may include at least one of Compounds HT1 to HT20, or a combination thereof, but embodiments are not limited thereto:

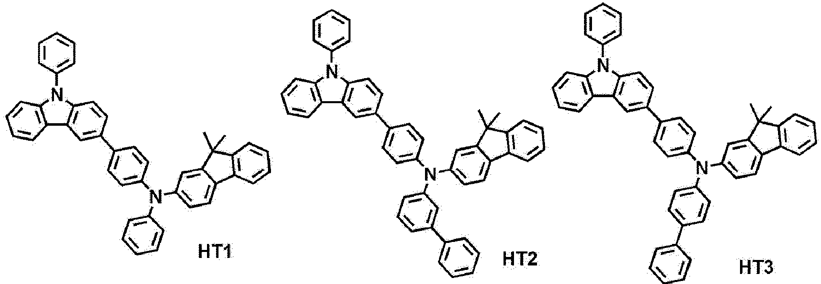

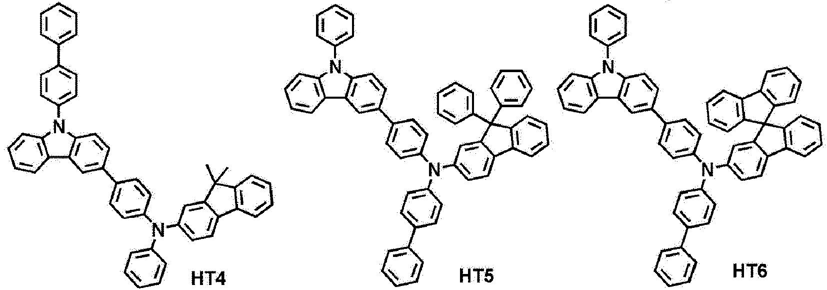

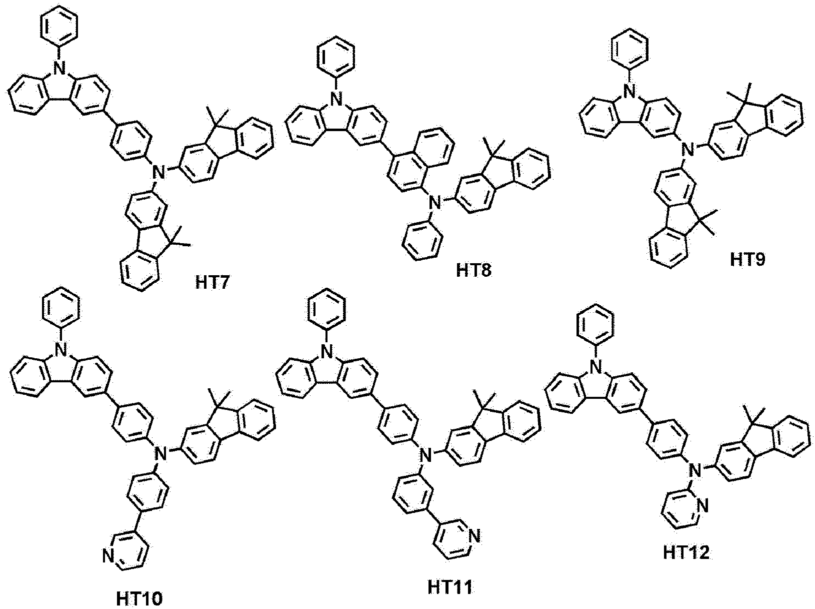

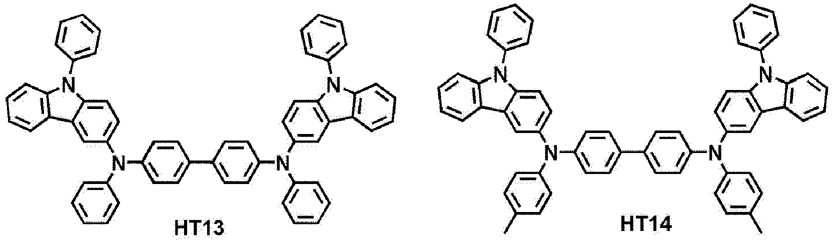

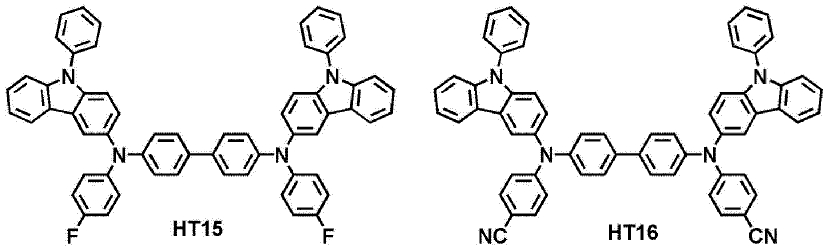

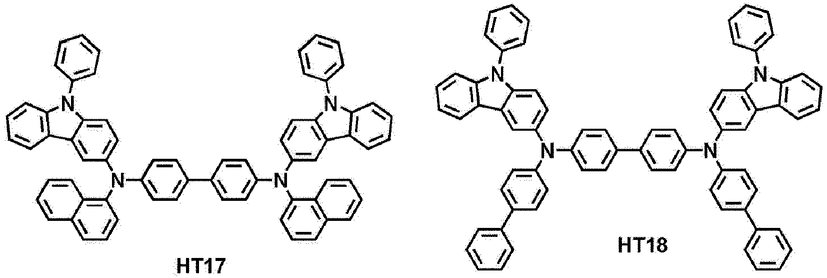

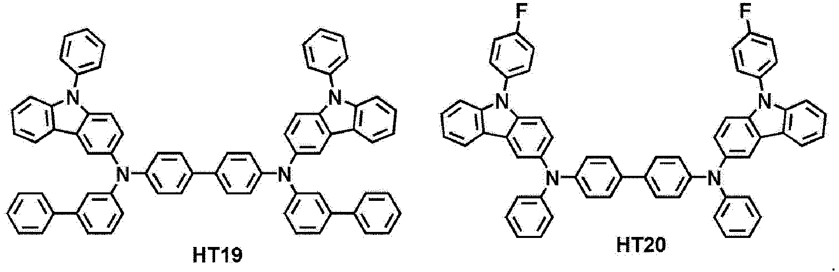

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. Without wishing to be bound to theory, when the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or a combination thereof, but embodiments are not limited thereto. For example, non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNQ), or the like; a metal oxide, such as a tungsten oxide, a molybdenum oxide, or the like; or a compound containing a cyano group, such as Compound HT-D1 or Compound HT-D2, but embodiments are not limited thereto:

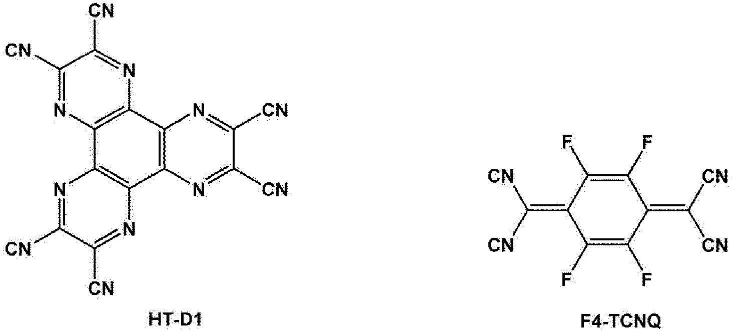

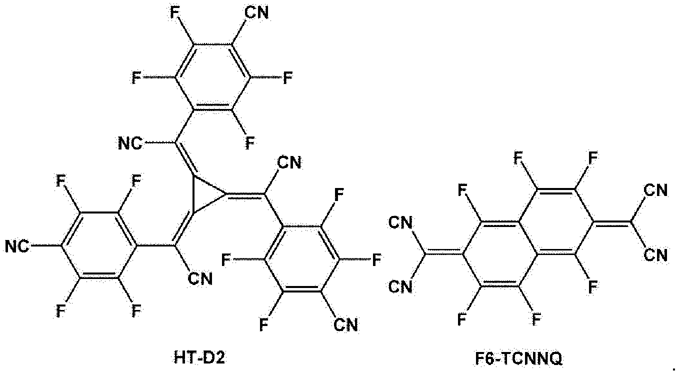

The hole transport region may include a buffer layer.

In some embodiments, the buffer layer may compensate for an optical resonance distance according to a wavelength of light emitted from the emission layer, and thus, efficiency of a formed organic light-emitting device may be improved.

The emission layer may be formed on the hole transport region by using one or more suitable methods, such as vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The hole transport region may further include an electron blocking layer. The electron blocking layer may include a material available in the art, for example, 1,3-bis(N-carbazolyl)benzene (mCP), but embodiments are not limited thereto.

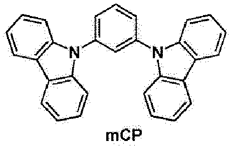

A thickness of the electron blocking layer may be about 50 Å to about 1,000 Å, for example about 70 Å to about 500 Å. Without wishing to be bound to theory, when the thickness of the electron blocking layer is within the range described above, the electron blocking layer may have satisfactory electron blocking characteristics without a substantial increase in driving voltage.

When the organic light-emitting device 10 is a full-color organic light-emitting device 10, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light.

The emission layer may include at least one of the organometallic compounds represented by Formula 1.

The emission layer may include a host and a dopant, and the dopant may include at least one of the organometallic compounds represented by Formula 1.

The host may include, for example, at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazole-9-yl)benzene (TCP), 1,3-bis(N-carbazolyl)benzene (mCP), Compound H50, Compound H51, Compound H52, or a combination thereof, but embodiments are not limited thereto:

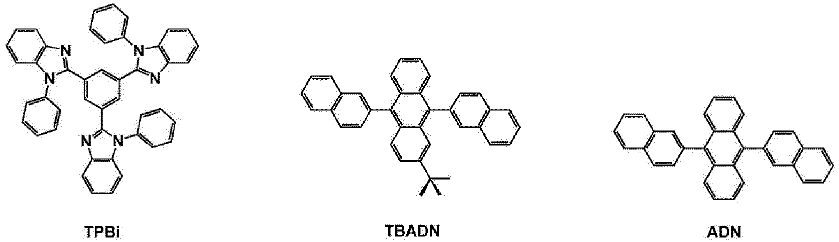

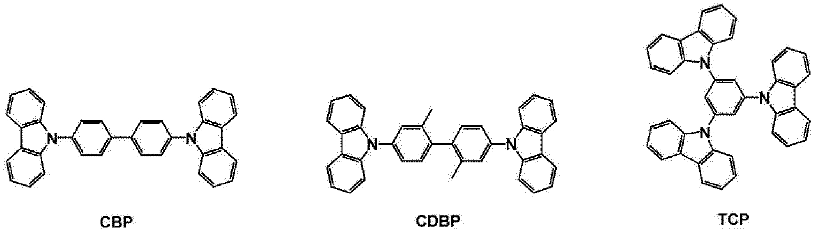

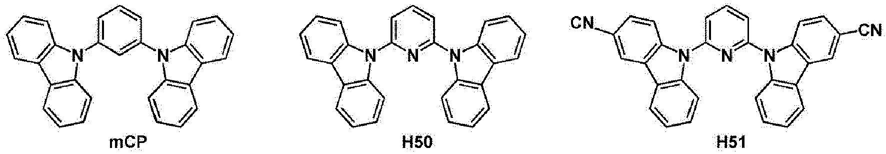

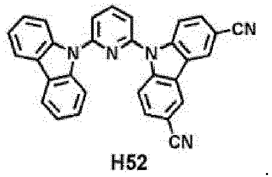

In one or more embodiments, the host may further include a compound represented by Formula 301, but embodiments are not limited thereto:

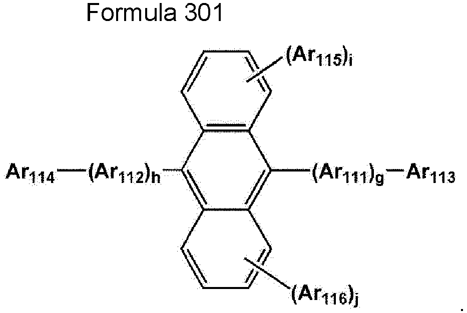

Ar₁₁₁ and Ar₁₁₂ in Formula 301 may each independently be:
a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, an anthracenyl group, or a combination thereof.

Ar₁₁₃ to Ar₁₁₆ in Formula 301 may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

In Formula 301, g, h, i, and j may each independently be 0, 1, 2, 3, or 4, for example, g, h, i, and j may each independently be 0, 1, or 2.

Ar₁₁₃ to Ar₁₁₆ in Formula 301 may each independently be:
a C₁-C₁₀ alkyl group that is substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or
a group represented by formula: 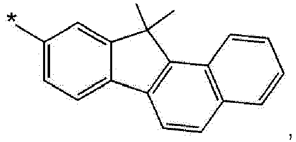 but embodiments are not limited thereto.

In one or more embodiments, the host may include a compound represented by Formula 302, but embodiments are not limited thereto:

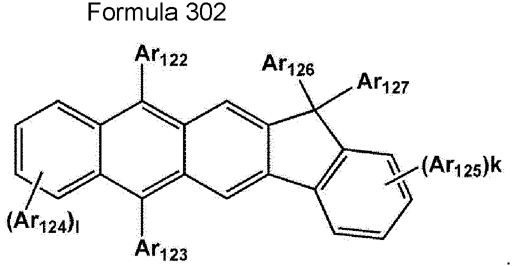

Ar₁₂₂ to Ar₁₂₅ in Formula 302 may be as described in detail in connection with Ar₁₁₃ in Formula 301.

Ar₁₂₆ and Ar₁₂₇ in Formula 302 may each independently be a C₁-C₁₀ alkyl group (for example, a methyl group, an ethyl group, a propyl group, or the like).

In Formula 302, k and l may each independently be an integer of 0, 1, 2, 3, or 4. For example, k and I may each independently be 0, 1, or 2.

When the organic light-emitting device 10 is a full-color organic light-emitting device 10, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light.

When the emission layer includes a host and a dopant, the amount of the dopant in the emission layer may be about 0.01 parts by weight to about 20 parts by weight such as about 5 parts by weight to about 15 parts by weight, or about 8 parts by weight to about 12 parts by weight, based on 100 parts by weight of the emission layer. However, the amount of the dopant included in the emission layer is not limited thereto. When the amount of the dopant satisfies the above range, it may be possible to realize emission without extinction phenomenon.

In one embodiment, the organic layer of the organic light-emitting device may further include a fluorescent dopant in addition to at least one of the organometallic compounds represented by Formula 1.

In some embodiments, the fluorescent dopant may be a condensed polycyclic compound, a styryl-containing compound, or a combination thereof.

According to one or more embodiments, the fluorescent dopant may include a compound represented by Formula 501: 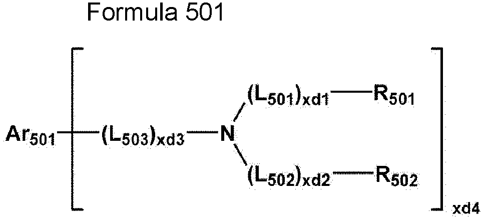 wherein, in Formula 501,
Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or -Si(Q₅₀₁)(Q₅₀₂)(Q₅₀₃), wherein Q₅₀₁ to Q₅₀₃ may each independently be hydrogen, a C₁-C₆₀ alkyl group, a C₁-C₆₀ alkoxy group, a C₁-C₆₀ alkylthio group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, or a combination thereof,
L₅₀₁ to L₅₀₃ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
R₅₀₁ and R₅₀₂ may each independently be:
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd1 to xd3 may each independently be 0, 1, 2, or 3, and
   xd4 may be 0, 1, 2, 3, 4, 5, or 6.

For example, in Formula 501,
Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group, or -Si(Q₅₀₁)(Q₅₀₂)(Q₅₀₃), wherein Q₅₀₁ to Q₅₀₃ may each independently be hydrogen, a C₁-C₂₀ alkyl group, a C₁-C₂₀ alkoxy group, a C₁-C₂₀ alkylthio group, a phenyl group, a biphenyl group, a terphenyl group or a naphthyl group, or a combination thereof, 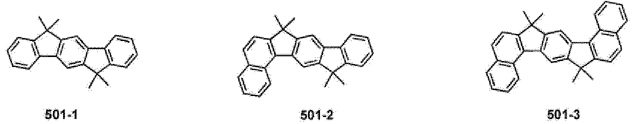 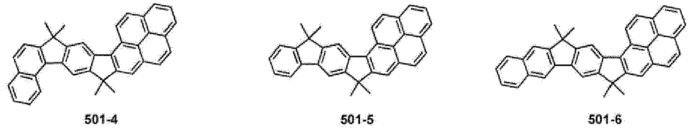 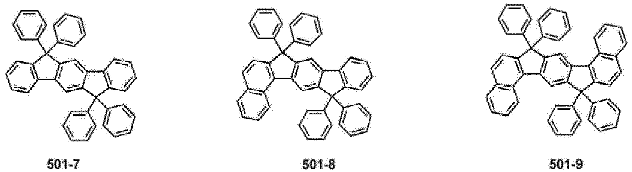 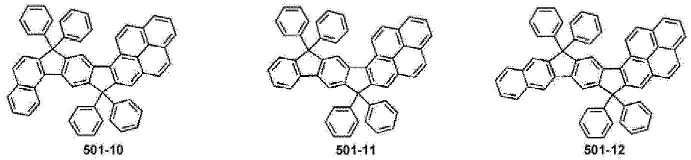 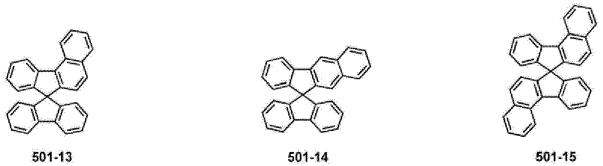 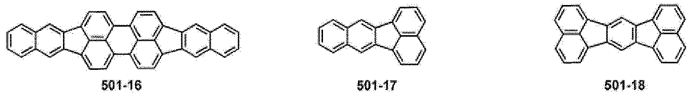
   L₅₀₁ to L₅₀₃ are as described above,
   xd1 to xd3 may be each independently 0, 1, or 2, and
   xd4 may be 0, 1, 2, or 3, but embodiments are not limited thereto.

The fluorescent dopant may include, for example, at least one of Compounds FD(1) to FD(16), Compounds FD1 to FD13, or a combination thereof, but embodiments are not limited thereto:

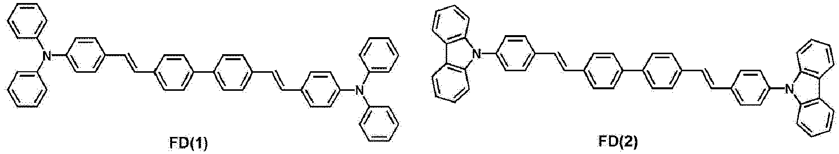

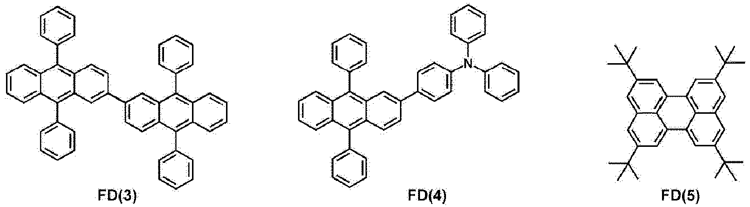

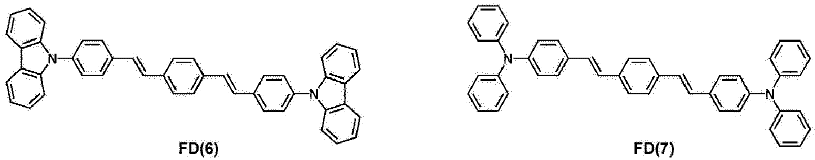

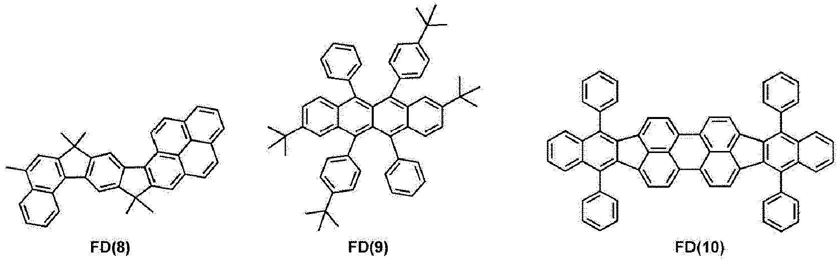

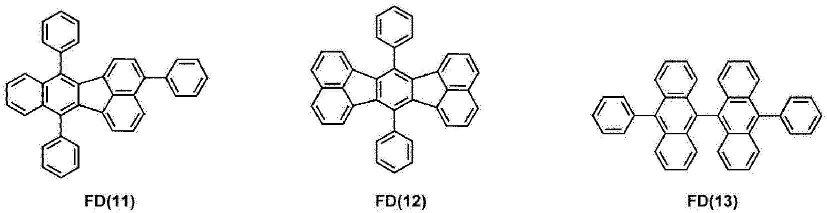

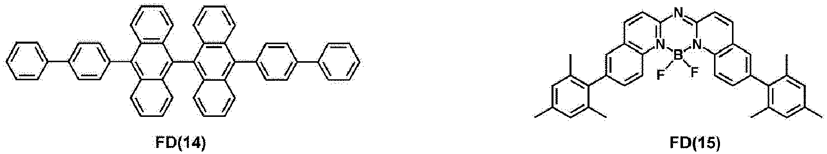

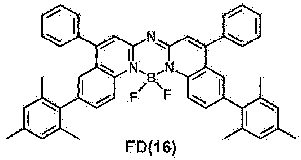

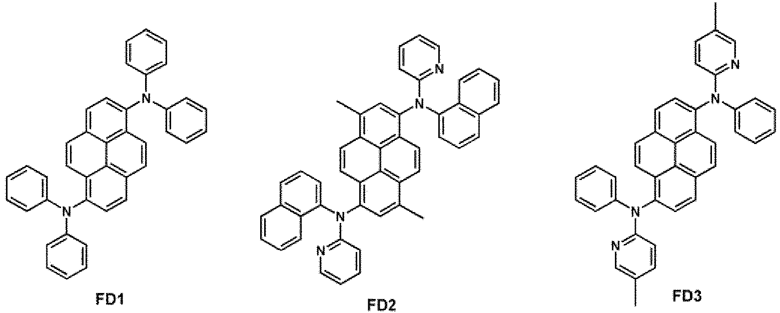

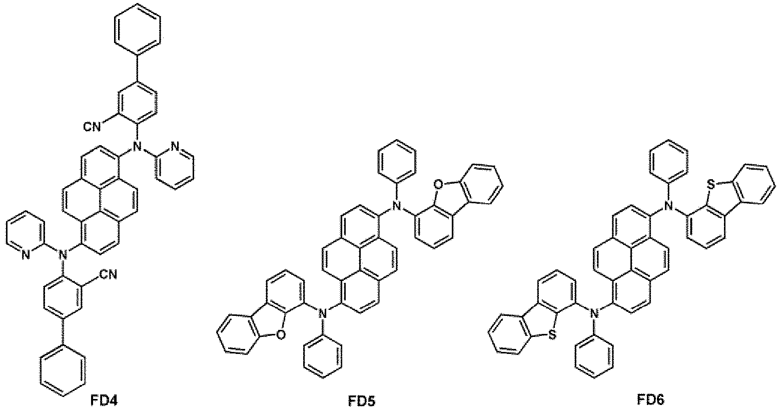

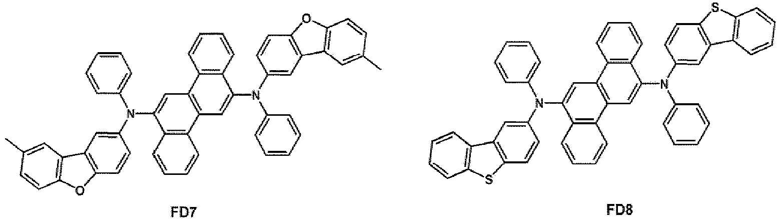

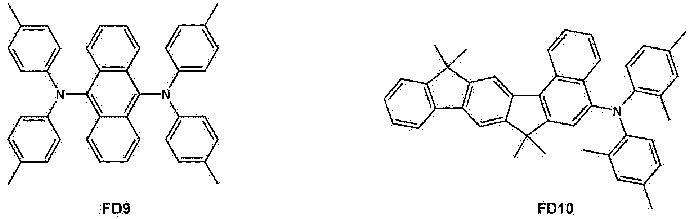

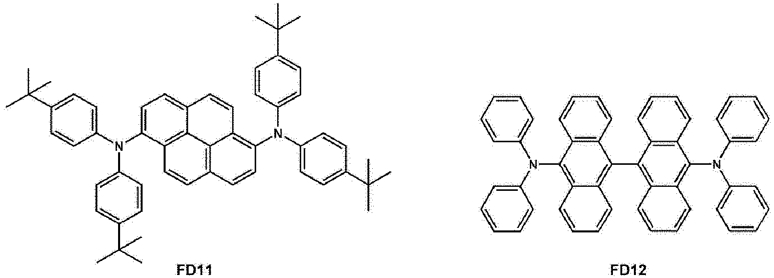

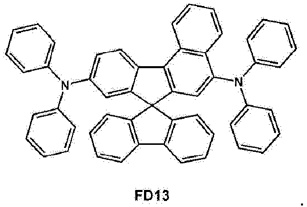

The thickness of the emission layer may be about 100 Å to about 1,000 Å, for example, about 200 Å to about 600 Å. Without wishing to be bound to theory, when the thickness of the emission layer is within these ranges, excellent luminescence characteristics may be obtained without a substantial increase in driving voltage.

An electron transport region may be located on the emission layer.

The electron transport region may include at least one of a hole blocking layer, an electron transport layer, an electron injection layer, or a combination thereof.

For example, the electron transport region may have a hole blocking layer/electron transport layer/electron injection layer structure, or an electron transport layer/electron injection layer structure, and the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), or a combination thereof, but embodiments are not limited thereto:

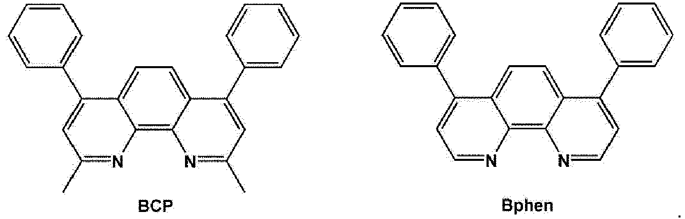

A thickness of the hole blocking layer may be about 20 Å to about 1,000 Å, for example, about 30 Å to about 300 Å. Without wishing to be bound to theory, when the thickness of the hole blocking layer is within these ranges, excellent hole blocking characteristics may be obtained without a substantial increase in driving voltage.

The electron transport layer may include, for example, at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof, but embodiments are not limited thereto:

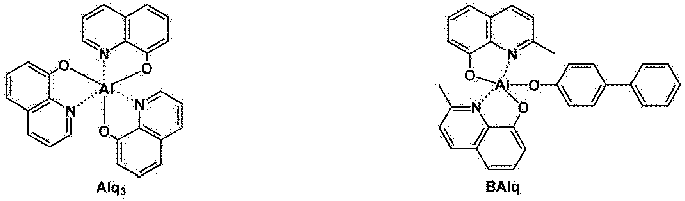

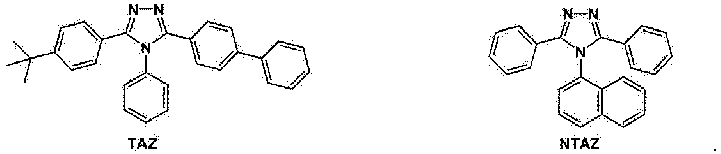

In one or more embodiments, the electron transport layer may include at least one of ET1 to ET25, but embodiments are not limited thereto:

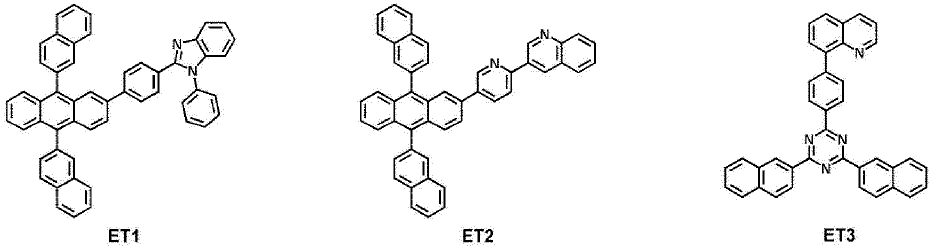

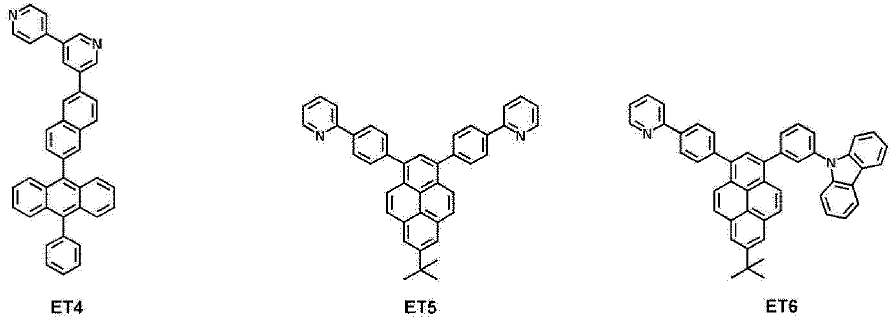

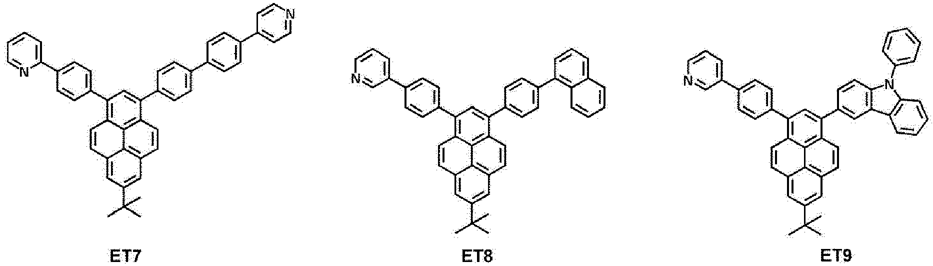

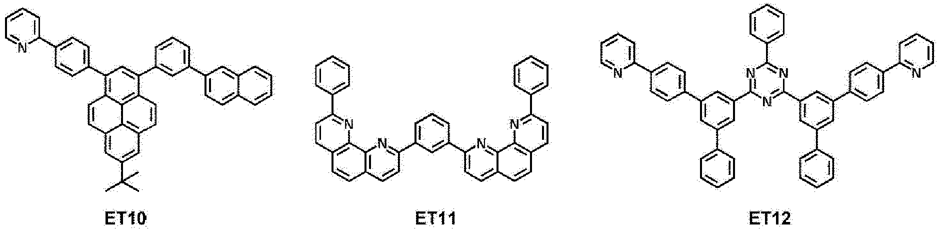

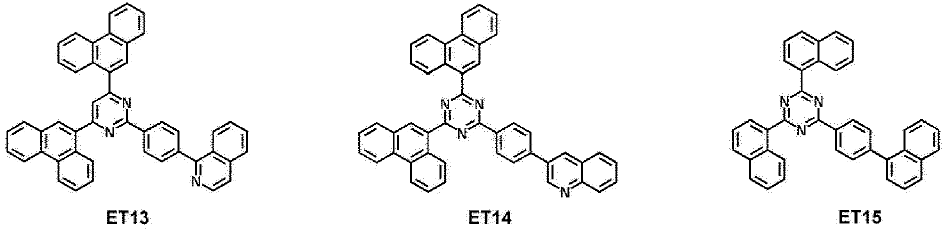

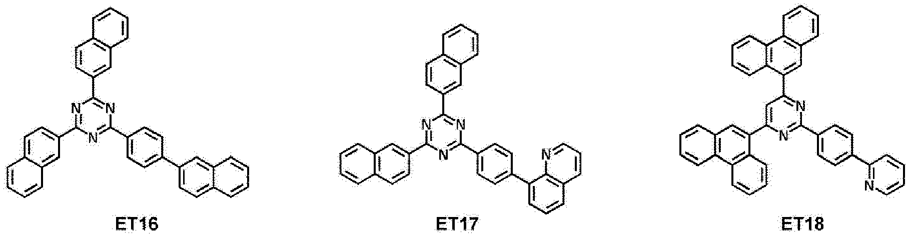

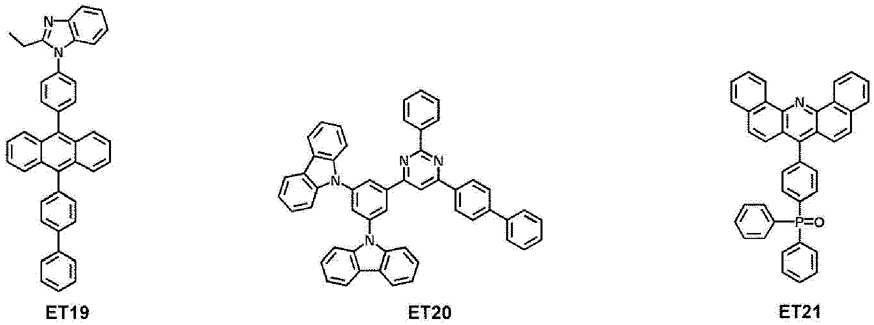

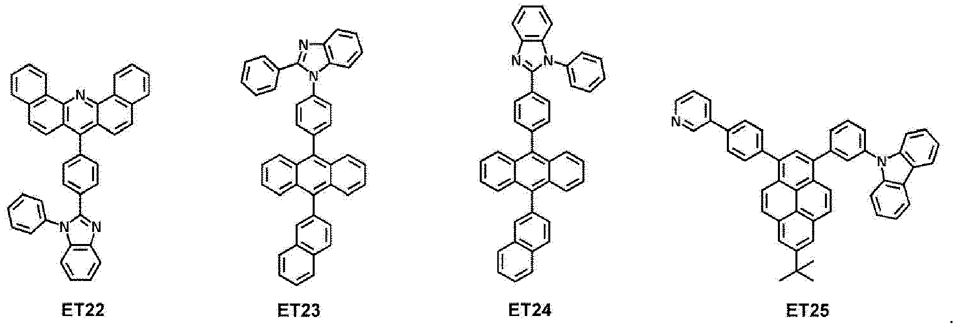

A thickness of the electron transport layer may be about 100 Å to about 1,000 Å, for example, about 150 Å to about 500 Å. Without wishing to be bound to theory, when the thickness of the electron transport layer is within the range described above, the electron transport layer may have satisfactory electron transporting characteristics without a substantial increase in driving voltage.

The electron transport layer may include a metal-containing material in addition to the material as described herein.

The metal-containing material may include a Li complex. The Li complex may include, for example, Compound ET-D1 (lithium quinolate, LiQ) or ET-D2, but embodiments are not limited thereto:

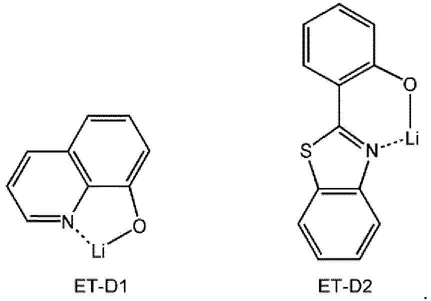

The electron transport region may include an electron injection layer that facilitates injection of electrons from the second electrode 19.

The electron injection layer may include at least one of LiQ, LiF, NaCl, CsF, Li₂O, or BaO, but embodiments are not limited thereto.

A thickness of the electron injection layer may be in a range of about 1 Å to about 100 Å, and, for example, about 3 Å to about 90 Å. Without wishing to be bound to theory, when the thickness of the electron injection layer is within the ranges above, satisfactory electron injection characteristics may be obtained without a substantial increase in driving voltage.

The second electrode 19 may be located on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 1, but embodiments are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, or the like, but embodiments are not limited thereto.

According to another aspect, a diagnostic composition may include at least one organometallic compound represented by Formula 1.

As the organometallic compound represented by Formula 1 provides a high luminescence efficiency, the diagnostic composition including at least one of the organometallic compounds represented by Formula 1 may have a high diagnostic efficiency.

The diagnostic composition may be used in various applications, for example, including a diagnosis kit, a diagnosis reagent, a biosensor, a biomarker, or the like, but embodiments are not limited thereto.

### Explanation of terms

The term "C₁-C₆₀ alkyl group" as used herein refers to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, a hexyl group, or the like. The term "C₁-C₆₀ alkylene group" as used herein refers to a divalent group having the same structure as the C₁-C₆₀ alkyl group.

The term "C₁-C₆₀ alkoxy group" used herein refers to a monovalent group represented by -OA₁₀₁ (wherein A₁₀₁ is the C₁-C₆₀ alkyl group), and non-limiting examples thereof include a methoxy group, an ethoxy group, an isopropyloxy group, or the like.

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and non-limiting examples thereof include a cyclopropyl group, a cyclobutyl group, a cyclopentyl group, a cyclohexyl group, a cycloheptyl group, or the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group having at least one heteroatom selected from N, O, P, Si, S, Se, Ge, and B as a ring-forming atom and 1 to 10 carbon atoms as ring-forming atom(s), and non-limiting examples thereof include a tetrahydrofuranyl group, a tetrahydrothiophenyl group, or the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, P, Si, S, Se, Ge, and B as a ring-forming atom, 1 to 10 carbon atoms as ring-forming atom(s), and at least one double bond in its ring. Non-limiting examples of the C₁-C₁₀ heterocycloalkenyl group include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic ring system having 6 to 60 carbon atoms, and the term "C₆-C₆₀ arylene group" as used herein refers to a divalent group having a carbocyclic aromatic ring system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The term "C₁-C₆₀ heteroaryl group" as used herein refers to a monovalent group having a heterocyclic aromatic ring system that has at least one heteroatom selected from N, O, P, Si, S, Se, Ge, and B as a ring-forming atom, and 1 to 60 carbon atoms as ring-forming atom(s). The term "C₁-C₆₀ heteroarylene group" as used herein refers to a divalent group having a heterocyclic aromatic ring system that has at least one heteroatom selected from N, O, P, Si, S, Se, Ge, and B as a ring-forming atom, and 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused to each other.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates -SA₁₀₃ (wherein A₁₀₃ is the C₆-C₆₀ aryl group).

The term "C₁-C₆₀ heteroaryloxy group" as used herein indicates -OA_{102'} (wherein A₁₀₂ is the C₁-C₆₀ heteroaryl group), and the term "C₁-C₆₀ heteroarylthio group" as used herein indicates -SA_{103'} (wherein A_{103'} is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 2 to 60 carbon atoms) having two or more rings condensed with each other, at least one heteroatom selected from N, O, P, Si, S, Se, Ge, and B, other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group described above.

The term "C₅-C₃₀ carbocyclic group" as used herein refers to a saturated or unsaturated ring group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated ring group having, as a ring-forming atom, at least one heteroatom selected from N, O, P, Si, S, Se, Ge, and B, other than 1 to 30 carbon atoms as ring-forming atom(s). The C₁-C₃₀ heterocyclic group may be a monocyclic group or a polycyclic group.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), - N(Q₁₄)(Q₁₅) -Ge(Q₁₃)(Q₁₄)(Q₁₅), -B(Q₁₆)(Q₁₇), -P(Q₁₈)(Q₁₉), or -P(=O)(Q₁₈)(Q₁₉),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), or -P(=O)(Q₂₈)(Q₂₉); or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉ and Q₃₁ to Q₃₉ as described herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

The term "room temperature" used herein refers to a temperature of about 25°C.

The terms "a biphenyl group, a terphenyl group, and a tetraphenyl group" as used herein each refers to a monovalent group having two, three, or four phenyl groups linked via a single bond, respectively.

Hereinafter, a compound and an organic light-emitting device according to exemplary embodiments are described in further detail with reference to Synthesis Example and Examples. However, the organic light-emitting device is not limited thereto. The wording "'B' was used instead of 'A"' used in describing Synthesis Examples means that an amount of 'A' used was identical to an amount of 'B' used, in terms of a molar equivalent.

### EXAMPLES

### Synthesis Example 1: Synthesis of Compound 1

### (1) Synthesis of Intermediate 1(1)

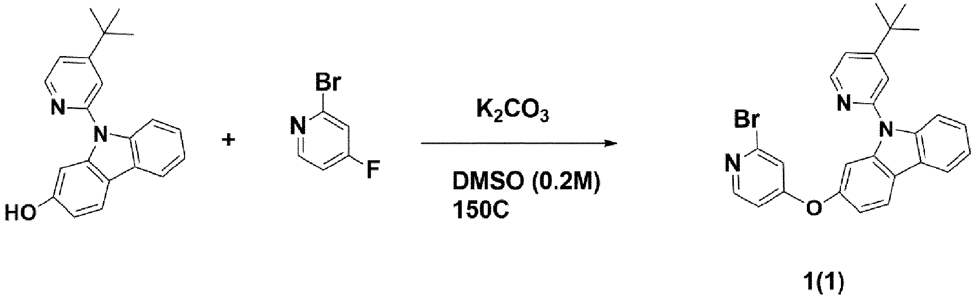

After 59.2 millimoles (mmol) (18.7 grams (g)) of 9-(4-(tert-butyl)pyridin-2-yl)-9H-carbazol-2-ol and 71.1 mmol (12.5 g) of 2-bromo-4-fluoropyridine were dissolved in 300 milliliters (mL) of dimethyl sulfoxide (DMSO), 118.5 mmol (16.4 g) of K₂CO₃ was added thereto, followed by heating at reflux at 150°C("°C" is written as "C" in the reaction scheme, the same below) for 12 hours. After completion of the reaction, the resultant mixture was allowed to cool to room temperature, and an organic layer was extracted therefrom using a mixture of ethyl acetate and water. The organic layer was washed three times with water and dried using anhydrous magnesium sulfate. Then, a solvent was removed therefrom under a reduced pressure to obtain a crude product. The crude product was purified by silica gel column chromatography (eluents: ethyl acetate:hexane) to obtain Intermediate 1(1) (yield: 72%). The product was identified by high-performance liquid chromatography-mass spectrometry (HPLC-MS).

HPLC-MS: m/z=474.09 [M+H]+.

### (2) Synthesis of Intermediate 1(2)

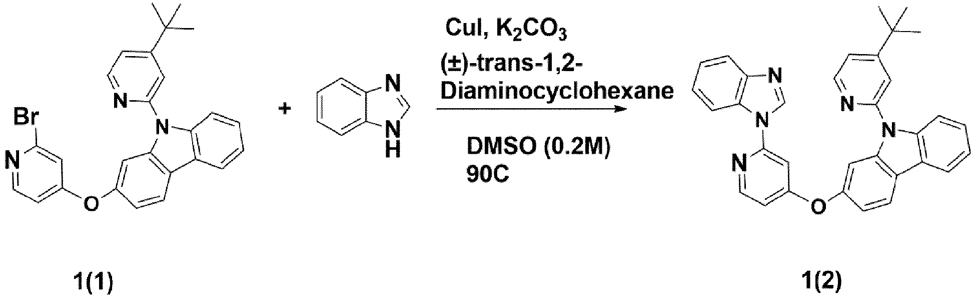

After 14.8 mmol (7.0 g) of Intermediate 1(1) and 19.3 mmol (2.3 g) of 1H-benzo[d]imidazole were dissolved in 75 mL of DMSO, 3.0 mmol (0.6 g) of Cul, 5.9 mmol (0.7 g) of (±)-trans-1,2-diaminocyclohexane, and 44.4 mmol (6.1 g) of K₂CO₃ were added thereto, followed by heating at reflux at 90°C for 12 hours. After completion of the reaction, the mixture was allowed to cool to room temperature, and an organic layer was extracted therefrom using the mixture including ethyl acetate and water. The organic layer was washed three times with water and dried using anhydrous magnesium sulfate, and then, a solvent was removed therefrom under a reduced pressure, thereby obtaining a crude product. The crude product was purified by silica gel column chromatography (eluents: ethyl acetate:hexane) to obtain Intermediate 1(2) (yield: 56%). The product was identified by HPLC-MS.

HPLC-MS: m/z=510.18 [M+H]+.

### (3) Synthesis of Intermediate 1(3)

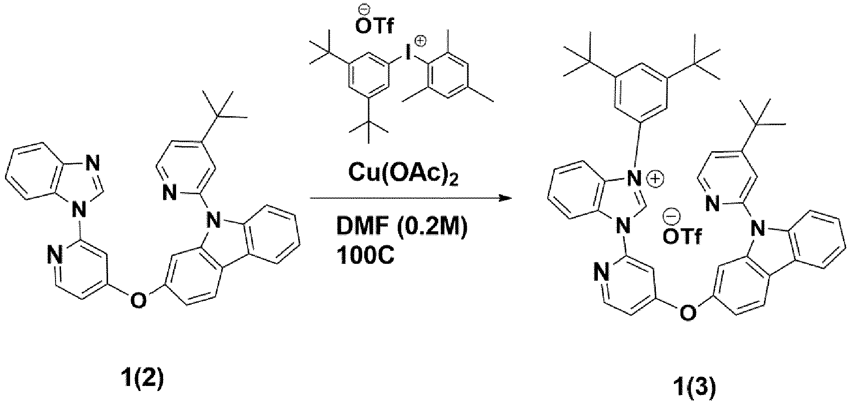

8.3 mmol (4.35 g) of Intermediate 1(2), 10.3 mmol (6.3 g) of (3,5-di-tert-butylphenyl)(mesityl)iodonium triflate (⁻OTf), and 0.8 mmol (0.2 g) copper (II) acetate (Cu(Oac)₂) were added to 50 mL of dimethylformamide (DMF), followed by heating at reflux at 100°C for 3 hours. After completion of the reaction, the mixture was allowed to cool to room temperature, and an organic layer was extracted therefrom using a mixture including ethyl acetate and water. The organic layer was washed three times with water and dried using anhydrous magnesium sulfate, and then, a solvent was removed therefrom under a reduced pressure, thereby obtaining a crude product. The crude product was purified by silica gel column chromatography (eluents: dichloromethane:acetone) to obtain Intermediate 1(3) (yield: 89%). The product was identified by HPLC-MS.

HPLC-MS: m/z=698.39 [M-OTf]+.

### (4) Synthesis of Compound 1

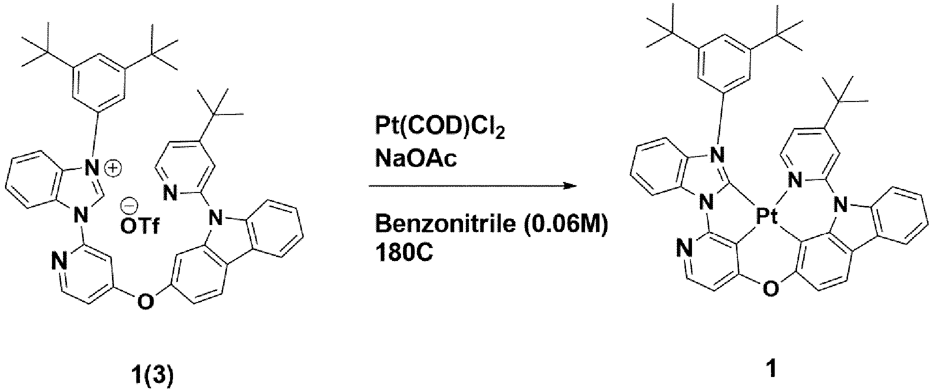

7.4 mmol (6.3 g) of Intermediate 1(3), 8.1 mmol (3.0 g) of (1,5-cyclooctadiene)platinum(II) dichloride (Pt(COD)Cl₂), and 22.2 mmol (1.8 g) of sodium acetate were mixed with 130 mL of benzonitrile, followed by stirring and heating at 180°C for 18 hours. Once the reaction was completed, the mixture was allowed to cool to room temperature, and the solvent was removed under reduced pressure. The resultant product thus obtained was purified by silica gel column chromatography to obtain Compound 1 (yield=18%). The product was identified by HPLC-MS.

HPLC-MS: m/z=891.34 [M+H]+.

### Synthesis Example 2: Synthesis of Compound 2

### (1) Synthesis of Intermediate 2(1)

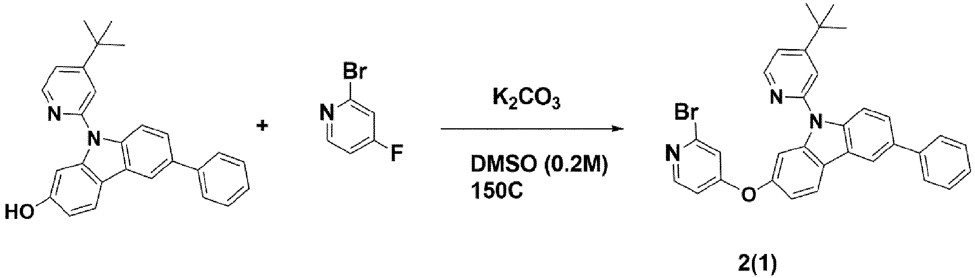

After 51.0 mmol (20.0 g) of 9-(4-(tert-butyl)pyridin-2-yl)-6-phenyl-9H-carbazol-2-ol, and 66.3 mmol (11.7 g) of 2-bromo-4-fluoropyridine were dissolved in 250 mL of DMSO, 101.9 mmol (14.1 g) of potassium carbonate (K₂CO₃) was added thereto, followed by heating at reflux at 150°C for 12 hours. After completion of the reaction, the resultant mixture was allowed to cool to room temperature, and an organic layer was extracted therefrom using a mixture of ethyl acetate and water. The organic layer was washed three times with water and dried using anhydrous magnesium sulfate. Then, a solvent was removed therefrom under a reduced pressure to obtain a crude product. The crude product was purified by silica gel column chromatography (eluents: ethyl acetate:hexane) to obtain Intermediate 2(1) (yield: 79%). The product was identified by HPLC-MS.

HPLC-MS: m/z=550.08 [M+H]+.

### (2) Synthesis of Intermediate 2(2)

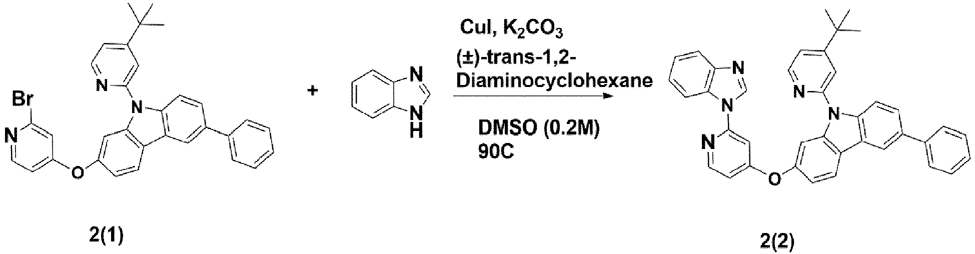

Intermediate 2(2) was synthesized in a similar manner as in Synthesis of Intermediate 1(2) in Synthesis Example 1, except that Intermediate 2(1) was used instead of Intermediate 1(1) (yield: 83%). The product was identified by HPLC-MS.

HPLC-MS: m/z=586.31 [M+H]+.

### (3) Synthesis of Intermediate 2(3)

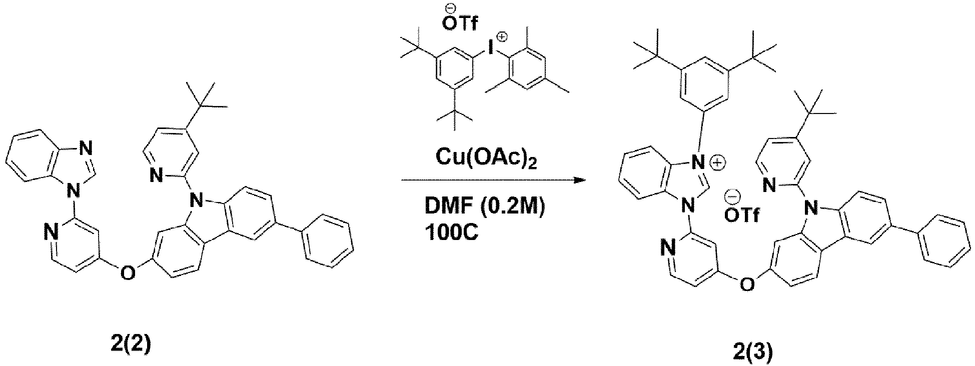

Intermediate 2(3) was synthesized in a similar manner as in Synthesis of Intermediate 1(3) in Synthesis Example 1, except that Intermediate 2(2) was used instead of Intermediate 1(2) (yield: 82%). The product was identified by HPLC-MS.

HPLC-MS: m/z=774.43 [M-OTf]+.

### (4) Synthesis of Compound 2

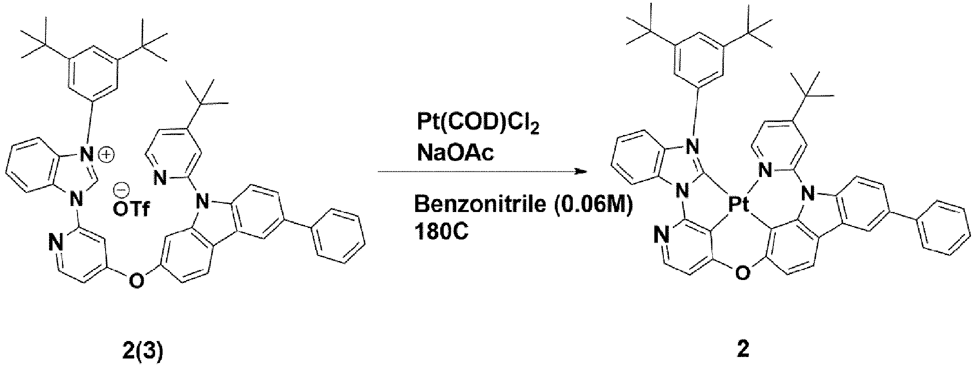

Compound 2 was synthesized in a similar manner as in Synthesis of Compound 1 in Synthesis Example 1, except that Intermediate 2(3) was used instead of Intermediate 1(3) (yield: 20%). The product was identified by HPLC-MS.

HPLC-MS: m/z=967.15 [M+H]+.

### Synthesis Example 3: Synthesis of Compound 3

### (1) Synthesis of Intermediate 3(1)

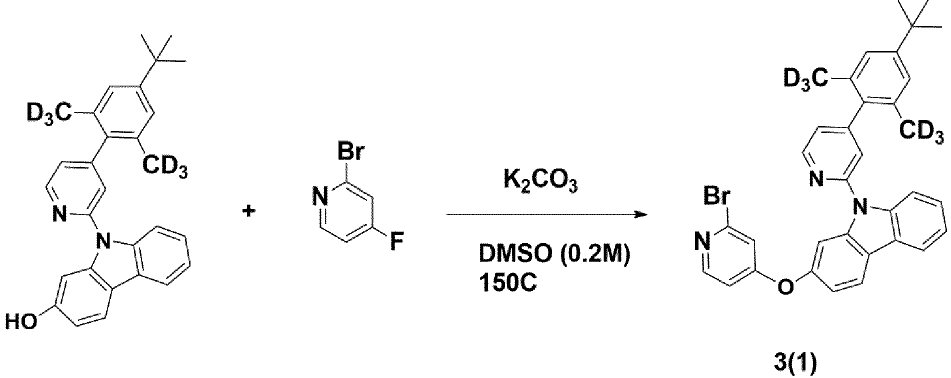

After 23.4 mmol (10.0 g) of 2-((2-bromopyridin-4-yl)oxy)-9-(4-(4-(tert-butyl)-2,6-bis(methyl-d3)phenyl)pyridin-2-yl)-9H-carbazole and 28.1 mmol (4.9 g) of 2-bromo-4-fluoropyridine were dissolved in 120 mL of DMSO, 46.9 mmol (6.5 g) of K₂CO₃ was added thereto, followed by heating at reflux at 150°C for 12 hours. After completion of the reaction, the resultant mixture was allowed to cool to room temperature, and an organic layer was extracted therefrom using a mixture of ethyl acetate and water. The organic layer was washed three times with water and dried using anhydrous magnesium sulfate. Then, a solvent was removed therefrom under a reduced pressure to obtain a crude product. The crude product was purified by silica gel column chromatography (eluents: ethyl acetate:hexane) to obtain Intermediate 3(1) (yield: 94%). The product was identified by HPLC-MS.

HPLC-MS: m/z=584.21 [M+H]+.

### (2) Synthesis of Intermediate 3(2)

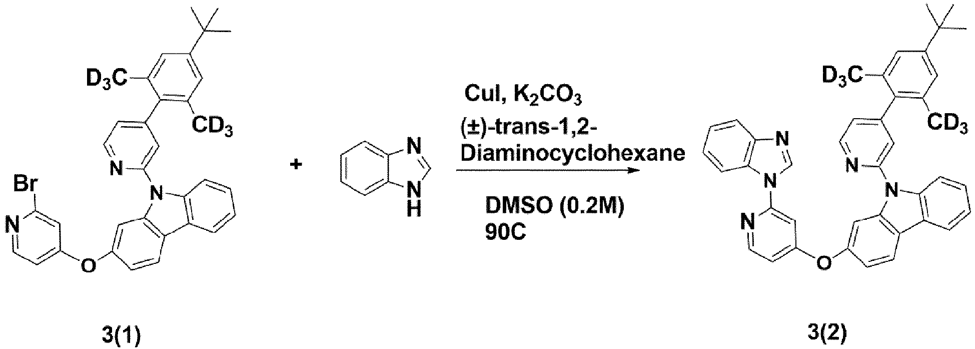

Intermediate 3(2) was synthesized in a similar manner as in Synthesis of Intermediate 1(2) in Synthesis Example 1, except that Intermediate 3(1) was used instead of Intermediate 1(1) (yield: 78%). The product was identified by HPLC-MS.

HPLC-MS: m/z=620.33 [M+H]+.

### (3) Synthesis of Intermediate 3(3)

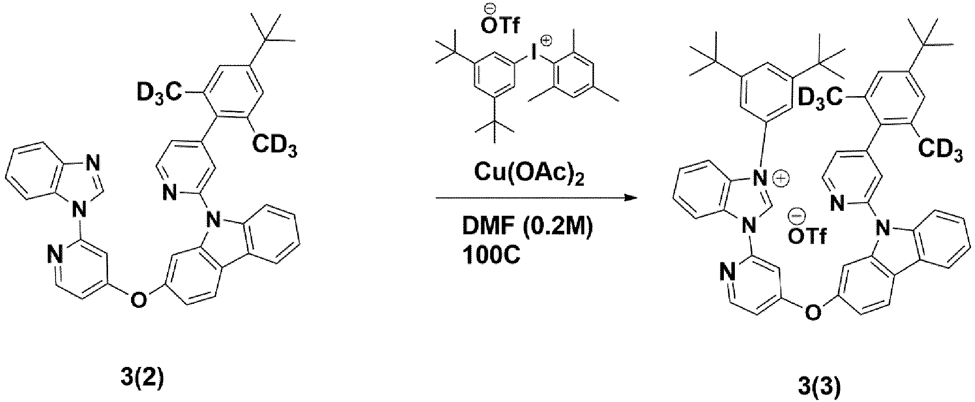

Intermediate 3(3) was synthesized in a similar manner as in Synthesis of Intermediate 1(3) in Synthesis Example 1, except that Intermediate 3(2) was used instead of Intermediate 1(2) (yield: 79%). The product was identified by HPLC-MS.

HPLC-MS: m/z=808.48 [M-OTf]+.

### (4) Synthesis of Compound 3

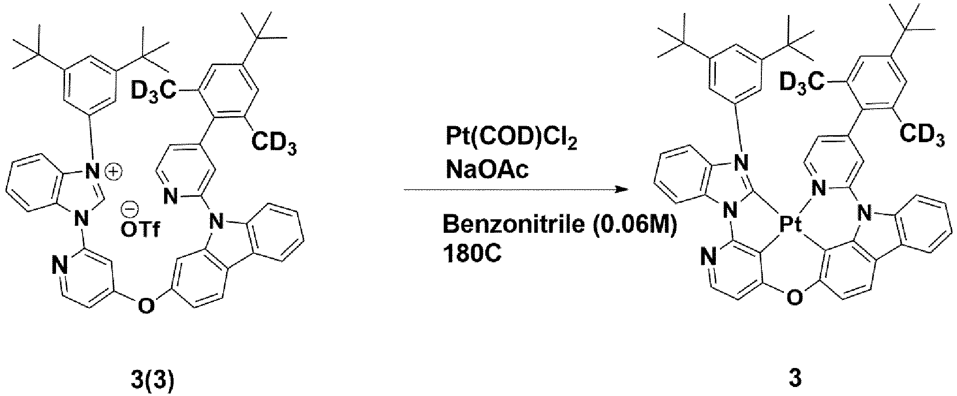

Compound 3 was synthesized in a similar manner as in Synthesis of Compound 1 in Synthesis Example 1, except that Intermediate 3(3) was used instead of Intermediate 1(3) (yield: 25%). The product was identified by HPLC-MS.

HPLC-MS: m/z=1001.44 [M+H]+.

### Synthesis Example 4: Synthesis of Compound 4

### (1) Synthesis of Intermediate 4(2)

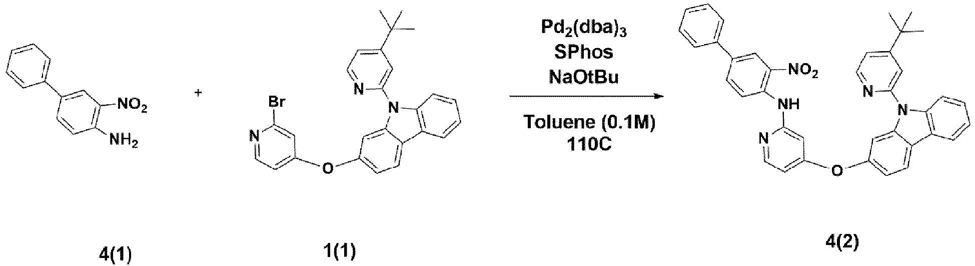

After 25.4 mmol (5.4 g) of 3-nitro-[1,1'-biphenyl]-4-amine (4(1)) and 21.2 mmol (10.0 g) of 2-((2-bromopyridin-4-yl)oxy)-9-(4-(tert-butyl)pyridin-2-yl)-9H-carbazole (1(1)) were dissolved in 210 mL of toluene, 4.2 mmol (3.9 g) of tris(dibenzylideneacetone)dipalladium(0) (Pd₂(dba)₃), 8.5 mmol (3.5 g) of 2-dicyclohexylphosphino-2',6'-dimethoxybiphenyl (SPhos), and 31.8 mmol (3.1 g) of sodium tert-butoxide (NaOtBu) were added thereto, followed by heating at reflux at 110°C for 6 hours. After completion of the reaction, the mixture was allowed to cool to room temperature, and an organic layer was extracted therefrom using ethyl acetate and water. The organic layer was washed three times with water and dried using anhydrous magnesium sulfate, and then, a solvent was removed therefrom under a reduced pressure, thereby obtaining a crude product. The crude product was purified by silica gel column chromatography (eluents: ethyl acetate:hexane) to obtain Intermediate 4(2) (yield: 64%). The product was identified by HPLC-MS.

HPLC-MS: m/z=606.25 [M+H]+.

### (2) Synthesis of Intermediate 4(3)

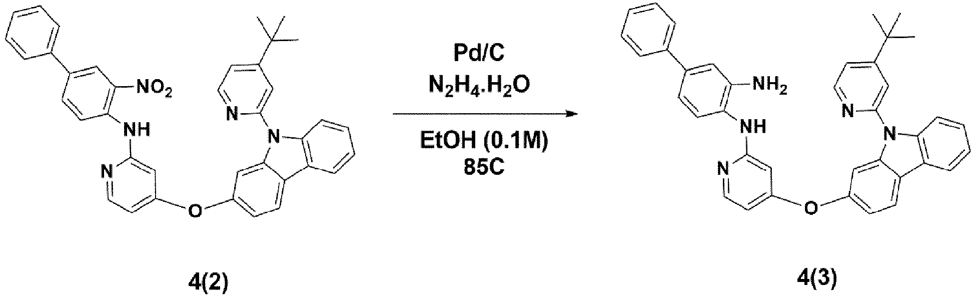

After 13.5 mmol (8.2 g) of Intermediate 4(2) and 13.5 mmol (1.4 g) of palladium on carbon (Pd/C) were dissolved in 130 mL of ethanol, 270 mmol (13.5 g) of hydrazine monohydrate (N₂H₄ H₂O, also referred to as H₂NNH₂ H₂O) was added thereto, followed by heating at reflux at 85°C for 4 hours. After completion of the reaction, the mixture was allowed to cool to room temperature, filtered using celite, and an organic layer was extracted therefrom using ethyl acetate and water. The organic layer was washed three times with water and dried using anhydrous magnesium sulfate, and then, a solvent was removed therefrom under a reduced pressure, thereby obtaining a crude product. The crude product was purified by silica gel column chromatography (eluents: dichloromethane:methanol) to obtain Intermediate 4(3) (yield: 96%). The product was identified by HPLC-MS.

HPLC-MS: m/z=576.27 [M+H]+.

### (3) Synthesis of Intermediate 4(4)

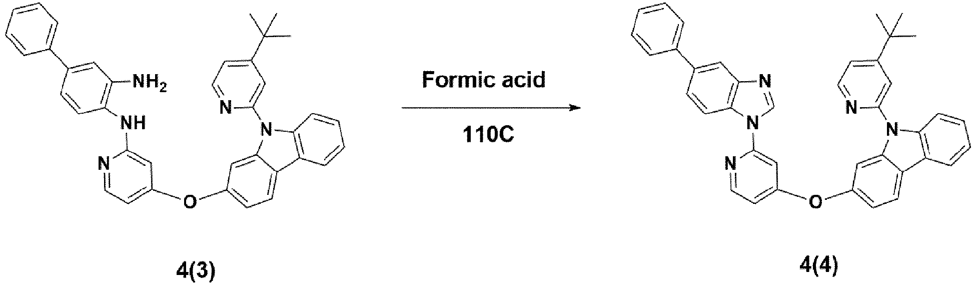

12.2 mmol (7.0 g) of Intermediate 4(3) was dissolved in 270 mmol (13.5 g) of formic acid, followed by heating at reflux at 110°C for 4 hours. After completion of the reaction, the mixture was allowed to cool to room temperature, neutralized using NaHCO₃, and an organic layer was extracted using therefrom using ethyl acetate and water. The organic layer was washed three times with water and dried using anhydrous magnesium sulfate, and then, a solvent was removed therefrom under a reduced pressure, thereby obtaining a crude product. The crude product was purified by silica gel column chromatography (eluents: dichloromethane:methanol) to obtain Intermediate 4(4) (yield: 75%). The product was identified by HPLC-MS.

HPLC-MS: m/z=586.07 [M+H]+.

### (4) Synthesis of Intermediate 4(5)

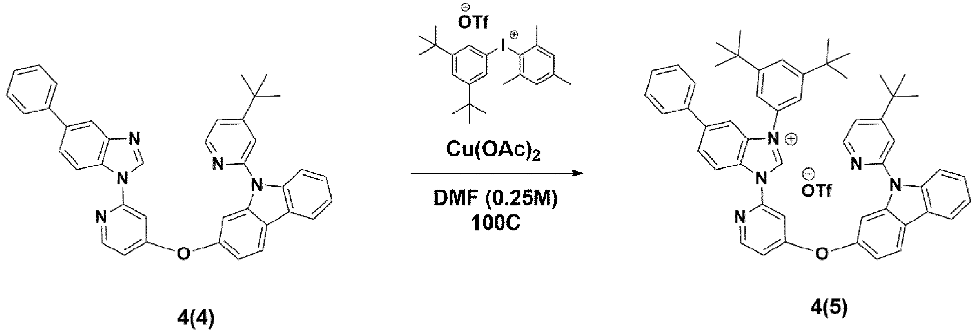

Intermediate 4(5) was synthesized in a similar manner as in Synthesis of Intermediate 1(3) in Synthesis Example 1, except that Intermediate 4(4) was used instead of Intermediate 1(2) (yield: 74%). The product was identified by HPLC-MS.

HPLC-MS: m/z=774.41 [M-OTf]+.

### (4) Synthesis of Compound 4

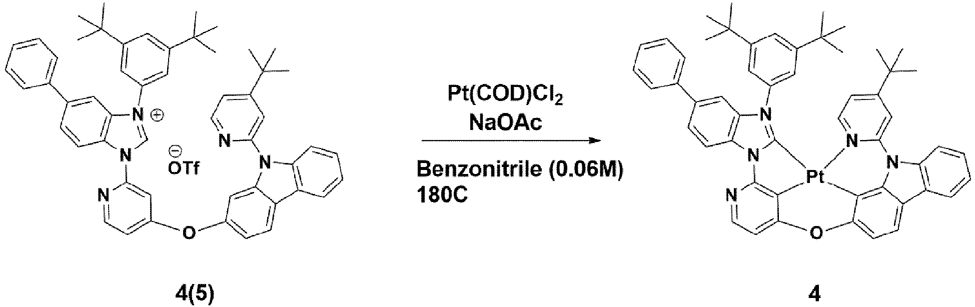

Compound 4 was synthesized in a similar manner as in Synthesis of Compound 1 in Synthesis Example 1, except that Intermediate 4(5) was used instead of Intermediate 1(3) (yield: 29%). The product was identified by HPLC-MS.

HPLC-MS: m/z=967.29 [M+H]+.

### Synthesis Example 5: Synthesis of Compound 5

### (1) Synthesis of Intermediate 5(1)

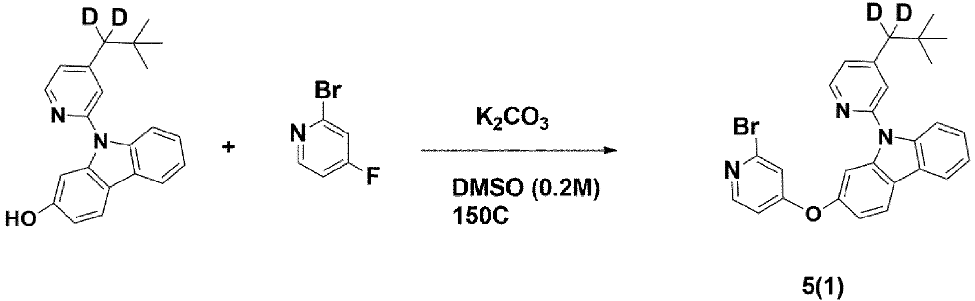

After 41.2 mmol (13.7 g) of 9-(4-(2,2-dimethylpropyl-1,1-d2)pyridin-2-yl)-9H-carbazol-2-ol and 49.5 mmol (8.7 g) of 2-bromo-4-fluoropyridine were dissolved in 205 mL of DMSO, 82.4 mmol (11.4 g) of K₂CO₃ was added thereto, followed by heating at reflux at 150°C for 12 hours. After completion of the reaction, the resultant mixture was allowed to cool to room temperature, and an organic layer was extracted therefrom using a mixture of ethyl acetate and water. The organic layer was washed three times with water and dried using anhydrous magnesium sulfate. Then, a solvent was removed therefrom under a reduced pressure to obtain a crude product. The crude product was subjected to purification by silica gel column chromatography (eluents: ethyl acetate:hexane) to obtain Intermediate 5(1) (yield: 99%). The product was identified by HPLC-MS.

HPLC-MS: m/z=490.13 [M+H]+.

### (2) Synthesis of Intermediate 5(2)

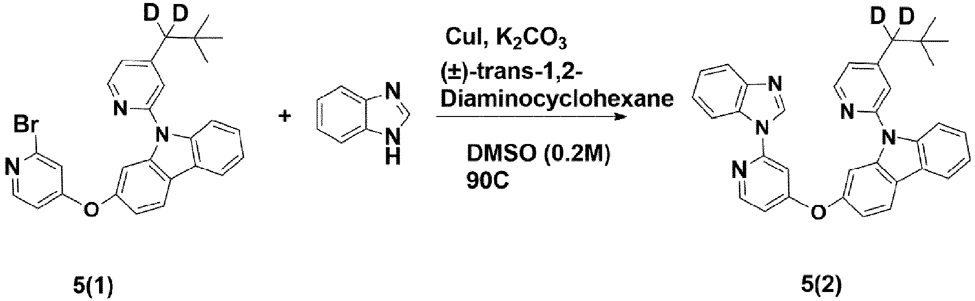

Intermediate 5(2) was synthesized in a similar manner as in Synthesis of Intermediate 1(2) in Synthesis Example 1, except that Intermediate 5(1) was used instead of Intermediate 1(1) (yield: 63%). The product was identified by HPLC-MS.

HPLC-MS: m/z=526.25 [M+H]+.

### (3) Synthesis of Intermediate 5(3)

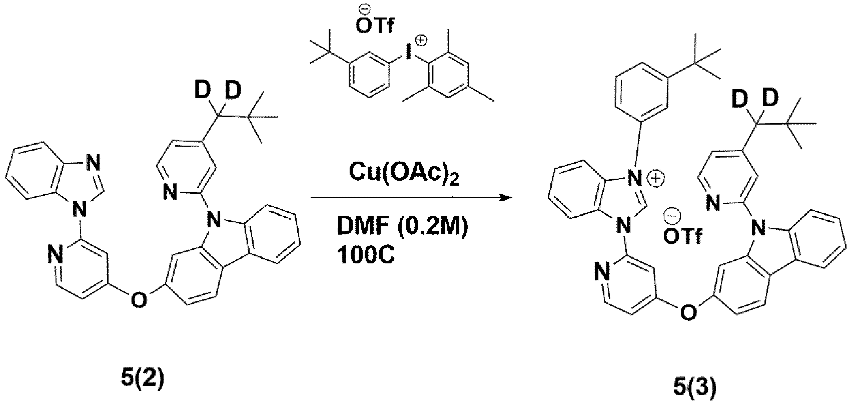

12.8 mmol (6.7 g) of Intermediate 5(2), 16.6 mmol (8.8 g) of (3-(tert-butyl)phenyl)(mesityl)iodonium triflate, and 1.2 mmol (0.2 g) of copper (II) acetate were added to 65 mL of DMF, followed heating at reflux at 100°C for 3 hours. After completion of the reaction, the mixture was allowed to cool to room temperature, and an organic layer was extracted therefrom using ethyl acetate and water. The organic layer was washed three times with water and dried using anhydrous magnesium sulfate, and then, a solvent was removed therefrom under a reduced pressure, thereby obtaining a crude product. The crude product was purified by silica gel column chromatography (eluents: dichloromethane:acetone) to obtain Intermediate 5(3) (yield: 84%). The product was identified by HPLC-MS.

HPLC-MS: m/z=659.36 [M-OTf]+.

### (4) Synthesis of Compound 5

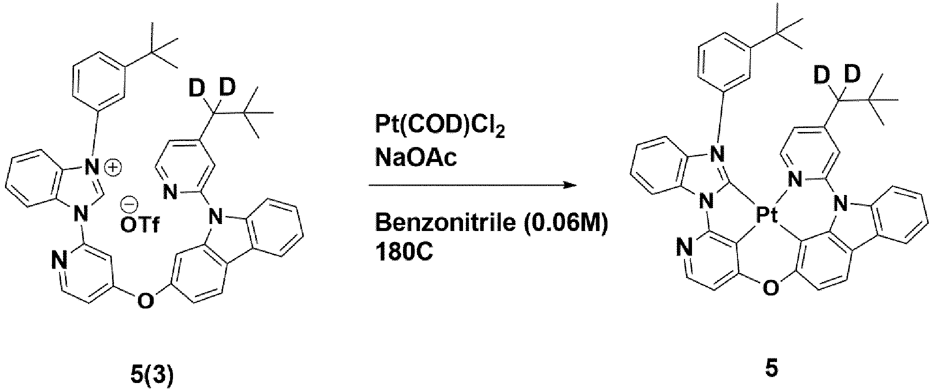

Compound 5 was synthesized in a similar manner as in Synthesis of Compound 1 in Synthesis Example 1, except that Intermediate 5(3) was used instead of Intermediate 1(3) (yield: 13%). The product was identified by HPLC-MS.

HPLC-MS: m/z=851.29 [M+H]+.

### Synthesis Example 6: Synthesis of Compound 6

### (1) Synthesis of Intermediate 6(1)

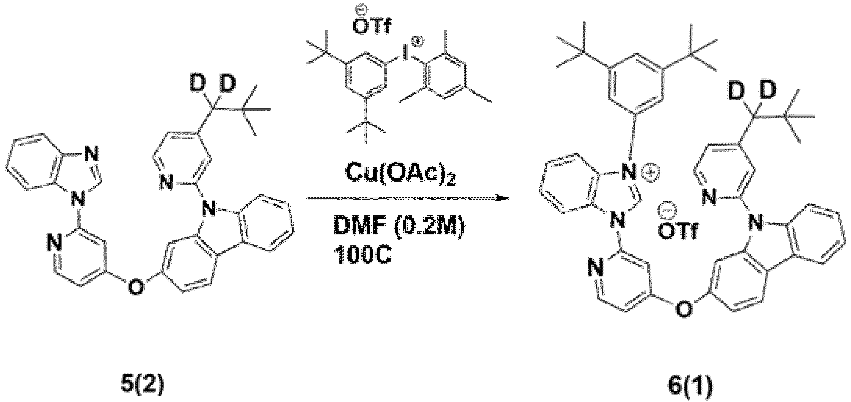

Intermediate 6(1) was synthesized in a similar manner as in Synthesis of Intermediate 1(3) in Synthesis Example 1, except that Intermediate 5(2) was used instead of Intermediate 1(2) (yield: 74%). The product was identified by HPLC-MS.

HPLC-MS: m/z=714.41 [M-OTf]+.

### (2) Synthesis of Compound 6

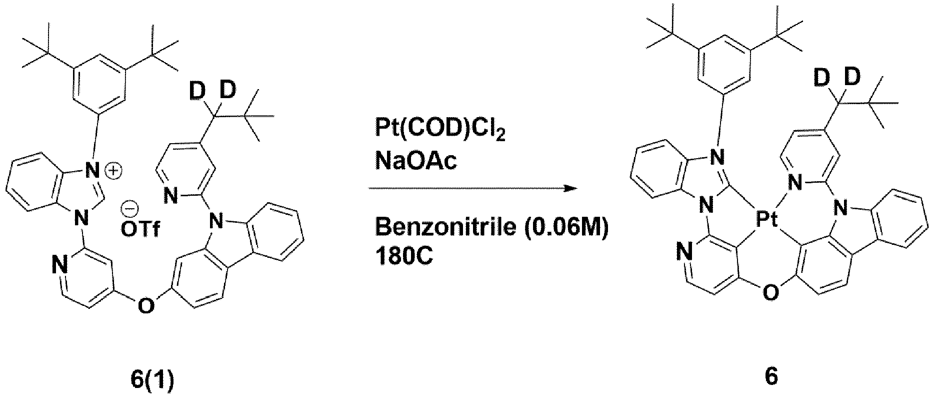

Compound 6 was synthesized in a similar manner as in Synthesis of Compound 1 in Synthesis Example 1, except that Intermediate 6(1) was used instead of Intermediate 1(3) (yield: 24%). The product was identified by HPLC-MS.

HPLC-MS: m/z=908.36 [M+H]+.

### Synthesis Example 7: Synthesis of Compound 7

### (1) Synthesis of Intermediate 7(1)

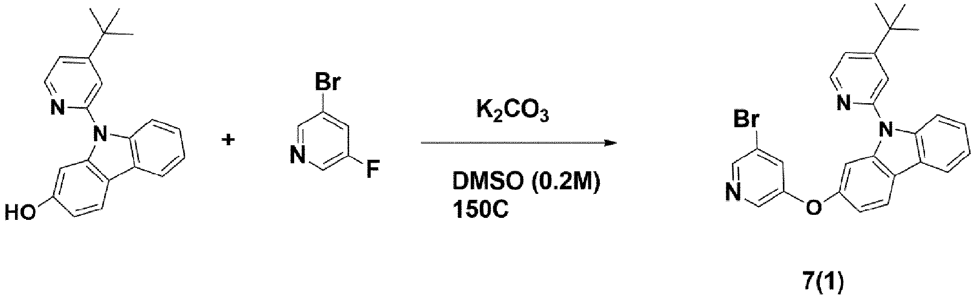

Compound 7(1) was synthesized in a similar manner as in Synthesis of Compound 1(1) in Synthesis Example 1, except that 3-bromo-5-fluoropyridine was used instead of 2-bromo-4-fluoropyridine (yield: 54%). The product was identified by HPLC-MS.

HPLC-MS: m/z=472.10 [M+H]+.

### (2) Synthesis of Intermediate 7(2)

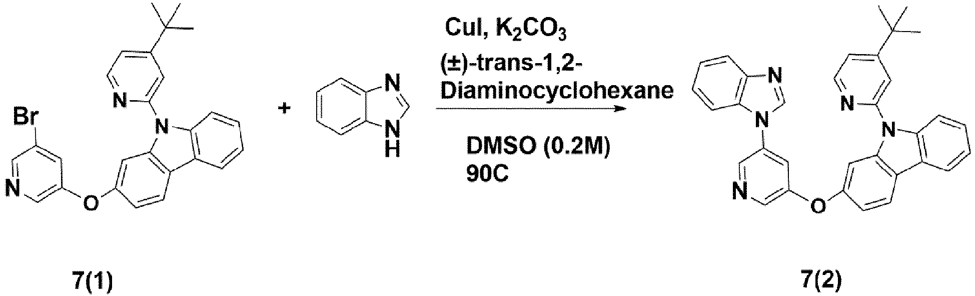

Compound 7(2) was synthesized in a similar manner as in Synthesis of Compound 1(2) in Synthesis Example 1, except that Intermediate 7(1) was used instead of Intermediate 1(1) (yield: 45%). The product was identified by HPLC-MS.

HPLC-MS: m/z=510.19 [M+H]+.

### (3) Synthesis of Intermediate 7(3)

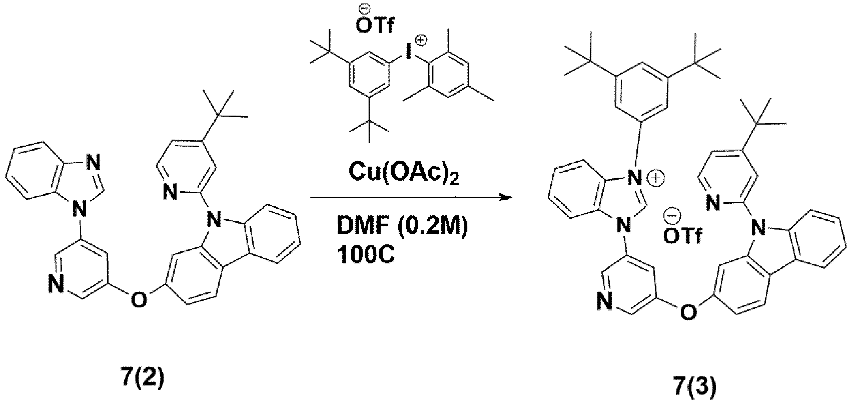

Compound 7(3) was synthesized in a similar manner as in Synthesis of Compound 1(3) in Synthesis Example 1, except that Intermediate 7(2) was used instead of Intermediate 1(2) (yield: 76%). The product was identified by HPLC-MS.

HPLC-MS: m/z=698.34 [M-OTf]+.

### (4) Synthesis of Compound 7

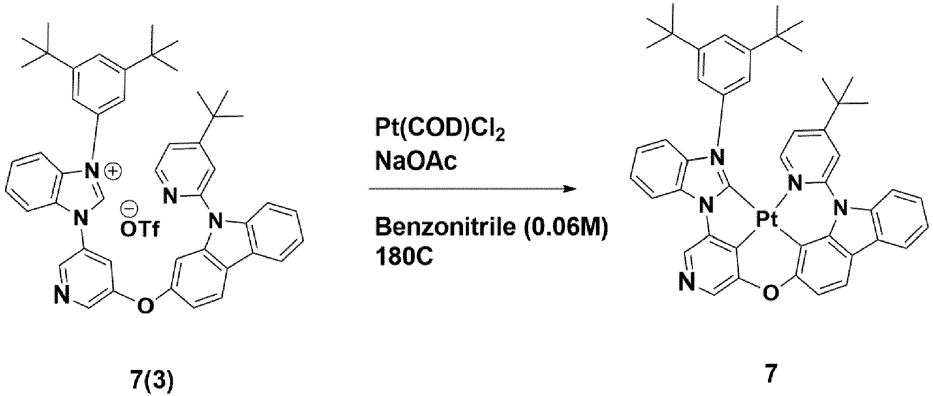

Compound 7 was synthesized in a similar manner as in Synthesis of Compound 1 in Synthesis Example 1, except that Intermediate 7(3) was used instead of Intermediate 1(3) (yield: 21%). The product was identified by HPLC-MS.

HPLC-MS: m/z=891.27 [M+H]+.

### Evaluation Example 1: Evaluation of Photoluminescence (PL) spectrum

Compounds 1 and 7 and Comparative Compound C1 were each diluted in toluene at a concentration of 10⁻⁴ molar (M). Then, the PL spectrum of each of the compounds was measured by using an ISC PC1 spectrofluorometer, in which a xenon lamp was mounted. The results thereof are shown in FIG. 2.

The maximum emission wavelength (λₘₐₓ, nm), the FWHM (nm), and the PLQY were obtained from the PL spectrum of each compound and shown in Table 3.

The HOMO and LUMO energy levels were measured by differential pulse voltammetry (DPV). The solvent used for the measurement was DMF, and tetrabutylammonium fluoride (TBAF) was used as an electrolyte. In addition, the reference electrode Ag/Ag+ was used, and the counter electrode Pt and the working electrode Pt were used. During the measurement, ferrocene (Fc) as used as a reference material, and the HOMO of Fc was known to be -4.8 eV. Therefore, the HOMO and LUMO energy levels of the compounds were calculated by applying the potential values measured by DPV to the data calculation method used to obtain results shown in Table 2 below.

**Table 2**

| | Measurement potential | Energy level (eV) |
|---|---|---|
| Ref. | α | -4.8 |
| HOMO | β | -4.8-(β) |
| LUMO | γ | -4.8-(γ) |

**Table 3**

| Compound | HOMO (eV) | LUMO (eV) | λₘₐₓ (nm) | FWHM (nm) | PLQY (PMMA) |
|---|---|---|---|---|---|
| Compound C1 | -5.30 | -2.09 | 460 | 20 | 0.712 |
| Compound 1 | -5.42 | -2.18 | 455 | 19 | 0.798 |
| Compound 2 | -5.42 | -2.12 | 456 | 18 | 0.799 |
| Compound 3 | -5.44 | -2.21 | 456 | 19 | 0.728 |
| Compound 4 | -5.44 | -2.28 | 458 | 20 | 0.730 |
| Compound 5 | -5.42 | -2.21 | 455 | 18 | 0.722 |
| Compound 6 | -5.43 | -2.23 | 455 | 20 | 0.714 |
| Compound 7 | -5.42 | -2.2 | 455 | 18 | 0.774 |

From Table 3, it was confirmed that Compounds 1 to 7 have a deeper HOMO energy level, emit a blue light having higher energy, have an equal or less FWHM, and have a higher PLQY, as compared to Comparative Example Compound C1.

### Example 1-1: Phosphorescent dopant bottom device

A glass substrate having 500 Å of indium tin oxide (ITO) electrode (first electrode, anode) deposited thereon was washed with DI water in the presence of ultrasonic waves. After the DI water ultrasonication, ultrasonic cleaning was performed with isopropyl alcohol, acetone, and then, methanol, in this stated order, and the glass substrate was dried and transferred to a plasma cleaner. The glass substrate was cleaned by using oxygen plasma for 5 minutes, and then transferred to a vacuum laminator.

Compound HT3 was vacuum-deposited on the ITO electrode of the glass substrate to form a first hole injection layer having a thickness of 3,500 Å, Compound HT-D1 was vacuum-deposited on the first hole injection layer to form a second hole injection layer having a thickness of 300 Å, and then, TAPC was vacuum-deposited on the second hole injection layer to form an electron blocking layer having a thickness of 100 Å, thereby completing the manufacture of a hole transport region.

Compound H52 and Compound 1 (10 wt%) were co-deposited on the hole transport region to form an emission layer having a thickness of 300 Å.

Compound ET3 was vacuum-deposited on the emission layer to form an electron transport layer having a thickness of 250 Å, and then, **ET-D1** (Liq) was deposited on the electron transport layer to form an electron injection layer having a thickness of 5 Å, and then, an Al second electrode (cathode) having a thickness of 1,000 Å was formed on the electron injection layer, thereby completing the manufacture of an organic light-emitting device.

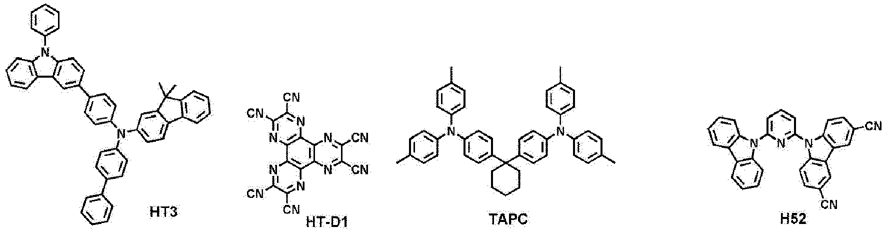

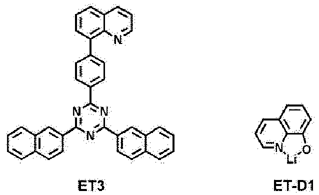

### Examples 1-2 to 1-6 and Comparative Examples 1-1 and 1-2

Organic light-emitting devices were manufactured in a similar manner as in Example 1-1, except that the dopant compounds shown in Table 4 were each used instead of Compound 1 in forming an emission layer.

### Example 2-1: Phosphorescent dopant top device

A glass substrate, having 500 Å of indium tin oxide (ITO) electrode (first electrode, anode) deposited thereon, was washed with DI water in the presence of ultrasonic waves. After the DI water ultrasonication, ultrasonic cleaning was performed with isopropyl alcohol, acetone, and then, methanol, in this stated order, and the glass substrate was dried and transferred to a plasma cleaner. The glass substrate was cleaned by using oxygen plasma for 5 minutes, and then transferred to a vacuum laminator.

Compound HT3 was vacuum-deposited on the ITO electrode of the glass substrate to form a first hole injection layer having a thickness of 3,500 Å, Compound HT-D1 was vacuum-deposited on the first hole injection layer to form a second hole injection layer having a thickness of 300 Å, and then, TAPC was vacuum-deposited on the second hole injection layer to form an electron blocking layer having a thickness of 100 Å, thereby completing the manufacture of a hole transport region.

Compound H52 and Compound 1 (10 wt%) were co-deposited on the hole transport region to form an emission layer having a thickness of 300 Å.

Compound ET3 was vacuum-deposited on the emission layer to form an electron transport layer having a thickness of 250 Å, and then, ET-D1 (Liq) was vacuum deposited on the electron transport layer to form an electron injection layer having a thickness of 5 Å, and then, an Al second electrode (cathode) having a thickness of 1,000 Å was formed on the electron injection layer, thereby completing the manufacture of an organic light-emitting device.

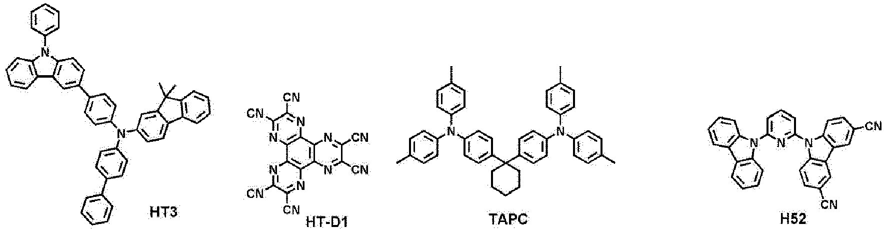

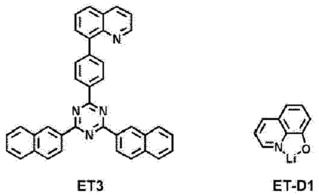

### Examples 2-2 to 2-5 and Comparative Examples 2-1 and 2-2

Organic light-emitting devices were manufactured in a similar manner as in Example 2-1, except that the dopant compounds shown in Table 5 were each used instead of Compound 1 in forming an emission layer.

### Example 3-1: Hyper OLED bottom device

A glass substrate having 500 Å of an indium tin oxide (ITO) electrode (first electrode, anode) deposited thereon was washed with DI water in the presence of ultrasonic waves. After the DI water ultrasonication, ultrasonic cleaning was performed with isopropyl alcohol, acetone, and then, methanol, in this stated order, and the glass substrate was dried and transferred to a plasma cleaner. The glass substrate was cleaned by using oxygen plasma for 5 minutes, and then transferred to a vacuum laminator.

Compound HT3 was vacuum-deposited on the ITO electrode of the glass substrate to form a first hole injection layer having a thickness of 3,500 Å, Compound HT-D1 was vacuum-deposited on the first hole injection layer to form a second hole injection layer having a thickness of 300 Å, and then, TAPC was vacuum-deposited on the second hole injection layer to form an electron blocking layer having a thickness of 100 Å, thereby completing the manufacture of a hole transport region.

Compound H52 and Compound 1 (10 wt%) were co-deposited on the hole transport region to form an emission layer having a thickness of 300 Å.

Compound ET3 was vacuum-deposited on the emission layer to form an electron transport layer having a thickness of 250 Å, and then, ET-D1 (Liq) was deposited on the electron transport layer to form an electron injection layer having a thickness of 5 Å, and then, an Al second electrode (cathode) having a thickness of 1,000 Å was formed on the electron injection layer, thereby completing the manufacture of an organic light-emitting device.

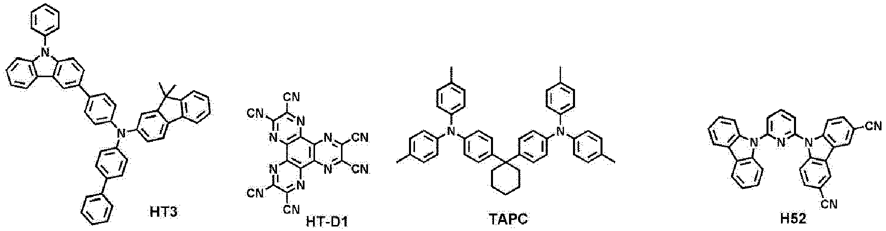

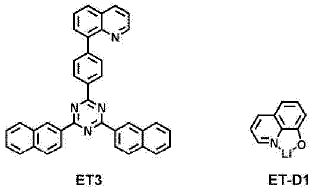

### Examples 3-2 to 3-5 and Comparative Examples 3-1 and 3-2

Organic light-emitting devices were manufactured in a similar manner as in Example 3-1, except that the dopant compounds shown in Table 6 were each used instead of Compound 1 in forming an emission layer.

### Evaluation of Example 2: Evaluation of Properties of Organic Light-Emitting Devices

The EL spectrum of each of the organic light-emitting devices manufactured in Examples 1-1 to 1-6 and Comparative Examples 1-1 and 1-2, Examples 2-1 to 2-5 and Comparative Examples 2-1 and 2-2, and Examples 3-1 to 3-6 and Comparative Examples 3-1 and 3-2 was measured, and from the EL spectrum of each device, various properties were measured. The results thereof are shown in Tables 4, 5, and 6. In Table 4, the driving voltage (Volts, V), maximum emission wavelength (λₘₐₓ, nm), CIE y color coordinate (CIEy), and external quantum luminescence efficiency (EQE, relative %) were evaluated for Comparative Examples 1-1 and 1-2, and Examples 1-1 to 1-6. In Table 5, the driving voltage (V), CIE y color coordinate (CIEy), conversion efficiency (cd/A/y, relative value, %), and the lifespan (T₉₅, relative %) were evaluated for Comparative Examples 2-1 and 2-2, and Examples 2-1 to 2-5. In Table 6, the driving voltage (V), CIE y color coordinate (CIEy), photoluminescence quantum yield (PLQY), and external quantum luminescence efficiency (EQE, relative %) were evaluated for Comparative Examples 3-1 and 3-2, and Examples 3-1 to 3-6. The EL spectra of the manufactured organic light-emitting devices at a luminance of 1,000 candela per square meter (cd/m²) were measured by using a luminance meter (Minolta Cs-1000A). Then, the maximum emission wavelength was evaluated. The driving voltage and the external quantum luminescence efficiency were evaluated by using a current-voltage meter (Keithley 2400) and a luminance meter (Minolta Cs-1000A), and the lifespan was evaluated based on the time taken for the luminance to decrease to 95% of the initial luminance. In addition, the conversion efficiency (cd/A/y) was obtained by dividing the EQE by the CIEy value.

**Table 4**

| | Dopant | Driving voltage (V) | λₘₐₓ (nm) | CIEy | EQE (relative value, %) |
|---|---|---|---|---|---|
| Comparative Example 1-1 | Compound C1 | 4.35 | 462 | 0.182 | 100 |
| Comparative Example 1-2 | Compound C3 | 3.91 | 459 | 0.133 | 107 |
| Example 1-1 | Compound 1 | 3.82 | 459 | 0.140 | 107 |
| Example 1-2 | Compound 2 | 3.72 | 459 | 0.134 | 122 |
| Example 1-3 | Compound 3 | 3.67 | 460 | 0.126 | 125 |
| Example 1-4 | Compound 4 | 3.74 | 461 | 0.153 | 117 |
| Example 1-5 | Compound 5 | 3.80 | 460 | 0.149 | 110 |
| Example 1-6 | Compound 6 | 3.67 | 459 | 0.138 | 120 |

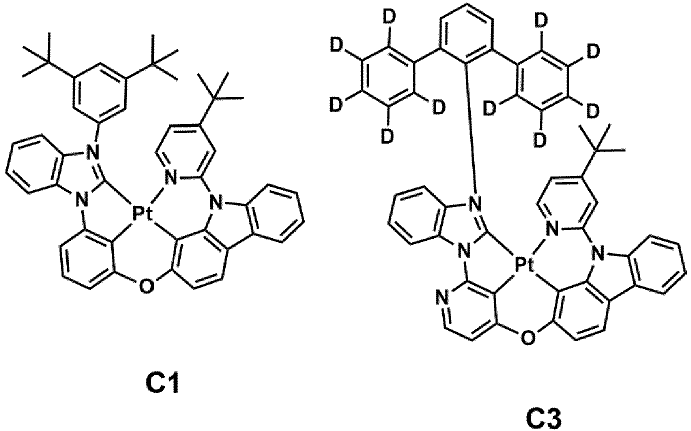

From Table 4, it was confirmed that the organic light-emitting devices of Examples 1-1 to 1-6 have lower driving voltages and higher external quantum luminescence efficiencies, compared to the organic light-emitting devices of Comparative Examples 1-1 and 1-2.

**Table 5**

| | Dopant | Driving voltage (V) | ClEy | Conversion efficiency (cd/A/y) (relative value, %) | T₉₅ (relative value, %) |
|---|---|---|---|---|---|
| Comparative Example 2-1 | Compound C1 | 4.76 | 0.055 | 100 | 100 |
| Comparative Example 2-2 | Compound C3 | 4.11 | 0.050 | 104 | 99 |
| Example 2-1 | Compound 1 | 3.99 | 0.051 | 112 | 108 |
| Example 2-2 | Compound 2 | 3.94 | 0.053 | 126 | 117 |
| Example 2-3 | Compound 3 | 3.89 | 0.056 | 128 | 105 |
| Example 2-4 | Compound 5 | 4.08 | 0.054 | 115 | 139 |
| Example 2-5 | Compound 6 | 3.90 | 0.050 | 118 | 119 |

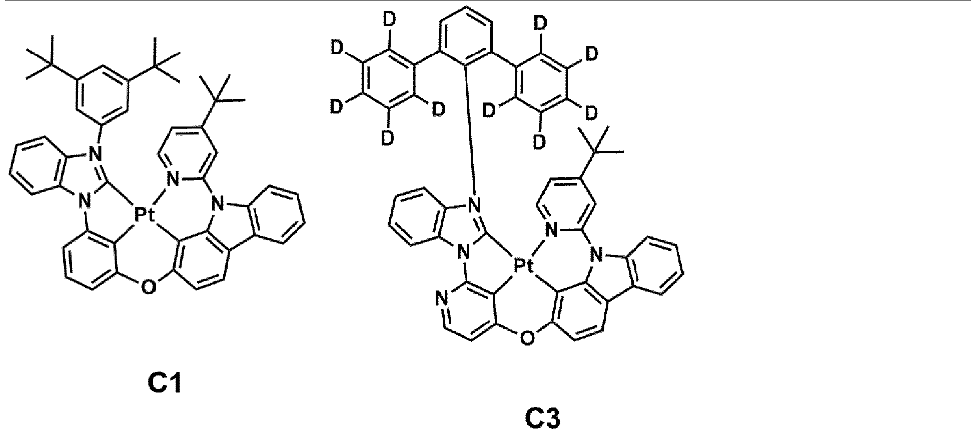

From Table 5, it was confirmed that the organic light-emitting devices of Examples 2-1 to 2-5 have lower driving voltages, higher conversion efficiencies, and longer lifespans, compared to the organic light-emitting devices of Comparative Examples 2-1 and 2-2.

**Table 6**

| | Dopant | Driving voltage (V) | ClEy | PLOY (in host) | EQE (relative value, %) |
|---|---|---|---|---|---|
| Comparative Example 3-1 | Compound C1 | 4.42 | 0.141 | 0.729 | 100 |
| Comparative Example 3-2 | Compound C3 | 4.08 | 0.096 | 0.740 | 105 |
| Example 3-1 | Compound 1 | 3.88 | 0.096 | 0.783 | 109 |
| Example 3-2 | Compound 2 | 3.90 | 0.094 | 0.766 | 111 |
| Example 3-3 | Compound 3 | 3.89 | 0.092 | 0.818 | 111 |
| Example 3-4 | Compound 4 | 3.94 | 0.106 | 0.823 | 115 |
| Example 3-5 | Compound 5 | 3.94 | 0.101 | 0.760 | 104 |
| Example 3-6 | Compound 6 | 3.86 | 0.098 | 0.819 | 106 |

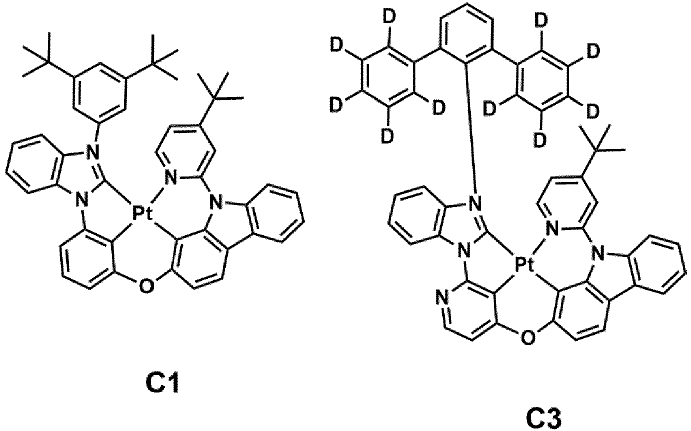

From Table 6, it was confirmed that the organic light-emitting devices of Examples 3-1 to 6-6 have lower driving voltages, higher PLQYs, and higher external quantum luminescence efficiencies, compared to the organic light-emitting devices of Comparative Examples 3-1 and 3-2.

By using at least one of the organometallic compounds represented by Formula 1 in an emission layer, an organic light-emitting device having excellent luminescence efficiency characteristics, and an electronic apparatus including the same may be provided.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

1. An organometallic compound represented by Formula 1: 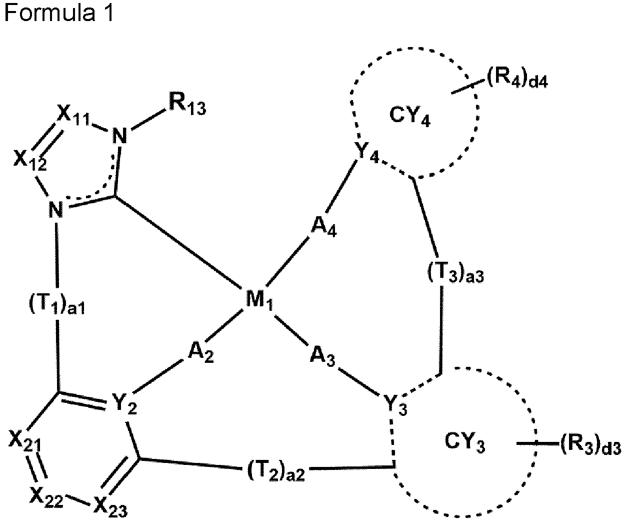 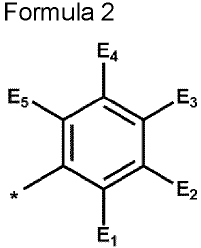 wherein, in Formulae 1 and 2,
M₁ is a transition metal,
X₁₁ is N or C(R₁₁),
X₁₂ is N or C(R₁₂),
X₂₁ is N or C(R₂₁),
X₂₂ is N or C(R₂₂),
X₂₃ is N or C(R₂₃),
at least one of X₂₁ and X₂₂ is N,
Y₂ to Y₄ are each independently C or N,
A₂ to A₄ are each independently a chemical bond, O, or S,
ring CY₃ and ring CY₄ are each independently a C₅-C₃₀ carbocyclic group or a C₁-C₃₀ heterocyclic group,
T₁ is a single bond, a double bond, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C≡C-*',
T₂ is a single bond, a double bond, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*', or *-C≡C-*',
T₃ is a single bond, a double bond, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*', **or** *-C≡C-*',
* and *' each indicate a binding site to a neighboring atom,
a1 is an integer from 1 to 3, and when a1 is 2 or greater, two or more of T₁ are identical to or different from each other,
a2 is an integer from 1 to 3, and when a2 is 2 or greater, two or more of T₂ are identical to or different from each other,
a3 is an integer from 1 to 3, and when a3 is 2 or greater, two or more of T₃ are identical to or different from each other,
L₁ to L₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b1 to b3 are each independently an integer from 1 to 3,
R₁₃ is a group represented by Formula 2,
R₁ₐ, R_{1b}, R₂ₐ, R_{2b}, R₃ₐ, R_{3b}, R₃, R₄, R₁₁, R₁₂, R₂₁ **to** R₂₃, and E₁ to Es are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), -B(Q₆)(Q₇), -P(Q₈)(Q₉), or -P(=O)(Q₈)(Q₉),
neighboring two or more of R₁ₐ, R_{1b}, R₂ₐ, R_{2b}, R₃ₐ, R_{3b}, R₁₁, R₁₂, R₂₁ to R₂₃, and E₁ to E₅ are optionally bonded to each other to form a substituted or unsubstituted C₅-C₃₀ carbocyclic group or a substituted or unsubstituted C₁-C₃₀ heterocyclic group,
at least one of E₂ and E₄ is not hydrogen,
R₁₀ₐ is as described in connection with R₃,
d3 and d4 are each independently an integer from 0 to 20,
when d3 is 2 or greater, two or more of R₃ are identical to or different from each other, and when d4 is 2 or greater, two or more of R₄ are identical to or different from each other,
* in Formula 2 indicates a binding site to a neighboring atom,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, - Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), - B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), - P(Q₂₈)(Q₂₉), -P(=O)(Q₂₈)(Q₂₉), or a combination thereof; or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉), or - P(=O)(Q₃₈)(Q₃₉), and
Q₁ to Q₉, Q₁₁ to Q₁₉, Q₂₁ to Q₂₉, and Q₃₁ to Q₃₉ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein M₁ is iridium, platinum, osmium, titanium, zirconium, hafnium, europium, terbium, thulium, rhodium, palladium, or gold.

3. The organometallic compound of claims 1 or 2, wherein Formula 1 satisfies one of Conditions 1-1 to 1-3:
Condition 1-1
X₂₁ is N, and X₂₂ is C(R₂₂);
Condition 1-2
X₂₁ is C(R₂₁), and X₂₂ is N;
Condition 1-3
X₂₁ is N, and X₂₂ is N; and/or
wherein Formula 2 satisfies at least one of Conditions 2-1 and 2-2:
Condition 2-1
E₂ is not hydrogen;
Condition 2-2
E₂ and E₄ are not hydrogen.

4. The organometallic compound of any of claims 1-3, wherein ring CY₃ and ring CY₄ are each independently a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzotriazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group; and/or
wherein at least one of Y₂ to Y₄ is N.

5. The organometallic compound of any of claims 1-4, wherein at least one of E₂ and E₄ is:
deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₂-C₂₀ alkenyl group, a C₂-C₂₀ alkynyl group, a C₁-C₂₀ alkoxy group, or a C₁-C₂₀ alkylthio group;
a C₁-C₂₀ alkyl group, a C₂-C₂₀ alkenyl group, a C₂-C₂₀ alkynyl group, a C₁-C₂₀ alkoxy group, or a C₁-C₂₀ alkylthio group, each substituted with at least one of deuterium, -F, -CI, - Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, - SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si(Q₃₁)(Q₃₂)(Q₃₃), -Ge(Q₃₁)(Q₃₂)(Q₃₃), -N(Q₃₄)(Q₃₆), -B(Q₃₆)(Q₃₇), -P(Q₃₈)(Q₃₉), -P(=O)(Q₃₉)(Q₃₉), or a combination thereof; or
-Si(Q₁)(Q₂)(Q₃), -Ge(Q₁)(Q₂)(Q₃), -N(Q₄)(Q₅), -B(Q₆)(Q₇), -P(Q₈)(Q₉), or - P(=O)(Q₈)(Q₉), and
Q₁ to Q₉ and Q₃₁ to Q₃₉ are each independently:
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

6. The organometallic compound of any of claims 1-5, wherein at least one of E₂ and E₄ is:
deuterium, -F, -Cl, -Br, -I, -SFs, -CD₃, -CD₂H, -CDH₂, -CF₃, -CF₂H, -CFH₂, a cyano group, a C₁-C₂₀ alkyl group, a C₂-C₂₀ alkenyl group, a C₂-C₂₀ alkynyl group, a C₁-C₂₀ alkoxy group, or a C₁-C₂₀ alkylthio group;
a group represented by one of Formulae 9-1 to 9-61, 9-201 to 9-237, 10-1 to 10-129, or 10-201 to 10-355;
a group represented by one of Formulae 9-1 to 9-61, 9-201 to 9-237, 10-1 to 10-129, or 10-201 to 10-355, in which at least one hydrogen is substituted with at least one of deuterium, -F, or a cyano group; or
-Si(Q₁)(Q₂)(Q₃), -Ge(Q₁)(Q₂)(Q₃), or -N(Q₄)(Q₅),
wherein Q₁ to Q₅ are each as described in claim 1: 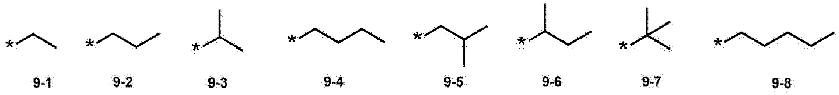 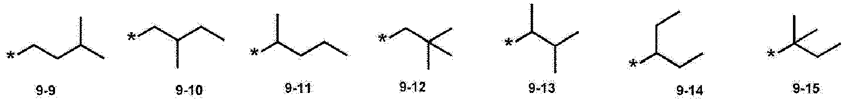 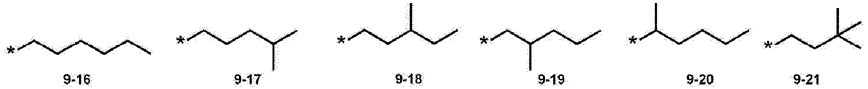 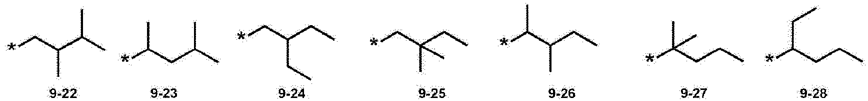 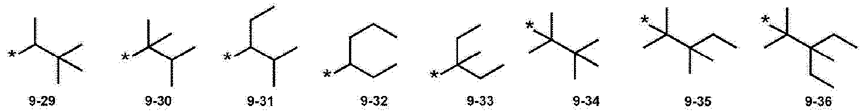 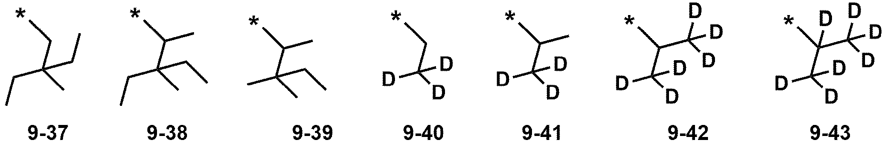 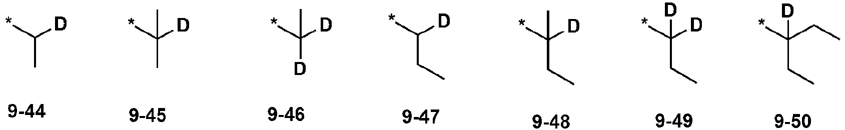 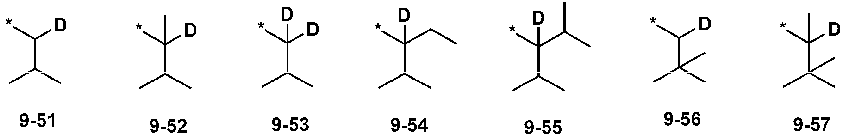 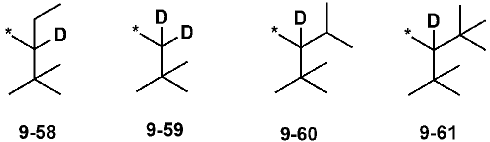 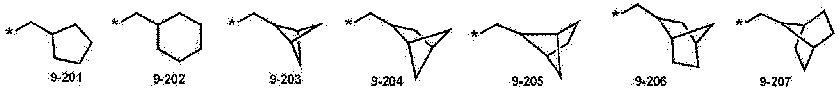 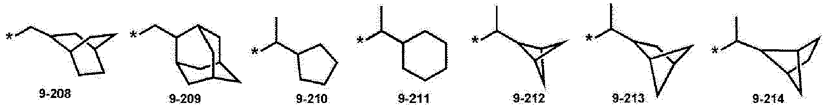 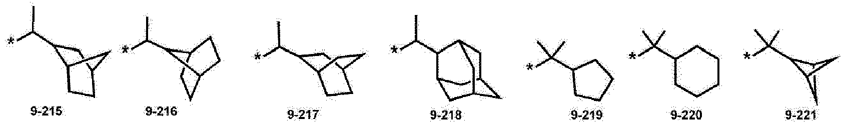 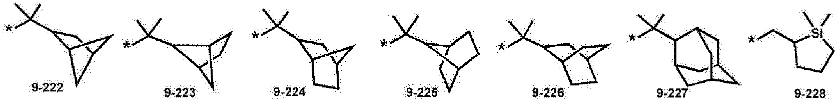 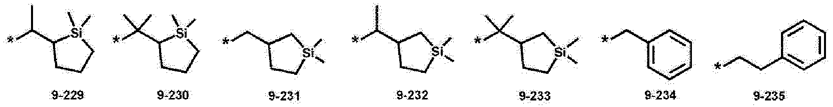 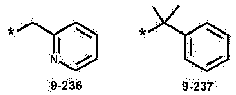 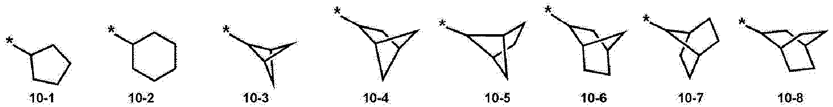 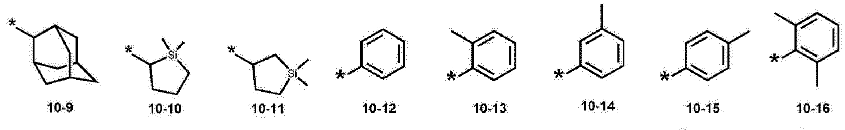 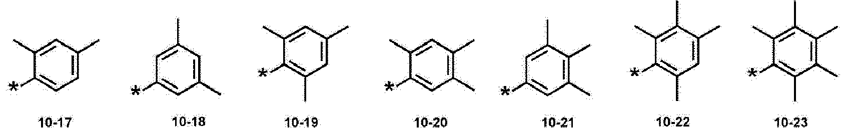 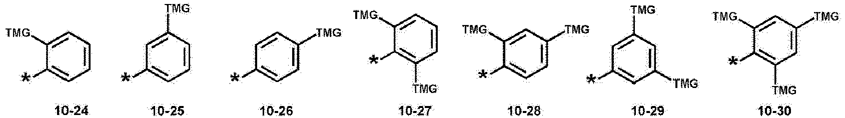 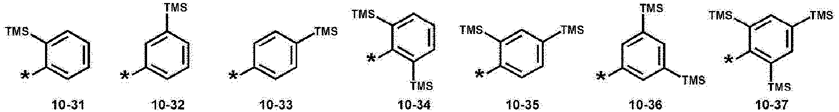 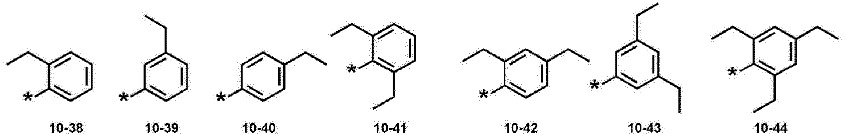 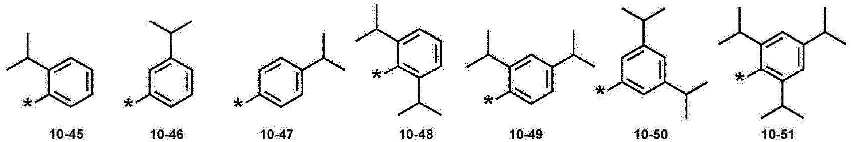 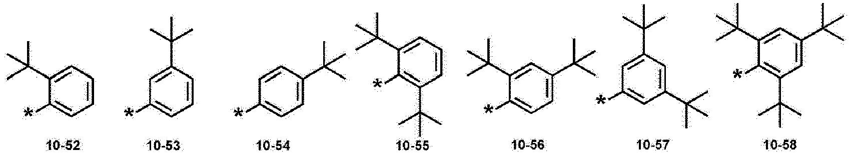 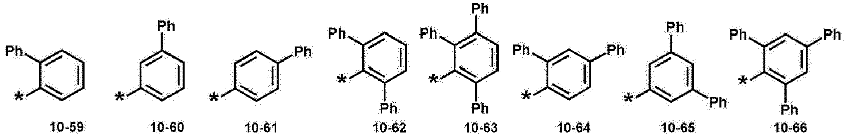 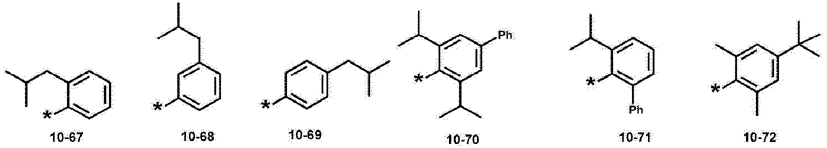 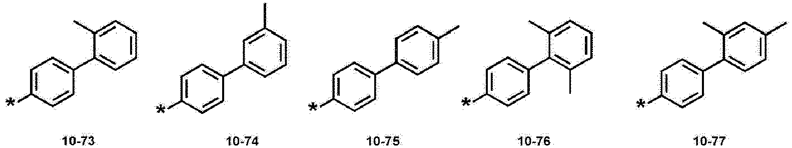 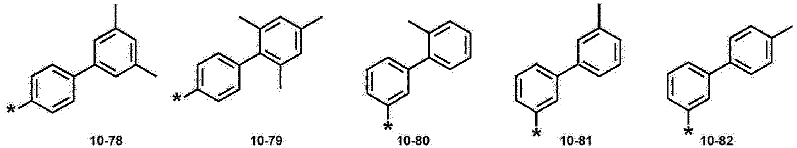 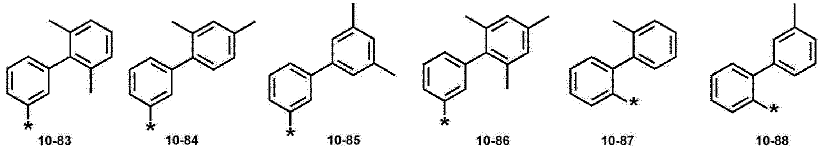 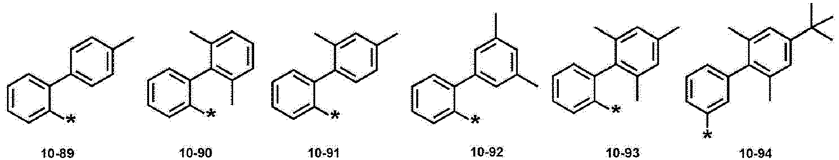 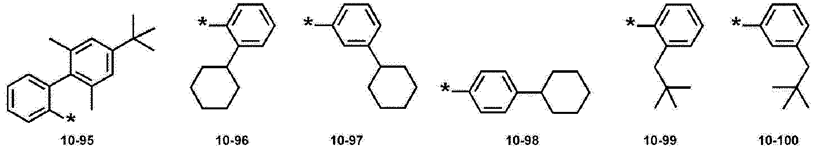 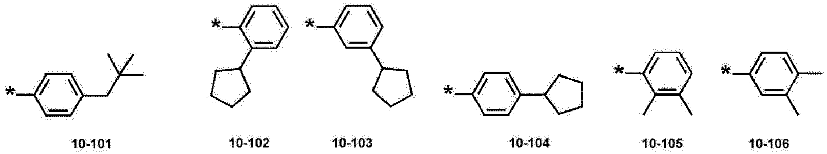 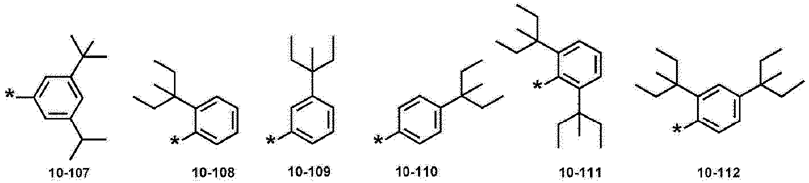 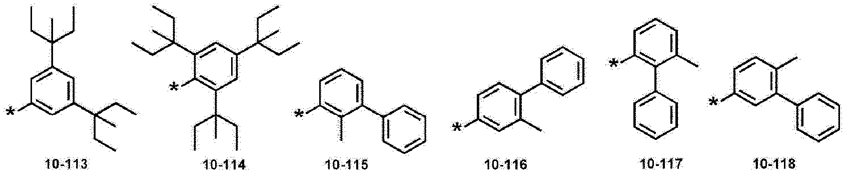 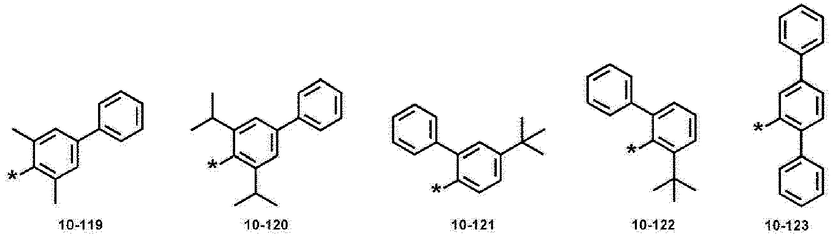 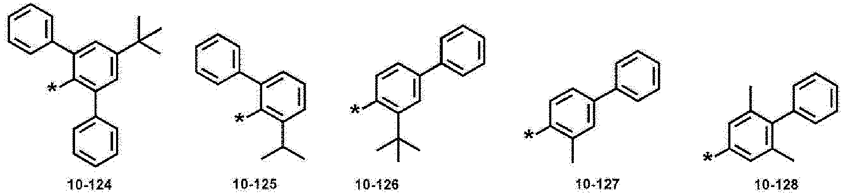 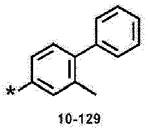 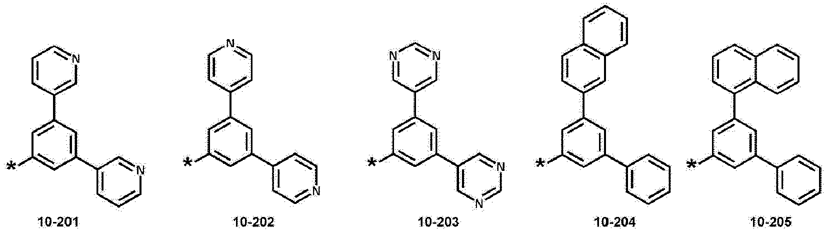 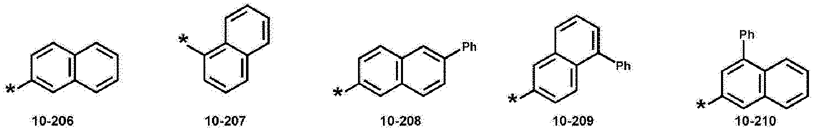 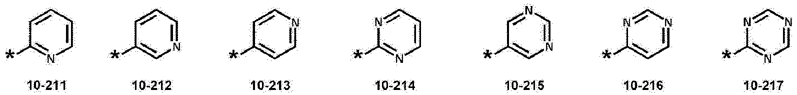 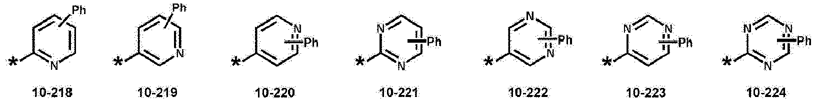 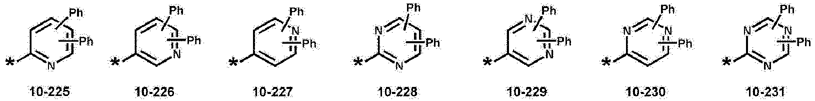 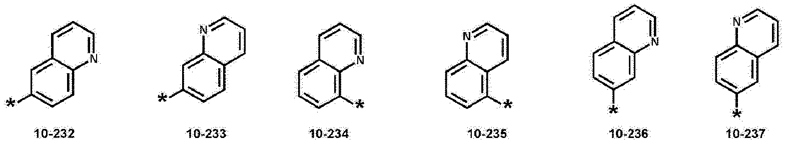 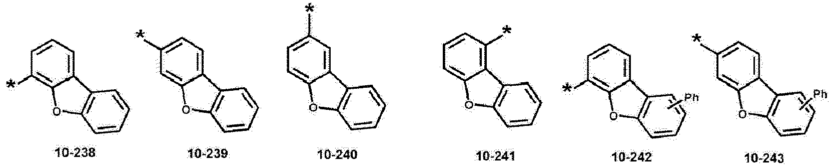 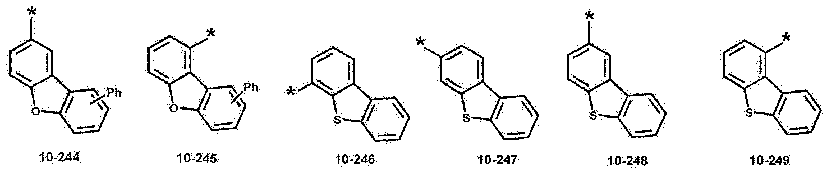 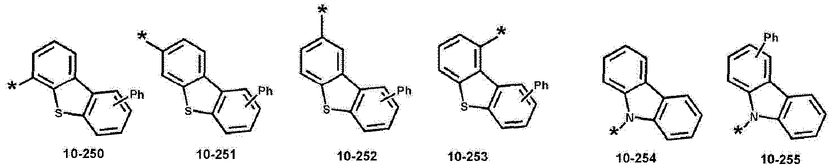 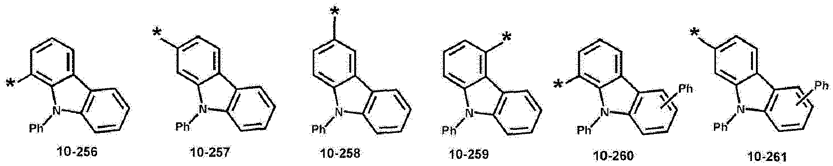 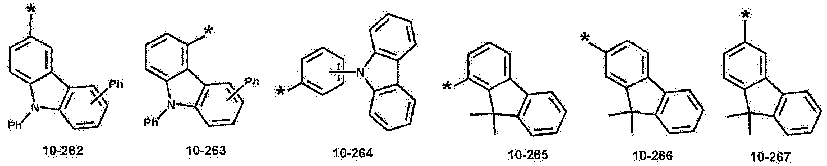 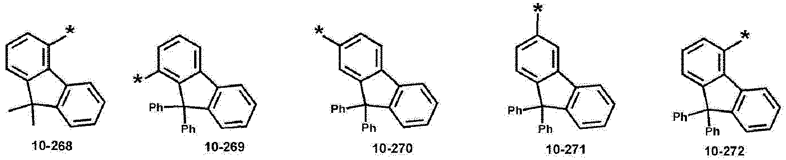 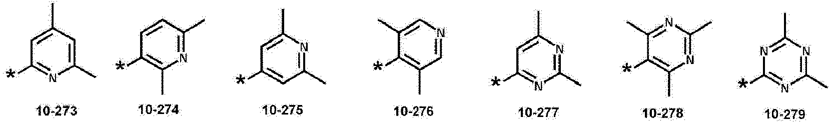 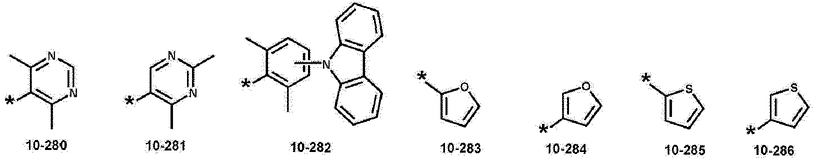 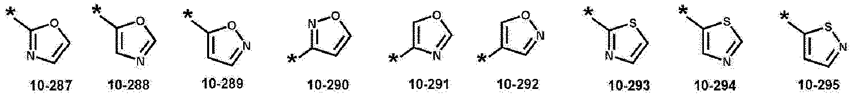 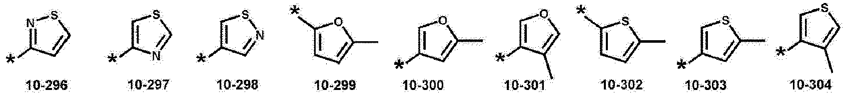 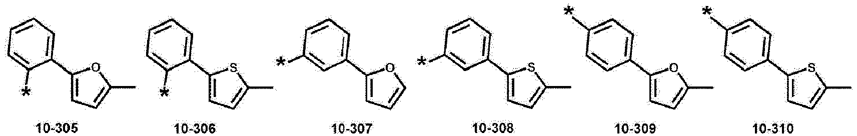 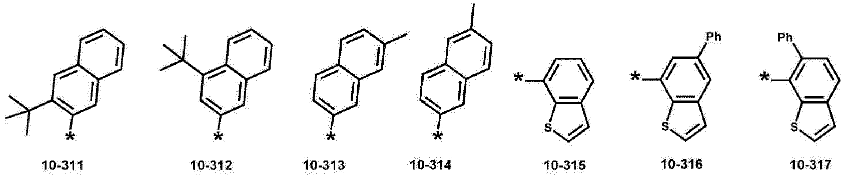 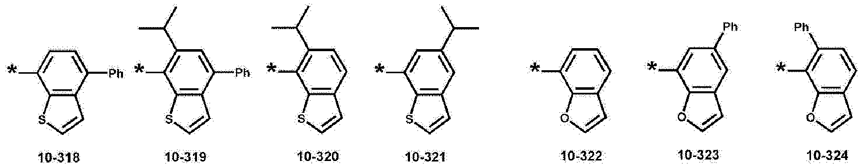 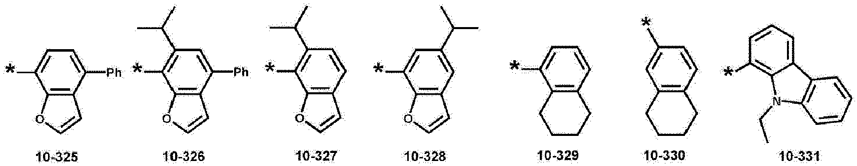 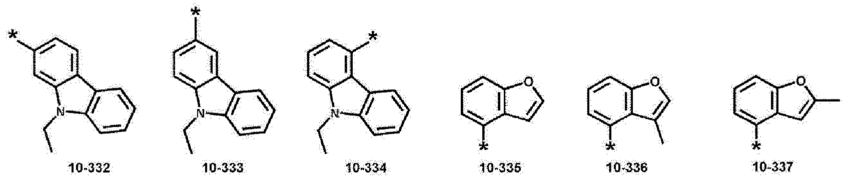 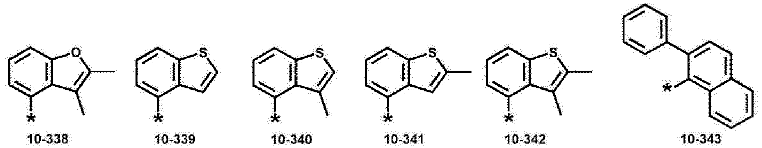 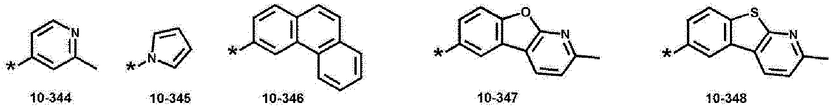 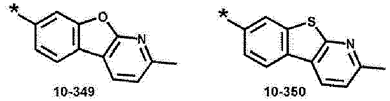 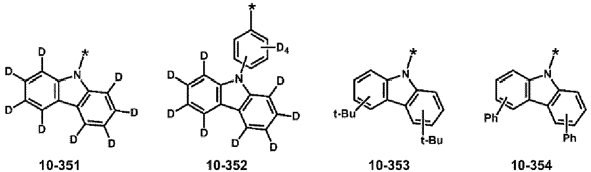 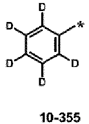
wherein * in Formulae 9-1 to 9-61, 9-201 to 9-237, 10-1 to 10-129, and 10-201 to 10-355 indicates a binding site to a neighboring atom, "Ph" is a phenyl group, "TMS" is a trimethylsilyl group, "TMG" is a trimethylgermyl group, and "t-Bu" is a t-butyl group.

7. The organometallic compound of any of claims 1-6, wherein a group represented by 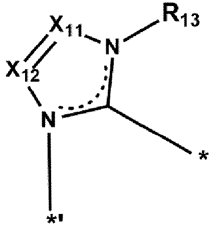 in Formula 1 is a group represented by Formula CY1-1 or CY1-2: 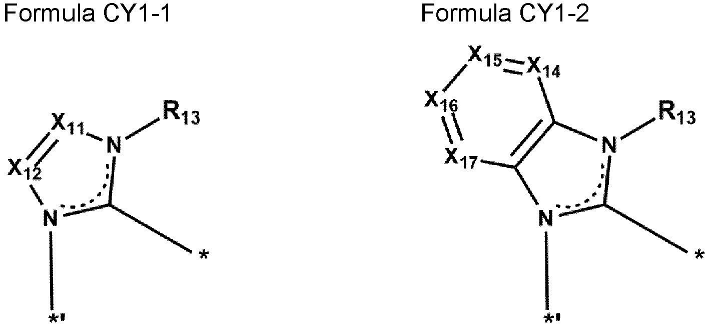 wherein, in Formulae CY1-1 and CY1-2,
X₁₁, X₁₂, and R₁₃ are each as described in claim 1,
X₁₄ is N or C(R₁₄),
X₁₅ is N or C(R₁₅),
X₁₆ is N or C(R₁₆),
X₁₇ is N or C(R₁₇),
R₁₄ to R₁₇ are each as defined for R₁₁ in claim 1,
* indicates a binding site to M₁, and
*' indicates a binding site to T₁.

8. The organometallic compound of any of claims 1-7, wherein a group represented by 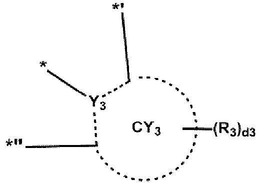 in Formula 1 is a group represented by one of Formulae 3-1 to 3-3: 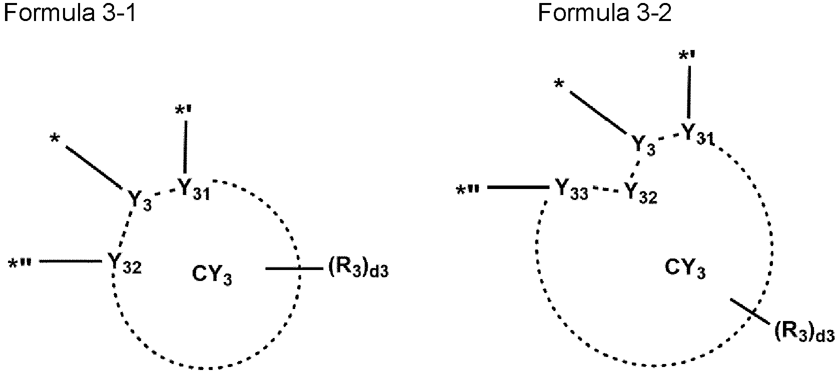 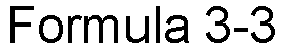 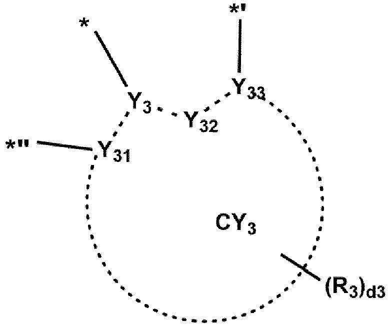 wherein, in Formulae 3-1 to 3-3,
Y₃₁ to Y₃₃ are each independently C or N,
Y₃₁ and Y₃, Y₃ and Y₃₂, and Y₃₂ and Y₃₃ are chemically bonded to each other,
*' indicates a binding site to T₃, *" indicates a binding site to T₂, * indicates a binding site to A₃ or M₁, and
CY₃, Y₃, R₃, and d3 are each as described in claim 1.

9. The organometallic compound of any of claims 1-8, wherein a group represented by 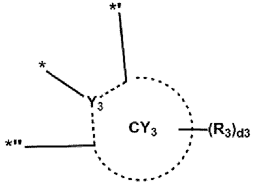 in Formula 1 is a group represented by one of Formulae CY3-1 to CY3-27: 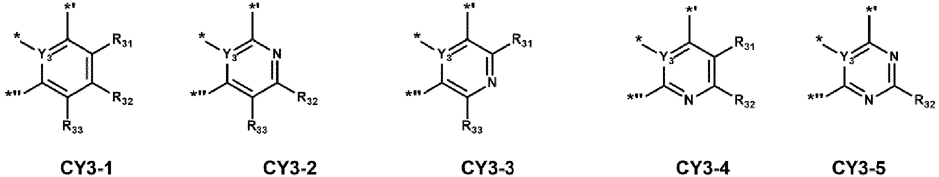 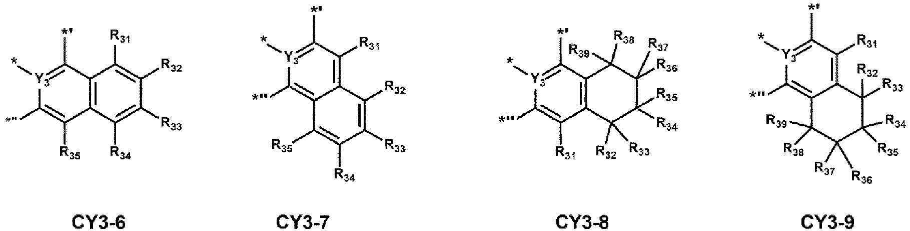 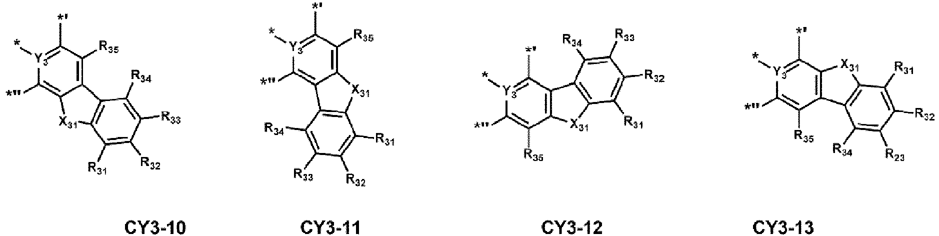 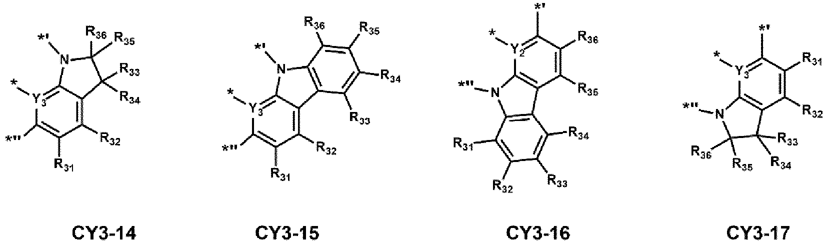 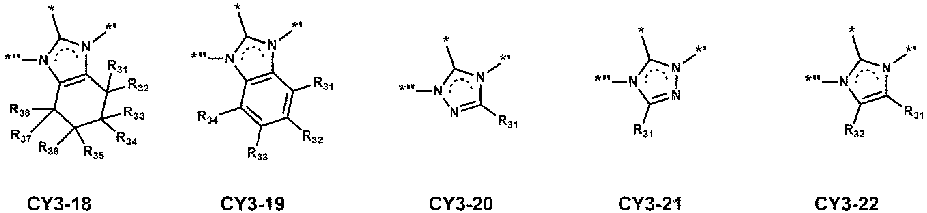 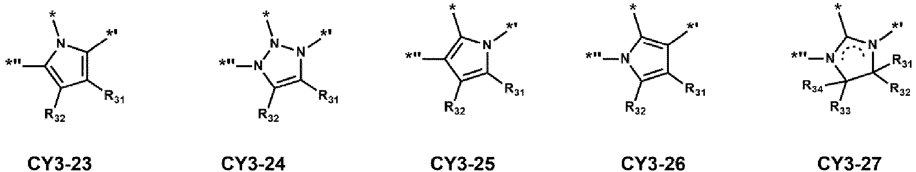 wherein, in Formulae CY3-1 to CY3-27,
Y₃ is C or N,
X₃₁ is N(R₃₁ₐ), O, Se, C(R₃₁ₐ)(R_{31b}), or Si(R₃₁ₐ)(R_{31b}),
R₃₁ to R₃₉, R₃₁ₐ, and R_{31b} are each defined as R₃ in claim 1,
* indicates a binding site to M₁ or A₃, *' indicates a binding site to T₃, and *" indicates a binding site to T₂.

10. The organometallic compound of any of claims 1-9, wherein a group represented by 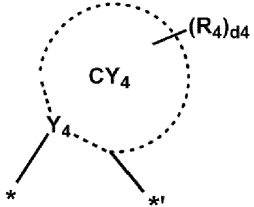 in Formula 1 is a group represented by one of Formulae CY4-1 to CY4-18: 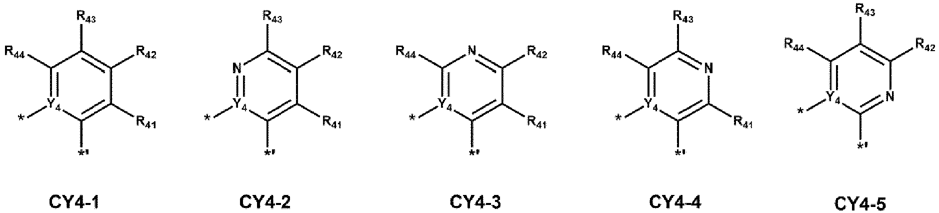 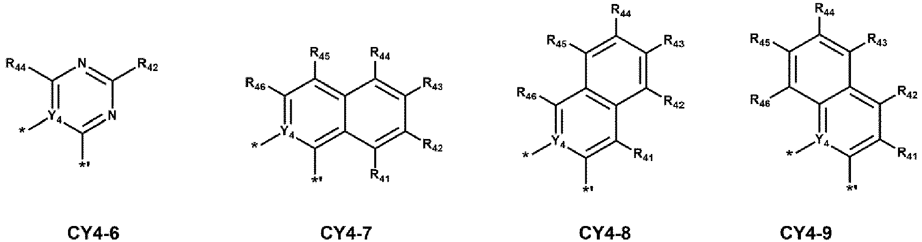 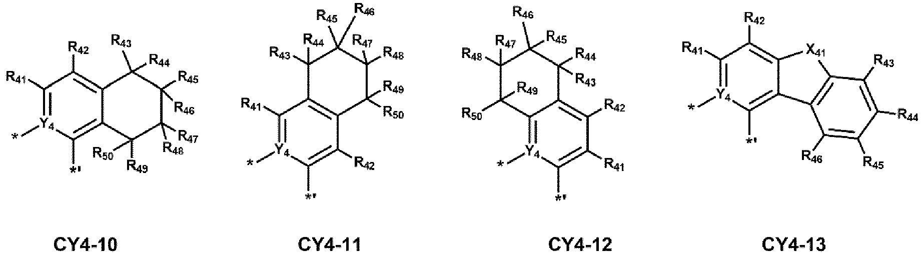 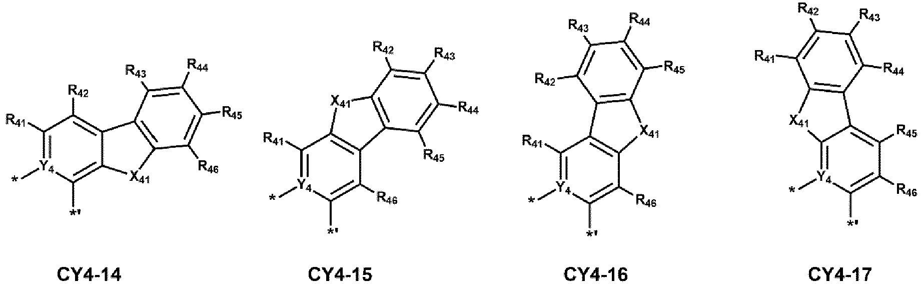 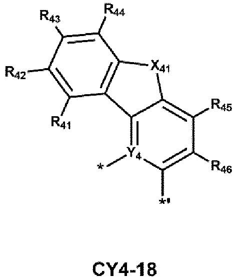 wherein, in Formulae CY4-1 to CY4-18,
Y₄ is C or N,
X₄₁ is N(R₄₁ₐ), O, Se, C(R₄₁ₐ)(R_{41b}), or Si(R₄₁ₐ)(R_{41b}),
R₄₁ to R₅₀, R₄₁ₐ, and R_{41b} are each defined as R₄ in claim 1,
* indicates a binding site to M₁ or A₄, and
*' indicates a binding site to T₃.

11. The organometallic compound of any of claims 1-10, wherein the organometallic compound is represented by one of Formulae 1-1 and 1-2: 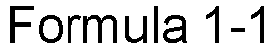 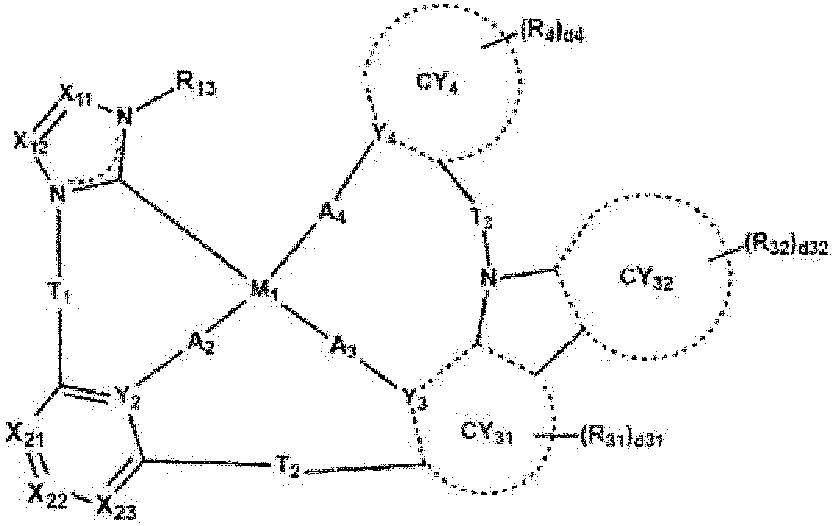 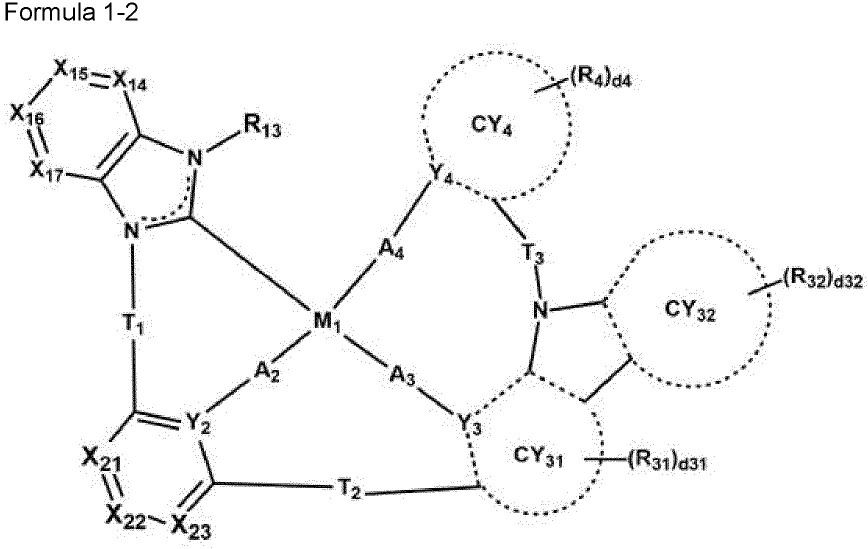 wherein, in Formulae 1-1 and 1-2,
ring CY₃₁ and ring CY₃₂ are each independently a C₅-C₃₀ carbocyclic group or a C₁-C₃₀ heterocyclic group,
R₃₁ and R₃₂ are each defined as R₃ in claim 1,
d31 and d32 are each independently an integer from 0 to 10,
X₁₄ is N or C(R₁₄),
X₁₅ is N or C(R₁₅),
X₁₆ is N or C(R₁₆),
X₁₇ is N or C(R₁₇),
R₁₄ to R₁₇ are each defined R₁₁ in claim 1, and
M₁, ring CY₄, Y₂ to Y₄, A₂ to A4, T₁ to T₃, X₁₁, X₁₂, X₂₁ to X₂₃, R₄, d4, and R₁₃ are each as described in claim 1; and/or
wherein Formula 2 is represented by one of Formulae 2-1 to 2-16: 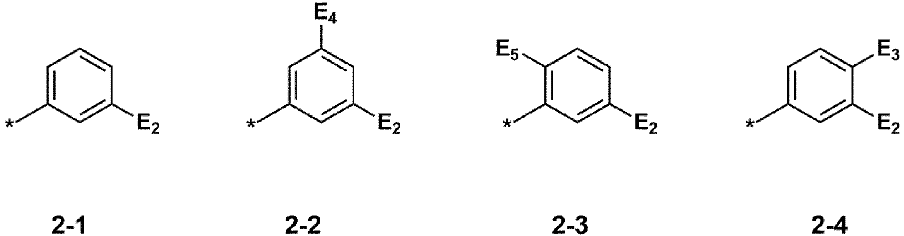 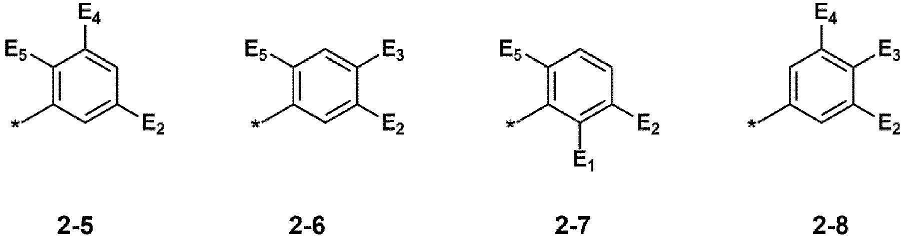 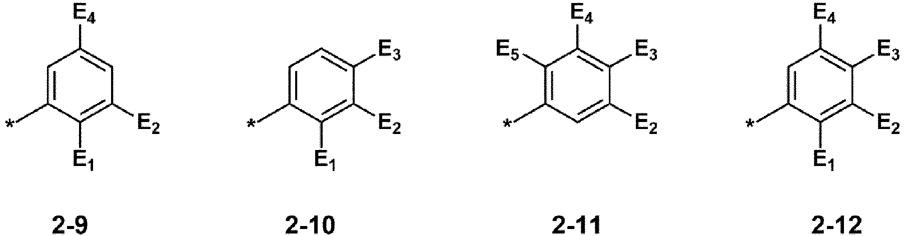 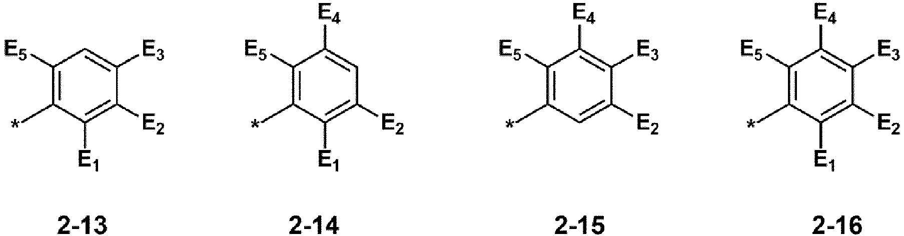 wherein, in Formulae 2-1 to 2-16,
E₁ to E₅ are each as described in claim 1, provided that each of E₁ to E₅ is not hydrogen, and
* indicates a binding site to a neighboring atom.

12. The organometallic compound of claim 1, wherein the organometallic compound is represented by one of Compounds 1 to 405:

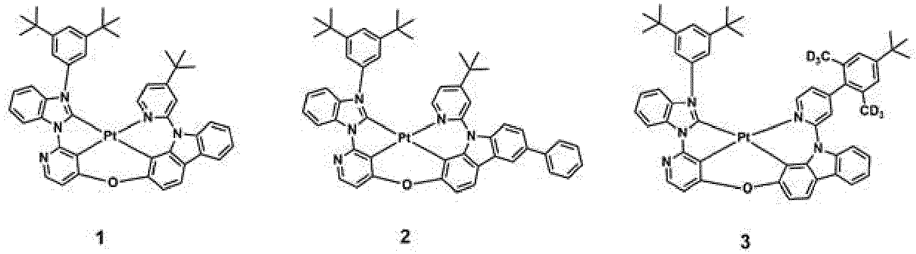

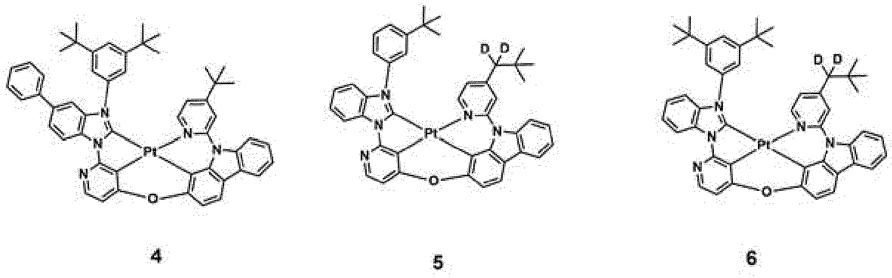

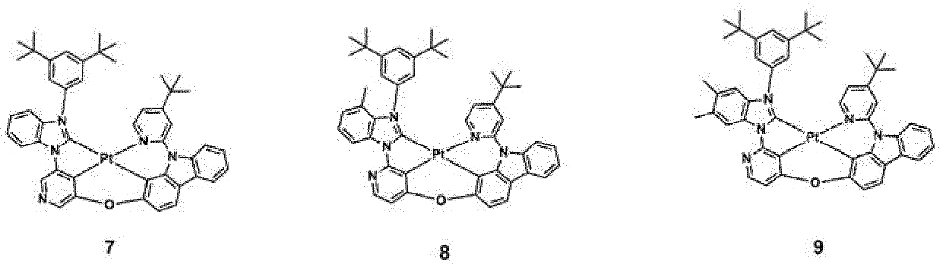

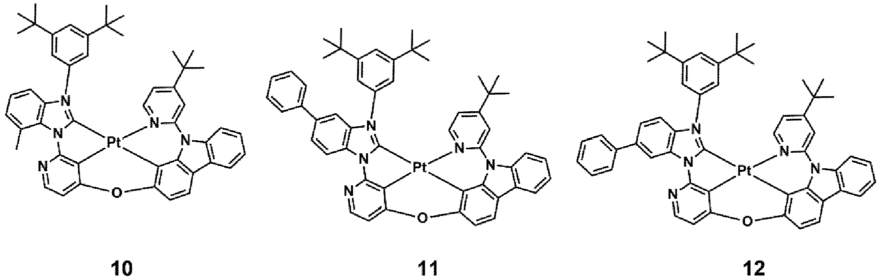

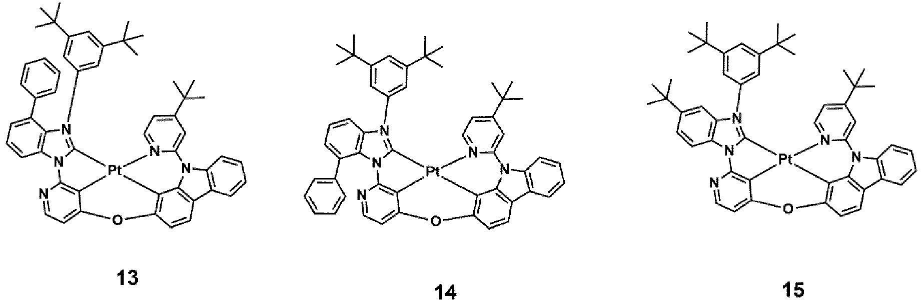

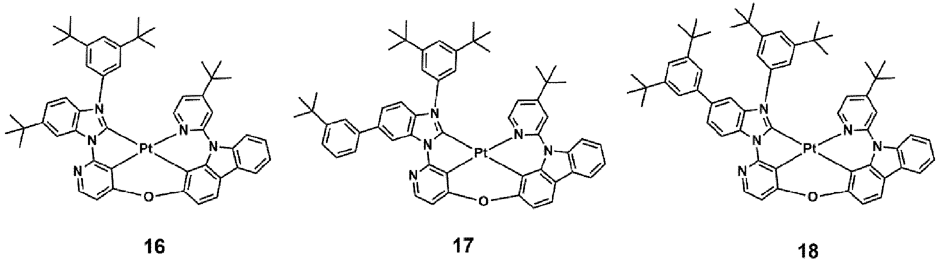

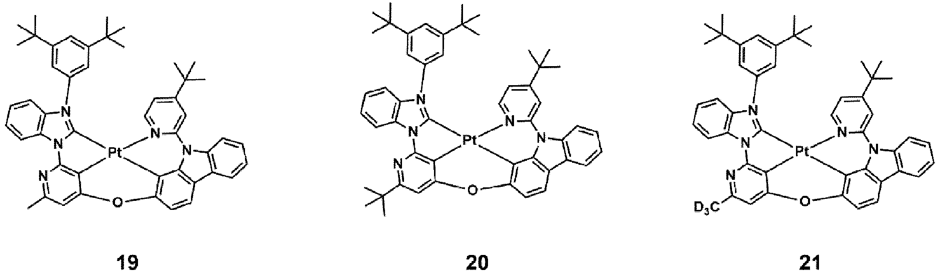

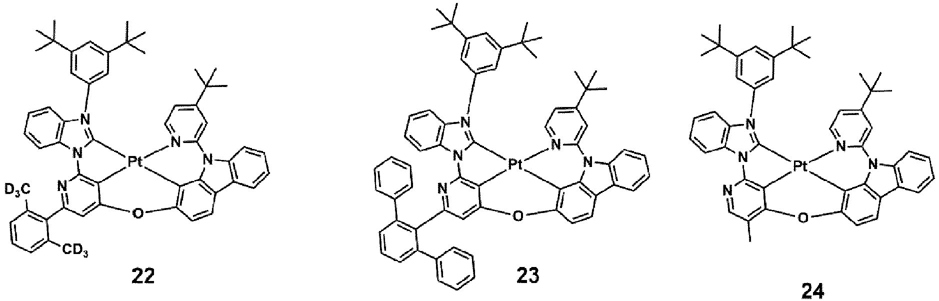

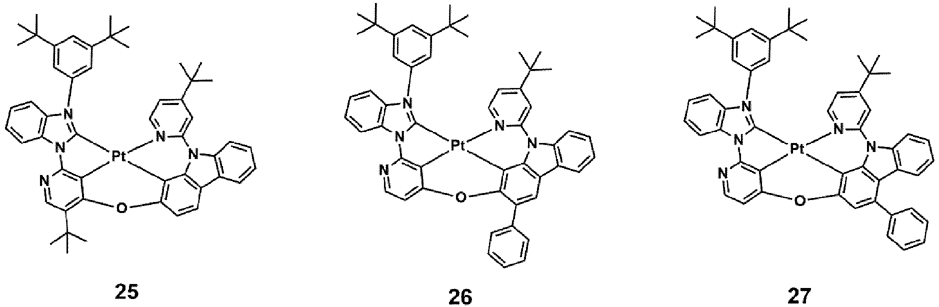

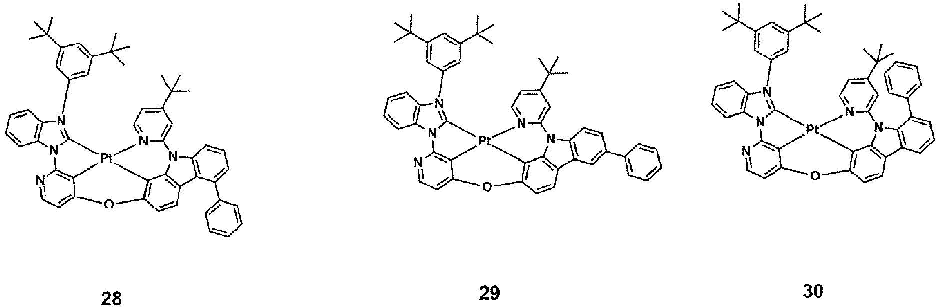

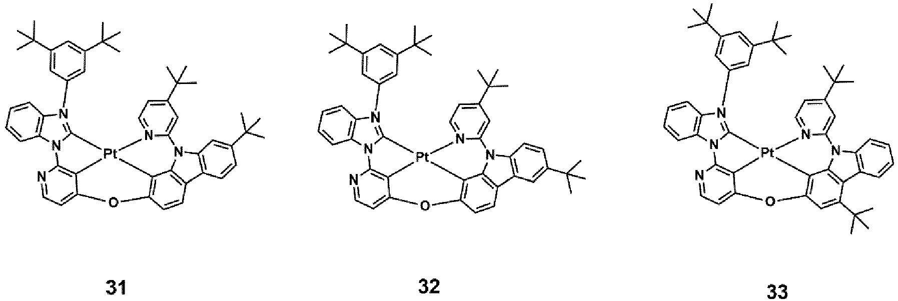

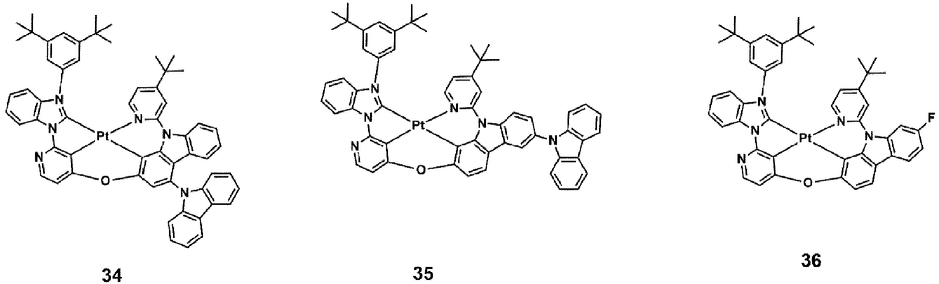

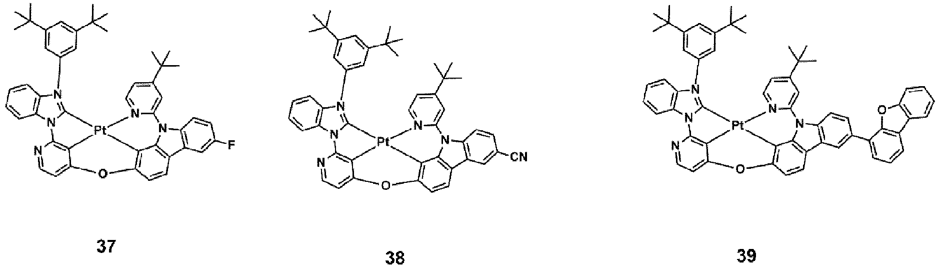

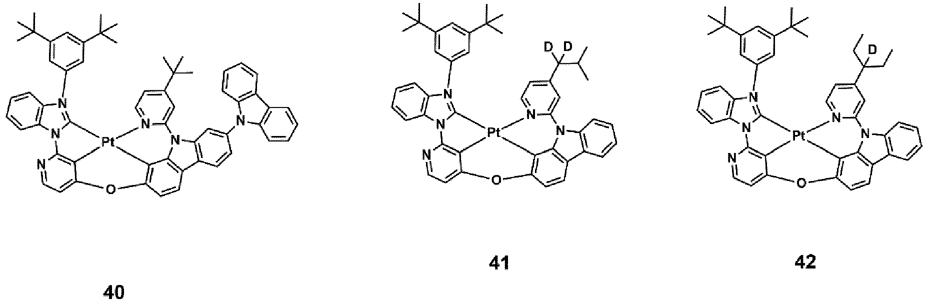

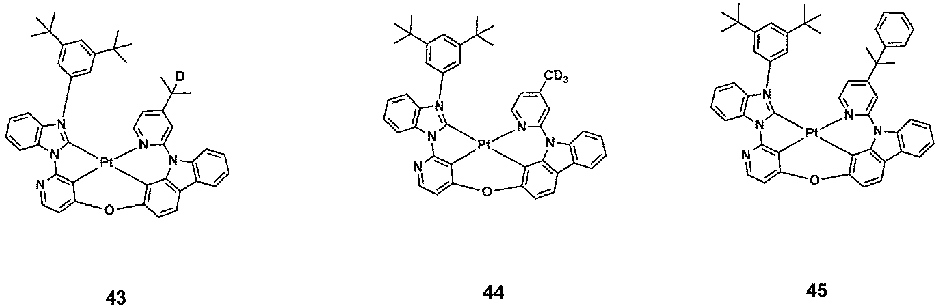

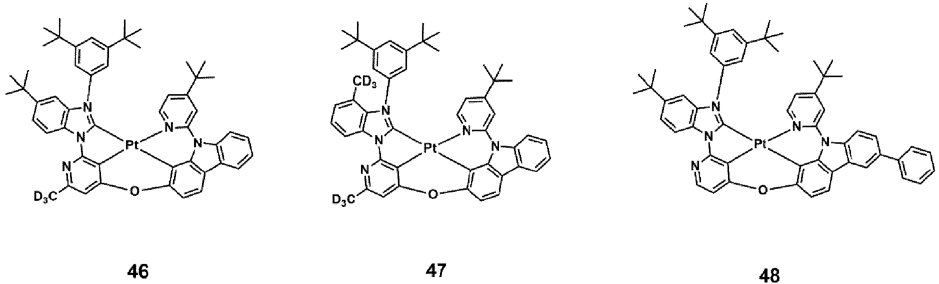

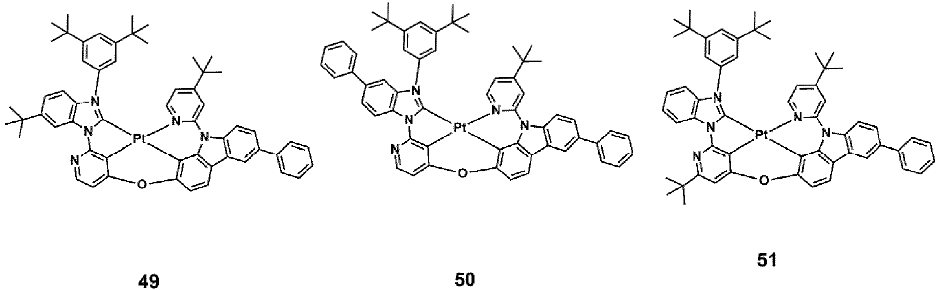

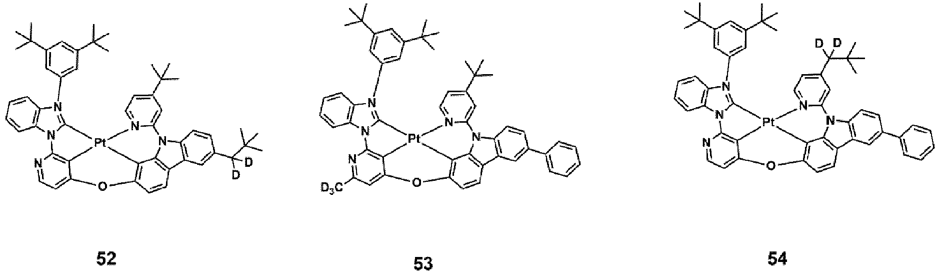

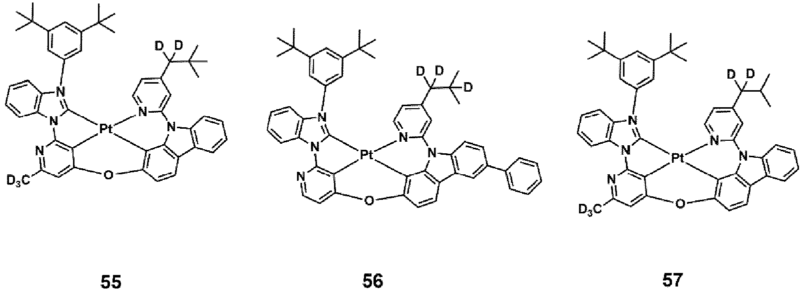

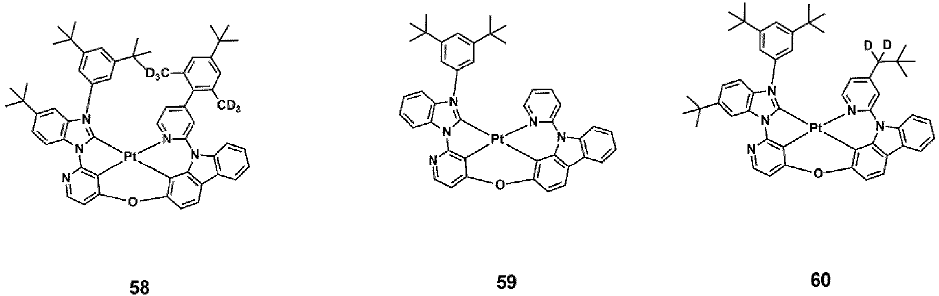

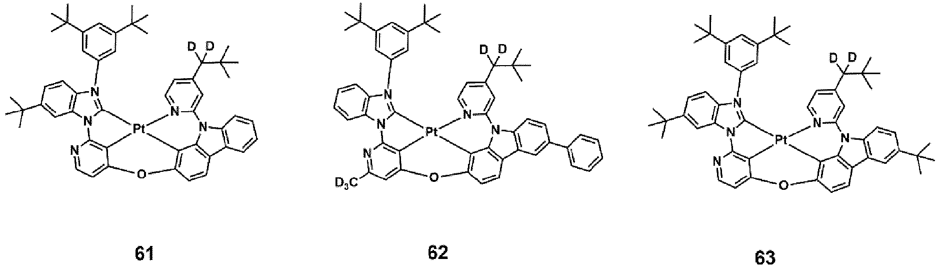

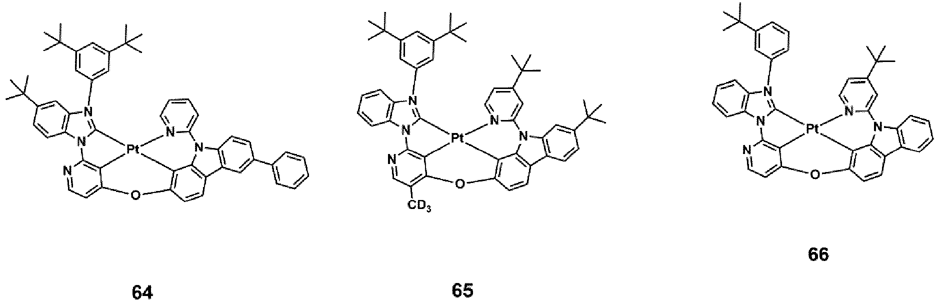

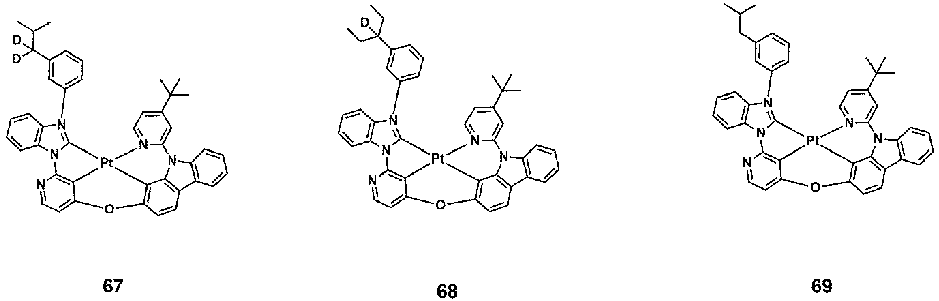

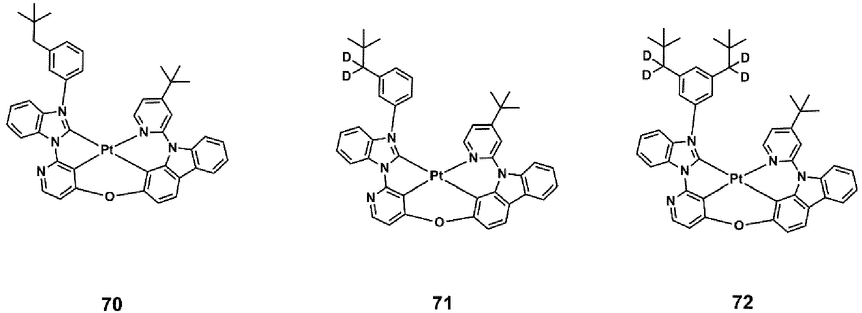

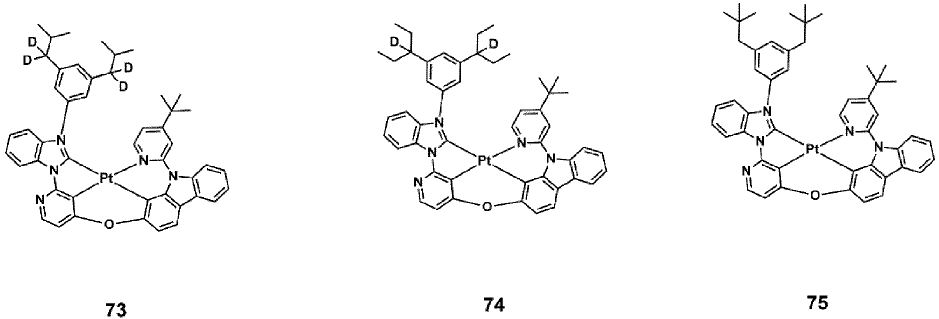

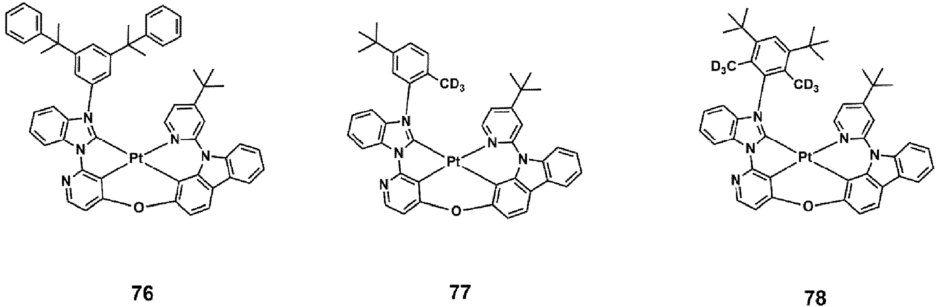

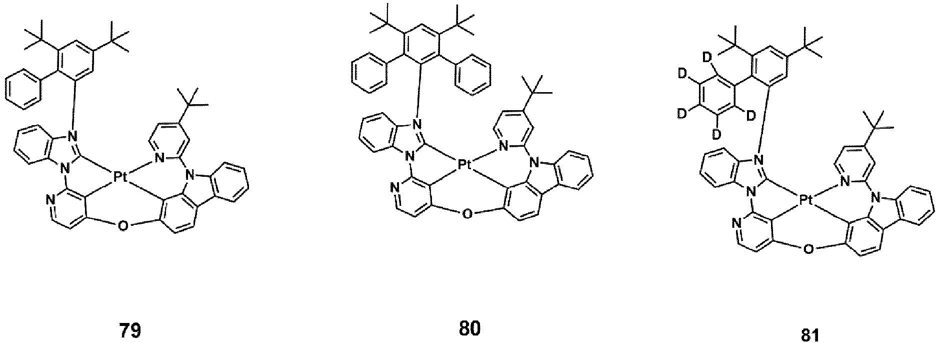

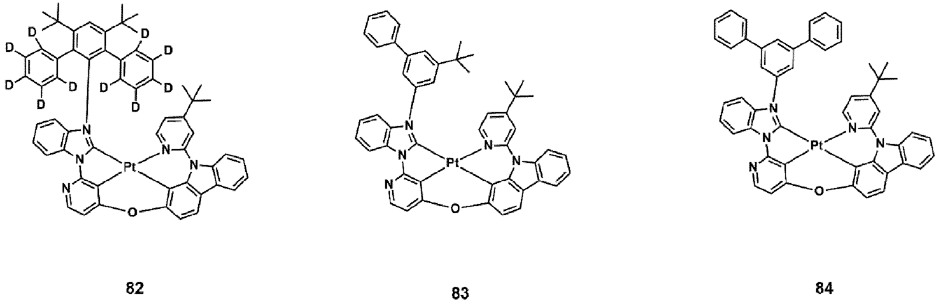

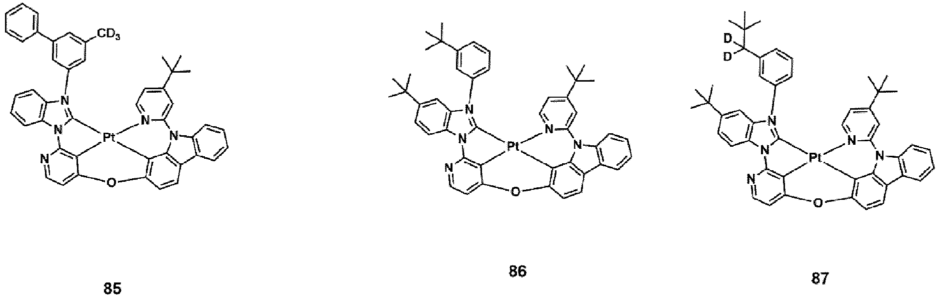

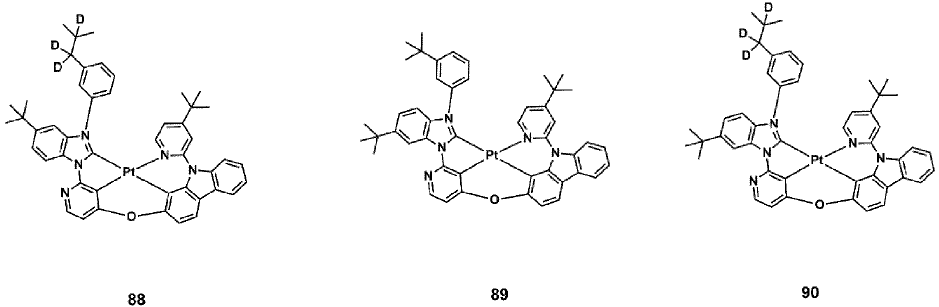

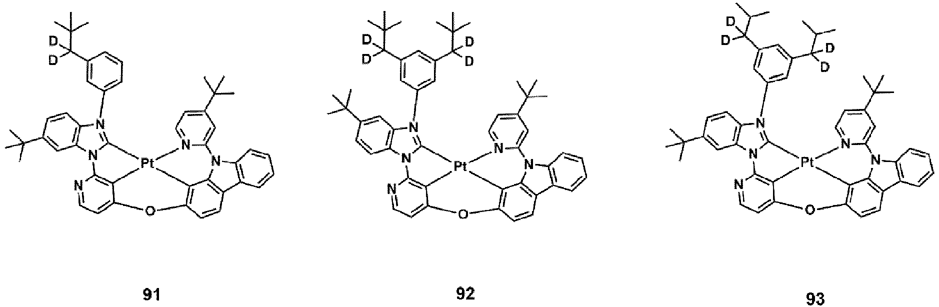

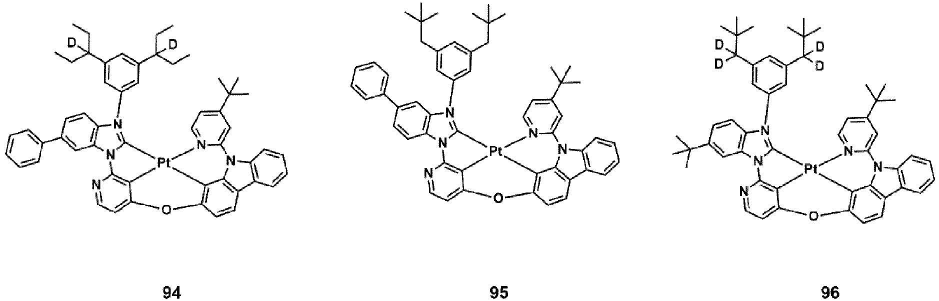

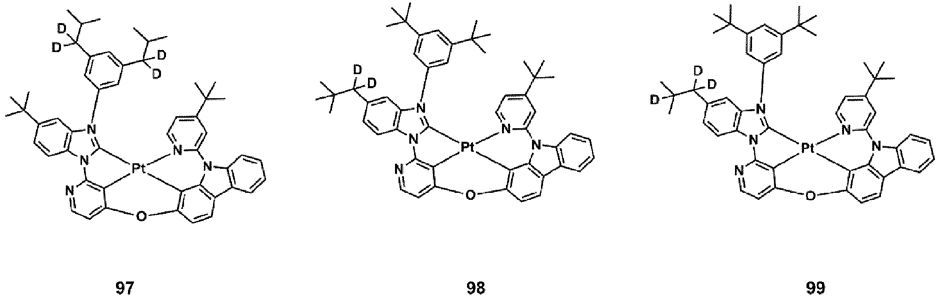

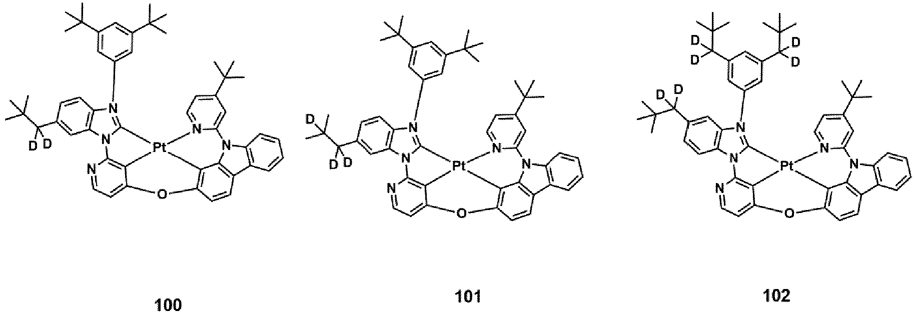

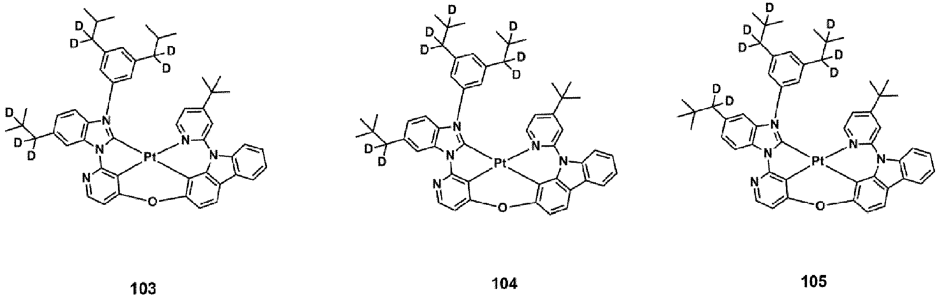

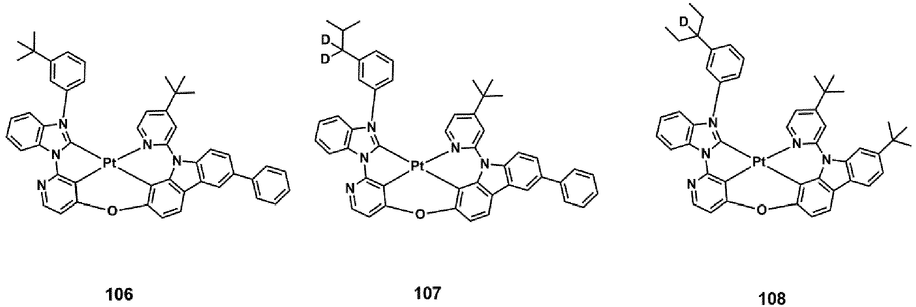

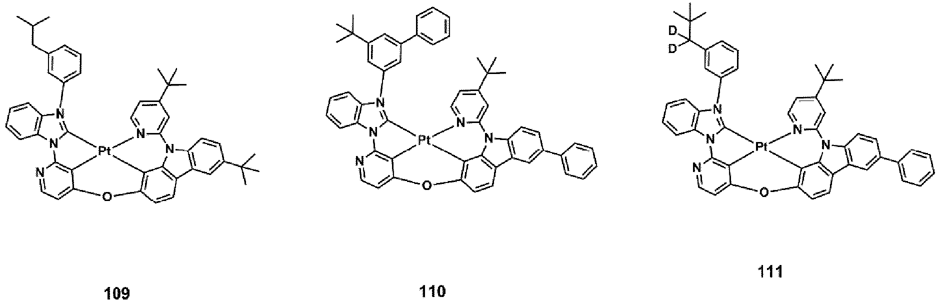

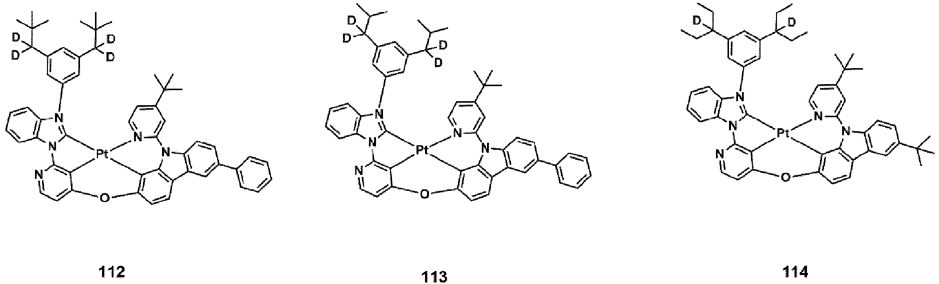

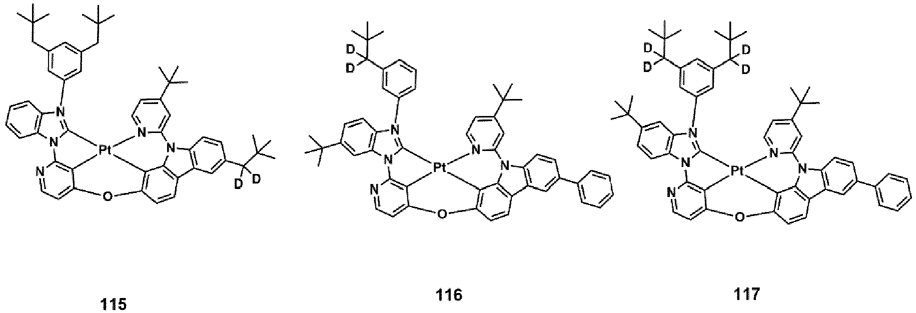

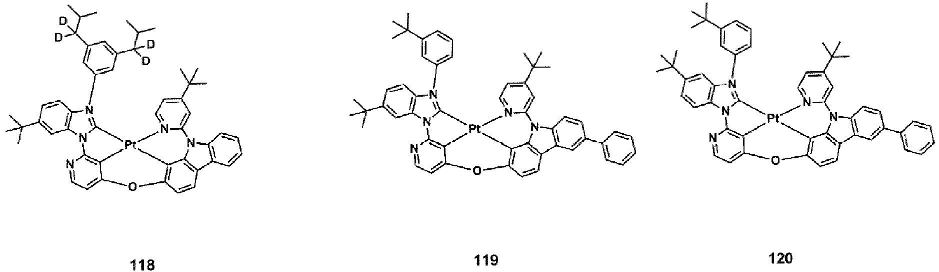

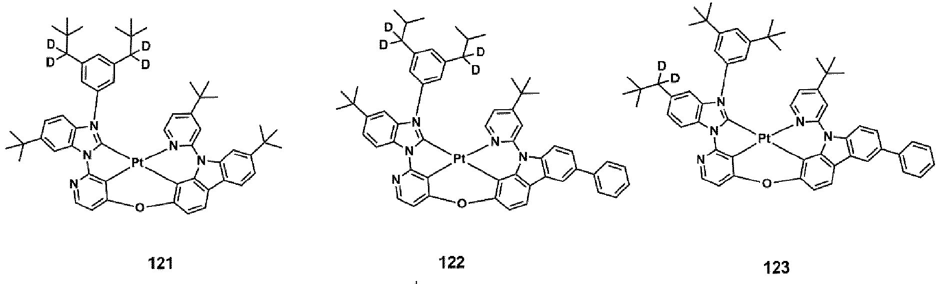

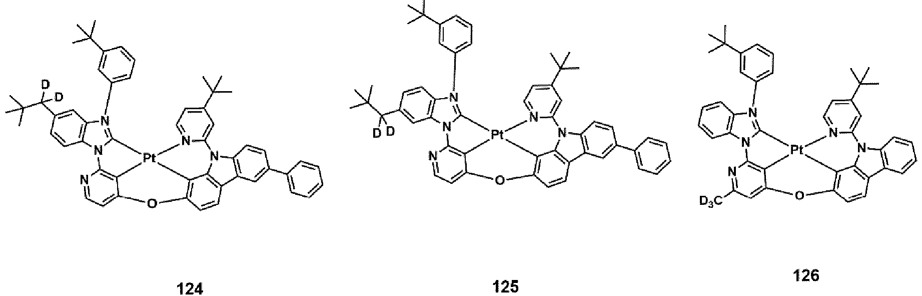

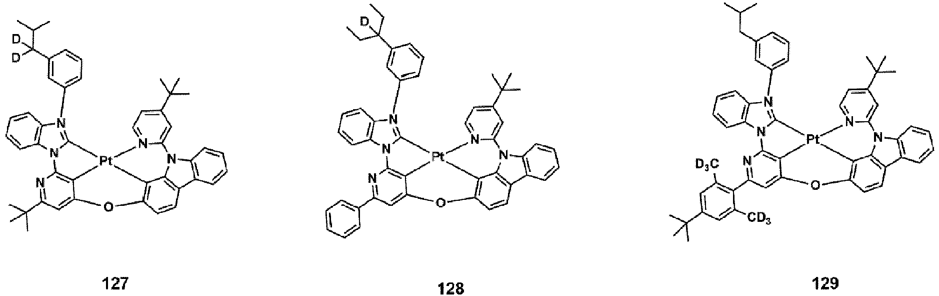

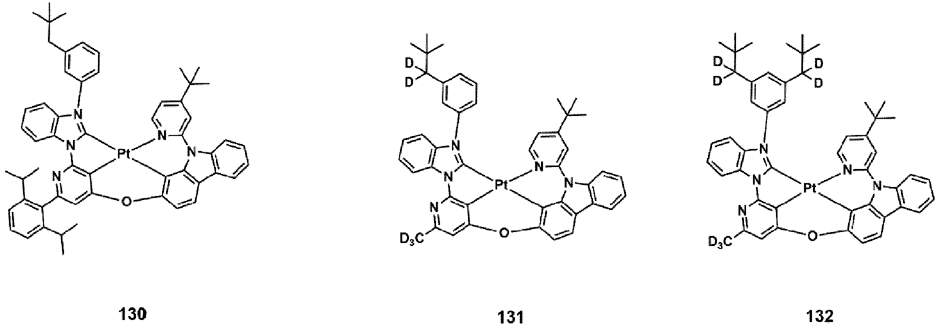

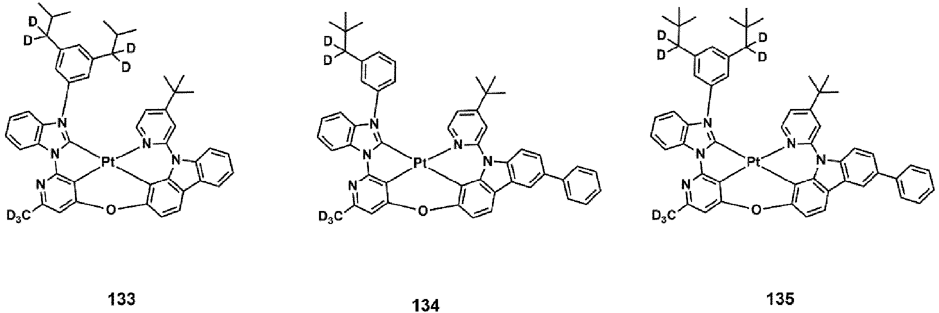

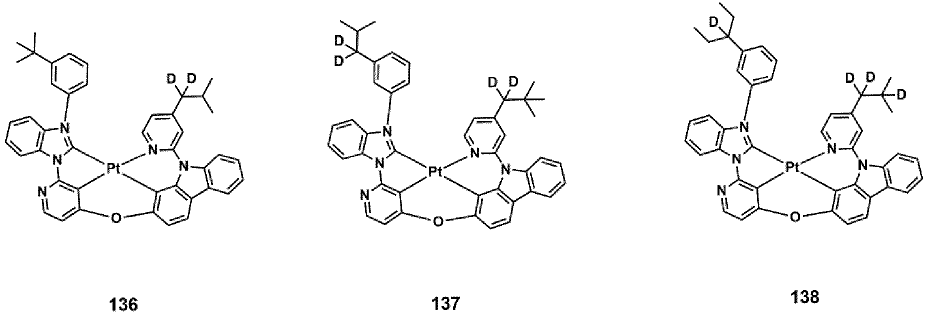

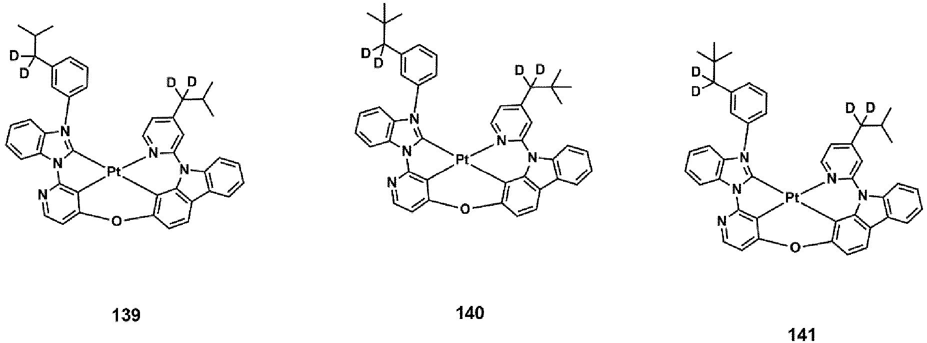

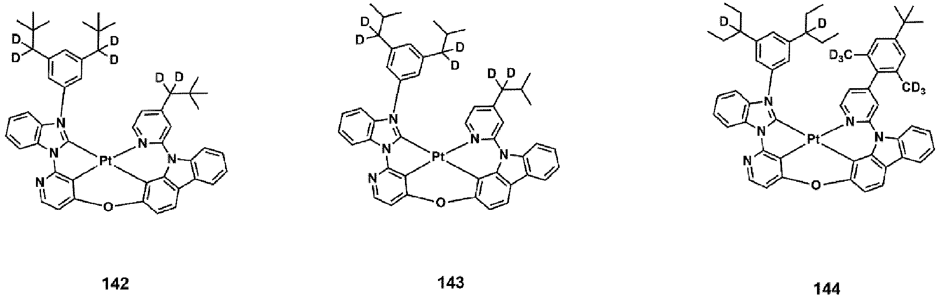

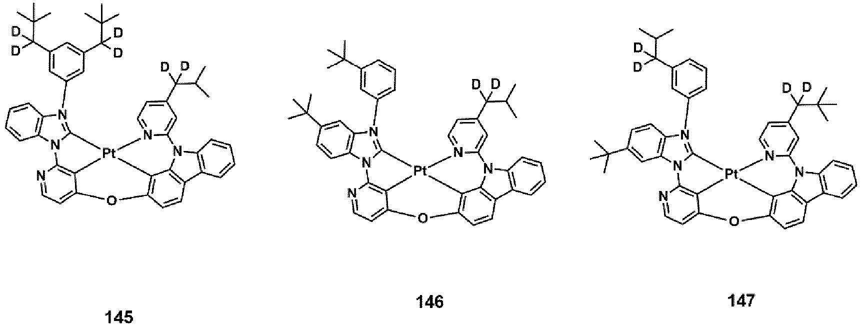

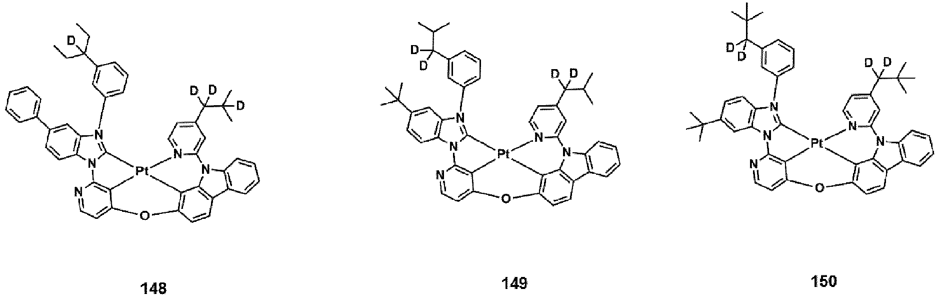

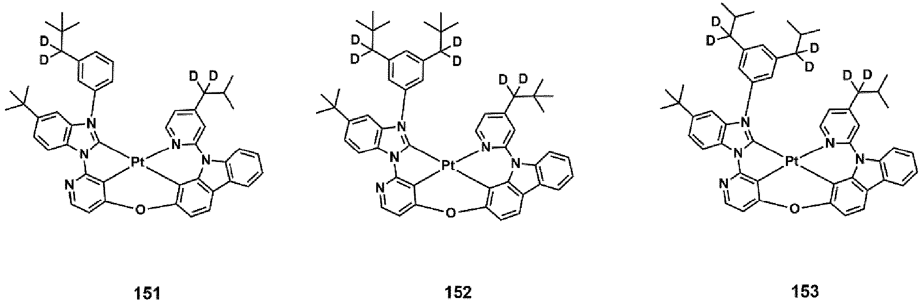

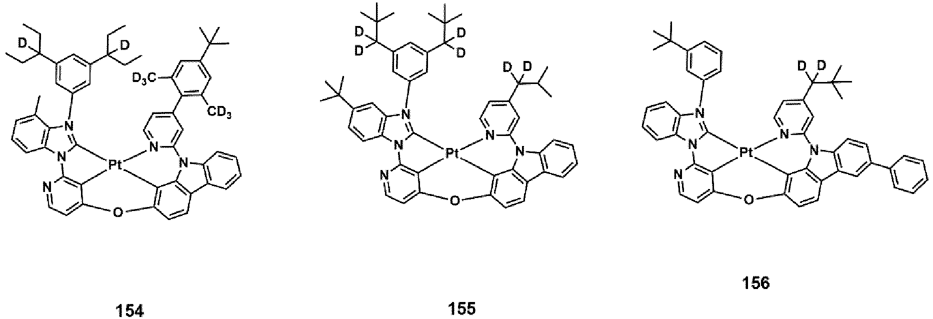

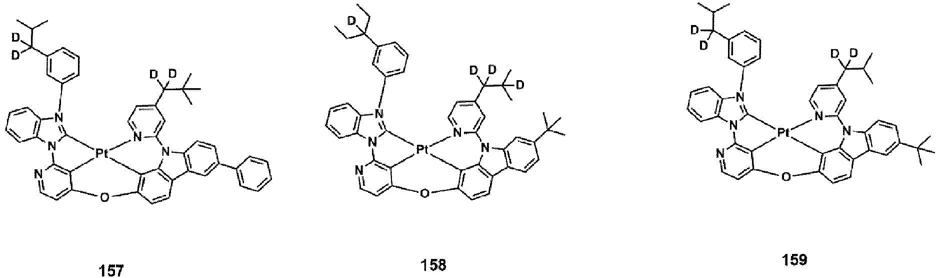

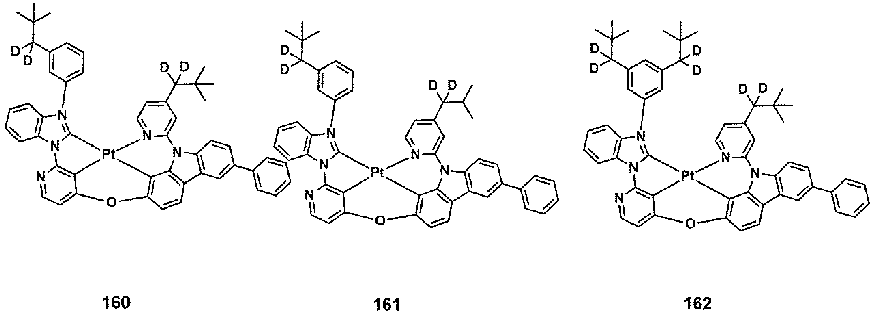

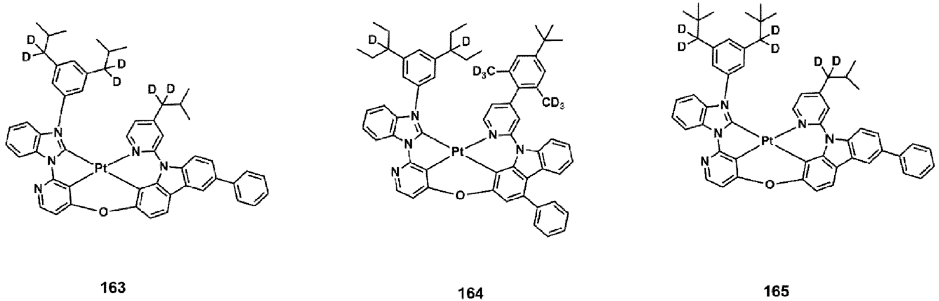

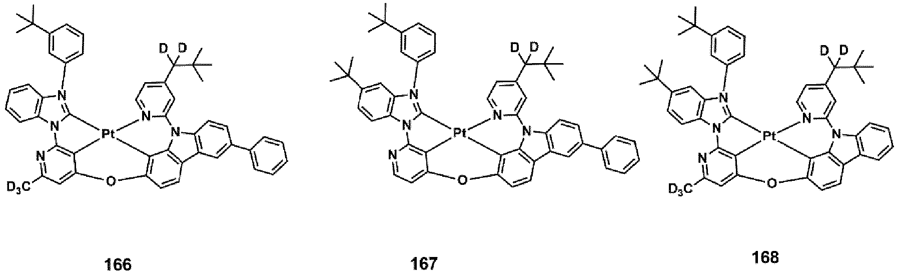

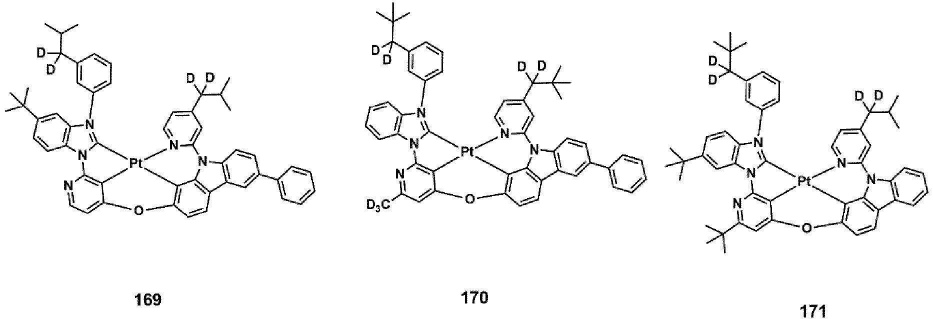

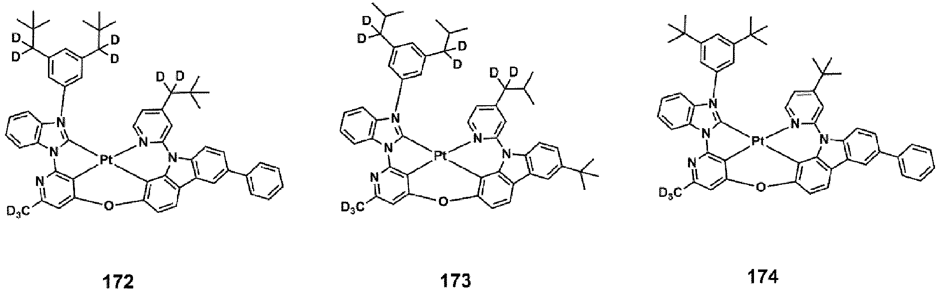

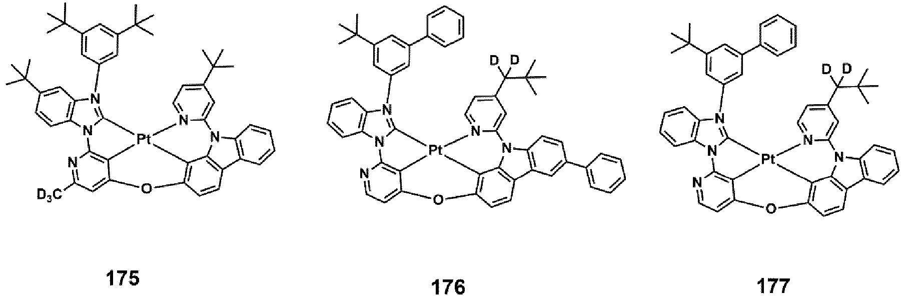

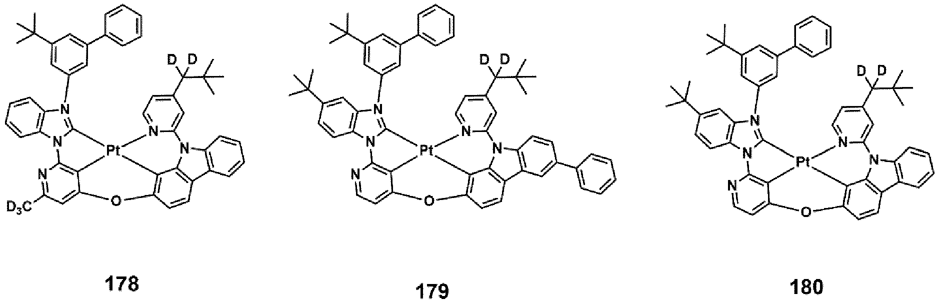

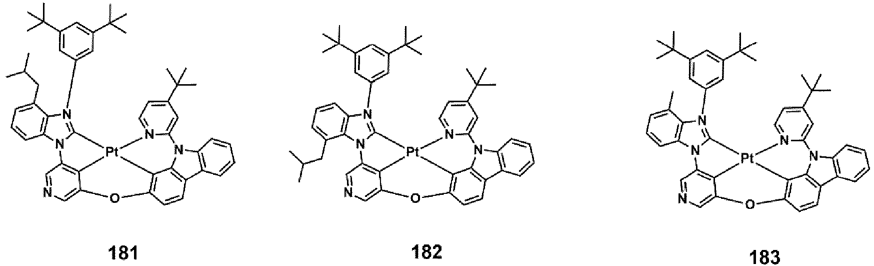

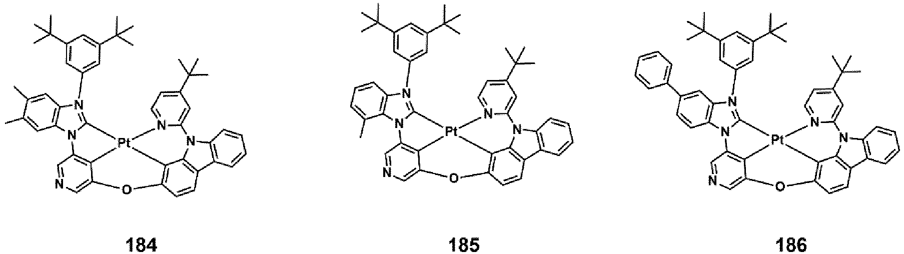

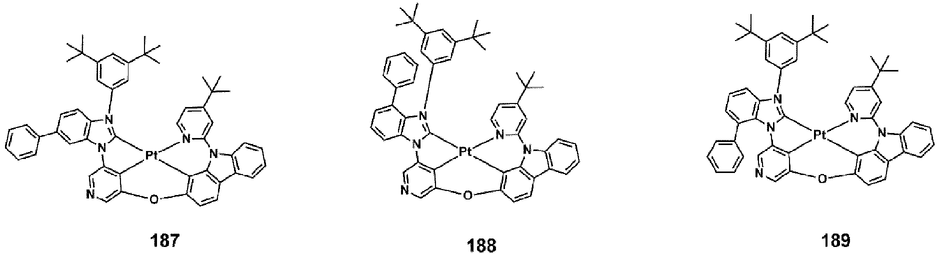

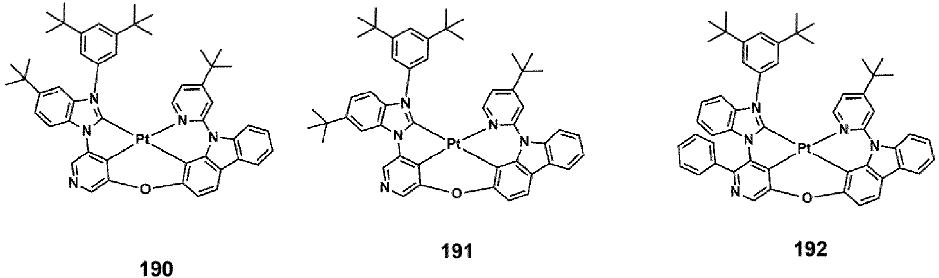

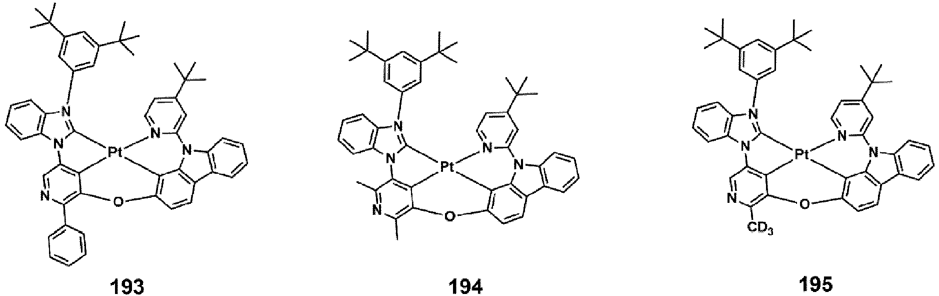

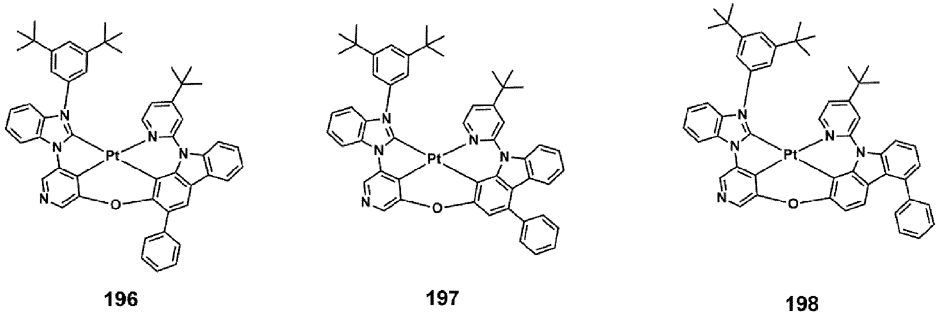

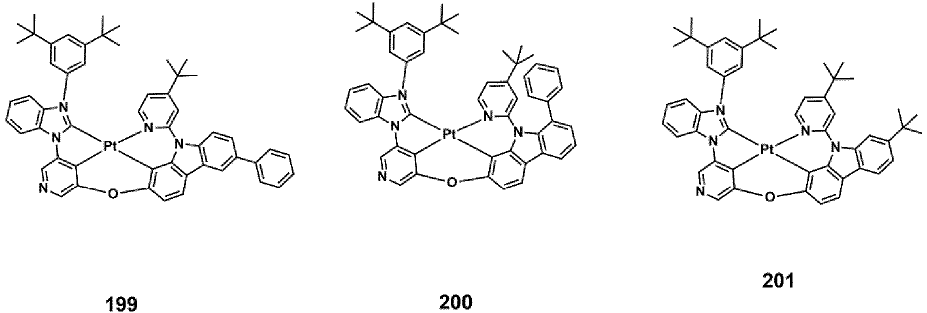

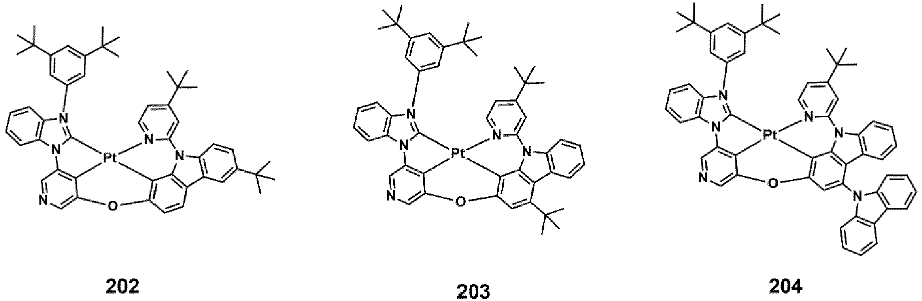

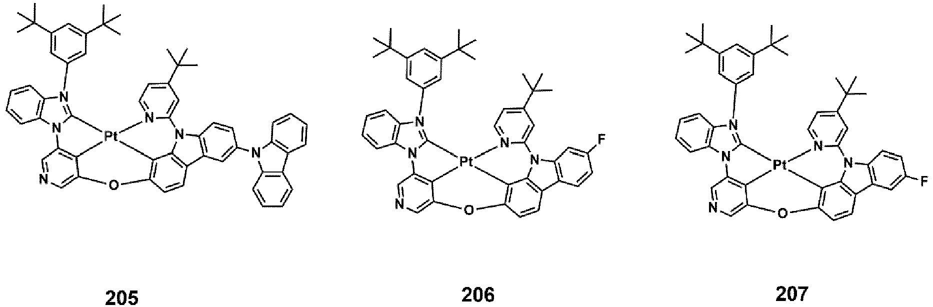

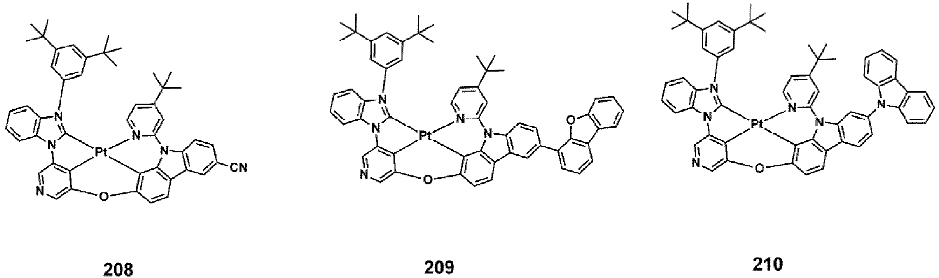

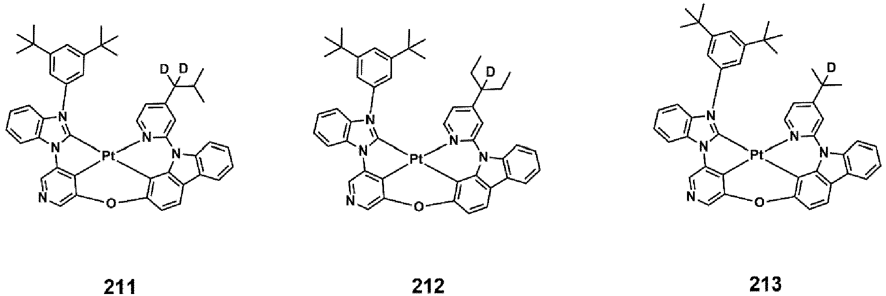

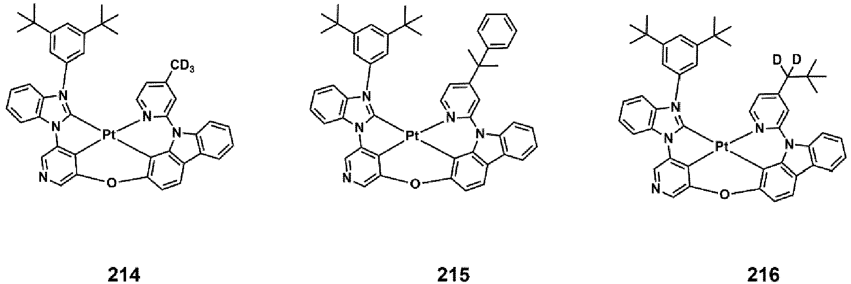

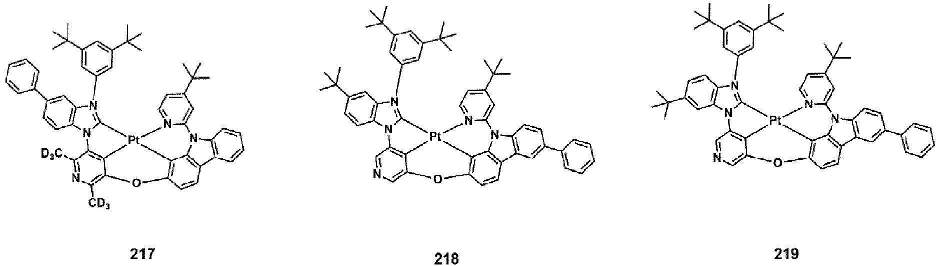

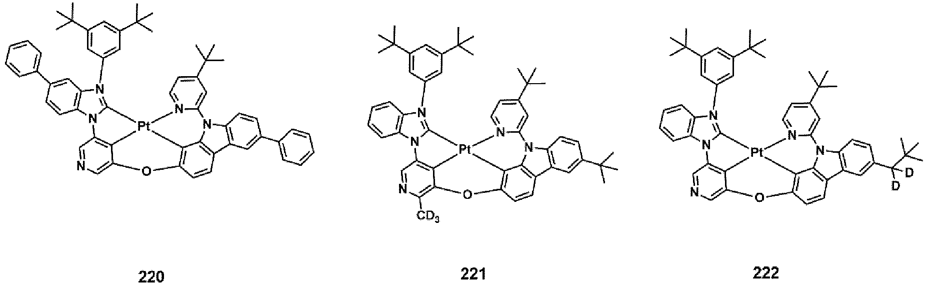

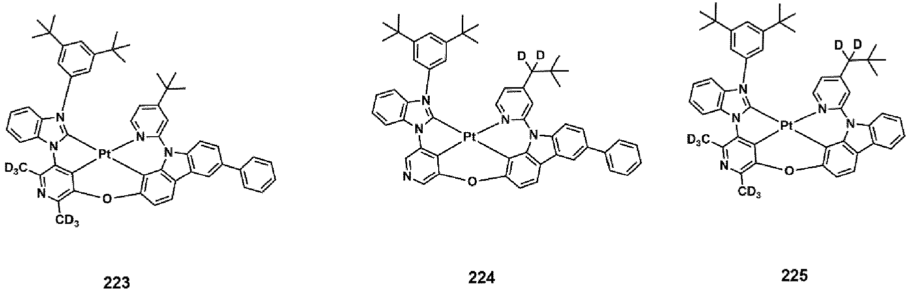

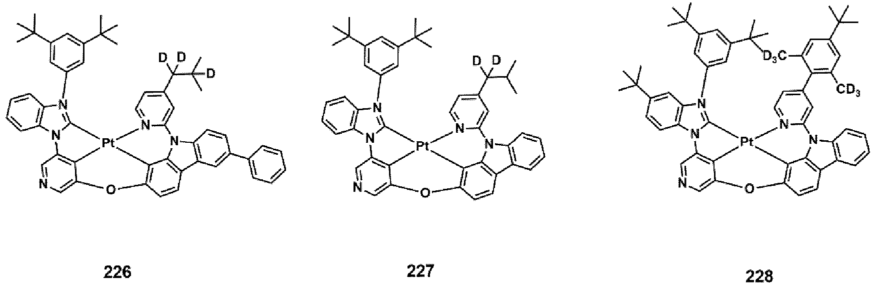

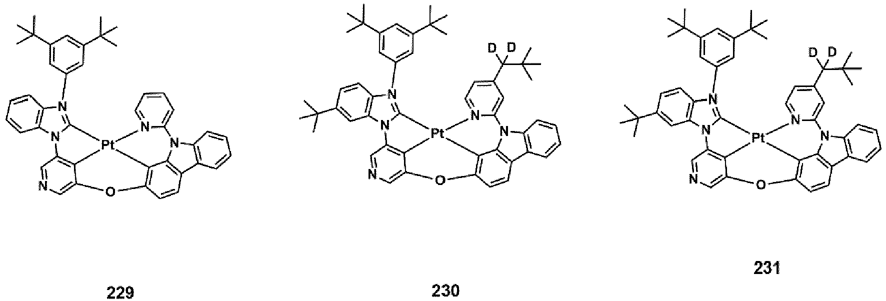

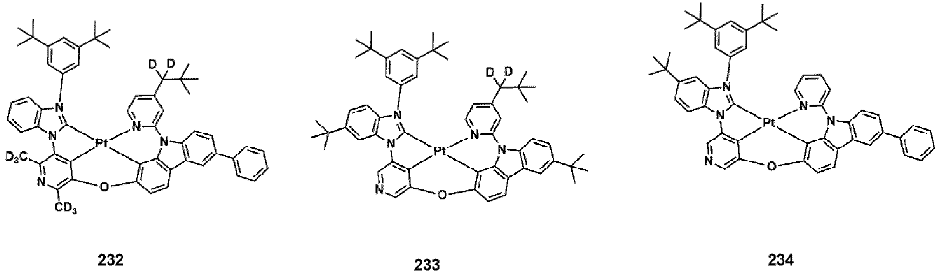

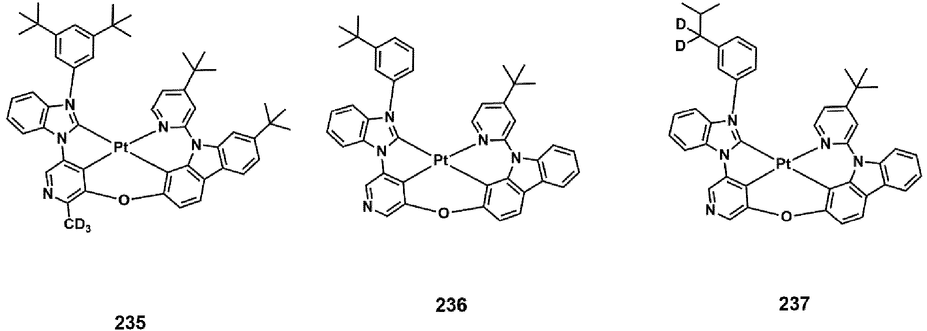

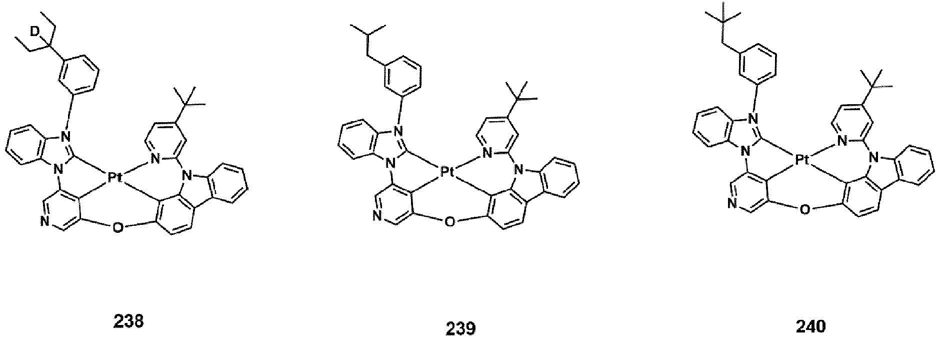

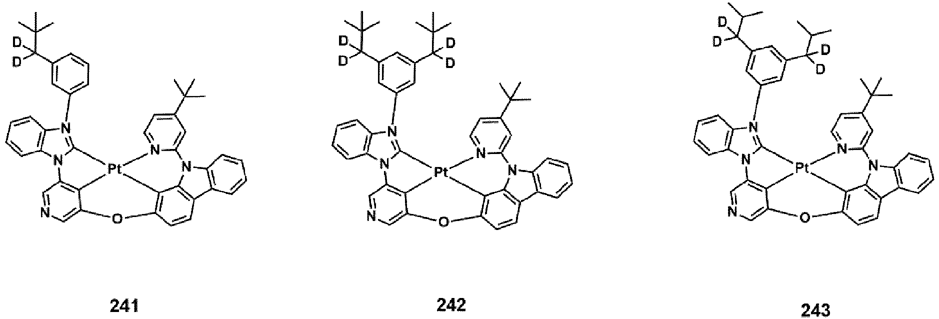

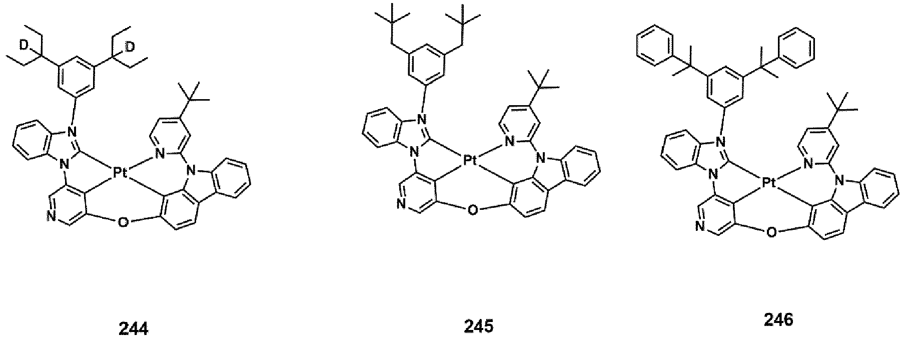

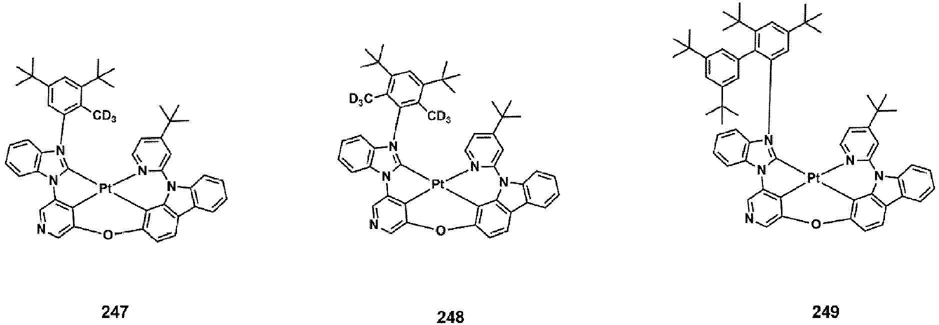

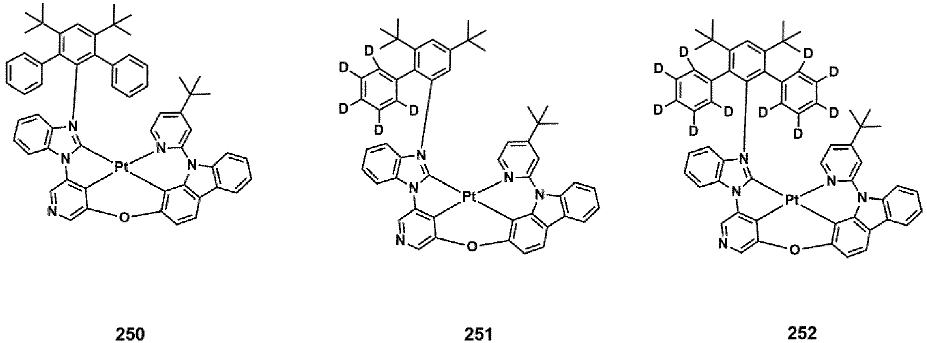

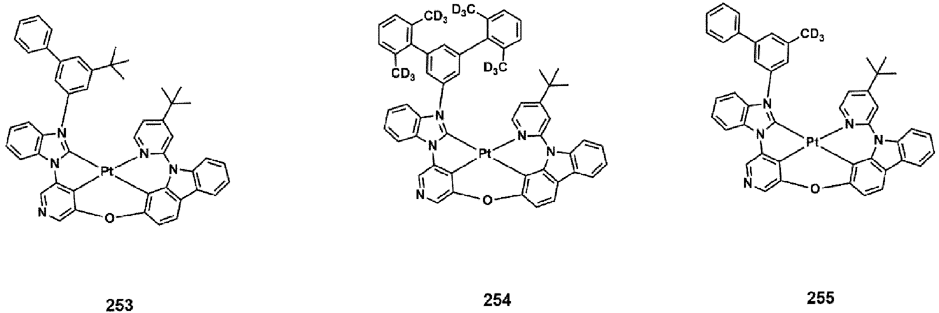

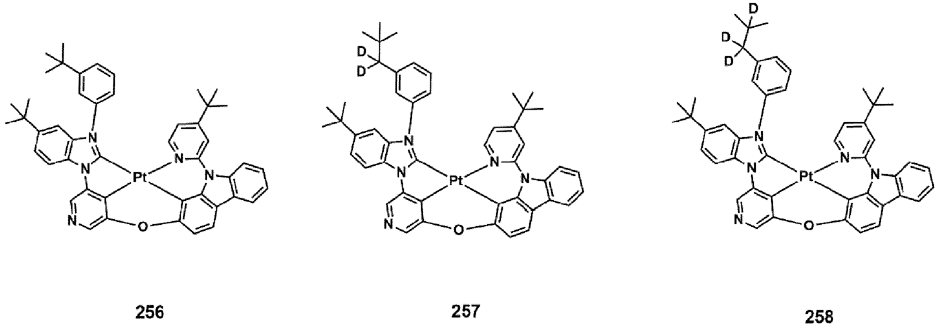

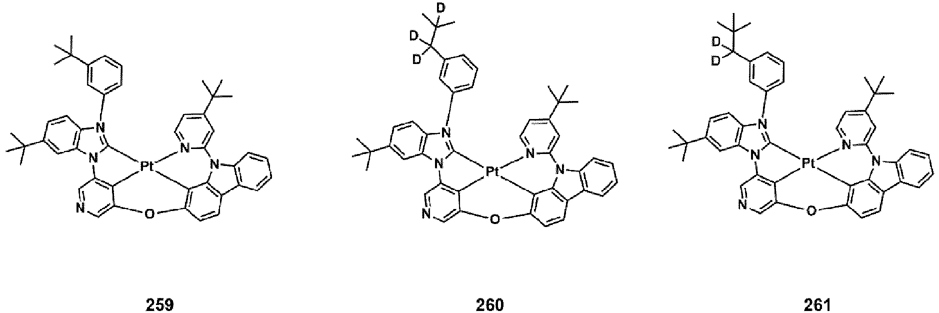

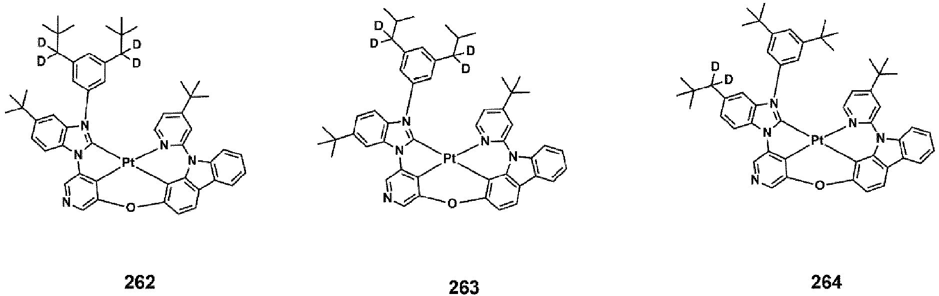

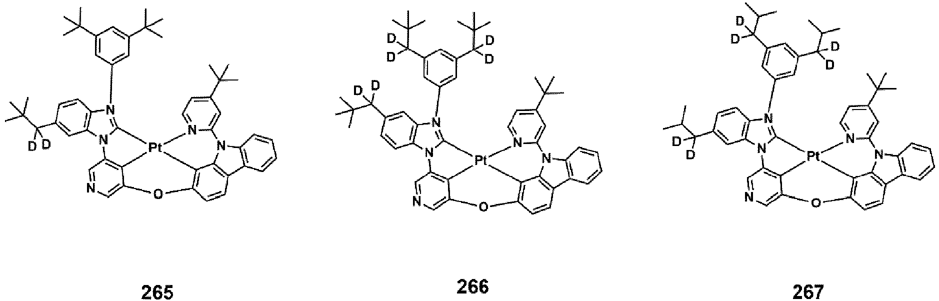

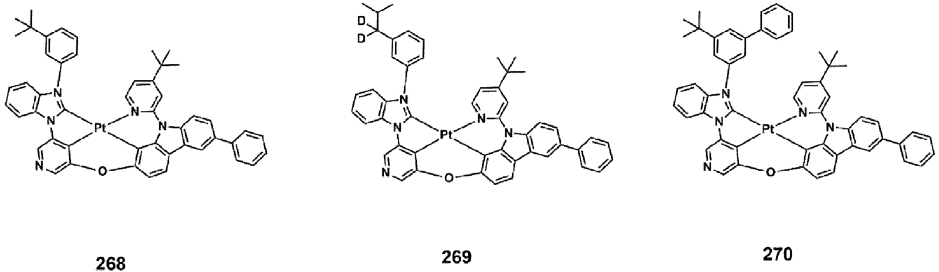

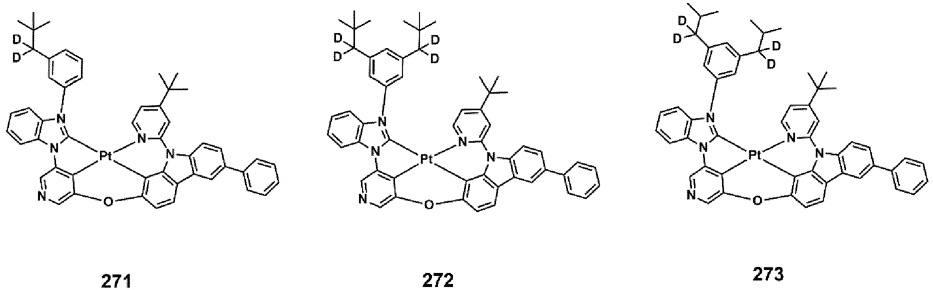

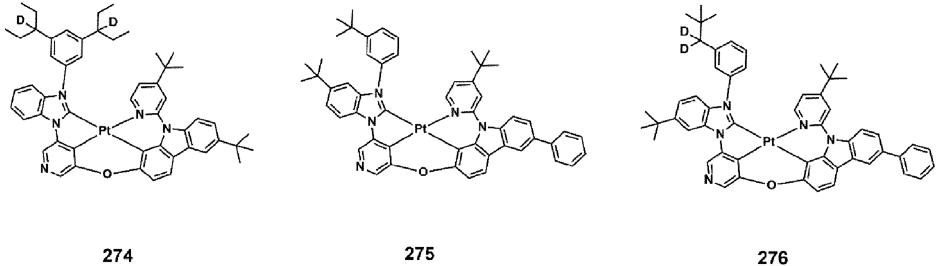

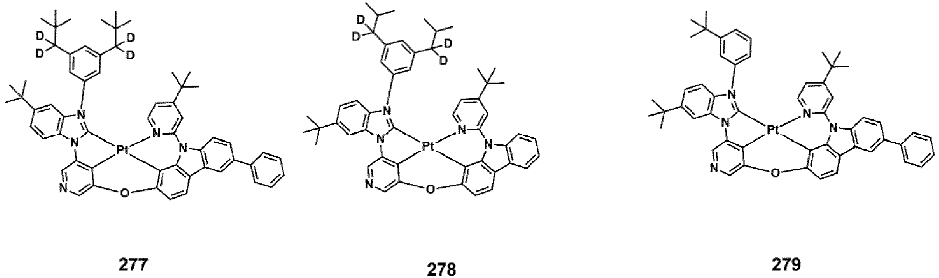

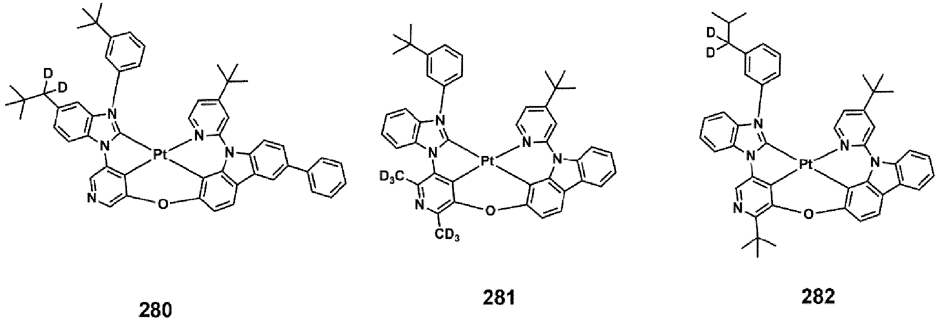

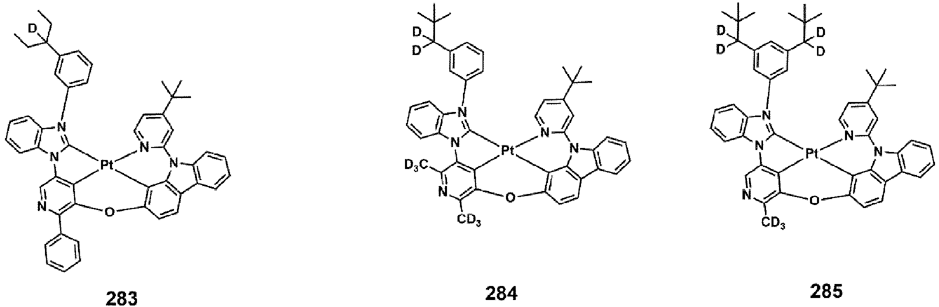

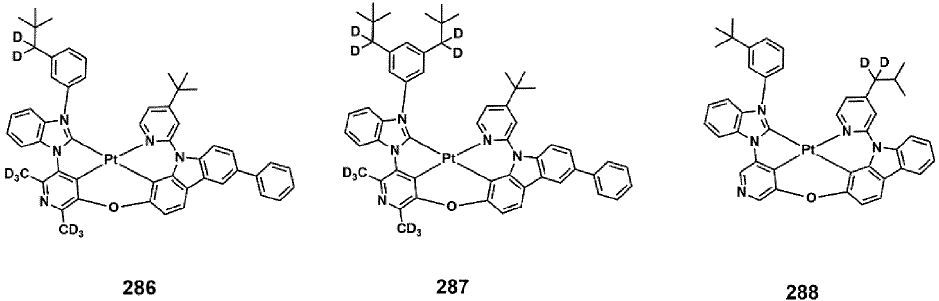

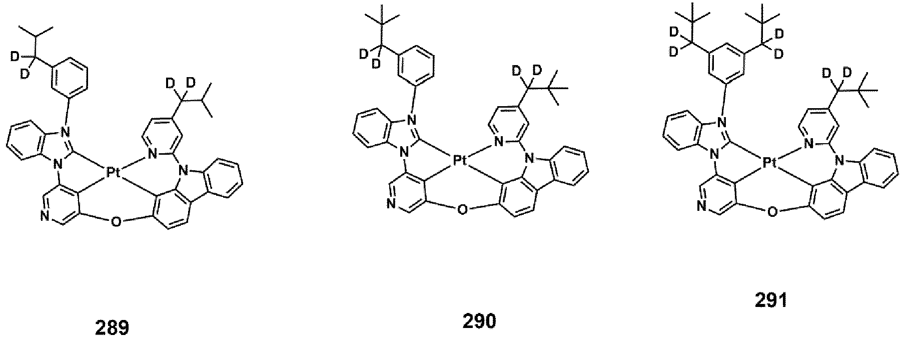

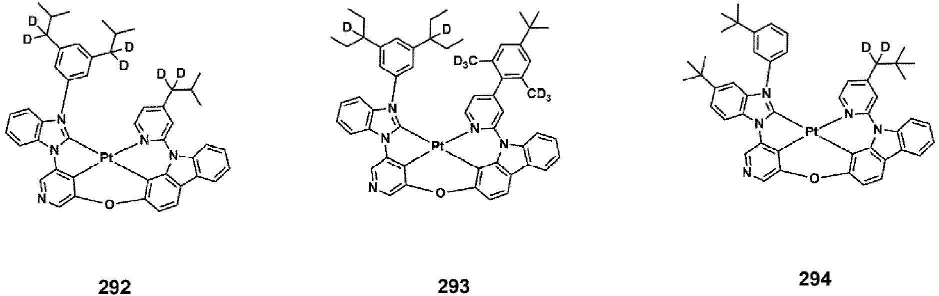

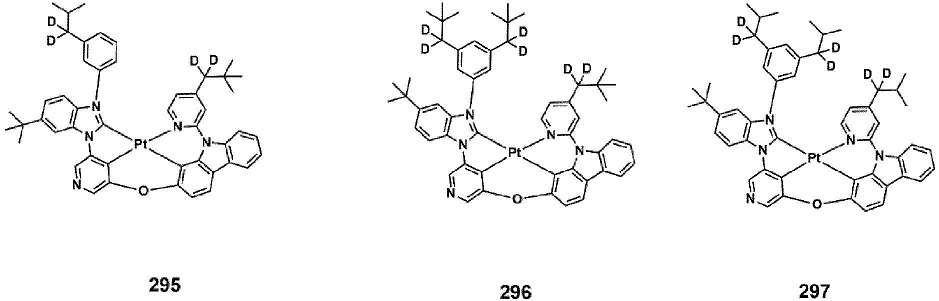

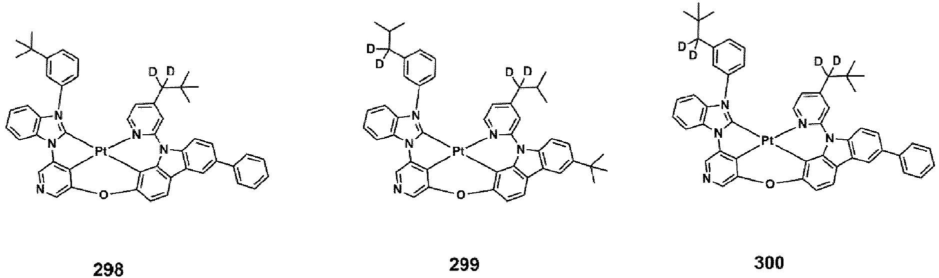

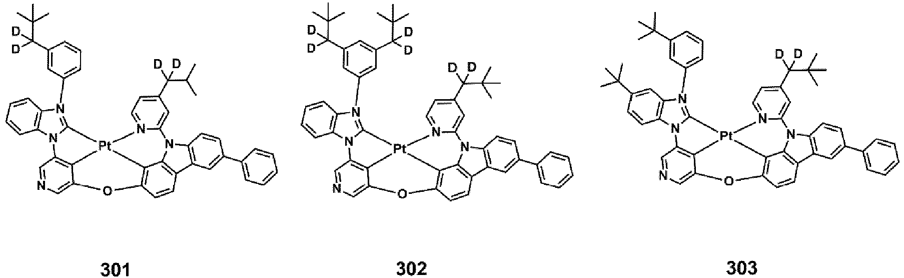

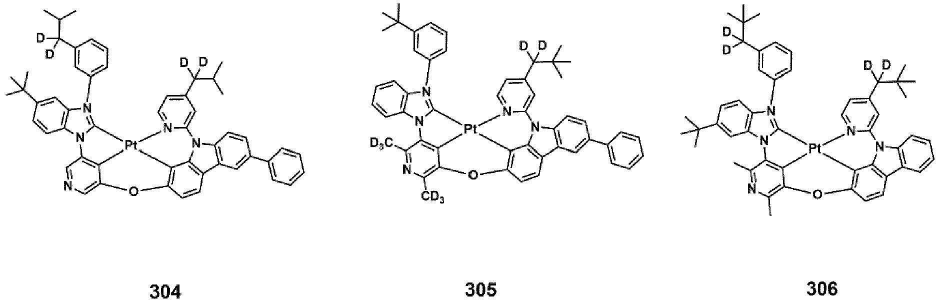

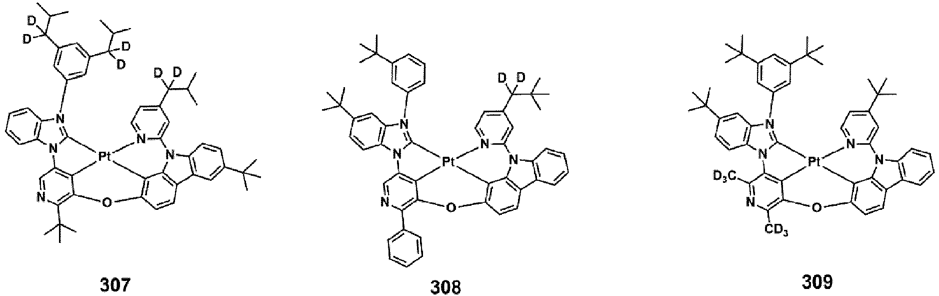

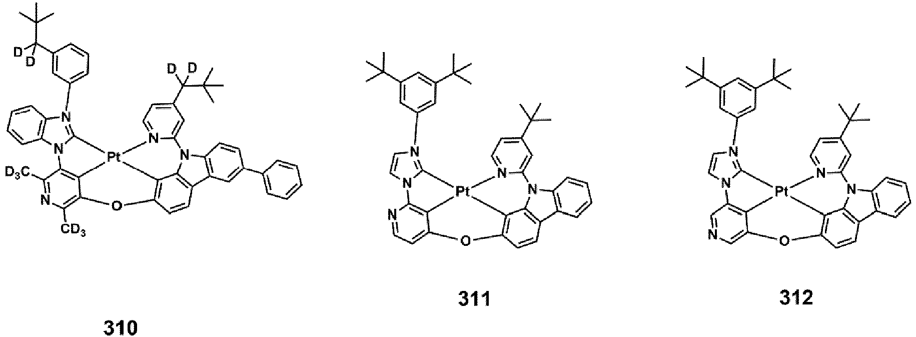

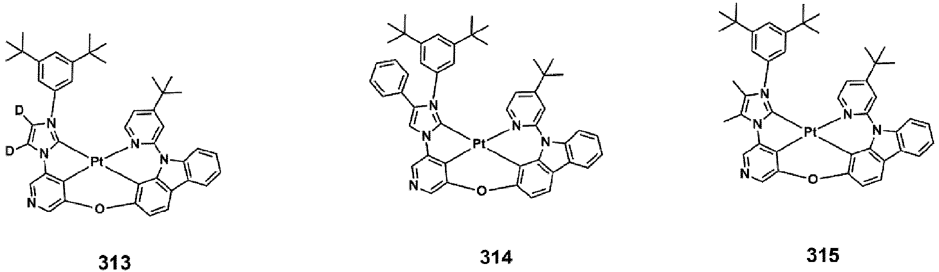

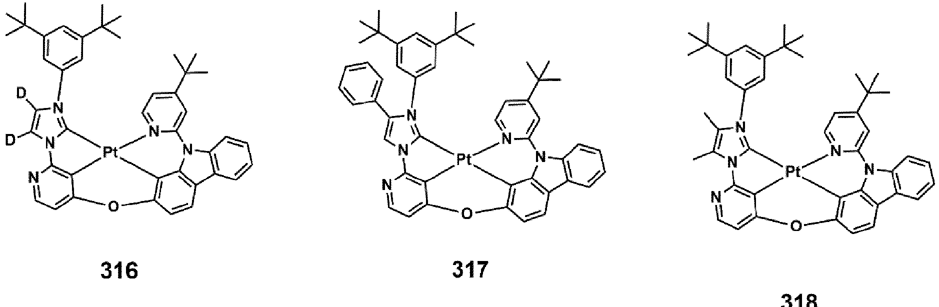

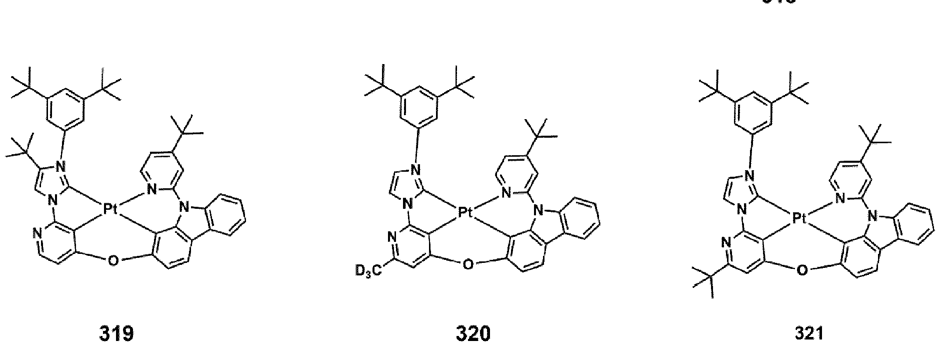

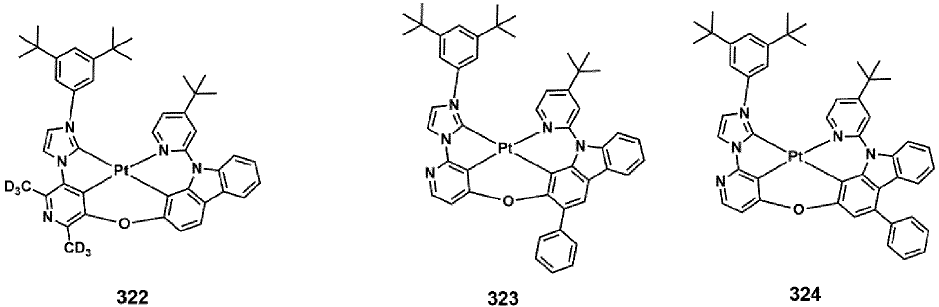

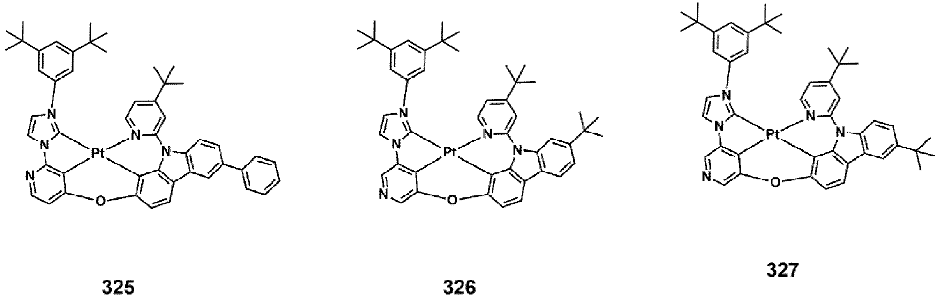

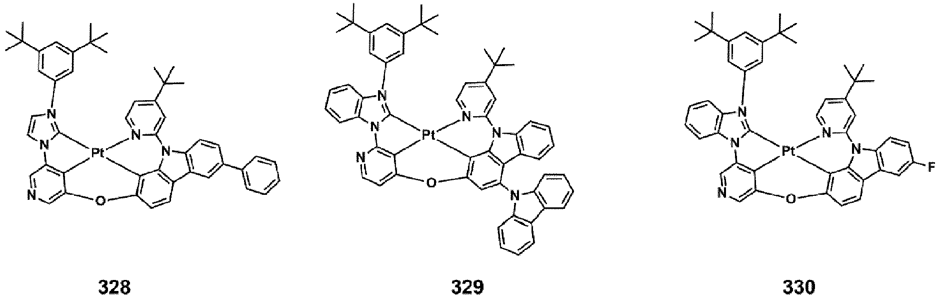

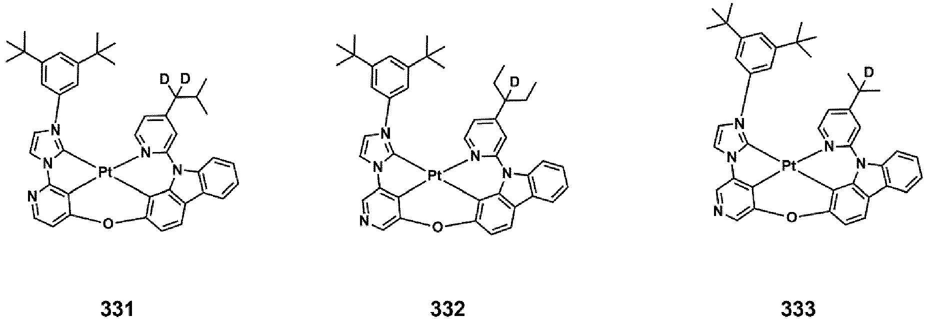

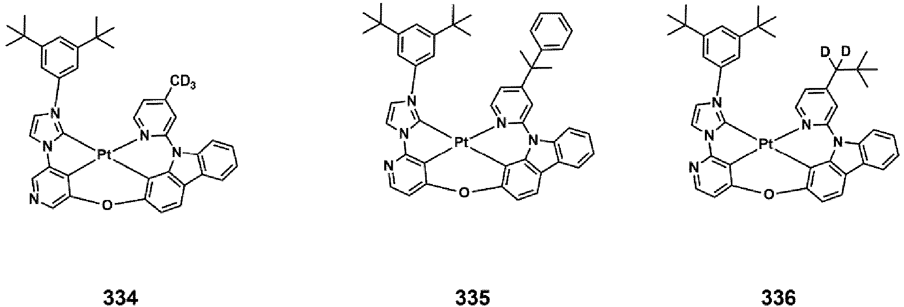

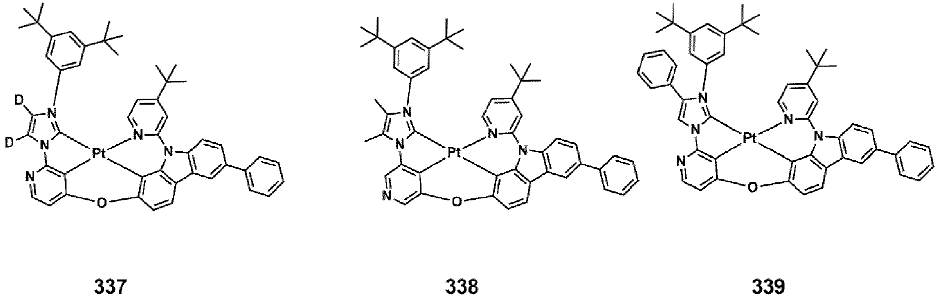

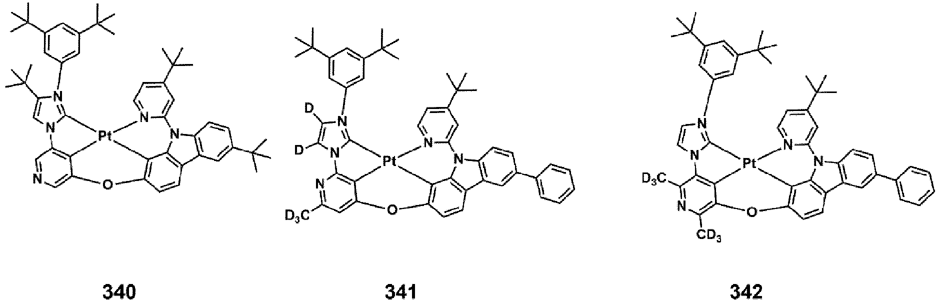

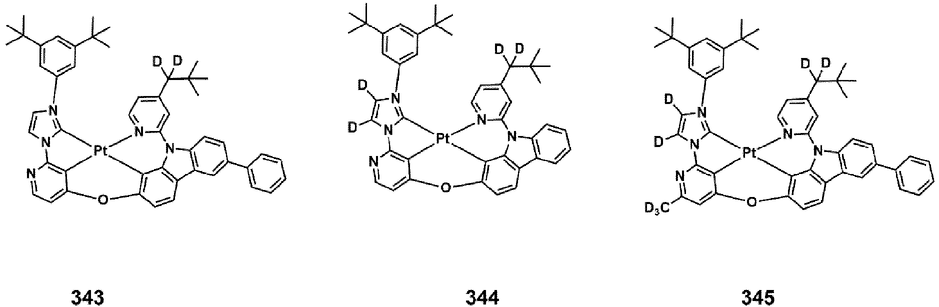

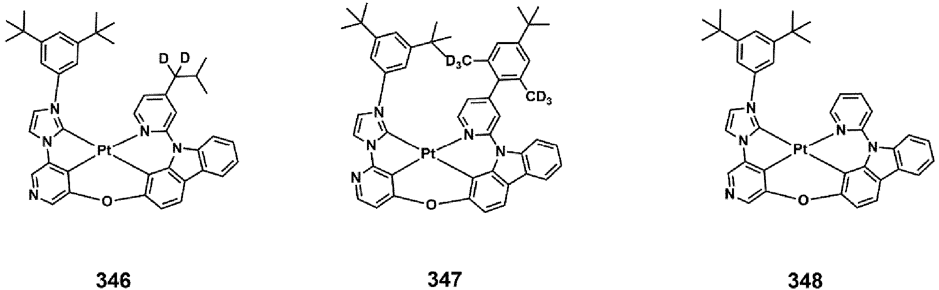

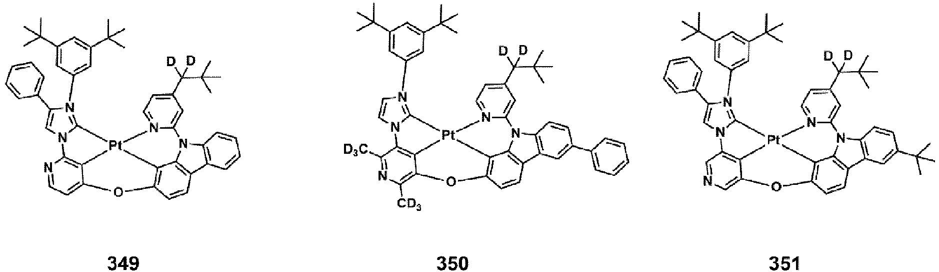

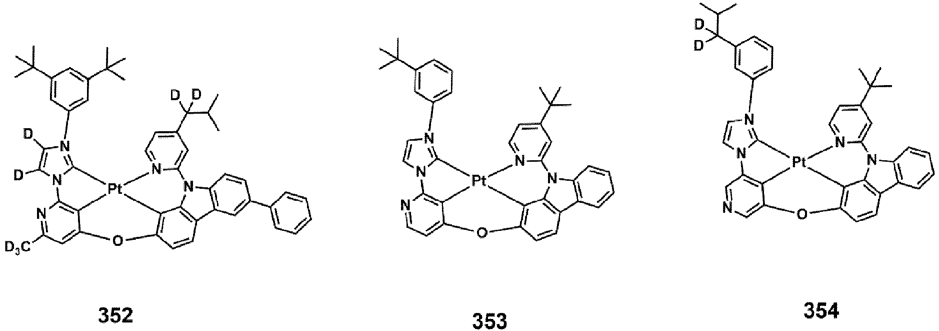

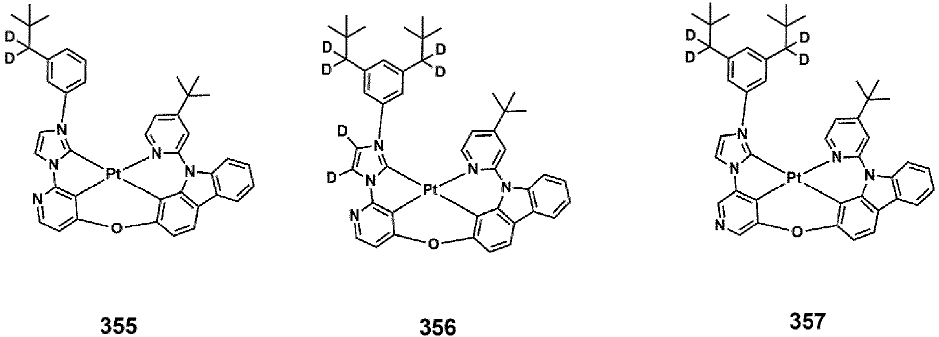

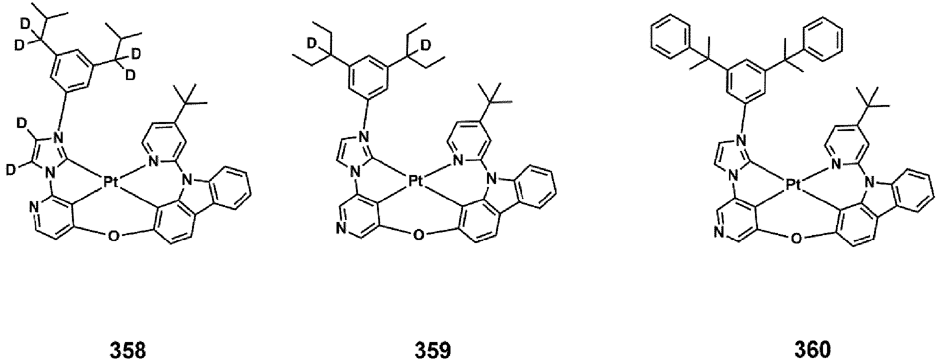

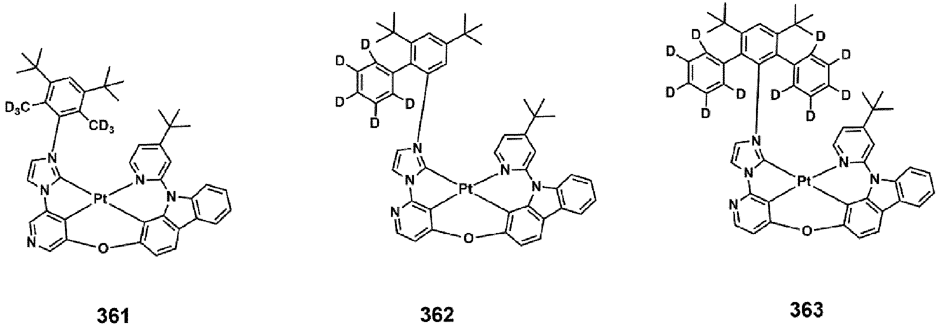

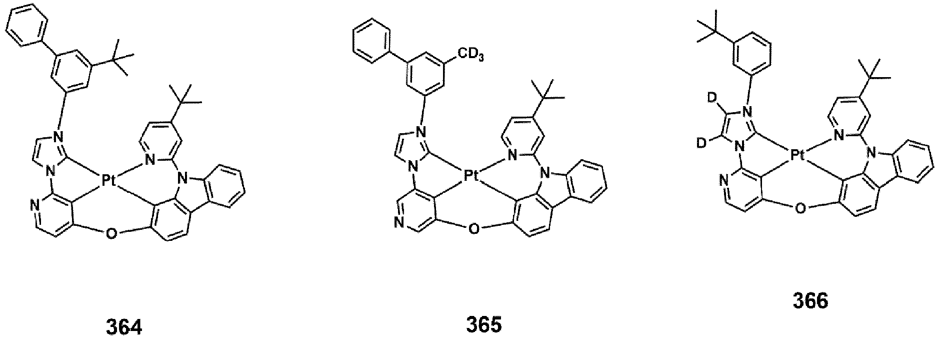

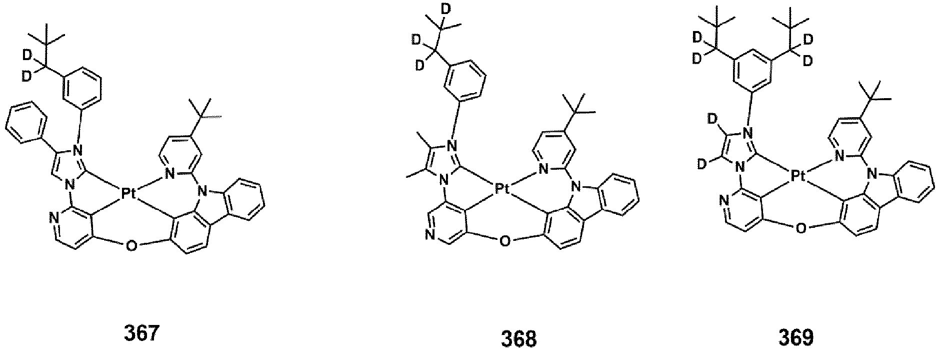

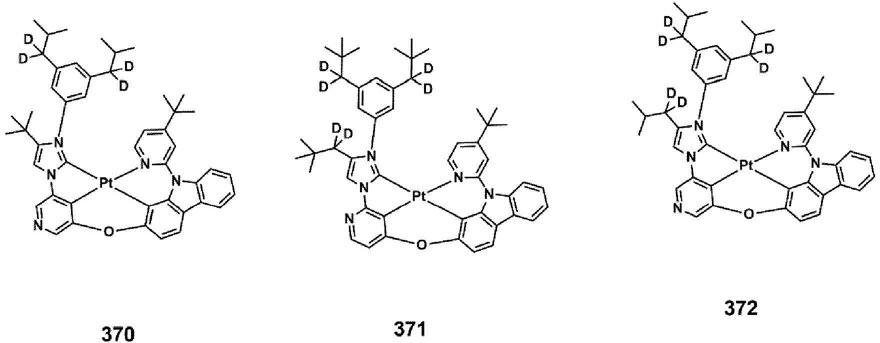

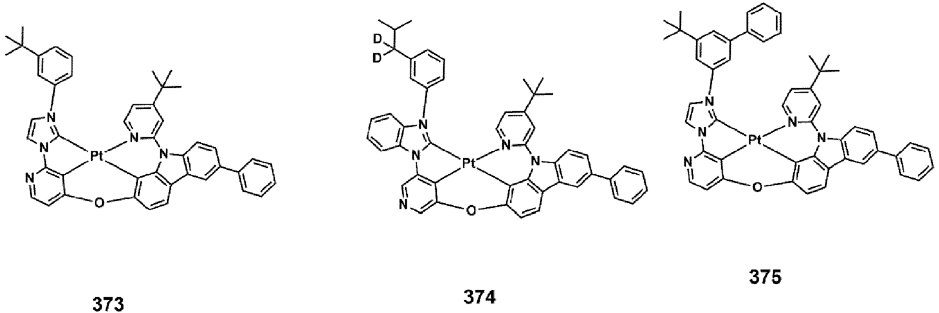

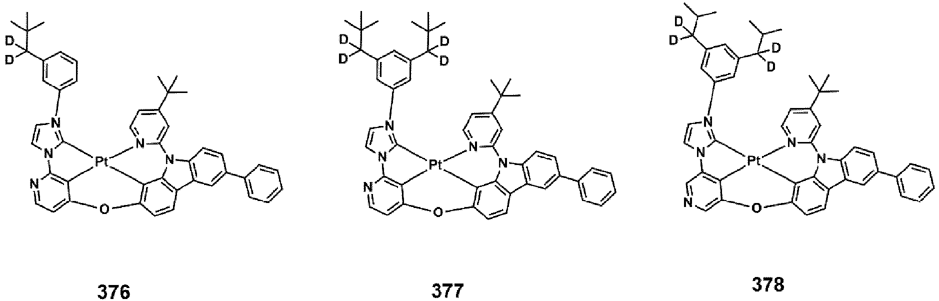

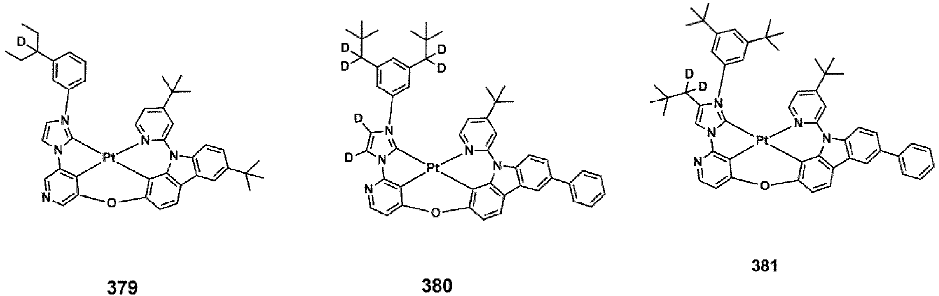

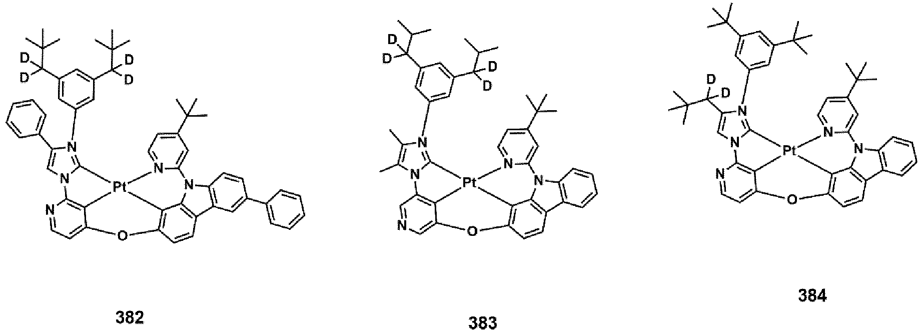

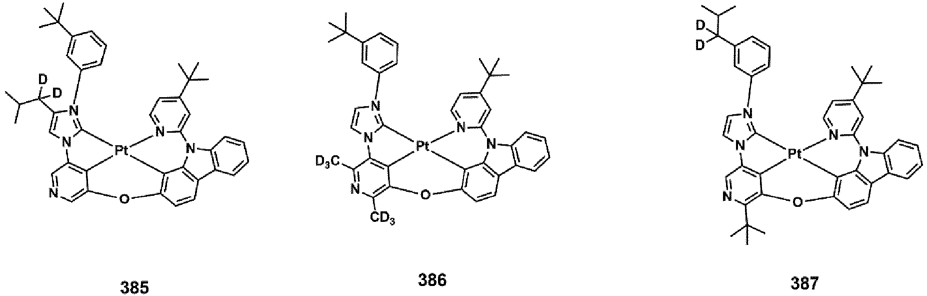

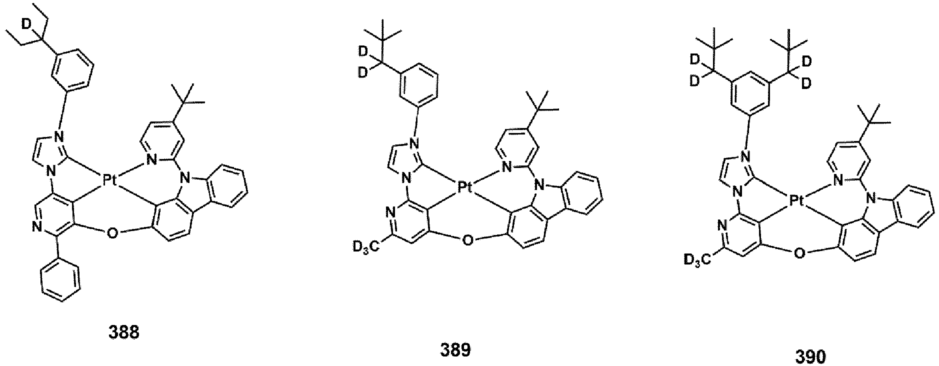

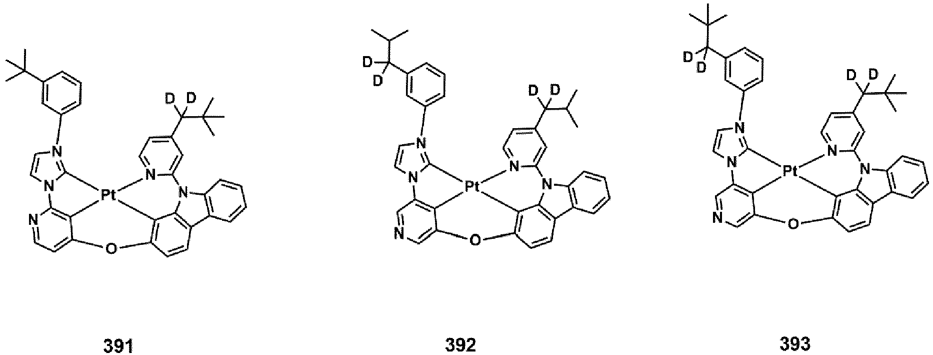

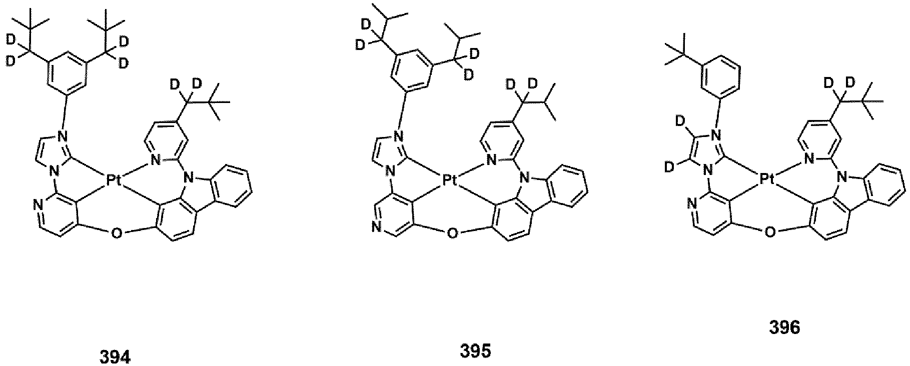

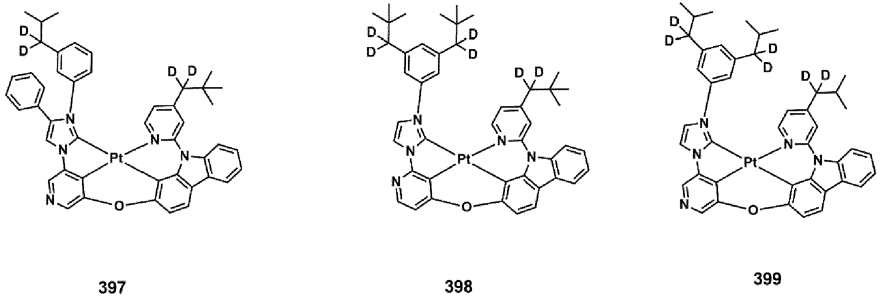

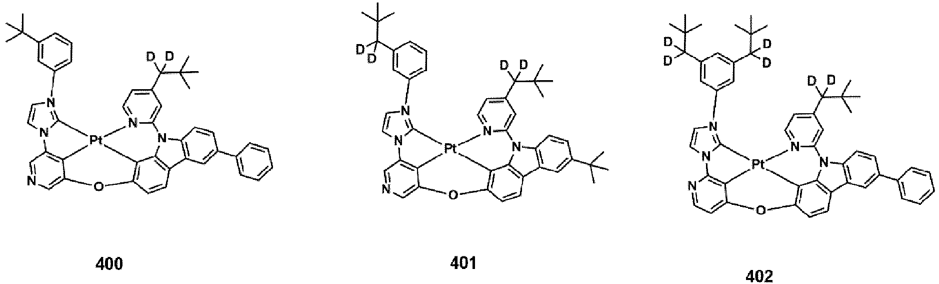

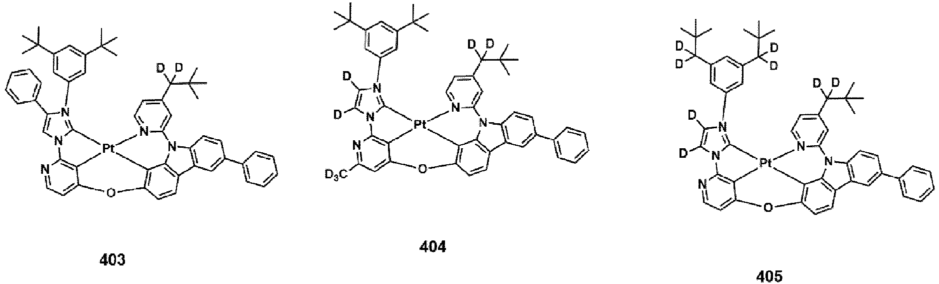

13. An organic light-emitting device, comprising:
a first electrode;
a second electrode; and
an organic layer arranged between the first electrode and the second electrode, wherein the organic layer comprises an emission layer, and
wherein the organic layer further comprises at least one of the organometallic compound of any of claims 1-12;
preferably wherein the emission layer comprises the at least one of the organometallic compound;
preferably wherein the emission layer emits a light having a maximum emission wavelength of 410 nanometers to 490 nanometers.

14. The light-emitting device of claim 13, wherein
the first electrode is an anode,
the second electrode is a cathode,
the organic layer further comprises a hole transport region arranged between the first electrode and the emission layer, and an electron transport region arranged between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

15. An electronic apparatus, comprising the organic light-emitting device of claims 13 or 14.

## Patentansprüche

1. Organometallische Verbindung dargestellt durch Formel 1: 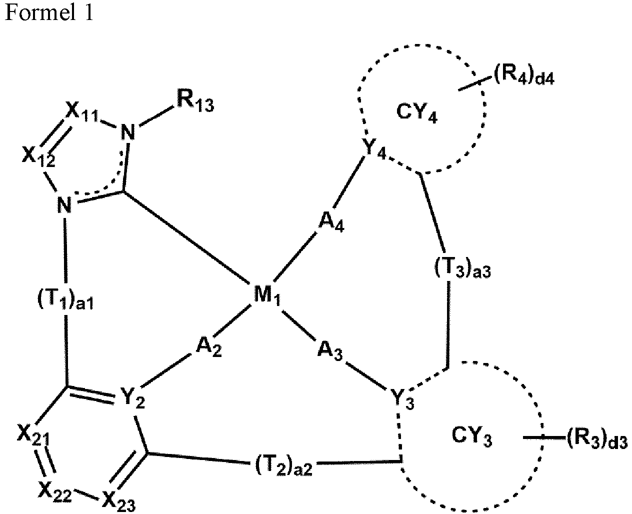 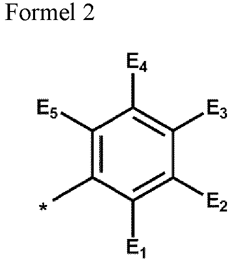 wobei in Formel 1 und 2
M₁ ein Übergangsmetall ist,
X₁₁ N oder C(R₁₁) ist,
X₁₂ N oder C(R₁₂) ist,
X₂₁ N oder C(R₂₁) ist,
X₂₂ N oder C(R₂₂) ist,
X₂₃ N oder C(R₂₃) ist,
zumindest eines von X₂₁ und X₂₂ N ist,
Y₂ bis Y₄ jeweils unabhängig C oder N sind,
A₂ bis A₄ jeweils unabhängig eine chemische Bindung, O oder S sind,
Ring CY₃ und Ring CY₄ jeweils unabhängig eine carbocyclische C₅-C₃₀-Gruppe oder eine heterocyclische C₁-C₃₀-Gruppe sind,
T₁ eine Einfachbindung, eine Doppelbindung, *-N[(L₁)_{b1}-(R₁ₐ)]-*', *-B(R₁ₐ)-*', *-P(R₁ₐ)-*', *-C(R₁ₐ)(R₁₆)-*', *-Si(R₁ₐ)(R₁₆)-*', *-Ge(R₁ₐ)(R₁ₚ)-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*' oder *-C≡C-*' ist,
T₂ eine Einfachbindung, eine Doppelbindung, *-N[(L₂)b₂-(R₂ₐ)]-*', *-B(R₂ₐ)-*', *-P(R₂ₐ)-*', *-C(R₂ₐ)(R₂₆)-*', *-Si(R₂ₐ)(R₂₆)-*', *-Ge(R₂ₐ)(R₂₆)-*', *-S-*', *-Se-*', *-O-*', *-C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*' oder *-C≡C-*' ist,
T₃ eine Einfachbindung, eine Doppelbindung, *-N[(L3)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*' oder *-C≡C-*' ist,
* und *' jeweils eine Bindungsstelle zu einem benachbarten Atom angeben,
a1 eine ganze Zahl von 1 bis 3 ist, und wenn a1 2 oder größer ist, zwei oder mehr von T₁ identisch miteinander oder unterschiedlich voneinander sind,
a2 eine ganze Zahl von 1 bis 3 ist, und wenn a2 2 oder größer ist, zwei oder mehr von T₂ identisch miteinander oder unterschiedlich voneinander sind,
a3 eine ganze Zahl von 1 bis 3 ist, und wenn a3 2 oder größer ist, zwei oder mehr von T₃ identisch miteinander oder unterschiedlich voneinander sind,
L₁ bis L₃ jeweils unabhängig eine Einfachbindung, eine carbocyclische C₅-C₃₀-Gruppe, unsubstituiert oder substituiert mit zumindest einem R₁₀ₐ, oder eine heterocyclische C₁-C₃₀-Gruppe, unsubstituiert oder substituiert mit zumindest einem R₁₀ₐ, sind,
b1 bis b3 jeweils unabhängig eine ganze Zahl von 1 bis 3 sind,
R₁₃ eine Gruppe dargestellt durch Formel 2 ist,
R₁ₐ, R₁₁, R₂ₐ, R_{2b}, R₃ₐ, R_{3b}, R₃, R₄, R₁₁, R₁₂, R₂₁ bis R₂₃ und E₁ bis E₅ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -Si(Q₁)(Q₂)(Q₃), -Ge(Q₁)(Q₂)(Q₃), -N(Q₄)(Q₅), -B(Q₆)(Q₇), - P(Q₈)(Q₉) oder -P(=O)(Q₈)(Q₉) sind,
benachbarte zwei oder mehr von R₁ₐ, R₁₁, R₂ₐ, R_{2b}, R₃ₐ, R_{3b}, R₁₁, R₁₂, R₂₁ bis R₂₃ und E₁ bis E₅ optional aneinander gebunden sind, um eine substituierte oder unsubstituierte carbocyclische C₅-C₃₀-Gruppe oder eine substituierte oder unsubstituierte heterocyclische C₁-C₃₀-Gruppe zu bilden,
zumindest eines von E₂ und E₄ nicht Wasserstoff ist,
R₁₀ₐ wie in Verbindung mit R₃ beschrieben ist,
d3 und d4 jeweils unabhängig eine ganze Zahl von 0 bis 20 sind,
wenn d3 2 oder größer ist, zwei oder mehr von R₃ identisch miteinander oder unterschiedlich voneinander sind, und wenn d4 2 oder größer ist, zwei oder mehr von R₄ identisch miteinander oder unterschiedlich voneinander sind,
* in Formel 2 eine Bindungsstelle zu einem benachbarten Atom angibt,
zumindest ein Substituent von der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten einwertigen nichtaromatischen kondensierten polycyclischen Gruppe und der substituierten einwertigen nichtaromatischen kondensierten heteropolycyclischen Gruppe wie folgt ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, -Si(Q₁₁)(Q₁₂)(Q₁₃), -Ge(Q₁₁)(Q₁₂)(Q₁₃), - N(Q₁₄)(Q₁₅), -B(Q₁₆)(Q₁₇), -P(Q₁₈)(Q₁₉), -P(=O)(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, - Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), -P(Q₂₈)(Q₂₉), - P(=O)(Q₂₈)(Q₂₉) oder einer Kombination davon; oder
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉) oder - P(⁼O)(Q₃₈)(Q₃₉), und
Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe oder eine substituierte oder unsubstituierte einwertige nichtaromatische kondensierte heteropolycyclische Gruppe sind.

2. Organometallische Verbindung nach Anspruch 1, wobei M₁ Iridium, Platin, Osmium, Titan, Zirkonium, Hafnium, Europium, Terbium, Thulium, Rhodium, Palladium oder Gold ist.

3. Organometallische Verbindung nach Anspruch 1 oder 2, wobei Formel 1 eine der Bedingungen 1-1 bis 1-3 erfüllt:
Bedingung 1-1
X₂₁ ist N und X₂₂ ist C(R₂₂);
Bedingung 1-2
X₂₁ ist C(R₂₁) und X₂₂ ist N;
Bedingung 1-3
X₂₁ ist N und X₂₂ ist N; und/oder
wobei Formel 2 zumindest eine der Bedingungen 2-1 und 2-2 erfüllt:
Bedingung 2-1
E₂ ist nicht Wasserstoff;
Bedingung 2-2
E₂ und E₄ sind nicht Wasserstoff.

4. Organometallische Verbindung nach einem der Ansprüche 1-3, wobei Ring CY₃ und Ring CY₄ jeweils unabhängig eine Benzolgruppe, eine Naphthalengruppe, eine Anthracengruppe, eine Phenanthrengruppe, eine Triphenylengruppe, eine Pyrengruppe, eine Chrysengruppe, eine Cyclopentadiengruppe, eine 1,2,3,4-Tetrahydronaphthalengruppe, eine Thiophengruppe, eine Furangruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-Oxidgruppe, eine 9H-Fluoren-9-on-Gruppe, eine Dibenzothiophen-5,5-Dioxidgruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe, eine Azadibenzoborolgruppe, eine Azadibenzophospholgruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-Oxidgruppe, eine Aza-9H-Fluoren-9-on-Gruppe, eine Azadibenzothiophen-5,5-Dioxidgruppe, eine Pyridingruppe, eine Pyrimidingruppe, eine Pyrazingruppe, eine Pyridazingruppe, eine Triazingruppe, eine Quinolingruppe, eine Isoquinolingruppe, eine Quinoxalingruppe, eine Quinazolingruppe, eine Phenanthrolingruppe, eine Pyrrolgruppe, eine Pyrazolgruppe, eine Imidazolgruppe, eine Triazolgruppe, eine Oxazolgruppe, eine Iso-Oxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzotriazolgruppe, eine Benzoxazolgruppe, eine Benzothiazolgruppe, eine Benzoxadiazolgruppe, eine Benzothiadiazolgruppe, eine 5,6,7,8-Tetrahydroisoquinolingruppe oder eine 5,6,7,8-Tetrahydroquinolingruppe sind; und/oder
wobei zumindest eines von Y₂ bis Y₄ N ist.

5. Organometallische Verbindung nach einem der Ansprüche 1-4, wobei zumindest eines von E₂ und E₄ wie folgt ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₂₀-Alkylgruppe, eine C₂-C₂₀-Alkenylgruppe, eine C₂-C₂₀-Alkinylgruppe, eine C₁-C₂₀-Alkoxygruppe oder eine C₁-C₂₀-Alkylthiogruppe;
eine C₁-C₂₀-Alkylgruppe, eine C₂-C₂₀-Alkenylgruppe, eine C₂-C₂₀-Alkinylgruppe, eine C₁-C₂₀-Alkoxygruppe oder eine C₁-C₂₀-Alkylthiogruppe, jeweils substituiert mit zumindest einem von Deuterium, -F, -Cl, - Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe oder einer Kombination davon;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Quinolinylgruppe, eine Isoquinolinylgruppe, eine Benzoquinolinylgruppe, eine Quinoxalinylgruppe, eine Quinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe oder eine Imidazopyrimidinylgruppe;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Quinolinylgruppe, eine Isoquinolinylgruppe, eine Benzoquinolinylgruppe, eine Quinoxalinylgruppe, eine Quinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe oder eine Imidazopyrimidinylgruppe, jeweils substituiert mit zumindest einem von Deuterium, -F, -Cl, -Br, -I, - SF₅, -CD₃, -CD₂H, - CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer C₁-C₂₀-Alkylthiogruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe, einer Imidazopyrimidinylgruppe, -Si(Q₃₁)(Q₃₂)(Q₃₃), - Ge(Q₃₁)(Q₃₂)(Q₃₃), -N(Q₃₄)(Q₃₅), -B(Q₃₆)(Q₃₇), -P(Q₃₈)(Q₃₉), -P(=O)(Q₃₉)(Q₃₉) oder einer Kombination davon; oder
-Si(Q₁)(Q₂)(Q₃), -Ge(Q₁)(Q₂)(Q₃), -N(Q₄)(Q₅), -B(Q₆)(Q₇), -P(Q₈)(Q₉) oder - P(=O)(Q₈)(Q₉), und
Q₁ bis Q₉ und Q₃₁ bis Q₃₉ jeweils unabhängig wie folgt sind:
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit zumindest einem von Deuterium, einer C₁-C₁₀-Alkylgruppe, einer Phenylgruppe oder einer Kombination davon.

6. Organometallische Verbindung nach einem der Ansprüche 1-5, wobei zumindest eines von E₂ und E₄ wie folgt ist:
Deuterium, -F, -Cl, -Br, -I, -SF₅, -CD₃, -CD₂H, -CDH₂, -CF₃, -CF₂H, -CFH₂, eine Cyanogruppe, eine C₁-C₂₀-Alkylgruppe, eine C₂-C₂₀-Alkenylgruppe, eine C₂-C₂₀-Alkinylgruppe, eine C₁-C₂₀-Alkoxygruppe oder eine C₁-C₂₀-Alkylthiogruppe;
eine Gruppe dargestellt durch eine der Formeln 9-1 bis 9-61, 9-201 bis 9-237, 10-1 bis 10-129 oder 10-201 bis 10-355;
eine Gruppe dargestellt durch eine der Formeln 9-1 bis 9-61, 9-201 bis 9-237, 10-1 bis 10-129 oder 10-201 bis 10-355, in der zumindest ein Wasserstoff mit zumindest einem von Deuterium, -F oder einer Cyanogruppe substituiert ist; oder
-Si(Q₁)(Q₂)(Q₃), -Ge(Q₁)(Q₂)(Q₃) oder -N(Q₄)(Q₅),
wobei Q₁ bis Q₅ jeweils wie in Anspruch 1 beschrieben sind: 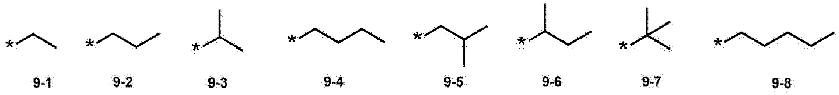 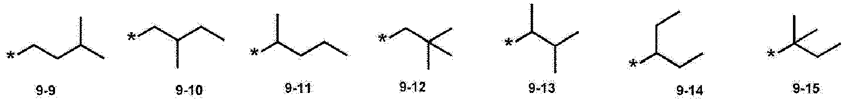 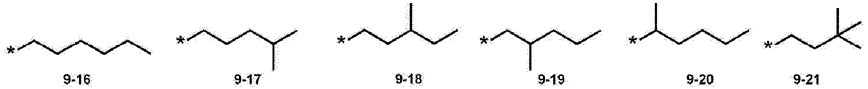 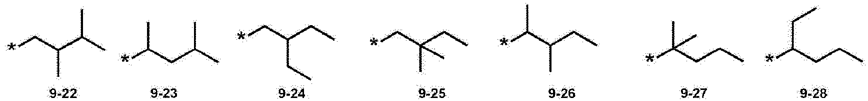 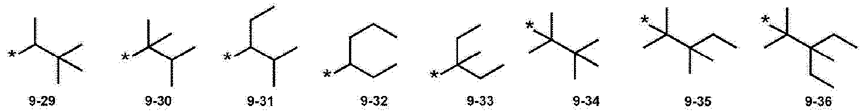 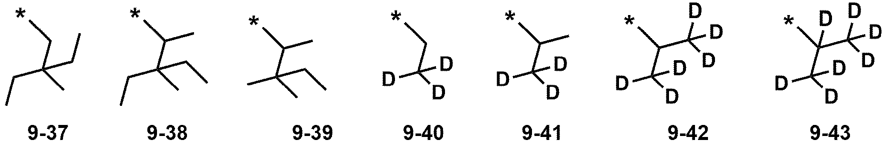 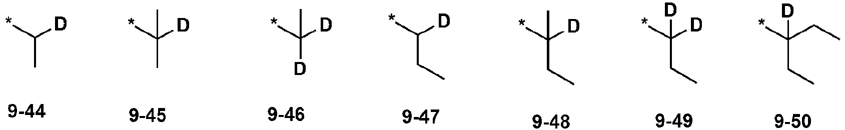 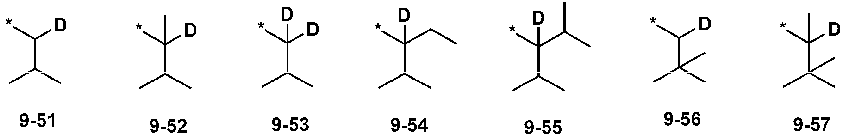 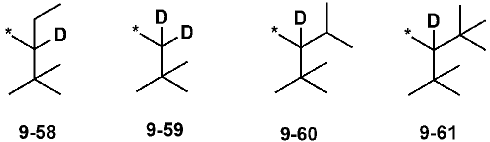 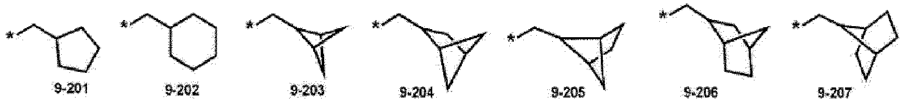 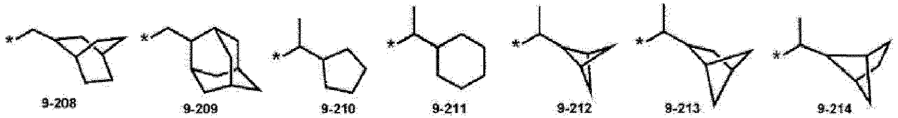 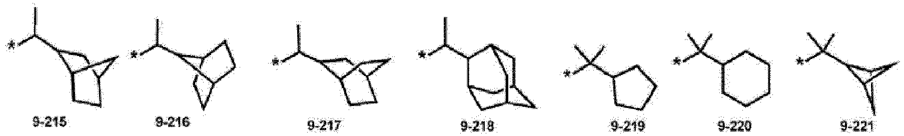 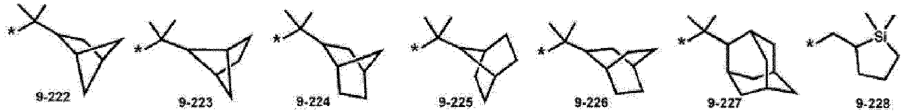 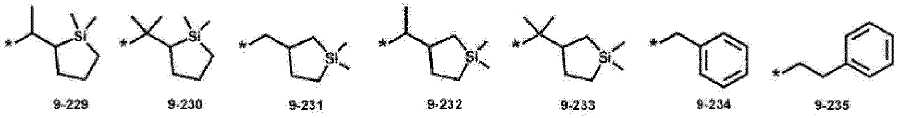 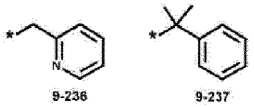 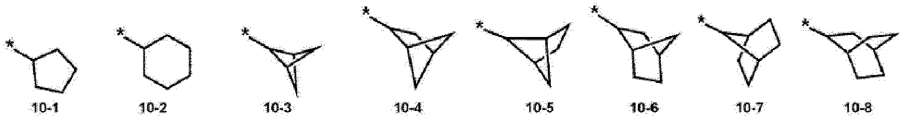 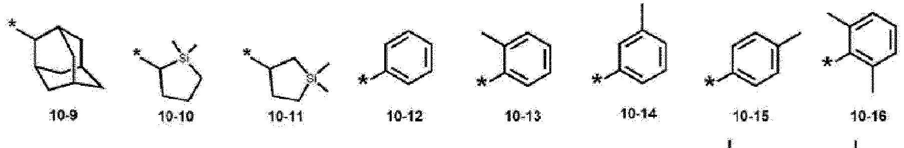 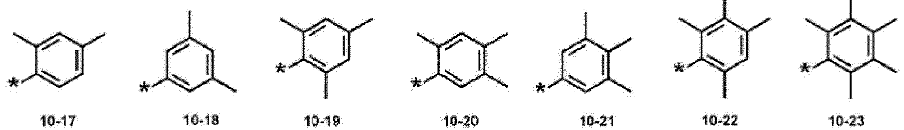 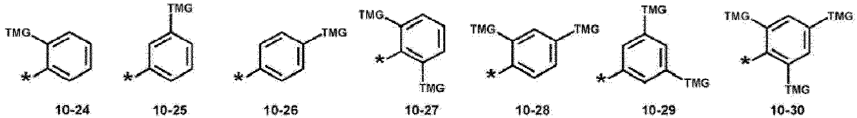 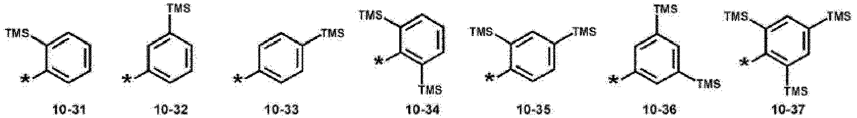 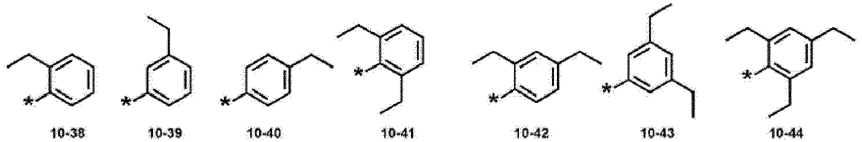 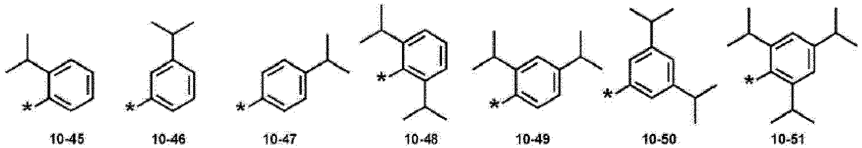 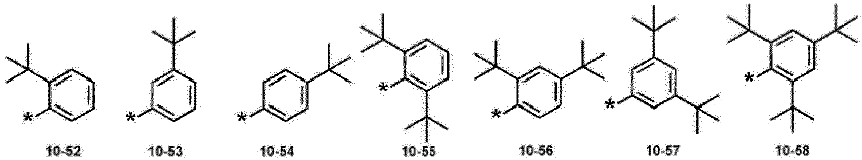 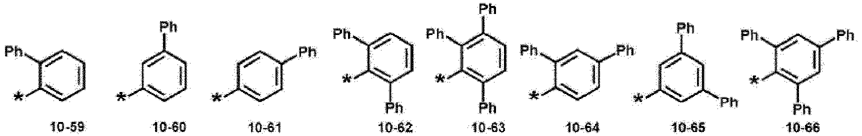 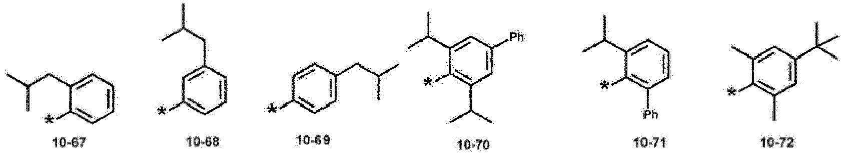 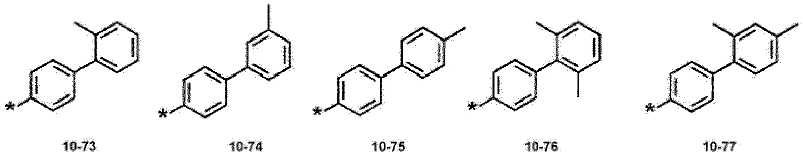 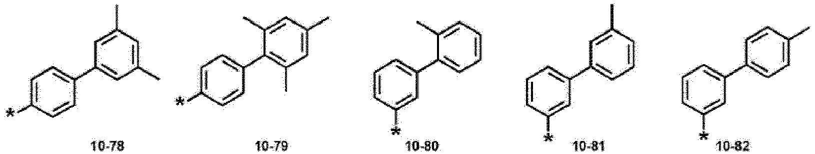 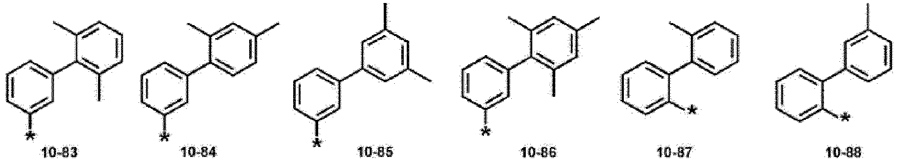 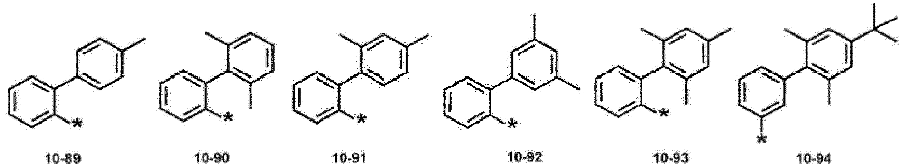 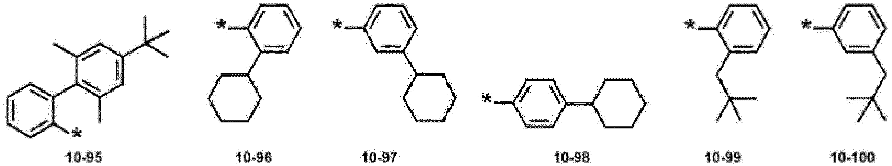 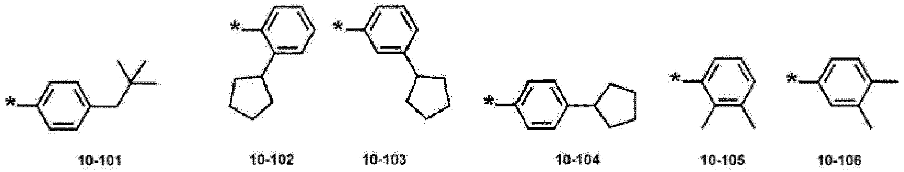 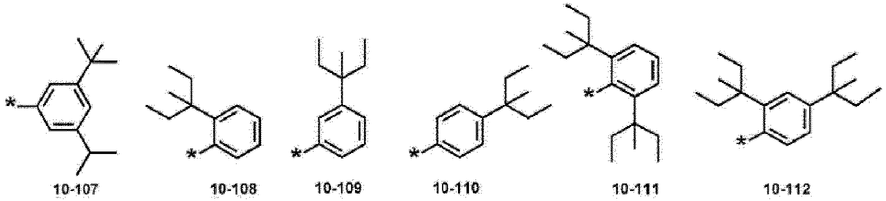 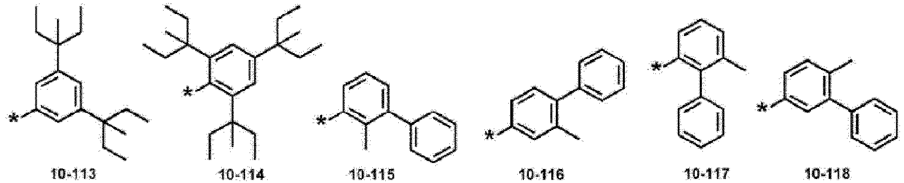 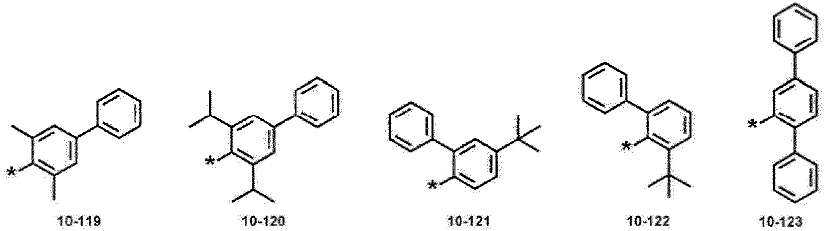 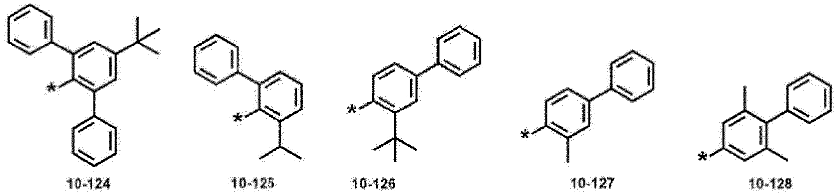 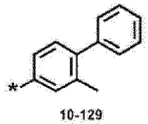 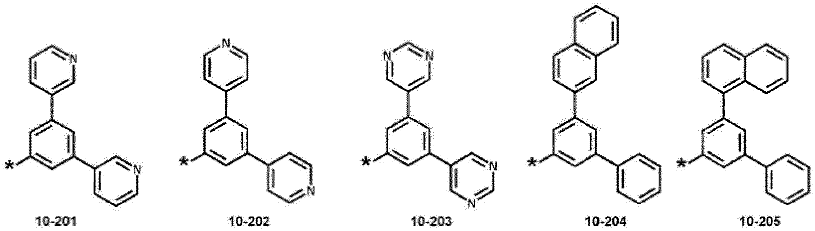 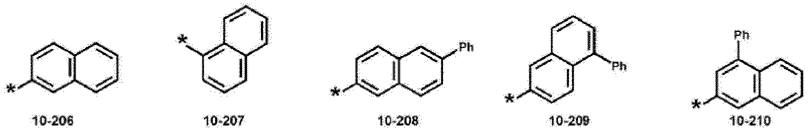 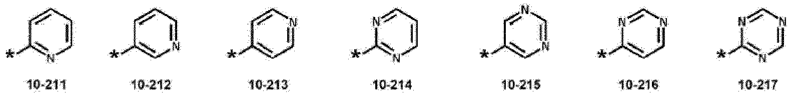 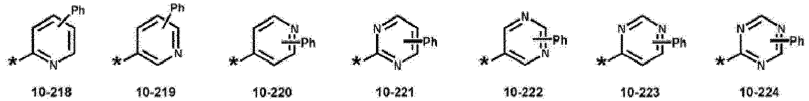 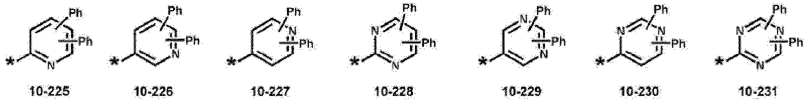 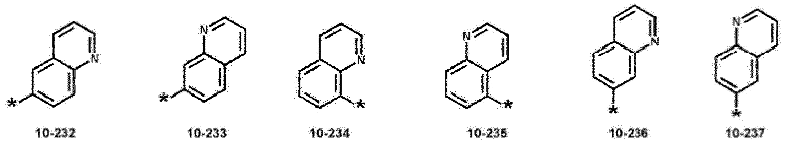 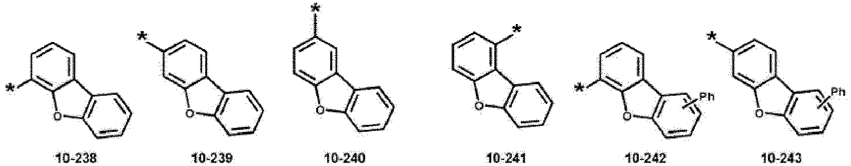 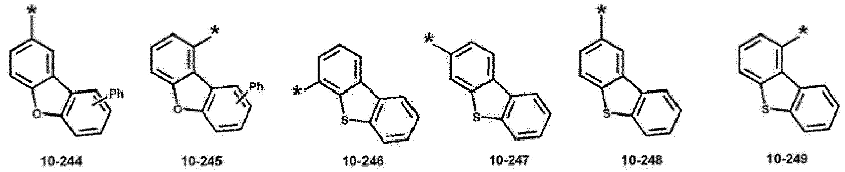 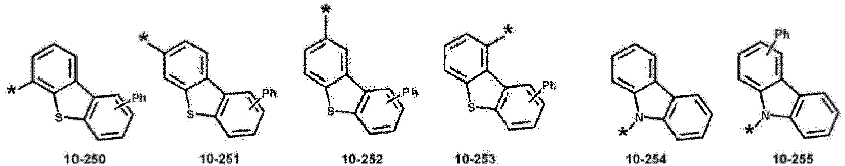 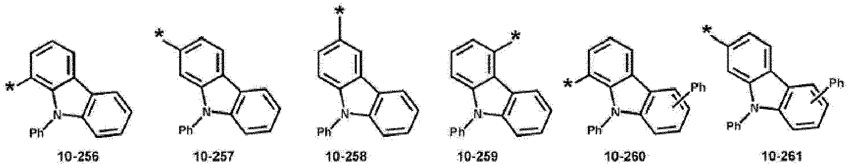 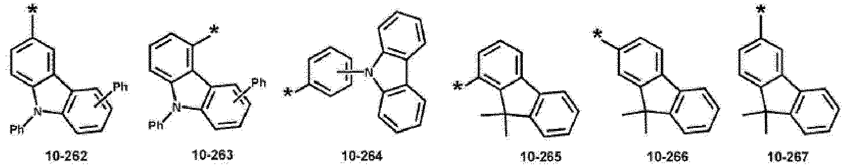 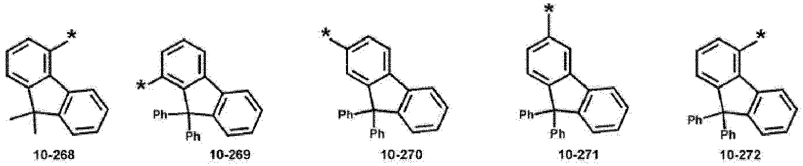 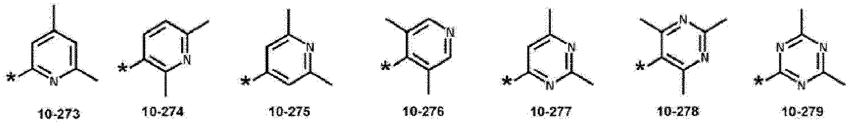 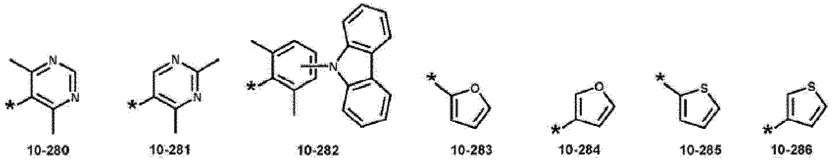 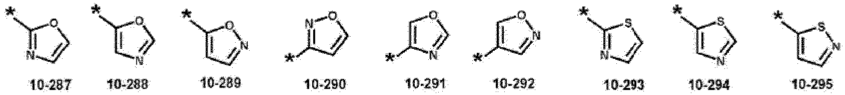 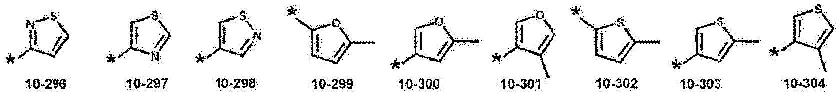 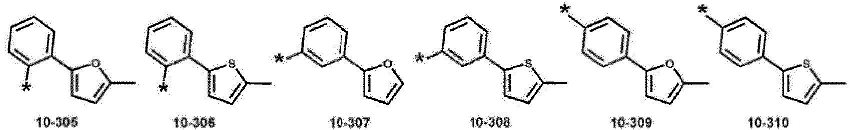 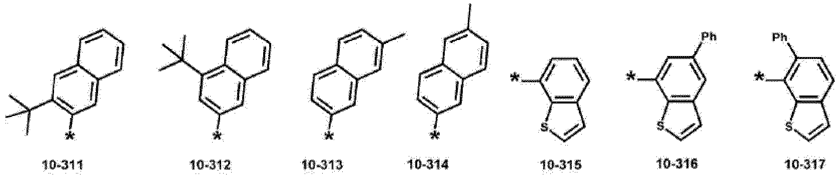 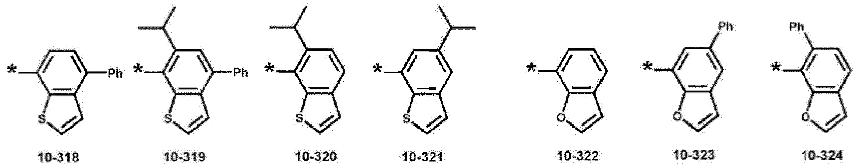 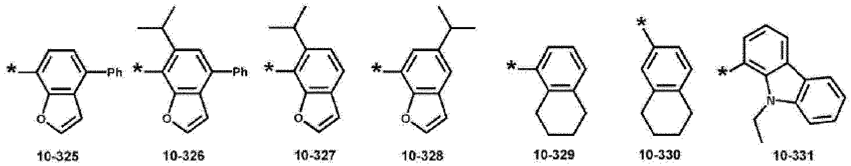 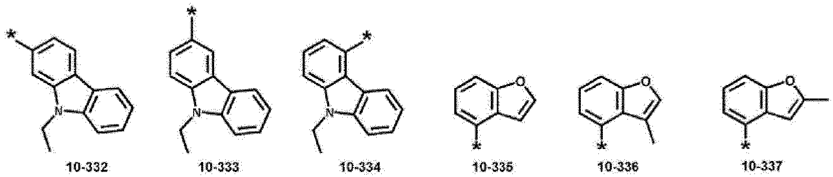 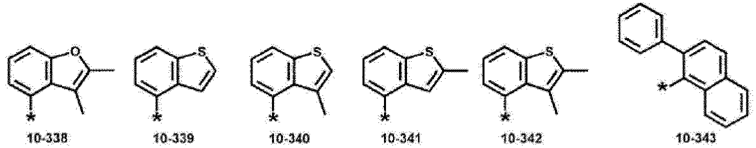 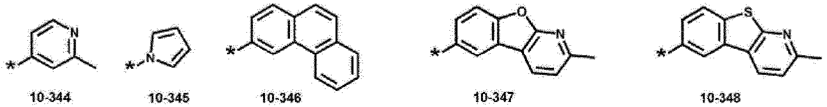 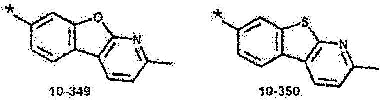 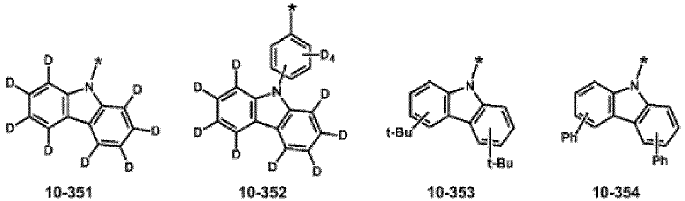 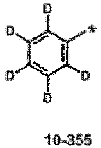
wobei * in Formel 9-1 bis 9-61, 9-201 bis 9-237, 10-1 bis 10-129 und 10-201 bis 10-355 eine Bindungsstelle zu einem benachbarten Atom angibt, "Ph" eine Phenylgruppe ist, "TMS" eine Trimethylsilylgruppe ist, "TMG" eine Trimethylgermylgruppe ist und "t-Bu" eine t-Butylgruppe ist.

7. Organometallische Verbindung nach einem der Ansprüche 1-6, wobei eine Gruppe dargestellt durch 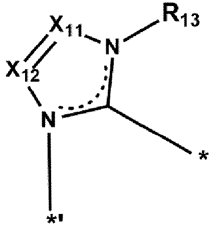 in Formel 1 eine Gruppe dargestellt durch Formel CY1-1 oder CY1-2 ist: 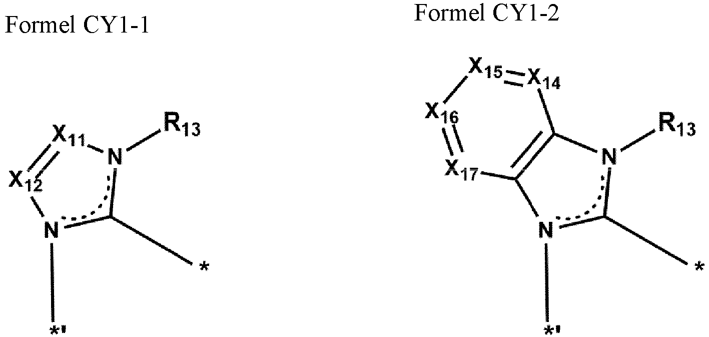 wobei in Formel CY1-1 und CY1-2
X₁₁, X₁₂ und R₁₃ jeweils wie in Anspruch 1 beschrieben sind,
X₁₄ N oder C(R₁₄) ist,
X₁₅ N oder C(R₁₅) ist,
X₁₆ N oder C(R₁₆) ist,
X₁₇ N oder C(R₁₇) ist,
R₁₄ bis R₁₇ jeweils wie für R₁₁ in Anspruch 1 definiert sind,
* eine Bindungsstelle zu M₁ angibt, und
*' eine Bindungsstelle zu T₁ angibt.

8. Organometallische Verbindung nach einem der Ansprüche 1-7, wobei eine Gruppe dargestellt durch 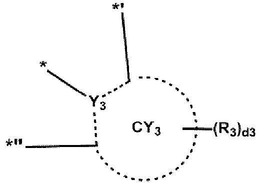 in Formel 1 eine Gruppe dargestellt durch eine der Formeln 3-1 bis 3-3 ist: 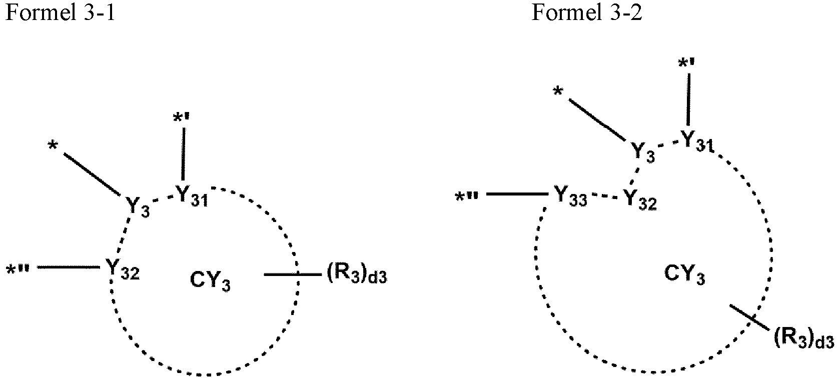 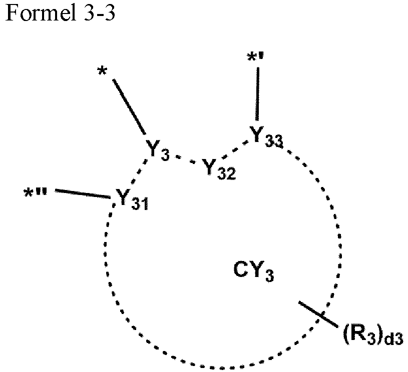 wobei in Formel 3-1 bis 3-3
Y₃₁ bis Y₃₃ jeweils unabhängig C oder N sind,
Y₃₁ und Y₃, Y₃ und Y₃₂ und Y₃₂ und Y₃₃ chemisch aneinander gebunden sind,
*' eine Bindungsstelle zu T₃ angibt, *" eine Bindungsstelle zu T₂ angibt, * eine Bindungsstelle zu A₃ oder M₁ angibt, und
CY₃, Y₃, R₃ und d3 jeweils wie in Anspruch 1 beschrieben sind.

9. Organometallische Verbindung nach einem der Ansprüche 1-8, wobei eine Gruppe dargestellt durch 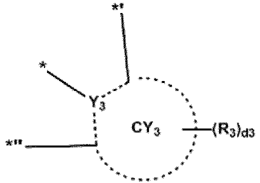 in Formel 1 eine Gruppe dargestellt durch eine der Formeln CY3-1 bis CY3-27 ist: 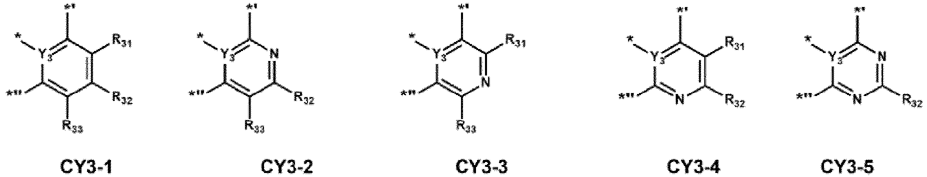 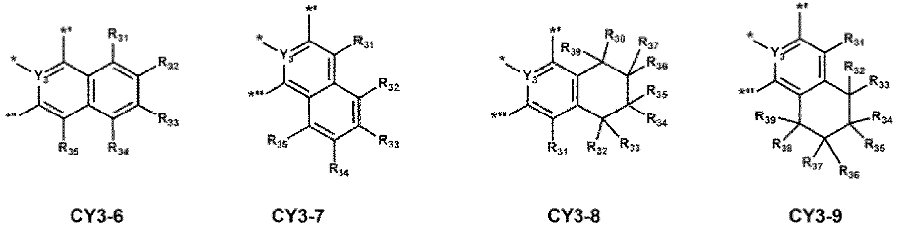 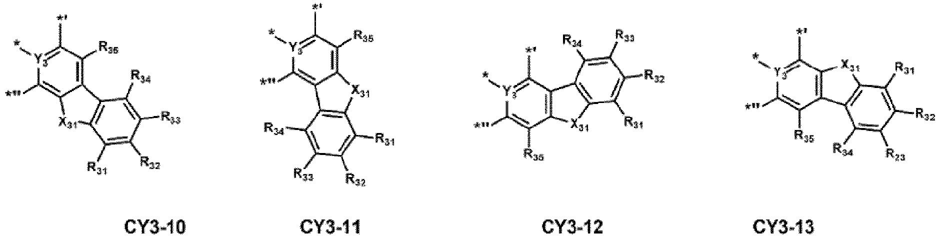 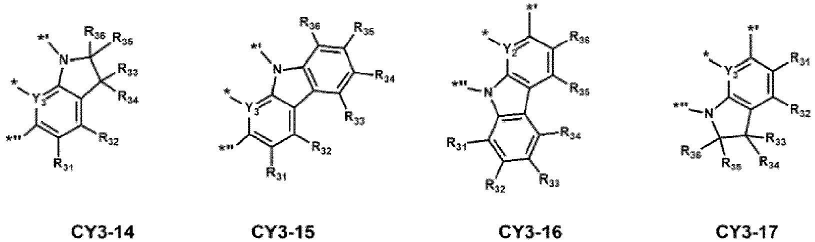 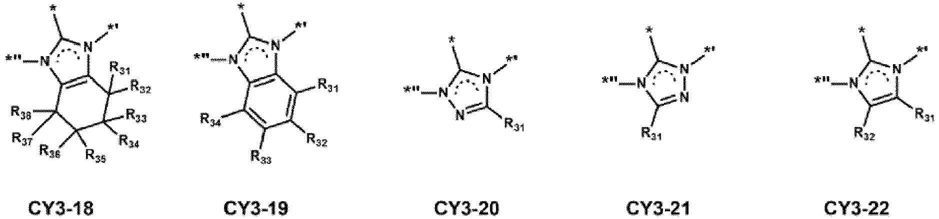 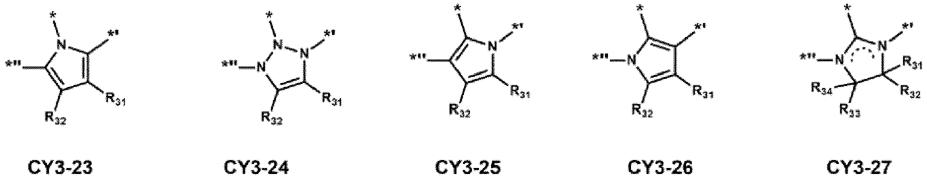 wobei in Formel CY3-1 bis CY3-27
Y₃ C oder N ist,
X₃₁ N(R₃₁ₐ), O, Se, C(R₃₁ₐ)(R_{31b}) oder Si(R₃₁ₐ)(R_{31b}) ist,
R₃₁ bis R₃₉, R₃₁ₐ und R_{31b} jeweils wie R₃ in Anspruch 1 definiert sind,
* eine Bindungsstelle zu M₁ oder A₃ angibt, *' eine Bindungsstelle zu T₃ angibt und *" eine Bindungsstelle zu T₂ angibt.

10. Organometallische Verbindung nach einem der Ansprüche 1-9, wobei eine Gruppe dargestellt durch 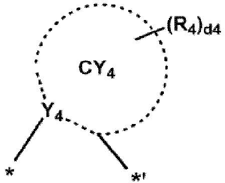 in Formel 1 eine Gruppe dargestellt durch eine der Formeln CY4-1 bis CY4-18 ist, 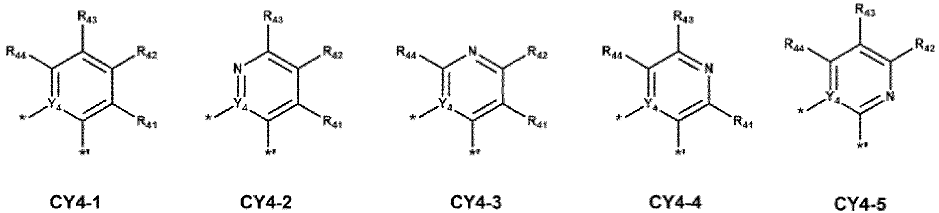 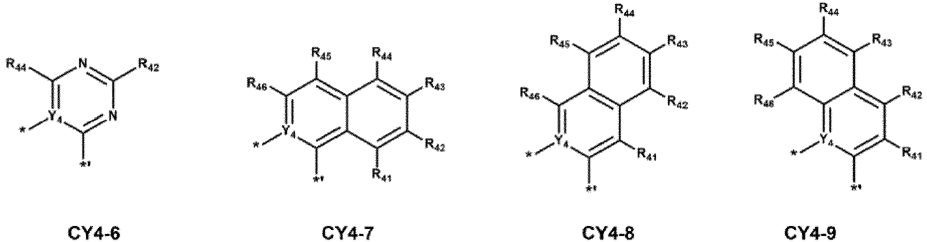 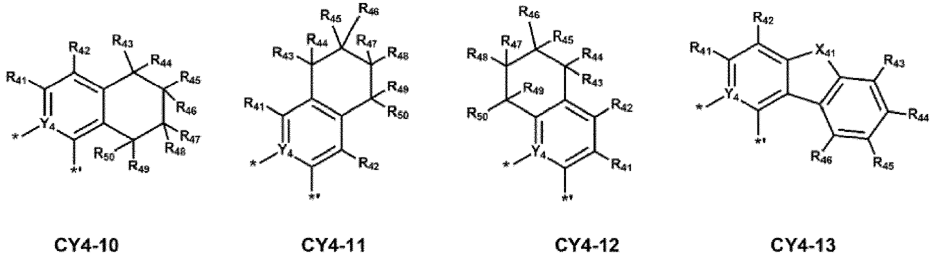 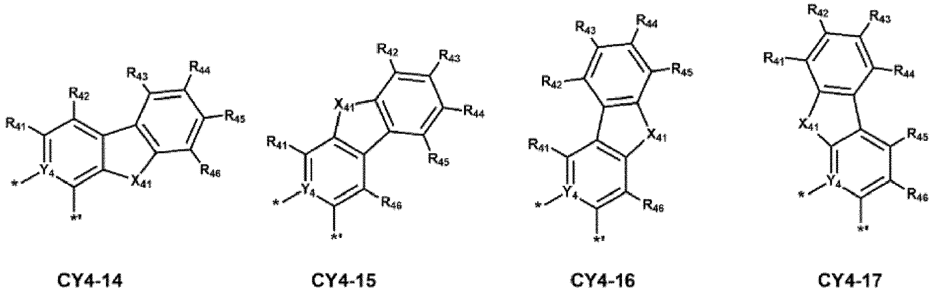 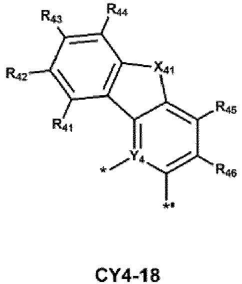 wobei in Formel CY4-1 bis CY4-18
Y₄ C oder N ist,
X₄₁ N(R₄₁ₐ), O, Se, C(R₄₁ₐ)(R_{41b}) oder Si(R₄₁ₐ)(R_{41b}) ist,
R₄₁ bis R₅₀, R₄₁ₐ und R_{41b} jeweils wie R₄ in Anspruch 1 definiert sind,
* eine Bindungsstelle zu M₁ oder A₄ angibt, und
*' eine Bindungsstelle zu T₃ angibt.

11. Organometallische Verbindung nach einem der Ansprüche 1-10, wobei die organometallische Verbindung durch eine der Formeln 1-1 bis 1-2 dargestellt ist: 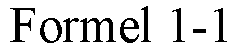 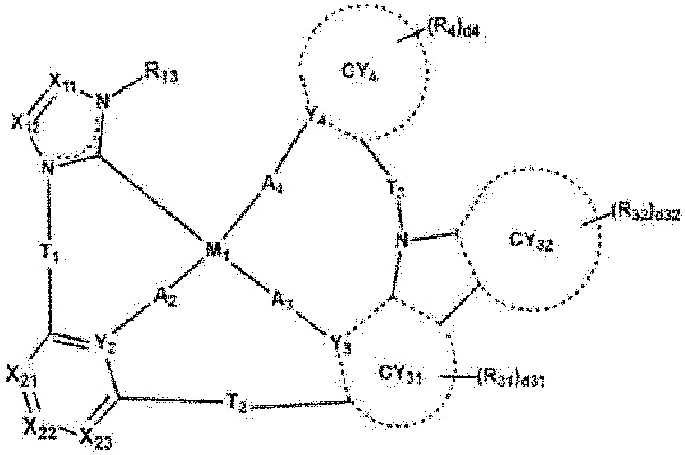 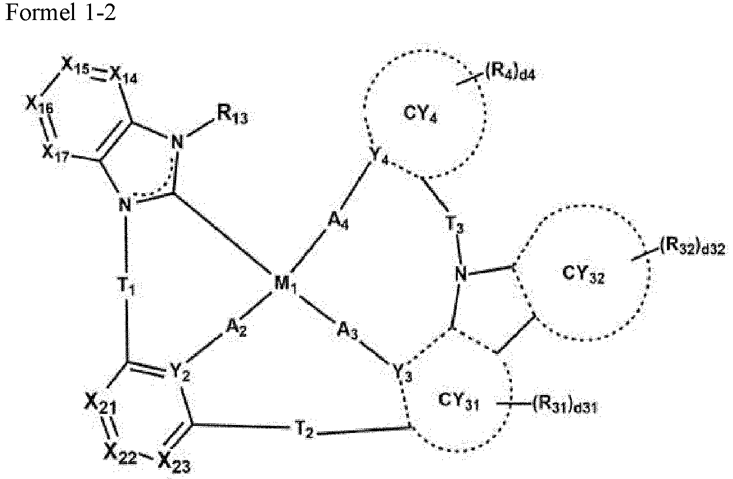 wobei in Formel 1-1 und 1-2
Ring CY₃₁ und Ring CY₃₂ jeweils unabhängig eine carbocyclische C₅-C₃₀-Gruppe oder eine heterocyclische C₁-C₃₀-Gruppe sind,
R₃₁ und R₃₂ jeweils wie R₃ in Anspruch 1 definiert sind,
d31 und d32 jeweils unabhängig eine ganze Zahl von 0 bis 10 sind,
X₁₄ N oder C(R₁₄) ist,
X₁₅ N oder C(R₁₅) ist,
X₁₆ N oder C(R₁₆) ist,
X₁₇ N oder C(R₁₇) ist,
R₁₄ bis R₁₇ jeweils wie R₁₁ in Anspruch 1 definiert sind, und
M₁, Ring CY₄, Y₂ bis Y₄, A₂ bis A₄, T₁ bis T₃, X₁₁, X₁₂, X₂₁ bis X₂₃, R₄, d4 und R₁₃ jeweils wie in Anspruch 1 beschrieben sind; und/oder
wobei Formel 2 durch eine der Formeln 2-1 bis 2-16 dargestellt ist: 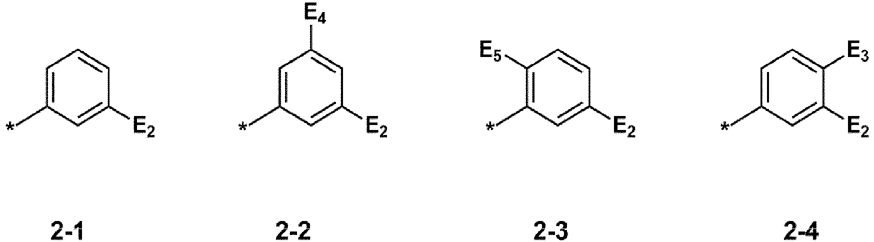 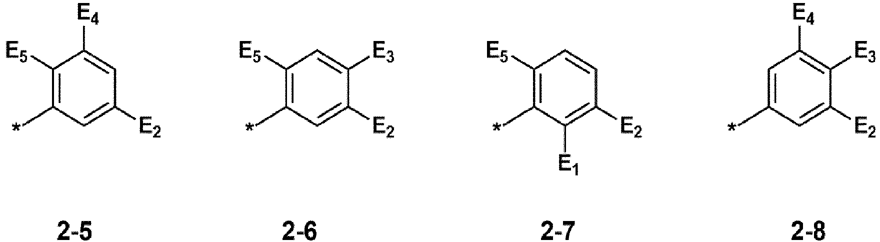 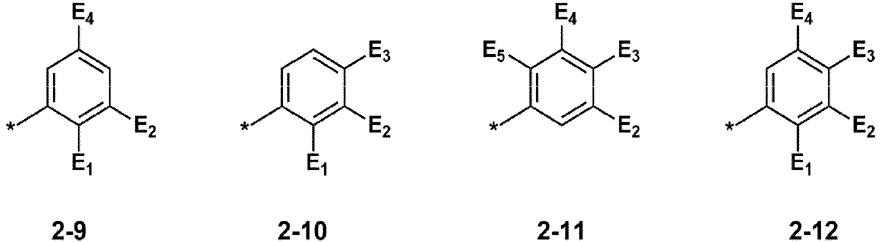 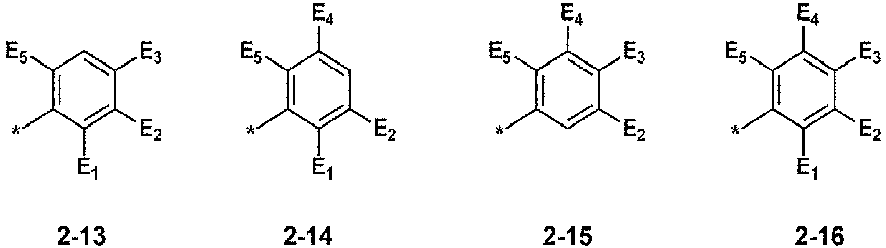 wobei in Formel 2-1 bis 2-16
E₁ bis E₅ jeweils wie in Anspruch 1 beschrieben sind, vorausgesetzt, dass jedes von E₁ bis E₅ nicht Wasserstoff ist, und
* eine Bindungsstelle zu einem benachbarten Atom angibt.

12. Organometallische Verbindung nach Anspruch 1, wobei die organometallische Verbindung durch eine der Verbindungen 1 bis 405 dargestellt ist:

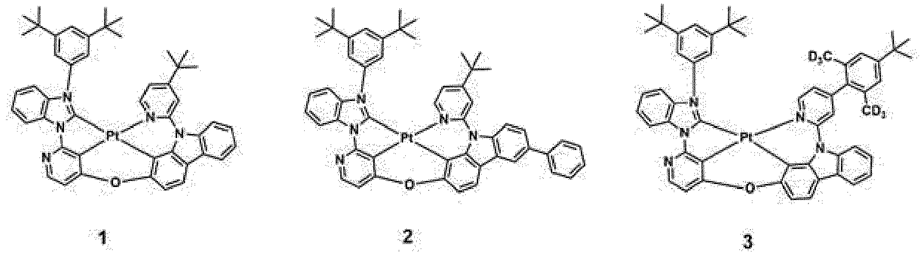

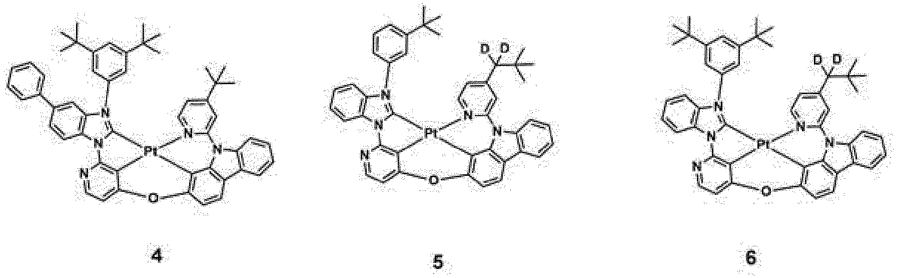

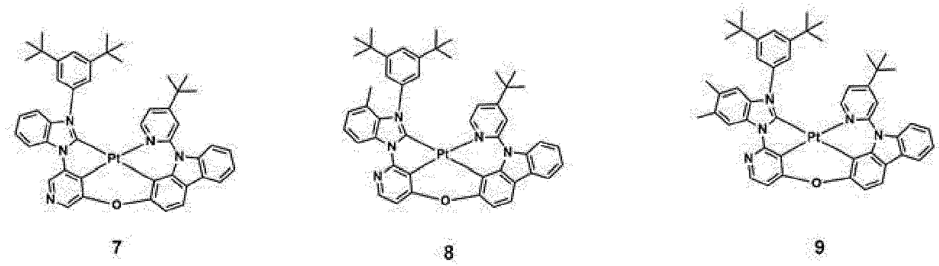

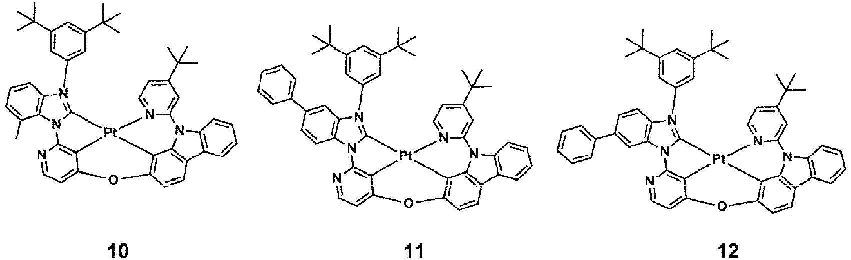

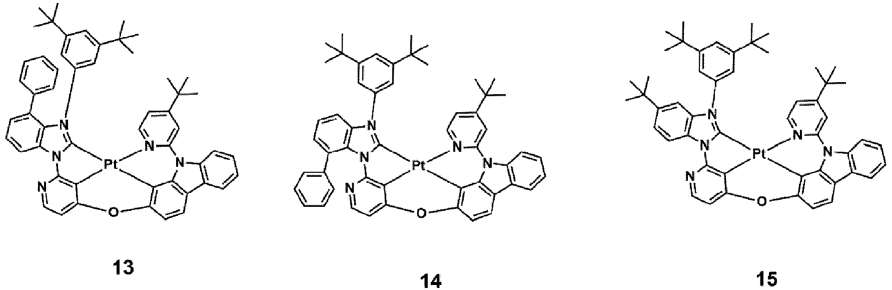

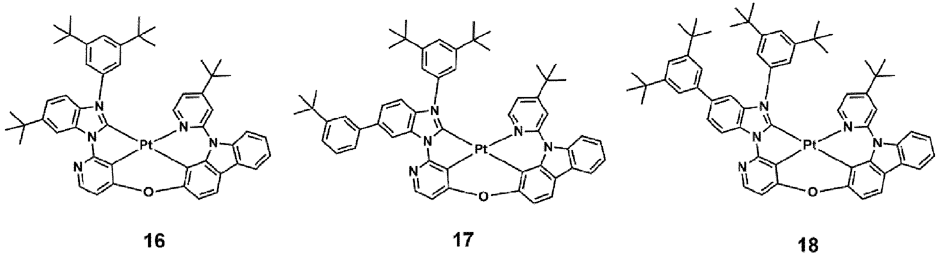

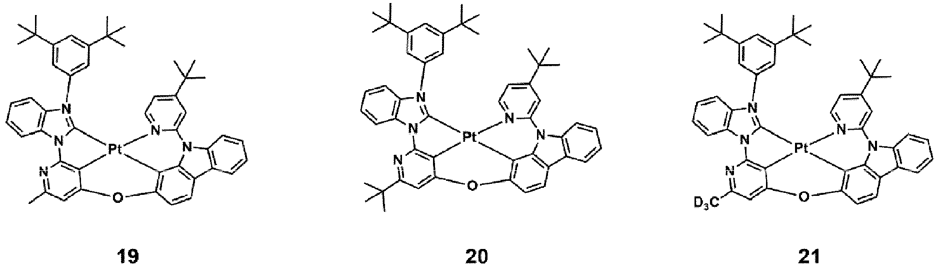

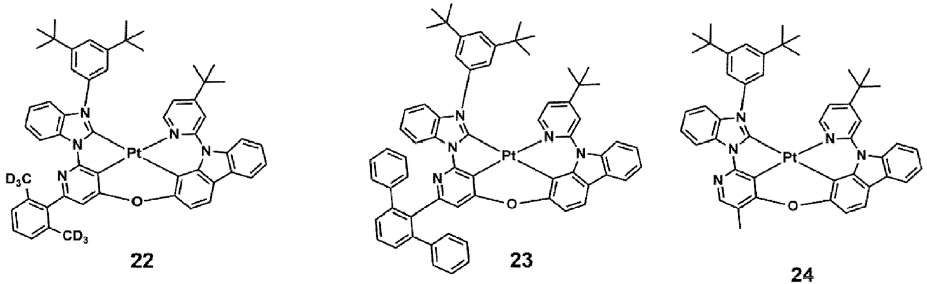

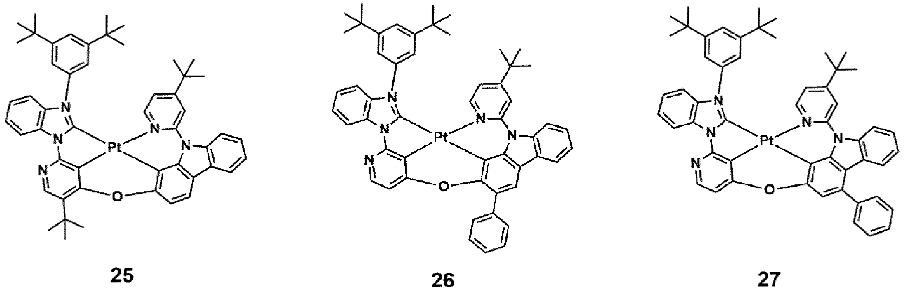

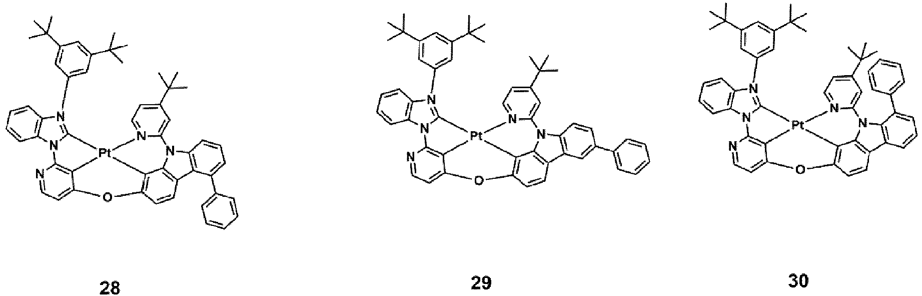

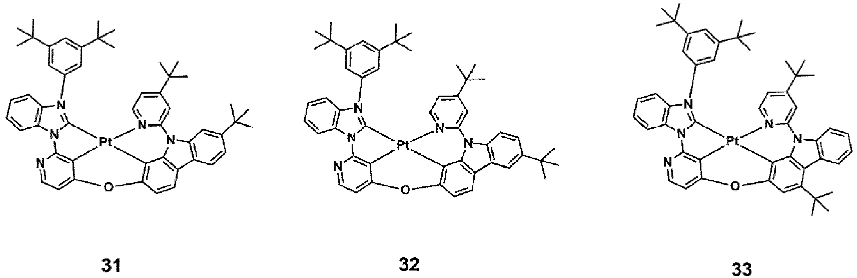

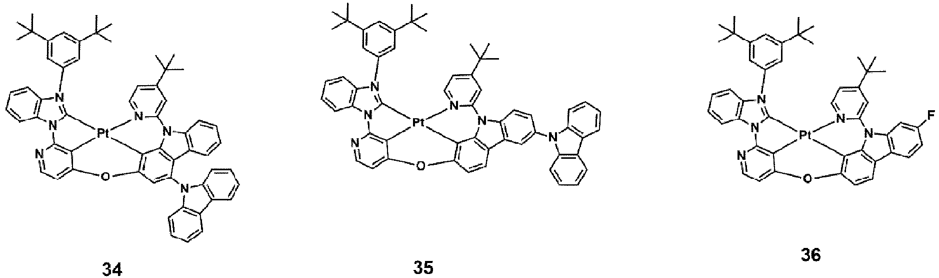

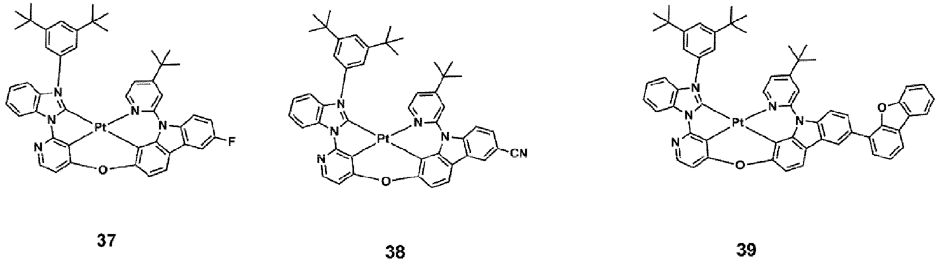

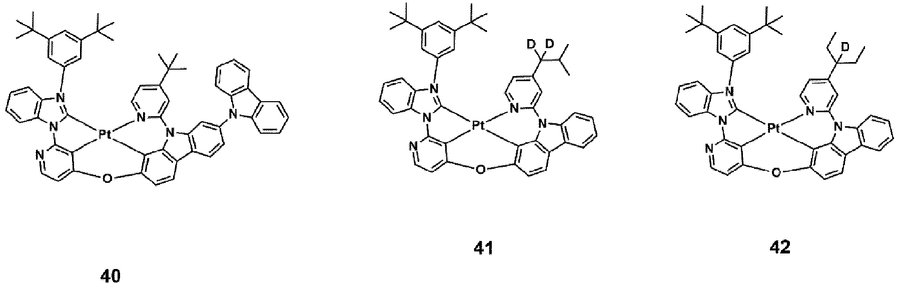

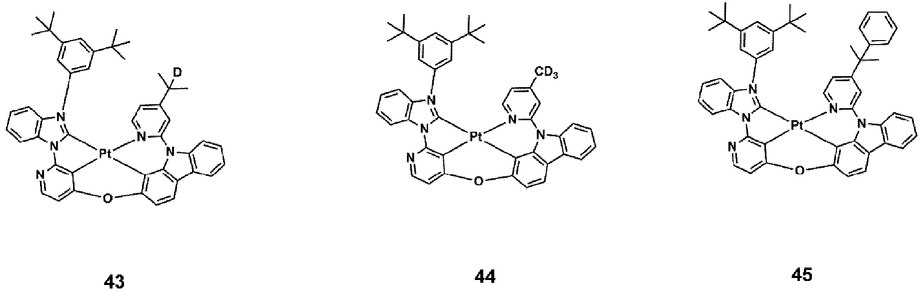

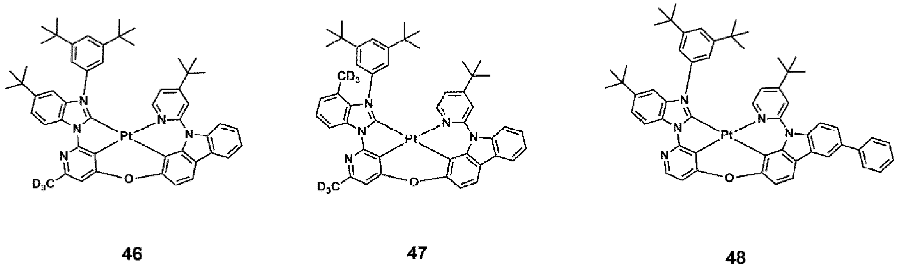

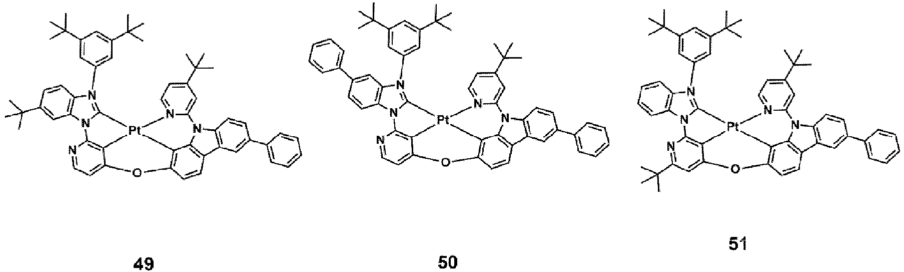

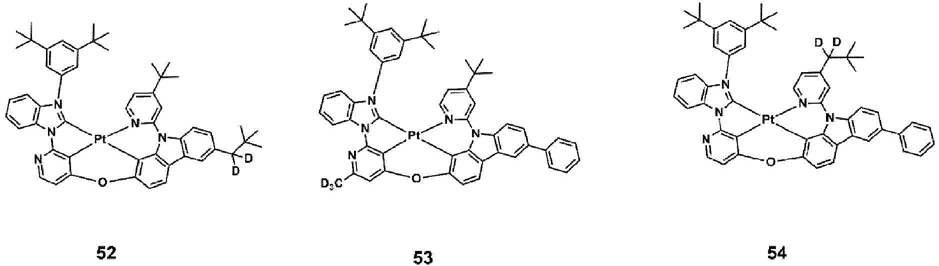

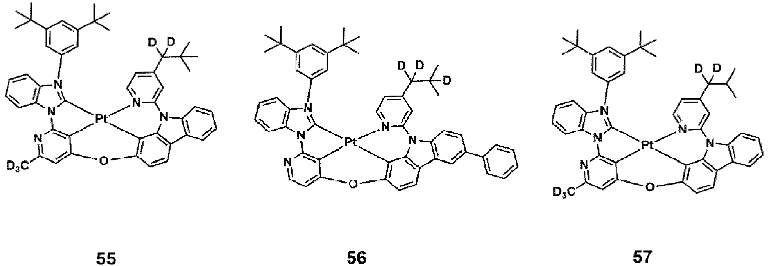

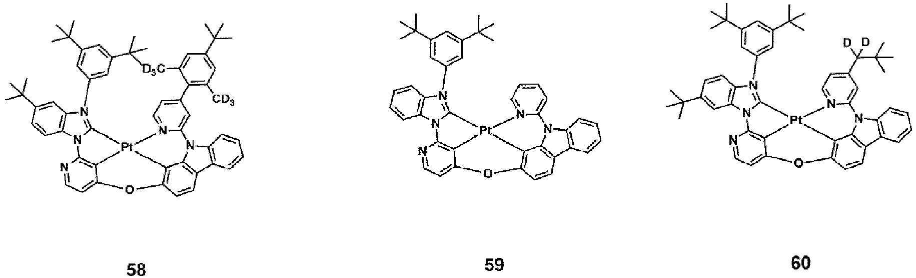

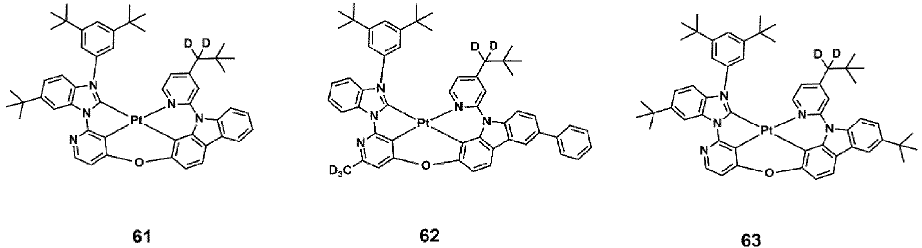

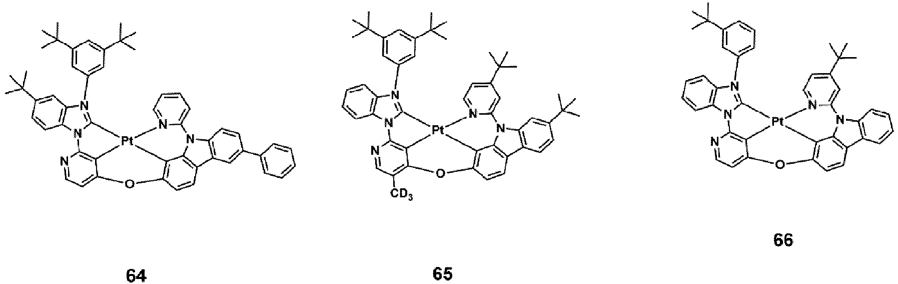

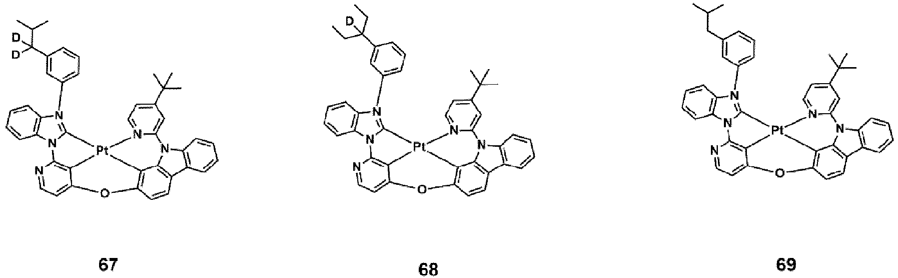

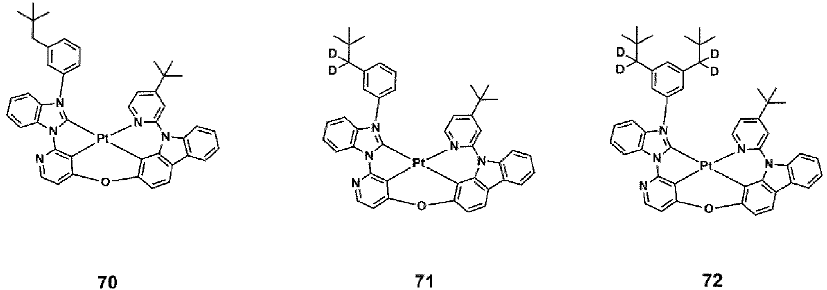

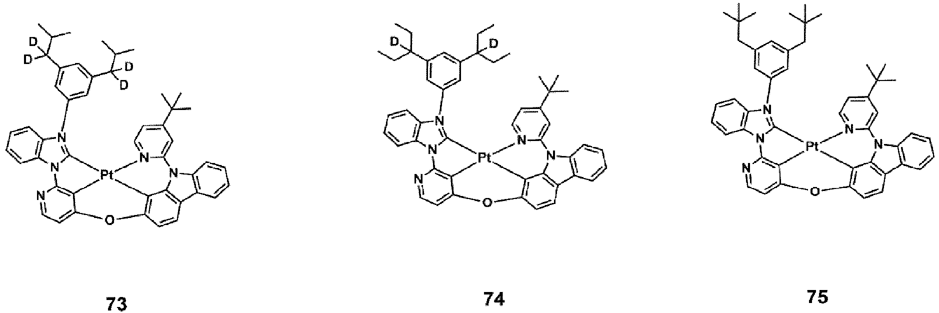

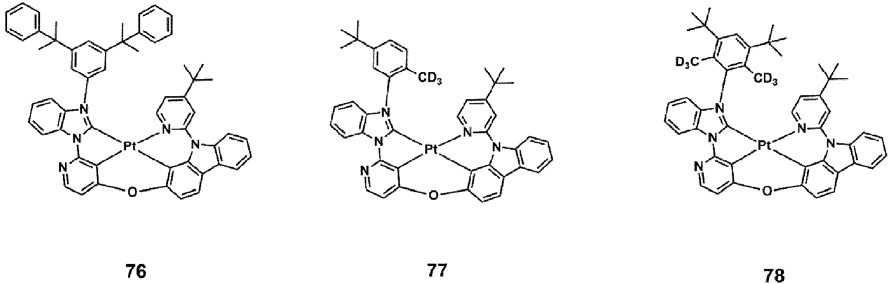

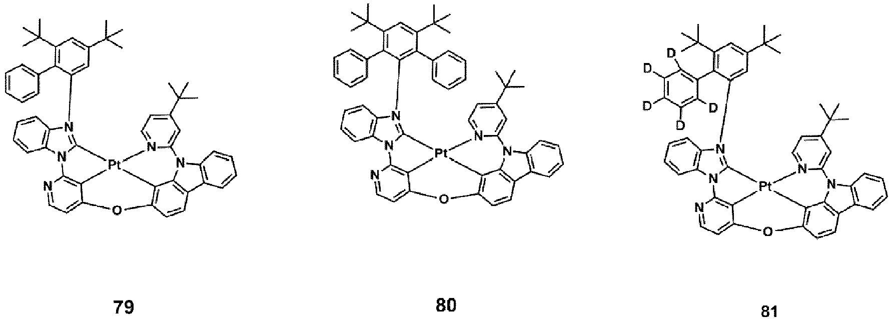

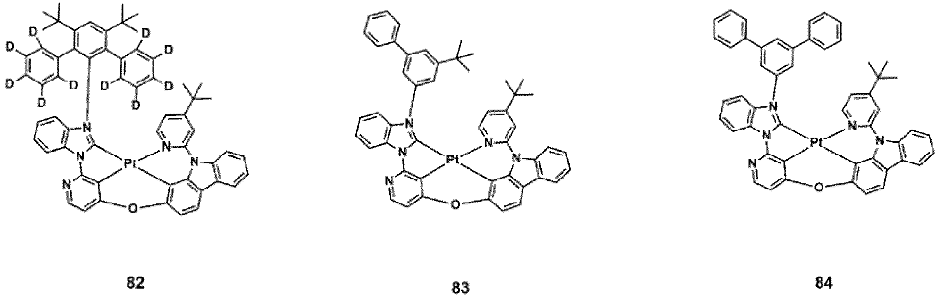

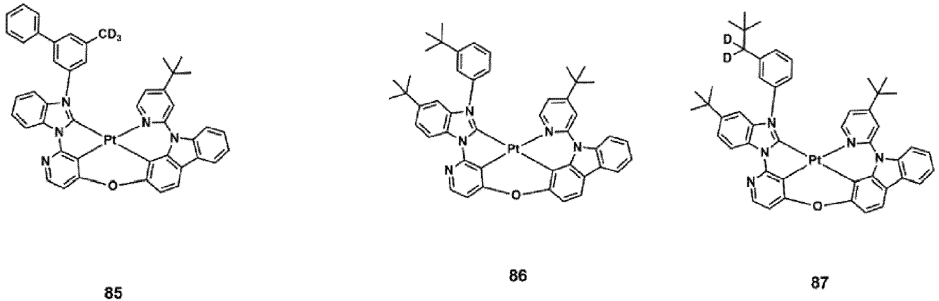

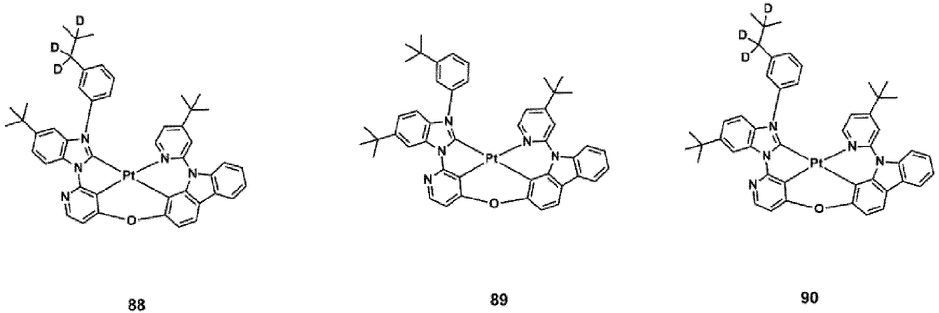

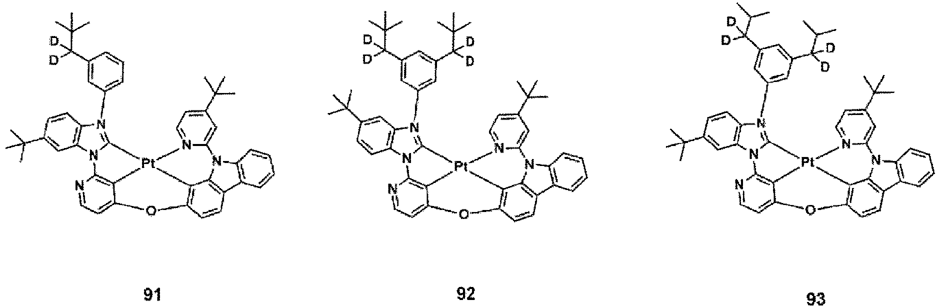

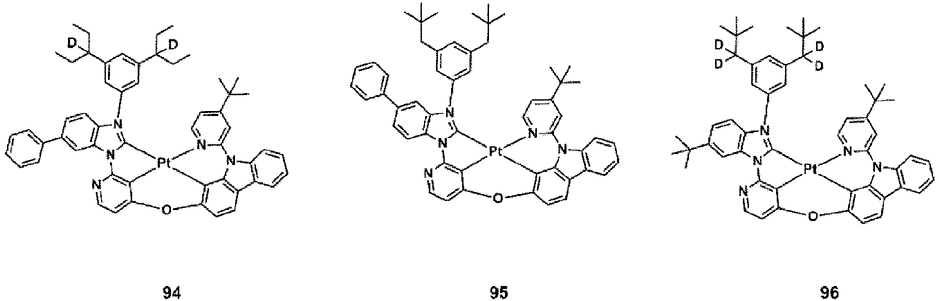

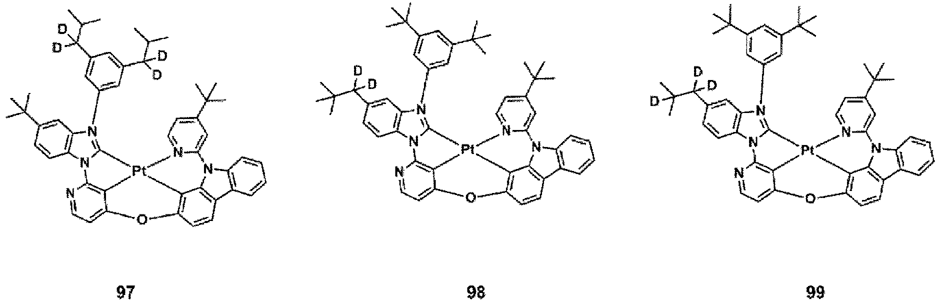

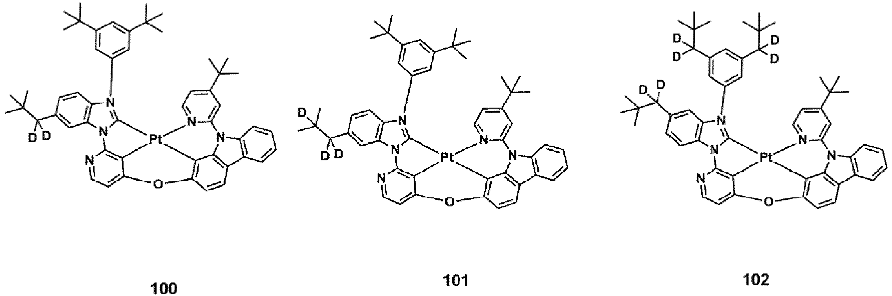

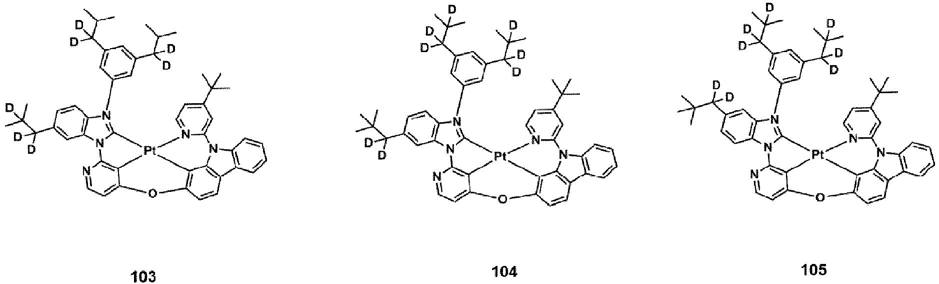

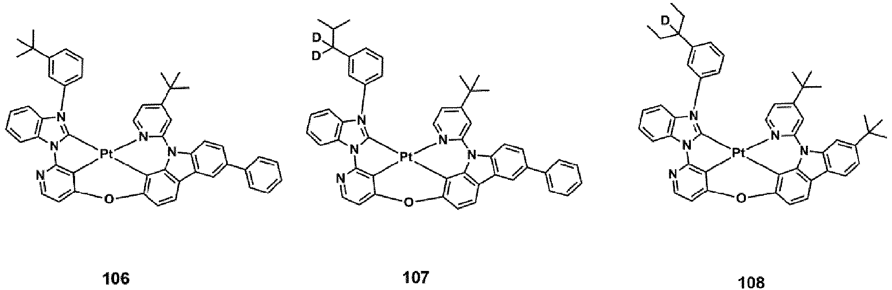

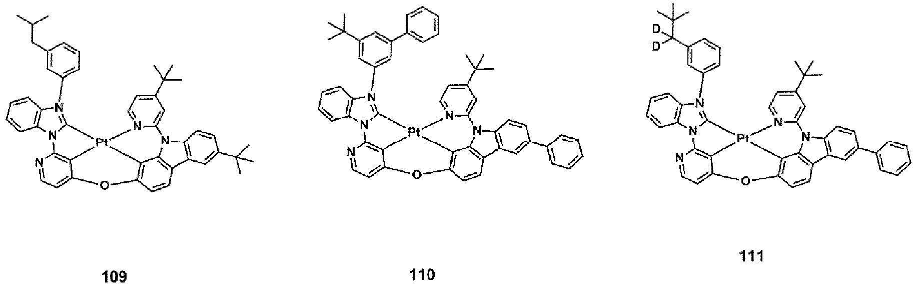

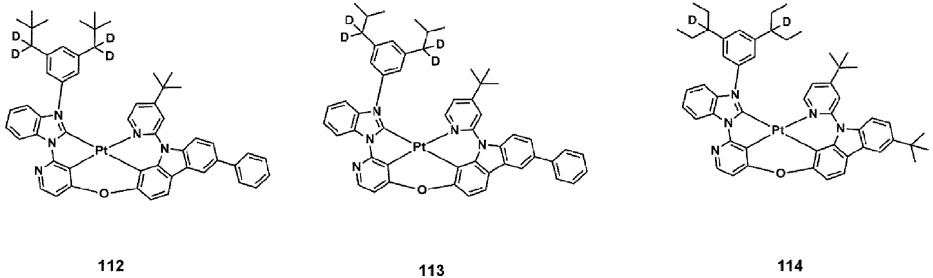

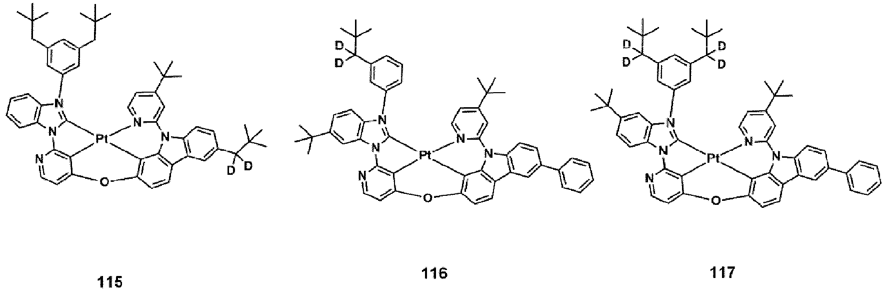

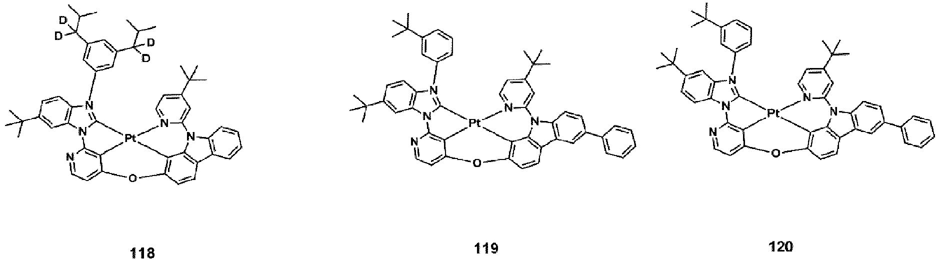

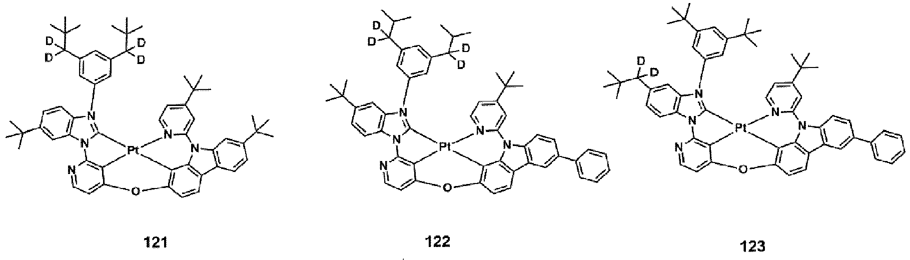

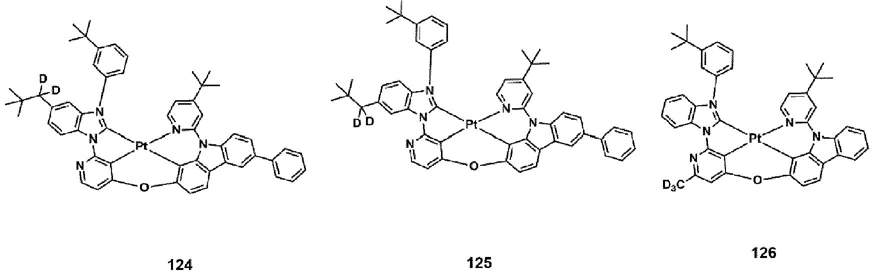

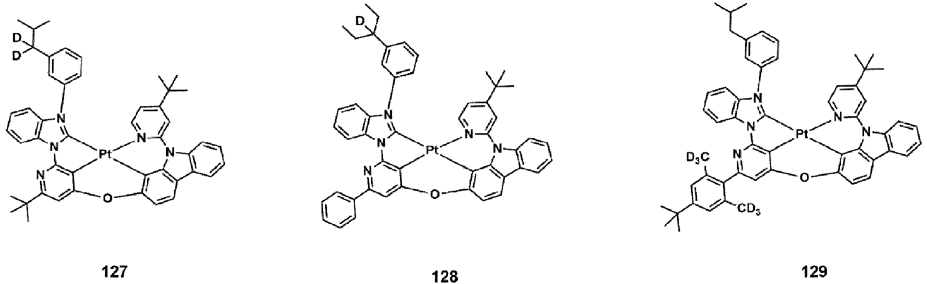

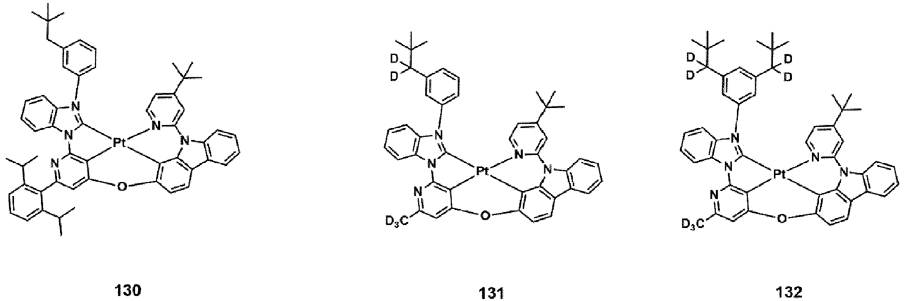

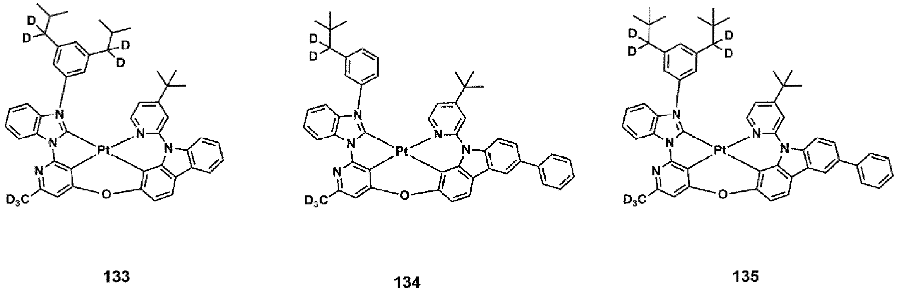

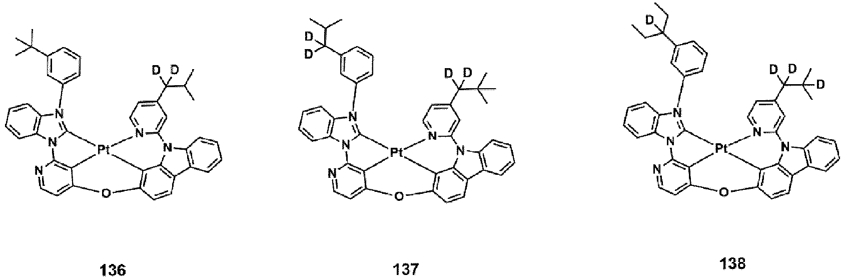

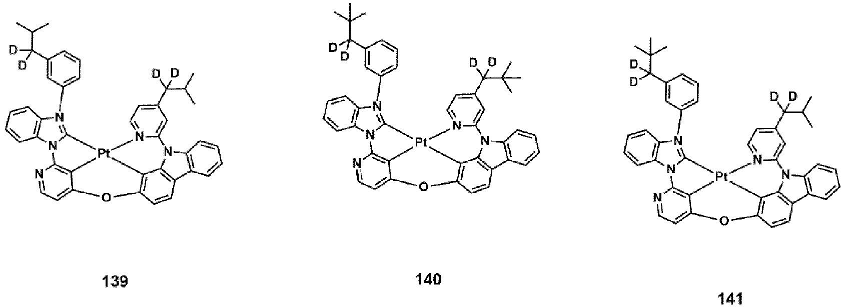

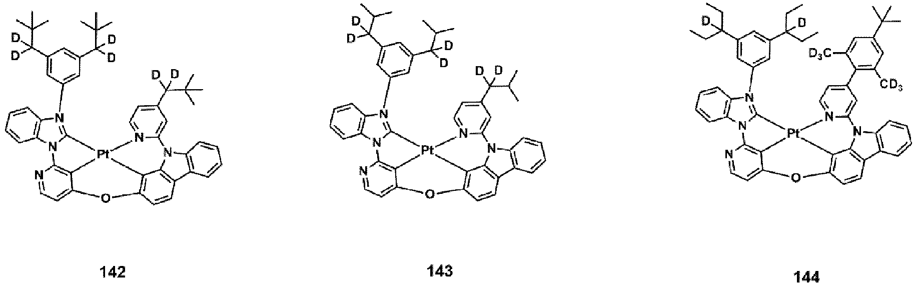

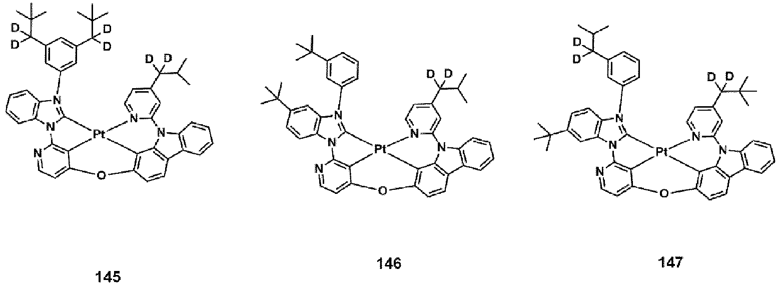

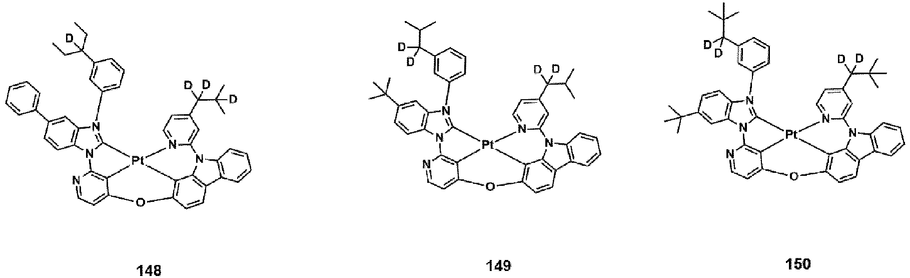

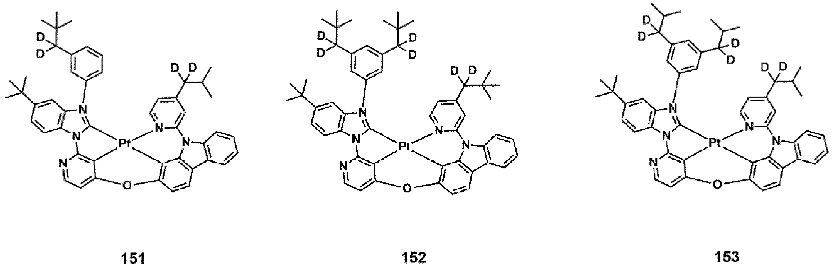

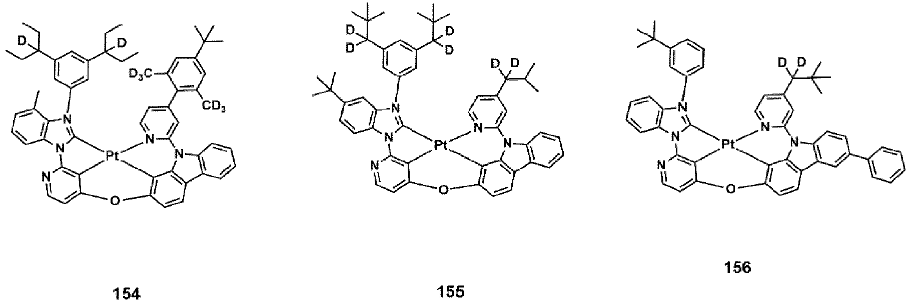

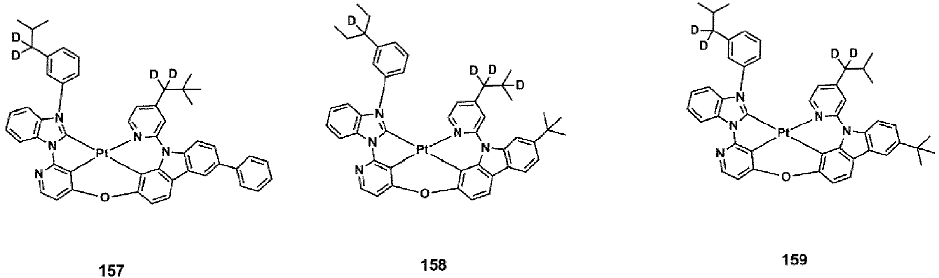

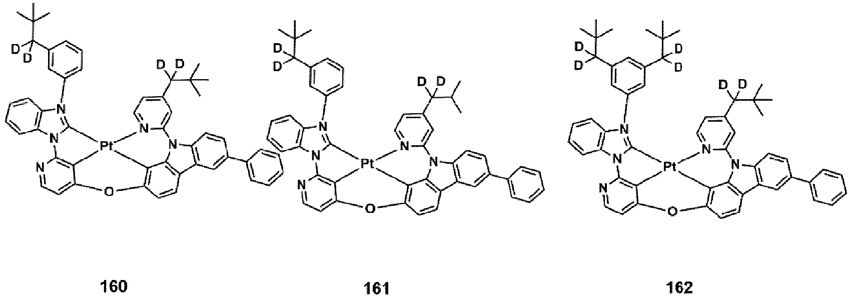

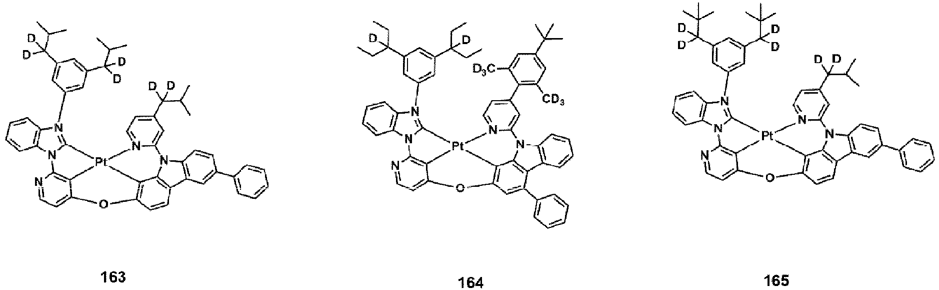

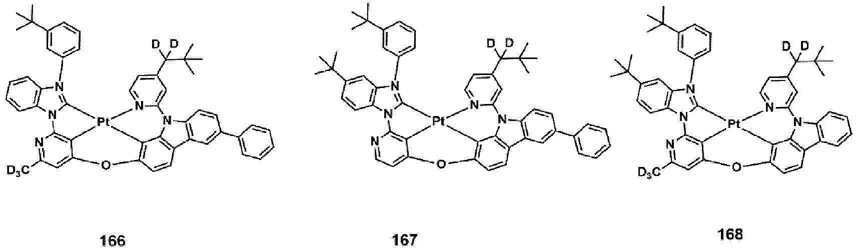

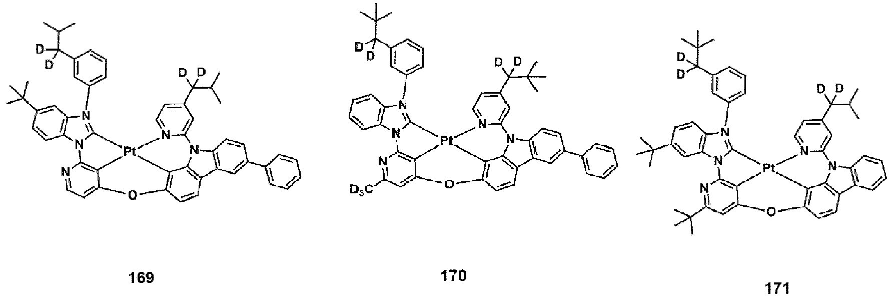

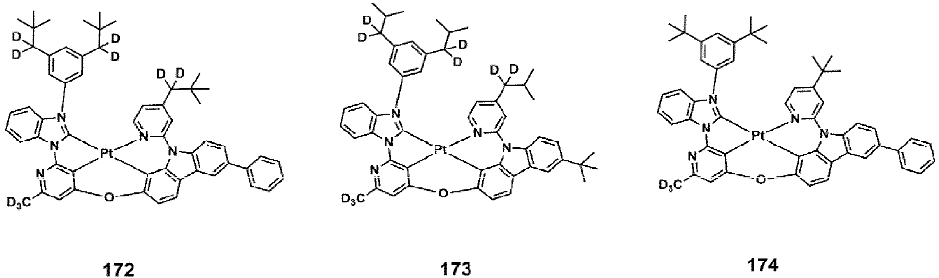

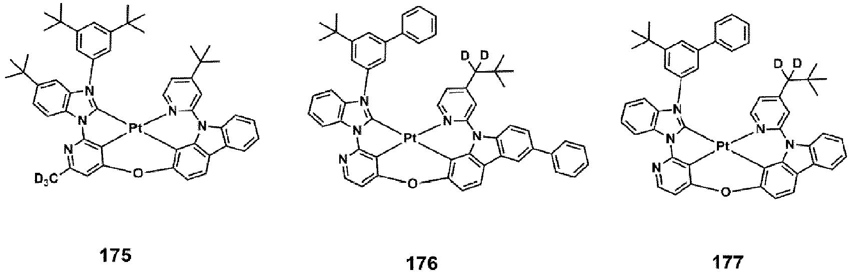

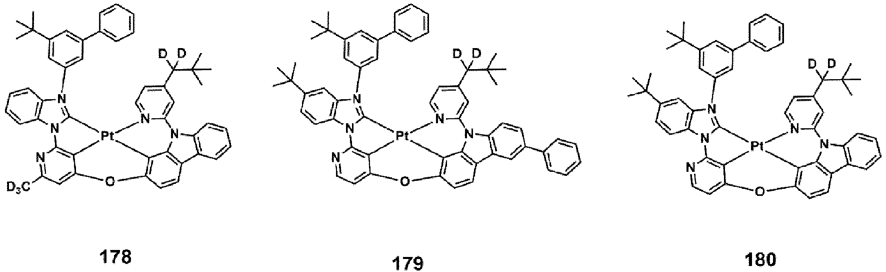

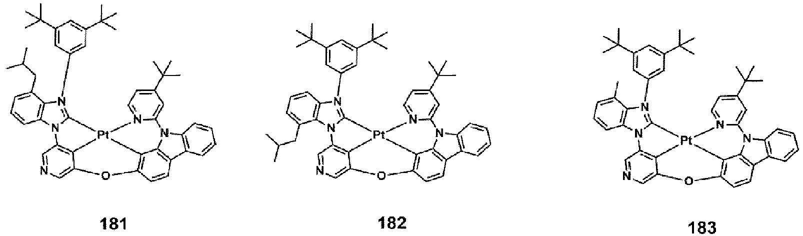

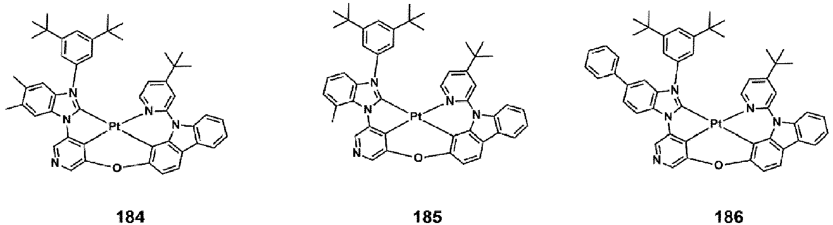

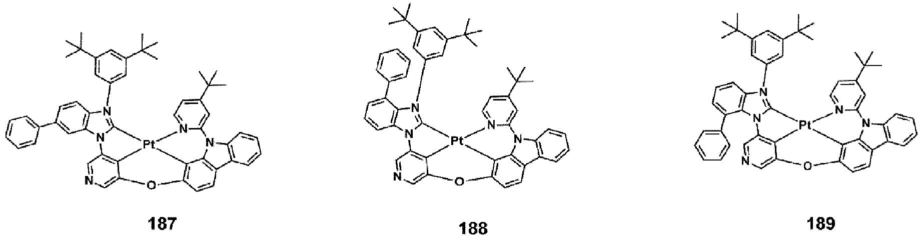

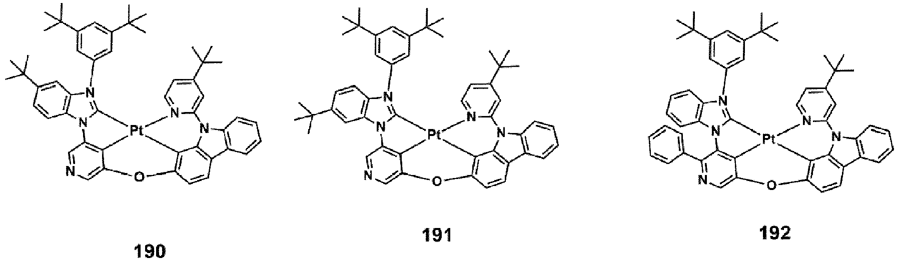

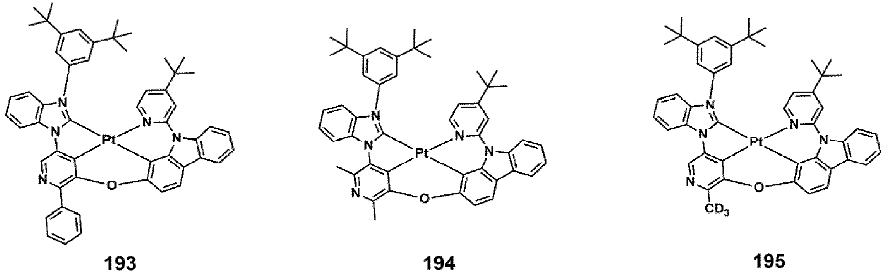

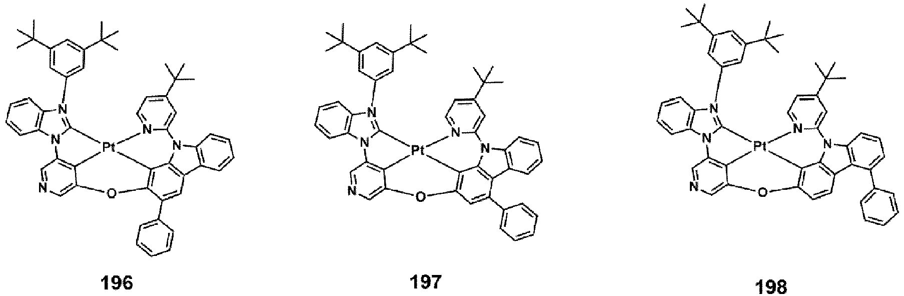

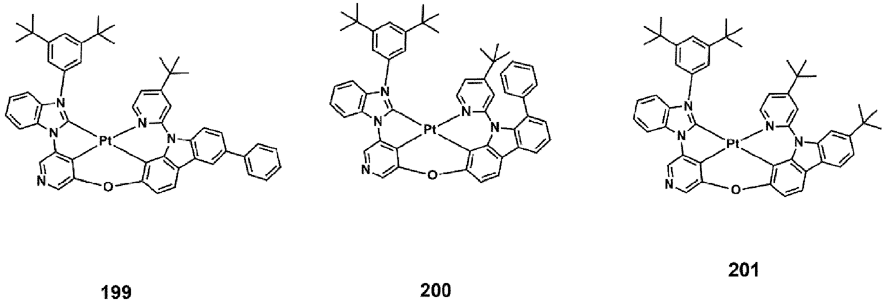

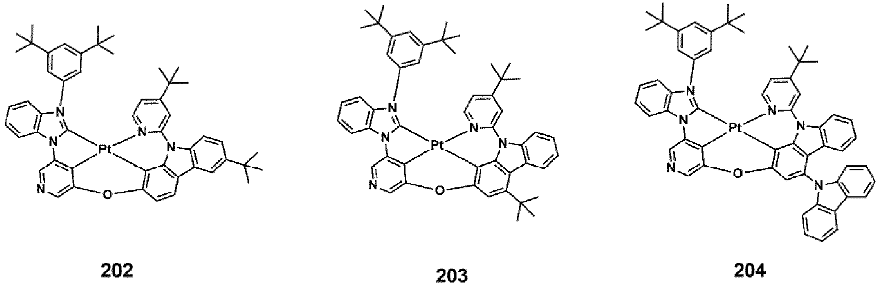

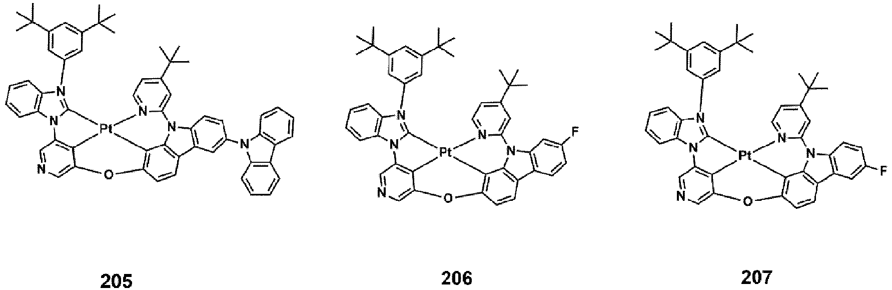

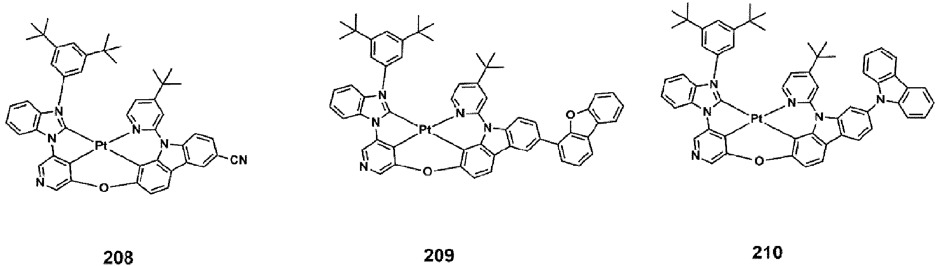

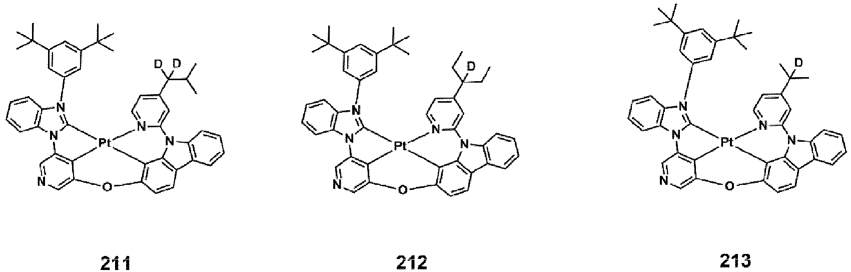

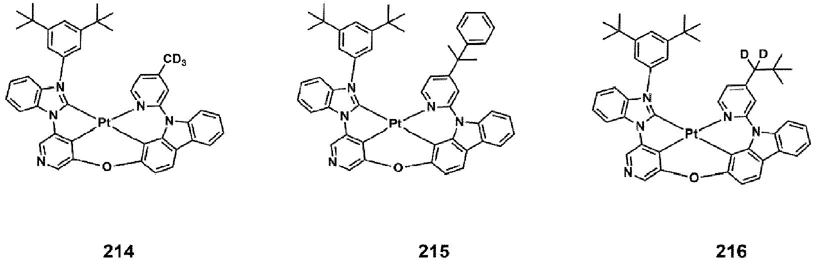

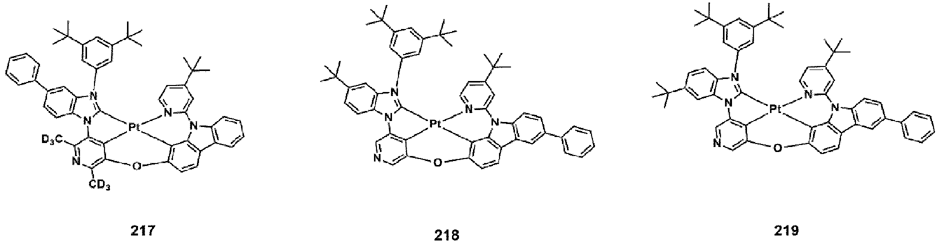

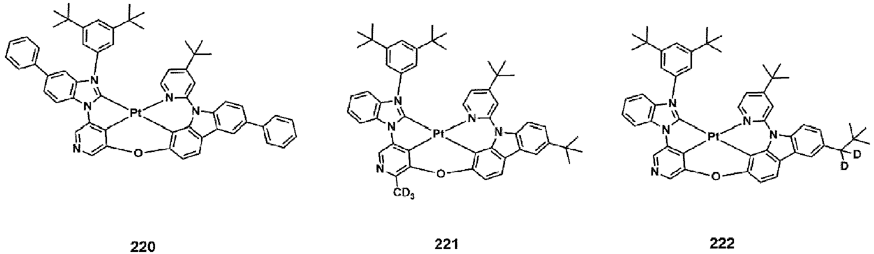

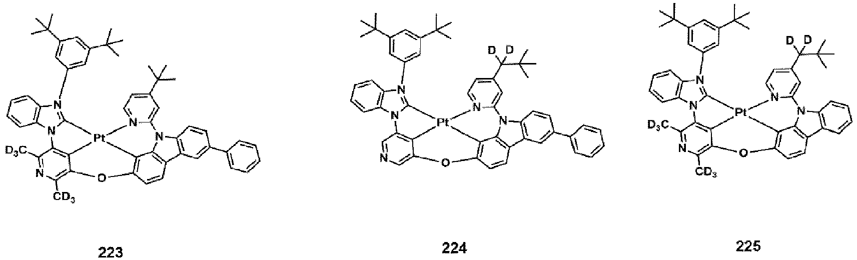

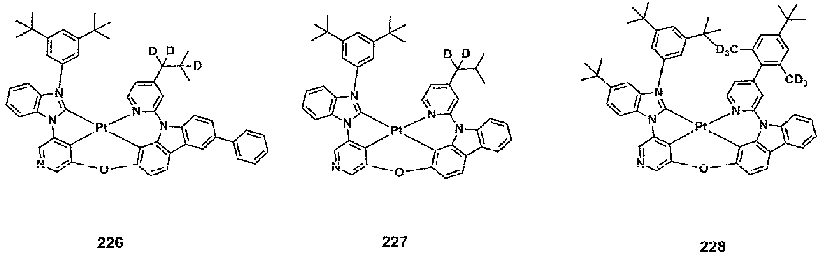

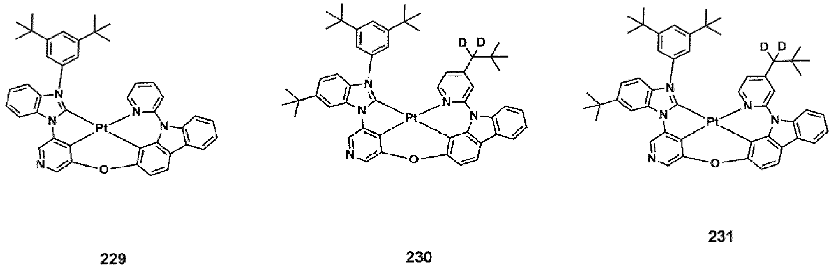

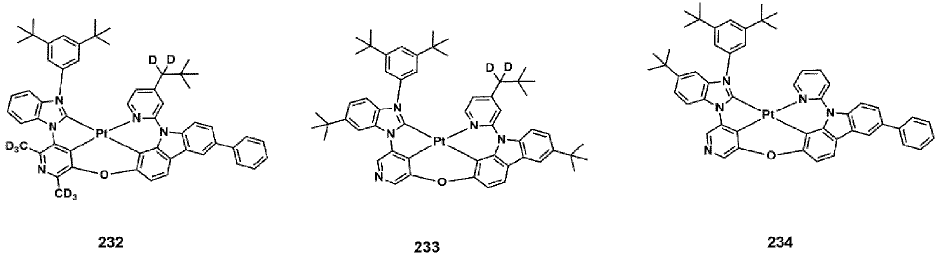

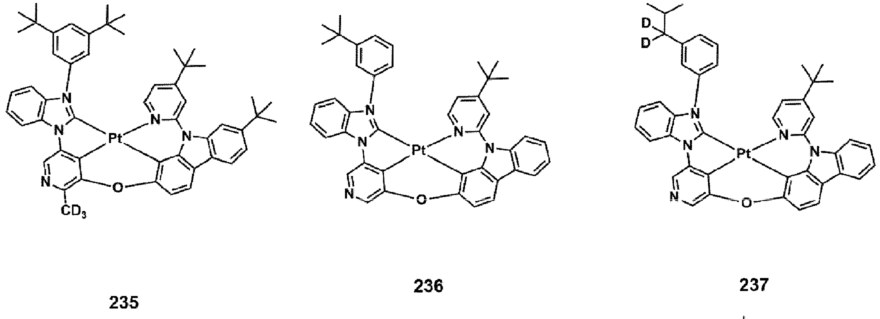

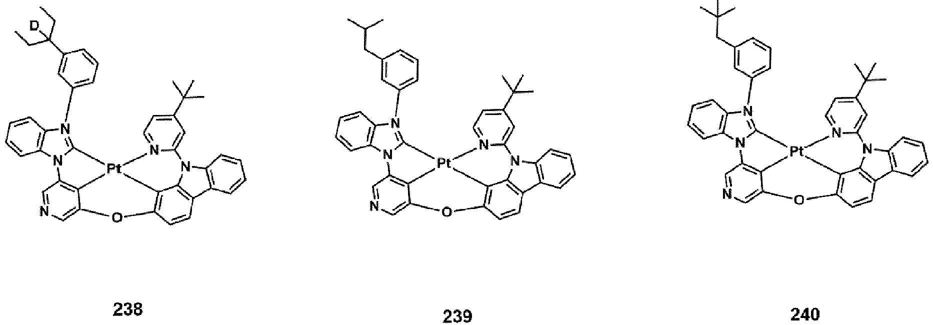

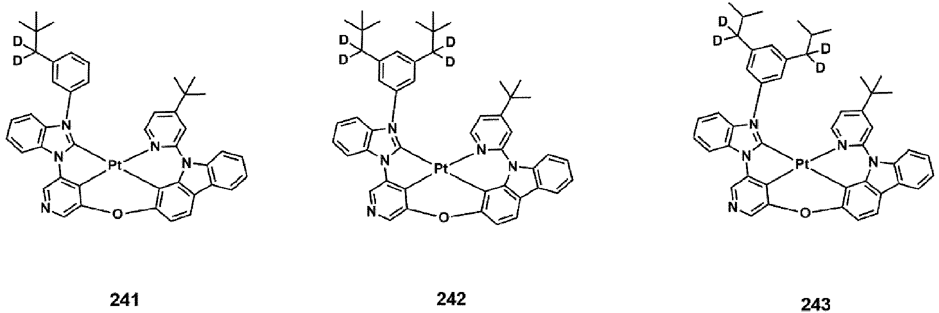

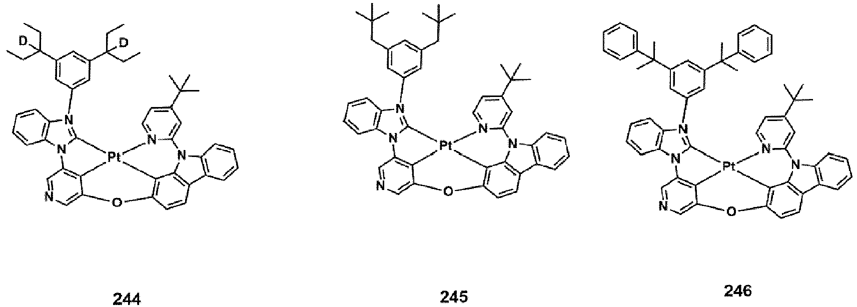

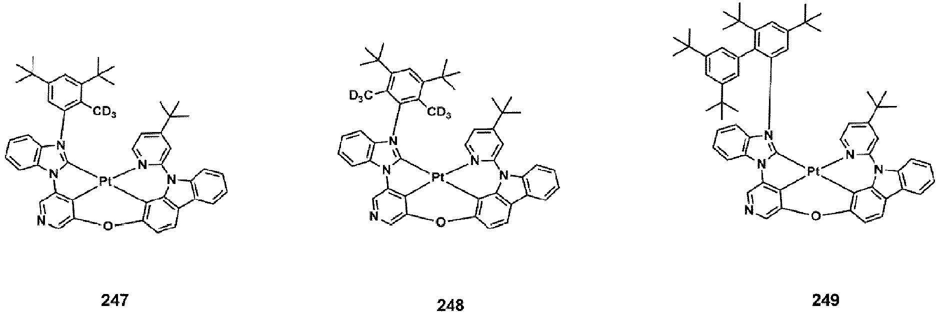

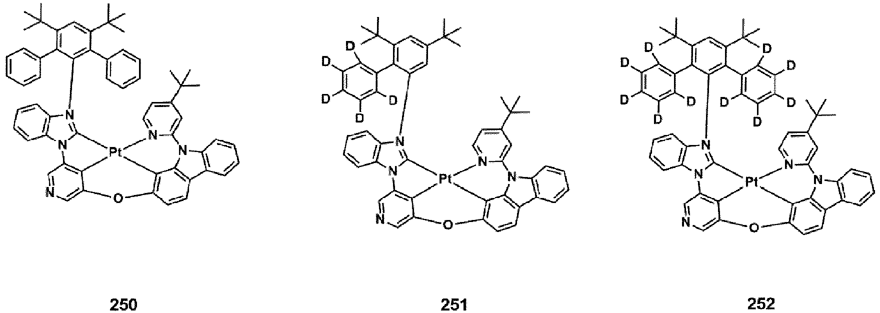

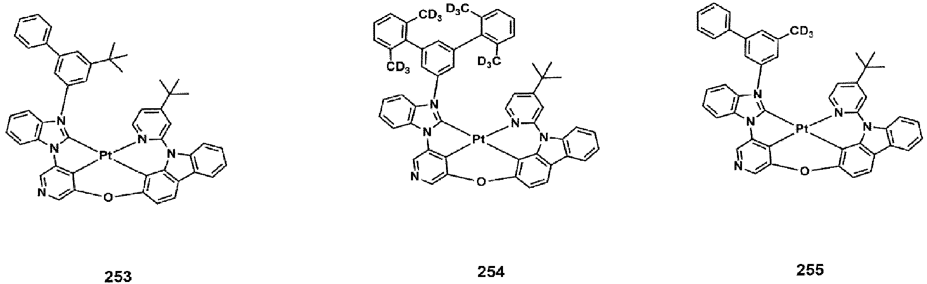

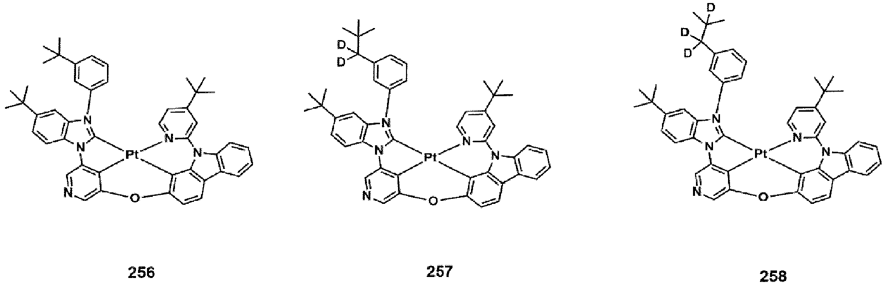

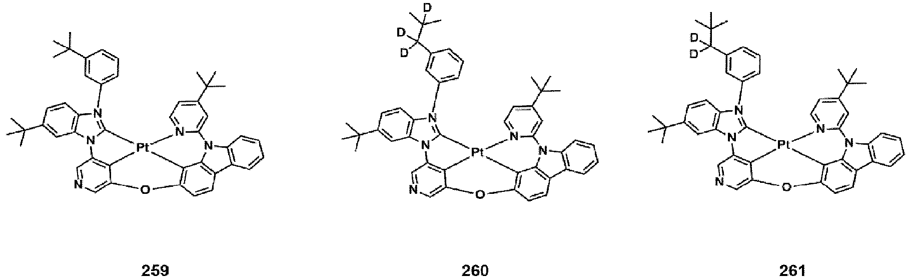

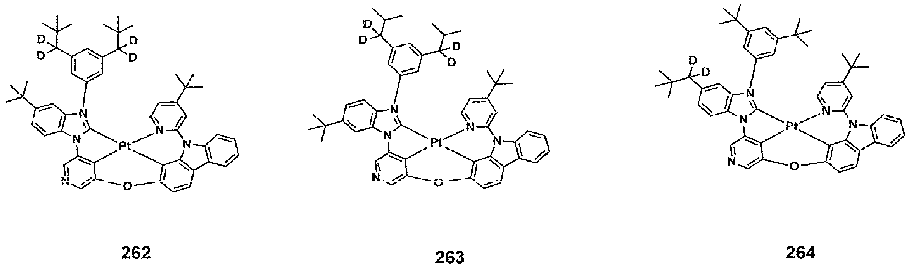

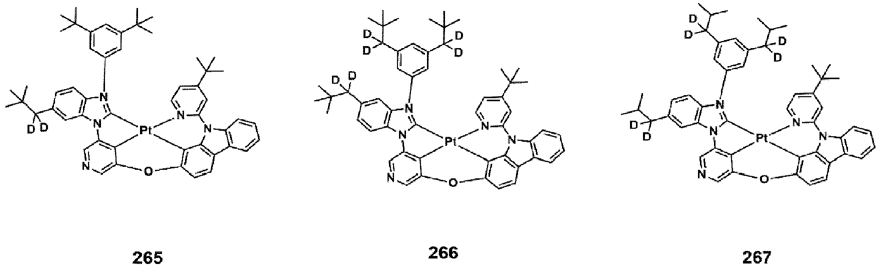

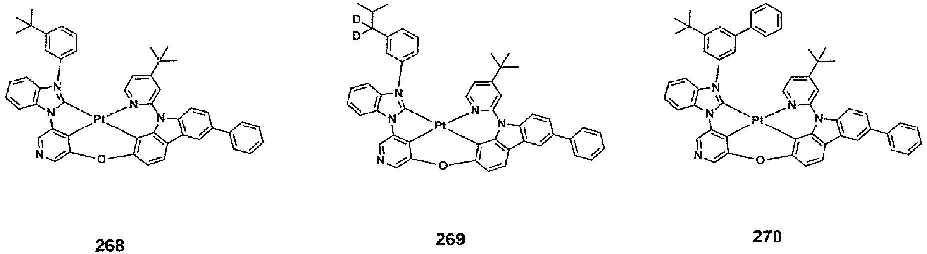

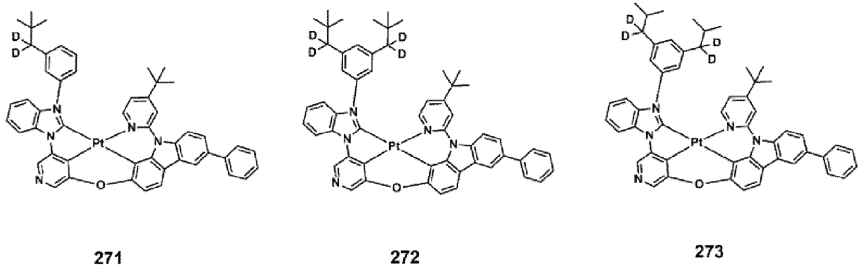

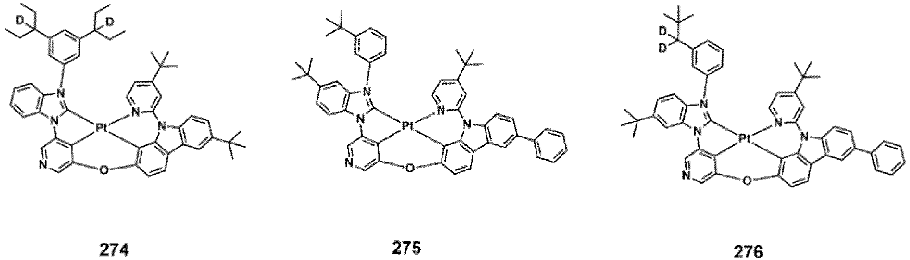

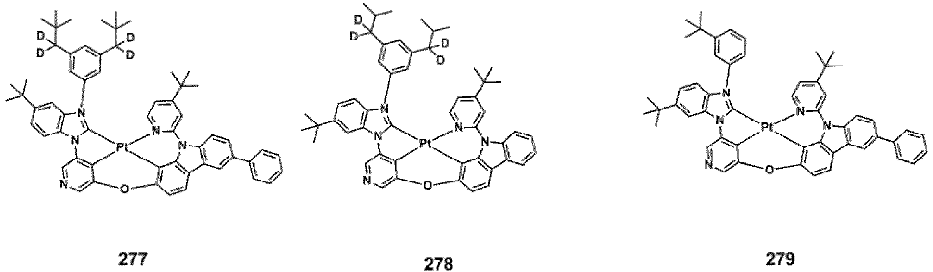

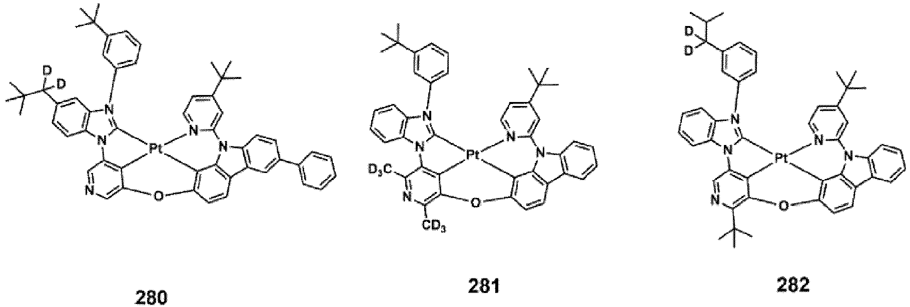

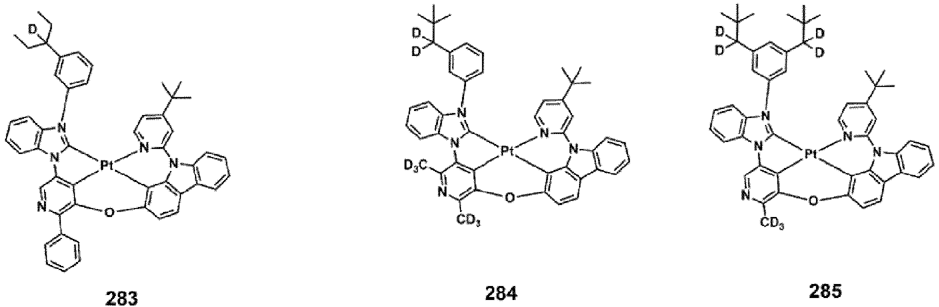

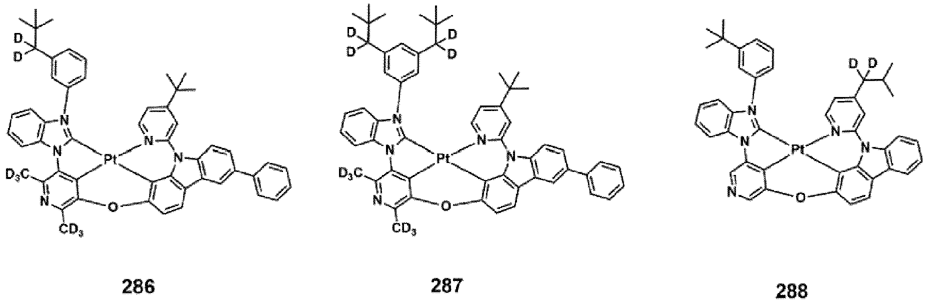

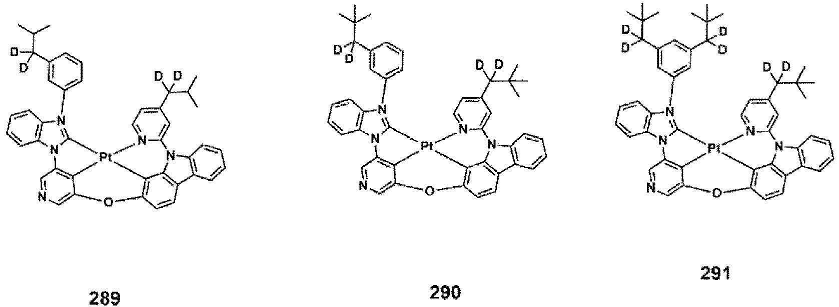

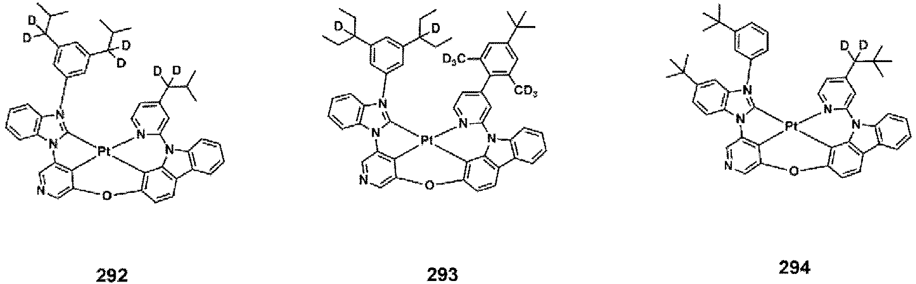

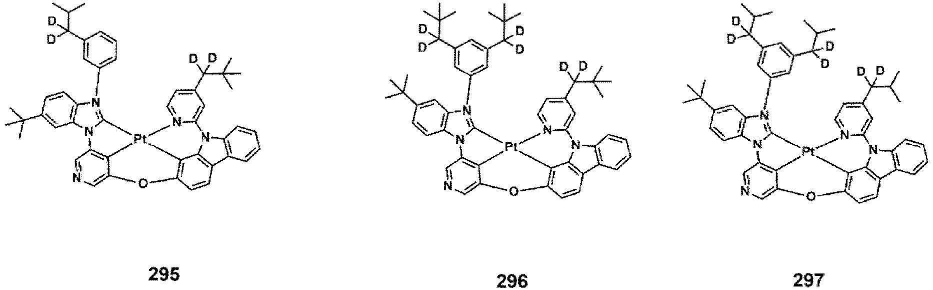

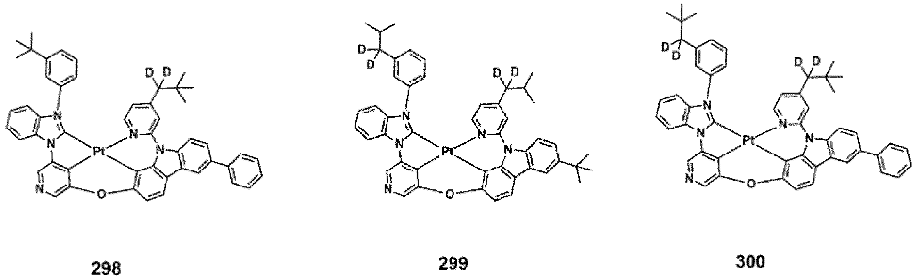

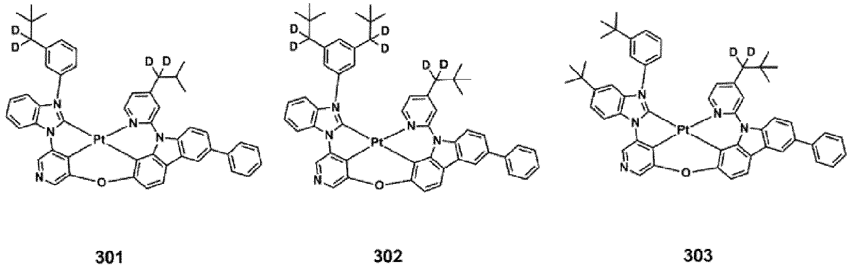

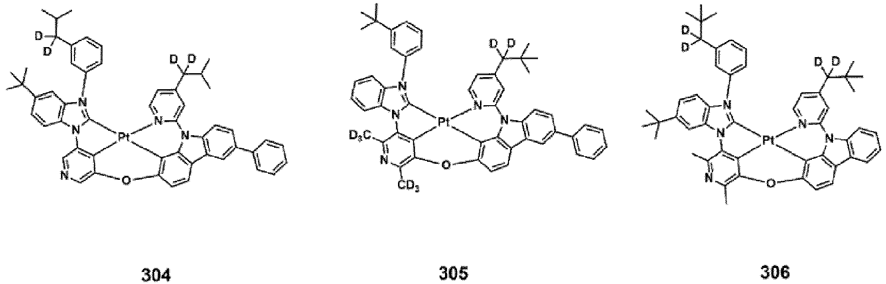

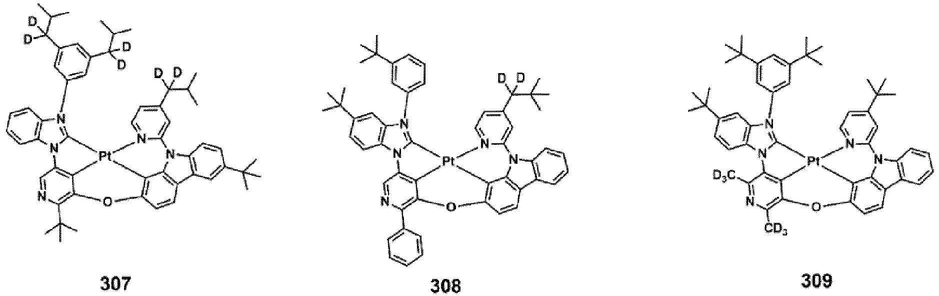

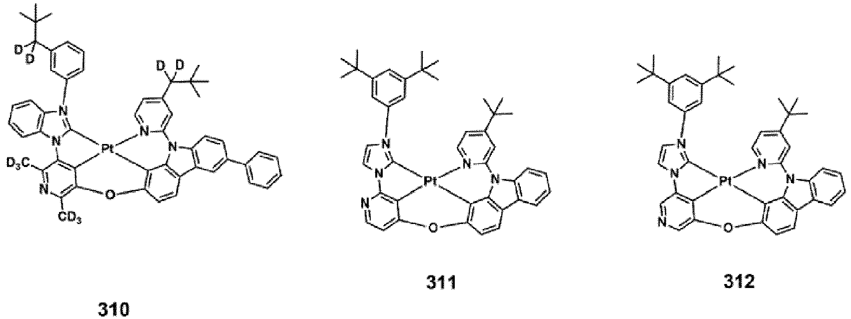

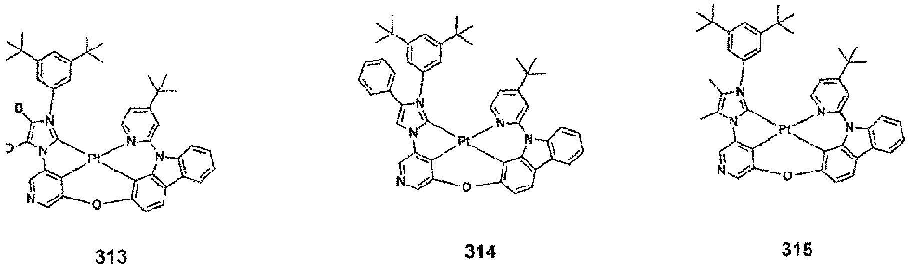

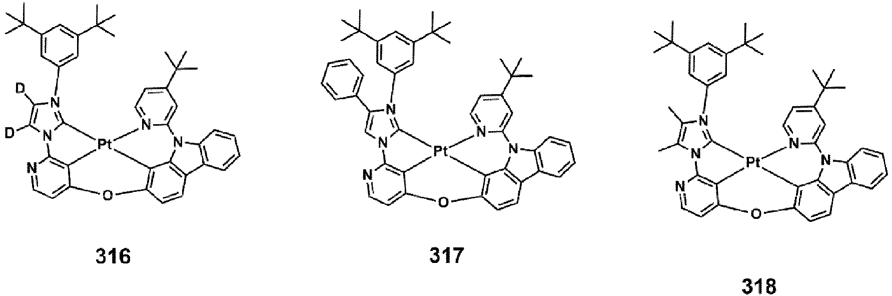

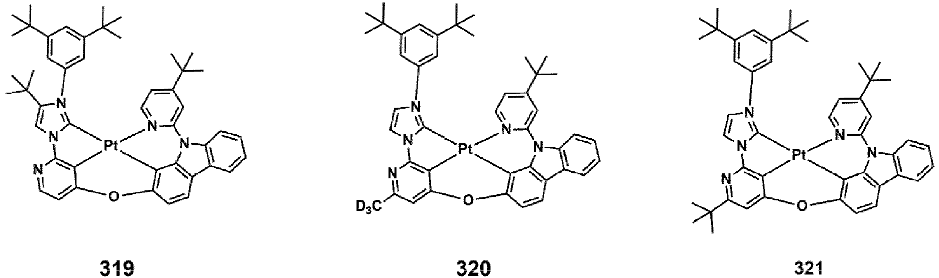

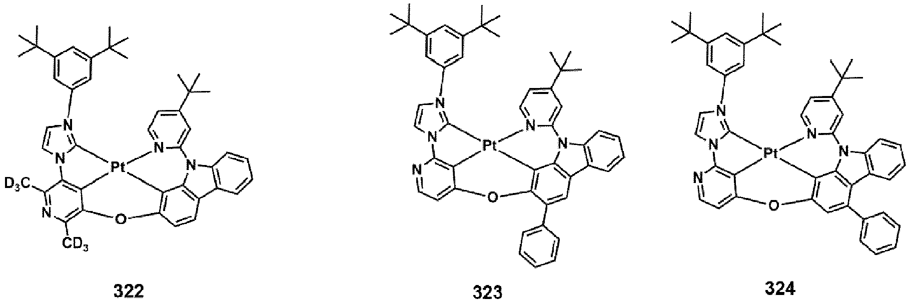

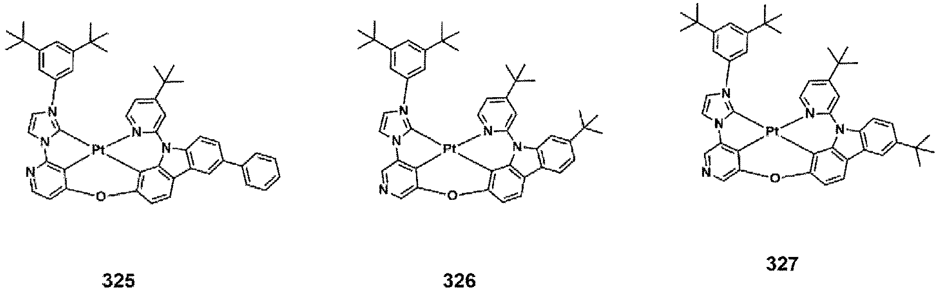

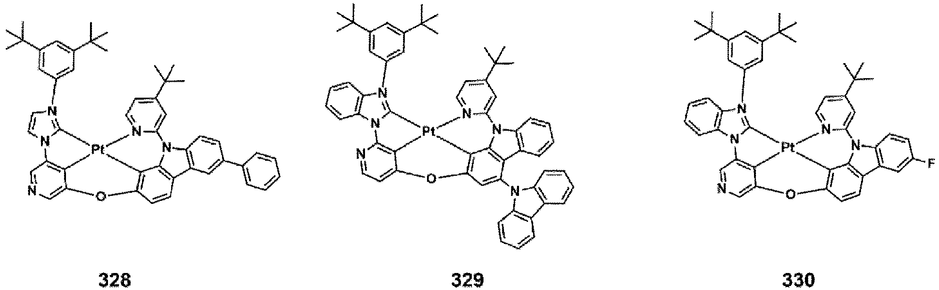

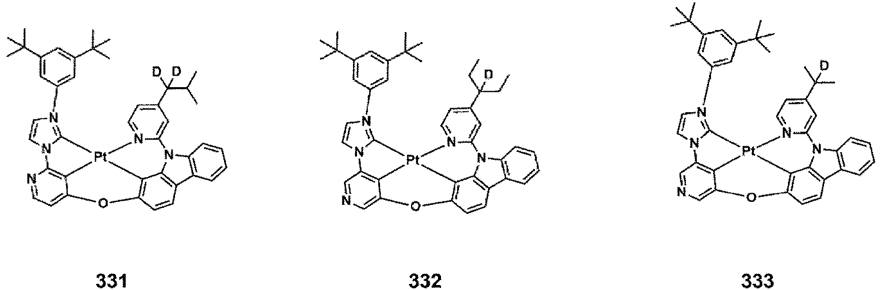

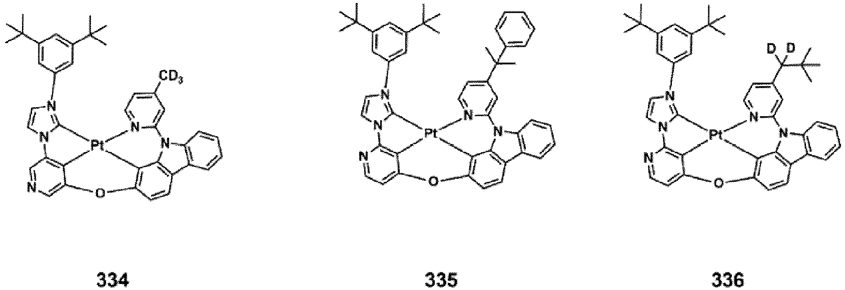

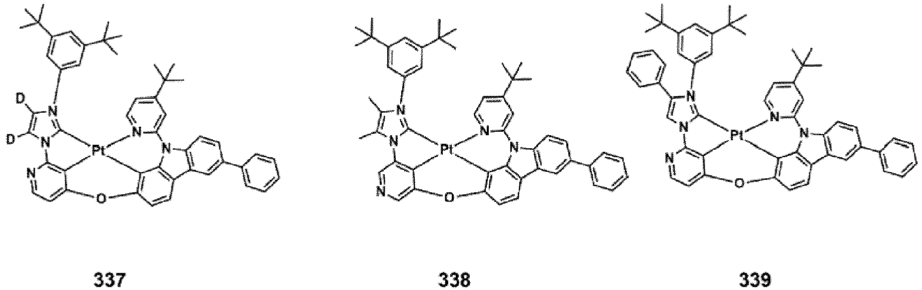

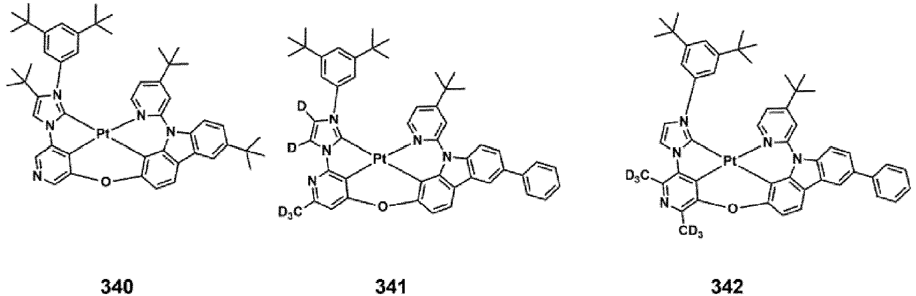

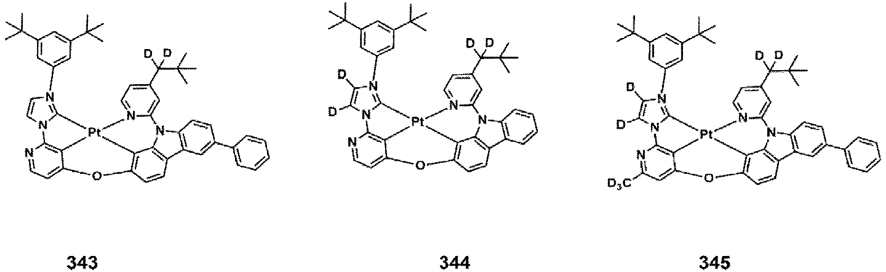

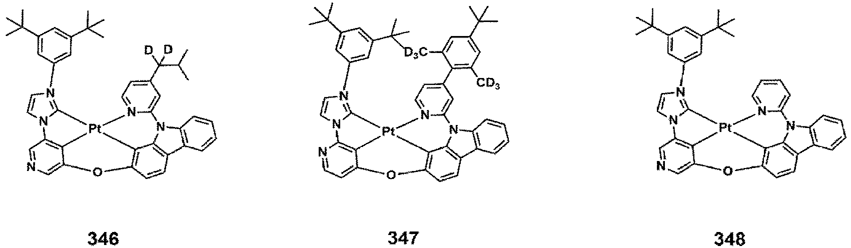

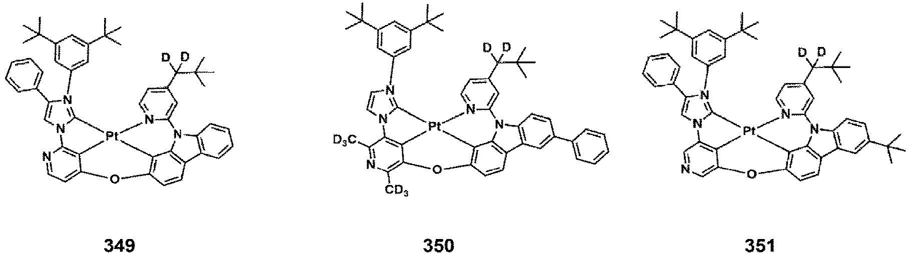

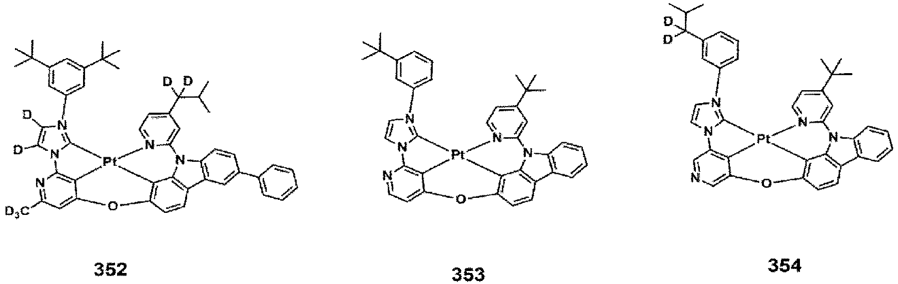

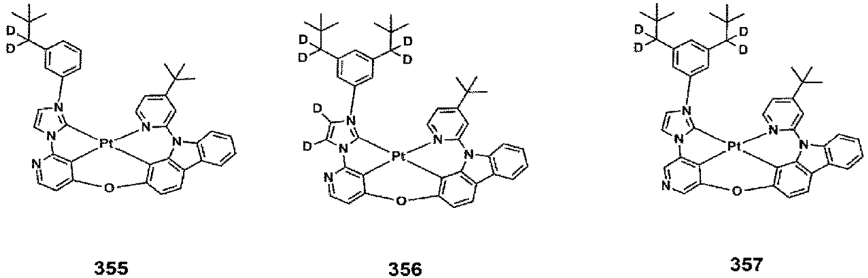

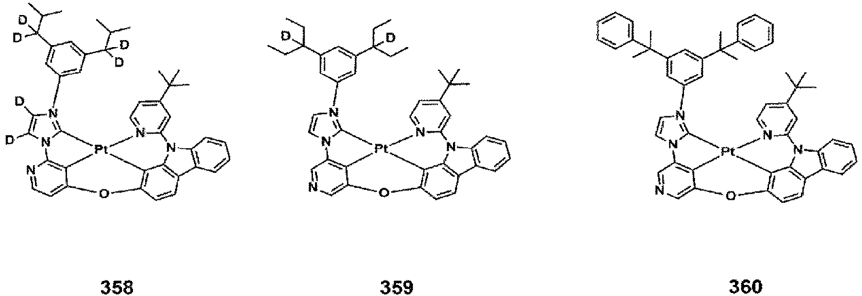

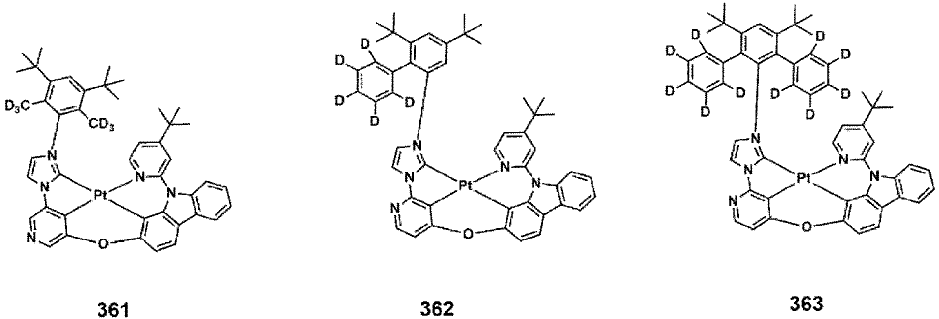

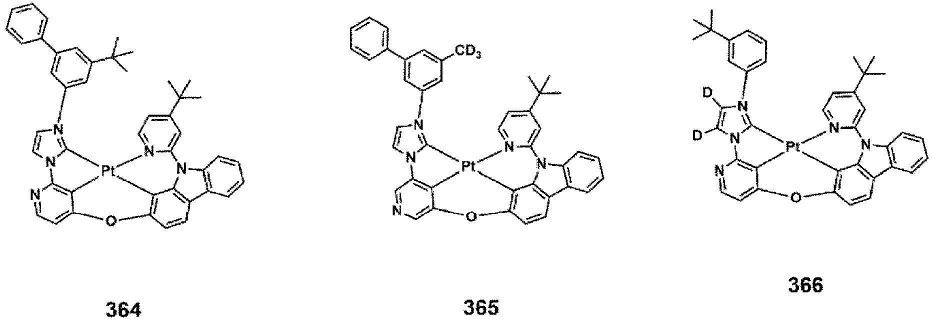

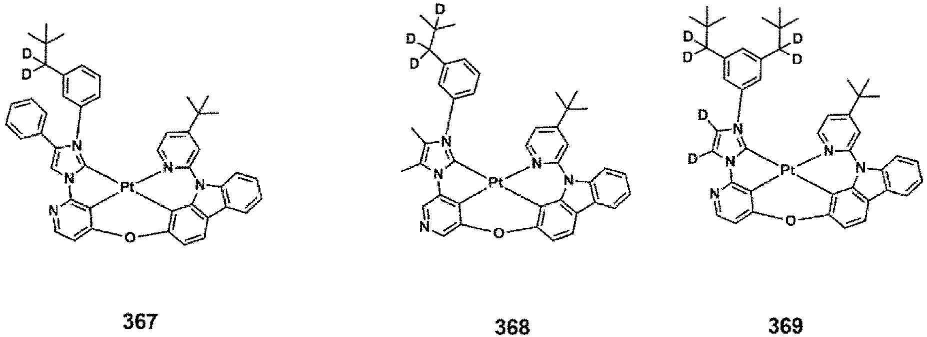

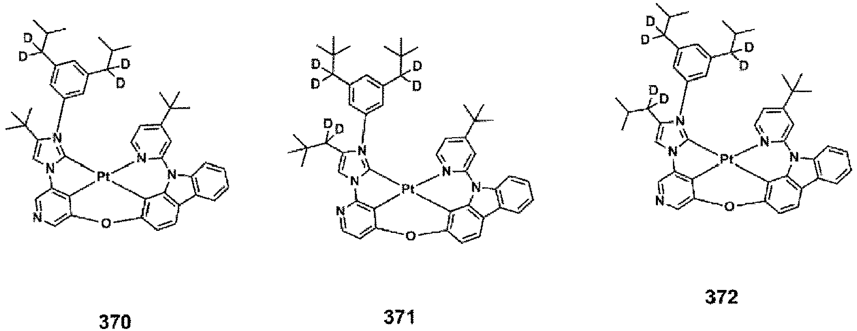

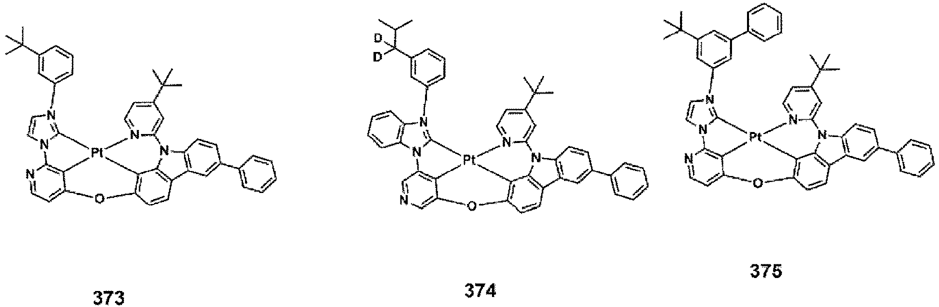

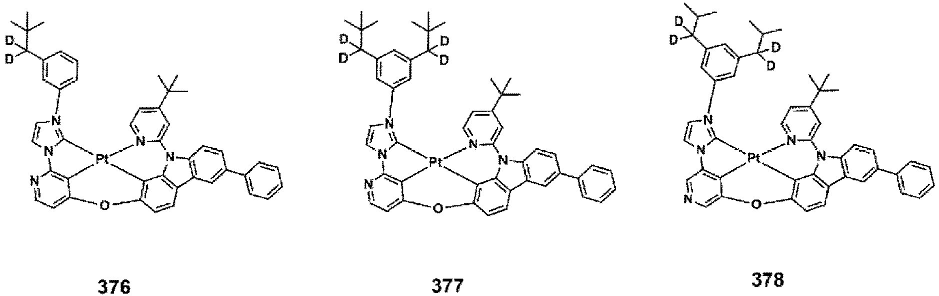

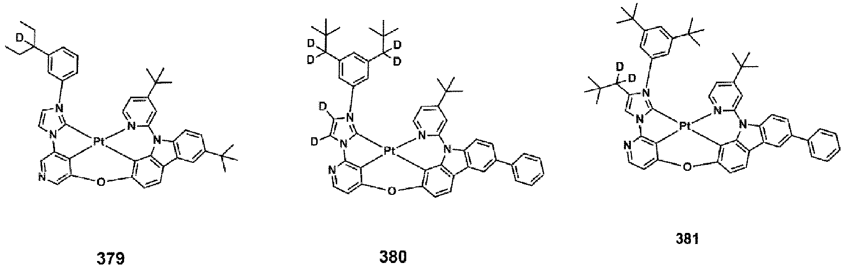

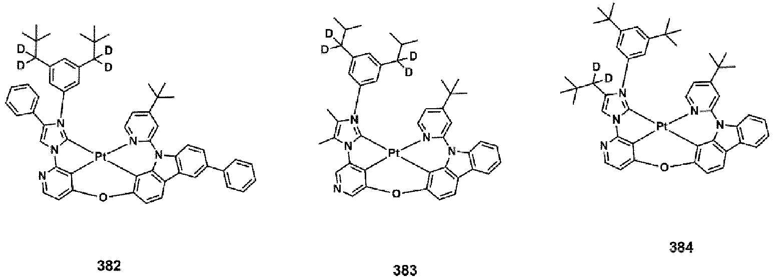

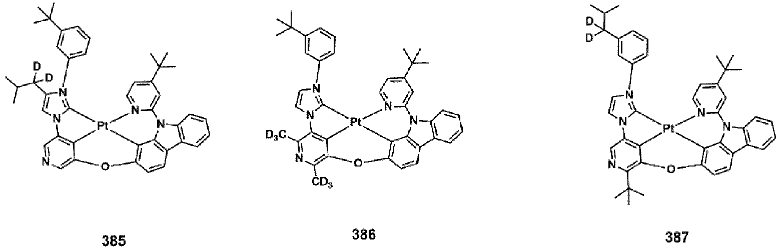

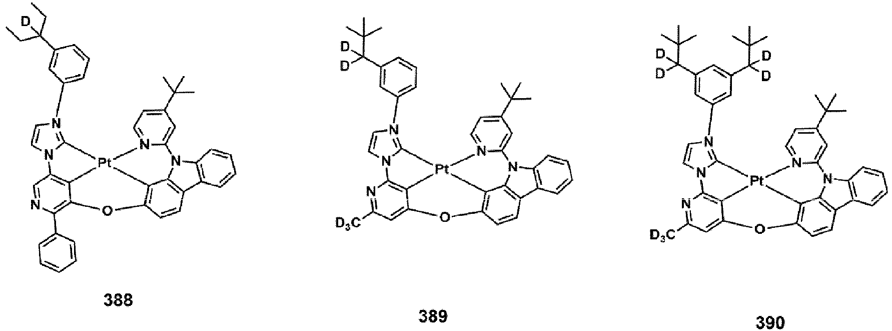

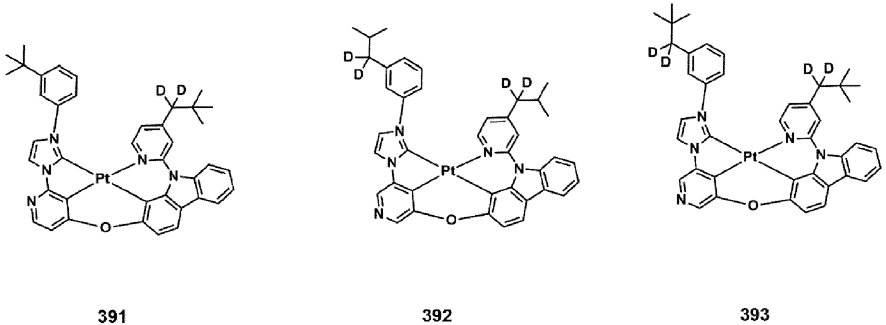

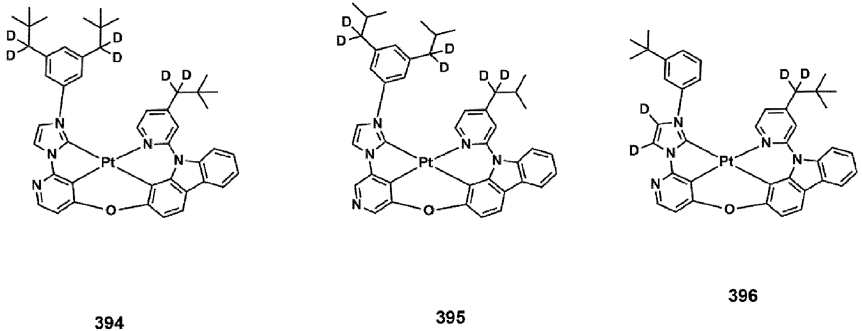

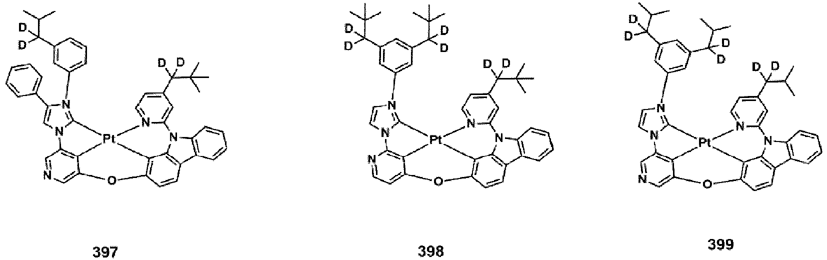

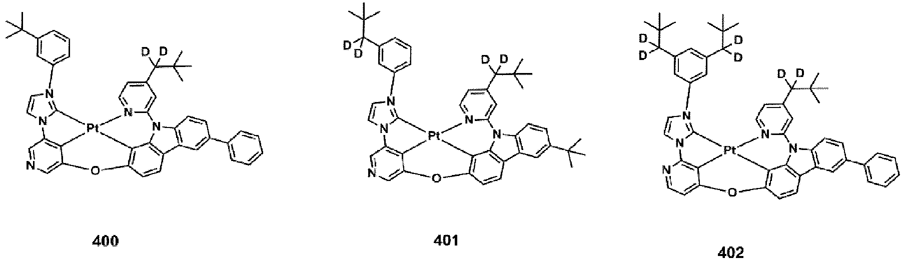

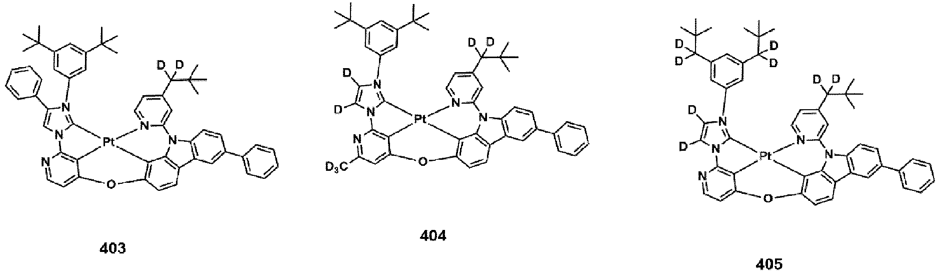

13. Organische lichtemittierende Vorrichtung, umfassend:
eine erste Elektrode;
eine zweite Elektrode; und
eine organische Schicht, die zwischen der ersten Elektrode und der zweiten Elektrode angeordnet ist, wobei die organische Schicht eine Emissionsschicht umfasst, und
wobei die organische Schicht ferner zumindest eine von der organometallischen Verbindung nach einem von Anspruch 1-12 umfasst;
wobei bevorzugt die Emissionsschicht die zumindest eine von der organometallischen Verbindung umfasst;
wobei bevorzugt die Emissionsschicht ein Licht mit einer maximalen Emissionswellenlänge von 410 Nanometern bis 490 Nanometern emittiert.

14. Lichtemittierende Vorrichtung nach Anspruch 13, wobei
die erste Elektrode eine Anode ist,
die zweite Elektrode eine Kathode ist,
die organische Schicht ferner eine Lochtransportregion, die zwischen der ersten Elektrode und der Emissionsschicht angeordnet ist, und eine Elektronentransportregion, die zwischen der Emissionsschicht und der zweiten Elektrode angeordnet ist, umfasst,
die Lochtransportregion eine Locheinspritzschicht, eine Lochtransportschicht, eine Elektronenblockierschicht, eine Pufferschicht oder eine Kombination davon umfasst, und
die Elektronentransportregion eine Lochblockierschicht, eine Elektronentransportschicht, eine Elektroneneinspritzschicht oder eine Kombination davon umfasst.

15. Elektronische Einrichtung, umfassend die organische lichtemittierende Vorrichtung nach Anspruch 13 oder 14.

## Revendications

1. Composé organométallique représenté par la Formule 1 : 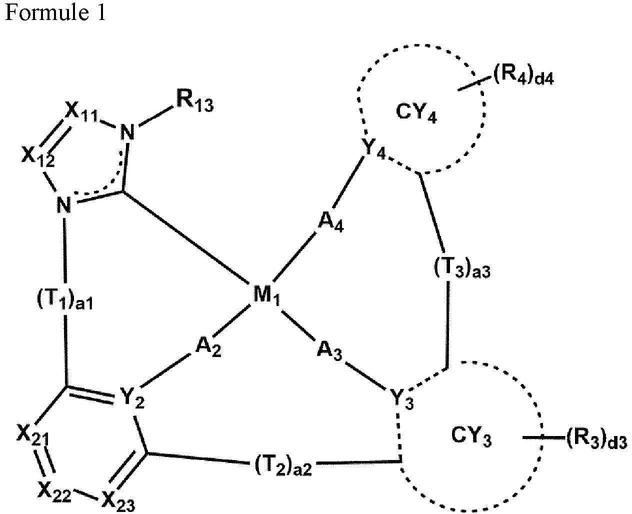 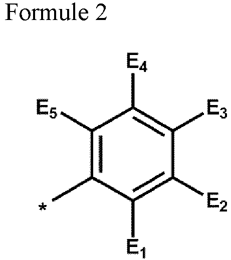 dans lequel, dans les Formules 1 et 2,
M₁ est un métal de transition ;
X₁₁ est N ou C(R₁₁),
X₁₂ est N ou C(R₁₂),
X₂₁ est N ou C(R₂₁),
X₂₂ est N ou C(R₂₂),
X₂₃ est N ou C(R₂₃),
au moins l'un de X₂₁ et X₂₂ est N,
Y₂ à Y₄ sont chacun indépendamment C ou N,
A₂ à A₄ sont chacun indépendamment une liaison chimique, O ou S,
le cycle CY₃ et le cycle CY₄ sont chacun indépendamment un groupe carbocyclique en C₅ à C₃₀ ou un groupe hétérocyclique en C₁ à C₃₀,
T₁ est une liaison simple, une liaison double, *-N[(L₁)_{b1}-(R₁ₐ)]-*', *-B(R₁ₐ)-*', *-P(R₁ₐ)-*', *- C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', ou *-C≡C-*',
T₂ est une liaison simple, une double liaison, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂)-*', *-C(R₂ₐ)=C(R_{2b})-*', *-C(=S)-*', ou *-C≡C-*',
T₃ est une simple liaison, une double liaison, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*' ou *-C≡C-*',
* et *' indiquent chacun un site de liaison à un atome voisin,
a1 est un nombre entier de 1 à 3, et lorsque a1 est supérieur ou égal à 2, deux T₁ ou plus sont identiques ou différents les uns des autres,
a2 est un nombre entier de 1 à 3, et lorsque a2 est supérieur ou égal à 2, deux T₂ ou plus sont identiques ou différents les uns des autres,
a3 est un nombre entier de 1 à 3, et lorsque a3 est supérieur ou égal à 2, deux T₃ ou plus sont identiques ou différents les uns des autres,
L₁ à L₃ sont chacun indépendamment une liaison simple, un groupe carbocyclique en C₅ à C₃₀ non substitué ou substitué par au moins un R₁₀ₐ ou un groupe hétérocyclique en C₁ à C₃₀ non substitué ou substitué par au moins un R₁₀ₐ,
b1 à b3 sont chacun indépendamment un nombre entier de 1 à 3,
R₁₃ est un groupe représenté par la Formule 2,
R₁ₐ, R_{1b}, R₂ₐ, R_{2b}, R₃ₐ, R_{3b}, R₃, R₄, R₁₁, R₁₂, R₂₁ à R₂₃ et E₁ à E₅ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe arylalkyle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryle en C₂ à C₆₀ substitué ou non substitué, un groupe hétéroarylalkyle en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non aromatique monovalent substitué ou non substitué, un groupe hétéropolycyclique condensé non aromatique monovalent substitué ou non substitué, - Si(Q₁)(Q₂)(Q₃), -Ge(Q₁)(Q₂)(Q₃), -N(Q₄)(Q₅), -B(Q₆)(Q₇), -P(Q₈)(Q₉) ou - P(=O)(Q₈)(Q₉),
deux éléments voisins ou plus parmi R₁ₐ, R_{1b}, R₂ₐ, R_{2b}, R₃ₐ, R_{3b}, R₁₁, R₁₂, R₂₁ à R₂₃ et E₁ à E₅ sont éventuellement liés les uns aux autres pour former un groupe carbocyclique en C₅ à C₃₀ substitué ou non substitué ou un groupe hétérocyclique en C₁ à C₃₀ substitué ou non substitué,
au moins l'un parmi E₂ et E₄ n'est pas un hydrogène,
R₁₀ₐ est tel que décrit en relation avec R₃,
d3 et d4 sont chacun indépendamment un nombre entier de 0 à 20,
lorsque d3 est supérieur ou égal à 2, deux R₃ ou plus sont identiques ou différents les uns des autres, et lorsque d4 est supérieur ou égal à 2, deux R₄ ou plus sont identiques ou différents les uns des autres,
* indique un site de liaison à un atome voisin dans la Formule 2,
au moins un substituant du groupe carbocyclique en C₅ à C₃₀ substitué, du groupe hétérocyclique en C₁ à C₃₀ substitué, du groupe alkyle en C₁ à C₆₀ substitué, du groupe alcényle en C₂ à C₆₀ substitué, du groupe alcynyle en C₂ à C₆₀ substitué, du groupe alcoxy en C₁ à C₆₀ substitué, du groupe alkylthio en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe alkylaryle en C₇ à C₆₀ substitué, du groupe arylalkyle en C₇ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe alkylhétéroaryle en C₂ à C₆₀ substitué, du groupe hétéroarylalkyle en C₂ à C₆₀ substitué, du groupe hétéroaryloxy en C₁ à C₆₀ substitué, du groupe hétéroarylthio en C₁ à C₆₀ substitué, du groupe polycyclique condensé non aromatique monovalent substitué et du groupe hétéropolycyclique condensé non aromatique monovalent substitué est :
un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀ ou un groupe alkylthio en C₁ à C₆₀ ;
un groupe alkyle en C₁ à C₆₀, un groupe alcényle en C₂ à C₆₀, un groupe alcynyle en C₂ à C₆₀, un groupe alcoxy en C₁ à C₆₀, ou un groupe alkylthio en C₁ à C₆₀, chacun étant substitué par au moins l'un choisi parmi le deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀,_{,}un groupe polycyclique condensé non aromatique monovalent, un groupe hétéropolycyclique condensé non aromatique monovalent, - Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), -P(Q₁₈)(Q₁₉), - P(=O)(Q₁₈)(Q₁₉) ou une combinaison de ceux-ci ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent ou un groupe hétéropolycyclique condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent, ou un groupe hétéropolycyclique condensé non aromatique monovalent, chacun étant substitué par au moins l'un parmi le deutérium, -F, -Cl, -Br, **-I,** -SF₅, -CD₃, -CD₂H, - CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, un groupe alkylthio en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe arylalkyle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroarylalkyle en C₂ à C₆₀, un groupe hétéroaryloxy en C₁ à C₆₀, un groupe hétéroarylthio en C₁ à C₆₀, un groupe polycyclique condensé non aromatique monovalent, un groupe hétéropolycyclique condensé non aromatique monovalent, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉) ou une combinaison de ceux-ci ; ou
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉) ou - P(=O)(Q₃₈)(Q₃₉), et
Q₁ à Q₉, Q₁₁ à Q₁₉, Q₂₁ à Q₂₉ et Q₃₁ à Q₃₉ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe arylalkyle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryle en C₂ à C₆₀ substitué ou non substitué, un groupe hétéroarylalkyle en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non-aromatique monovalent substitué ou non substitué, ou un groupe hétéropolycyclique condensé non-aromatique monovalent substitué ou non substitué.

2. Composé organométallique de la revendication 1, dans lequel M₁ est l'iridium, le platine, l'osmium, le titane, le zirconium, l'hafnium, l'europium, le terbium, le thulium, le rhodium, le palladium ou l'or.

3. Composé organométallique de l'une des revendications 1 ou 2, dans lequel la Formule 1 satisfaisant à l'une des conditions 1-1 à 1-3 :
Condition 1-1
X₂₁ est N et X₂₂ est C(R₂₂) ;
Condition 1-2
X₂₁ est C(R₂₁) et X₂₂ est N ;
Condition 1-3
X₂₁ est N, et X₂₂ est N ; et/ou
dans lequel la Formule 2 satisfait au moins à l'une des conditions 2-1 et 2-2 :
Condition 2-1
E₂ n'est pas un hydrogène ;
Condition 2-2
E₂ et E₄ ne sont pas un hydrogène.

4. Composé organométallique de l'une quelconque des revendications 1 à 3, dans lequel le cycle CY₃ et le cycle CY₄ sont chacun indépendamment un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofuranne, un groupe dibenzothiophène 5-oxyde, un groupe 9H-fluorène-9-one, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluorène-9-one, un groupe azadibenzothiophène 5,5-dioxyde, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isooxazole, un groupe thiazole, un groupe isothiazole, un groupe oxadiazole, un groupe thiadiazole, un groupe benzopyrazole, un groupe benzimidazole, un groupe benzotriazole, un groupe benzoxazole, un groupe benzothiazole, un groupe benzoxadiazole, un groupe benzothiadiazole, un groupe 5,6,7,8-tétrahydroisoquinoléine ou un groupe 5,6,7,8-tétrahydroquinoléine ; et/ou
dans lequel au moins l'un de Y₂ à Y₄ est N.

5. Composé organométallique de l'une quelconque des revendications 1 à 4, dans lequel au moins l'un parmi E₂ et E₄ est :
le deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₂₀, un groupe alcényle en C₂ à C₂₀, un groupe alcynyle en C₂ à C₂₀, un groupe alcoxy en C₁ à C₂₀ ou un groupe alkylthio en C₁ à C₂₀ ;
un groupe alkyle en C₁ à C₂₀, un groupe alcényle en C₂ à C₂₀, un groupe alcynyle en C₂ à C₂₀, un groupe alcoxy en C₁ à C₂₀ ou un groupe alkylthio en C₁ à C₂₀, chacun étant substitué par au moins l'un parmi le deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, un groupe pyrimidinyle ou une combinaison de ceux-ci ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle ou un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle ou un groupe imidazopyrimidinyle, chacun étant substitué par au moins l'un parmi le deutérium, -F, -Cl, -Br, - I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₂₀, un groupe alcoxy en C₁ à C₂₀, un groupe alkylthio en C₁ à C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, -Si(Q₃₁)(Q₃₂)(Q₃₃), - Ge(Q₃₁)(Q₃₂)(Q₃₃), -N(Q₃₄)(Q₃₅), -B(Q₃₆)(Q₃₇), -P(Q₃₈)(Q₃₉), -P(=O)(Q₃₉)(Q₃₉) ou une combinaison de ceux-ci ; ou
-Si(Q₁)(Q₂)(Q₃), -Ge(Q₁)(Q₂)(Q₃), -N(Q₄)(Q₅), -B(Q₆)(Q₇), -P(Q₈)(Q₉) ou -P(=O)(Q₈)(Q₉), et
Q₁ à Q₉ et Q₃₁ à Q₃₉ sont chacun indépendamment :
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H ou -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle, chacun étant substitué par au moins l'un parmi le deutérium, un groupe alkyle en C₁ à C₁₀, un groupe phényle, ou une combinaison de ceux-ci.

6. Composé organométallique de l'une quelconque des revendications 1 à 5, dans lequel au moins l'un parmi E₂ et E₄ est :
le deutérium, -F, -Cl, -Br, -I, -SF₅, -CD₃, -CD₂H, -CDH₂, -CF₃, -CF₂H, -CFH₂, un groupe cyano, un groupe alkyle en C₁ à C₂₀, un groupe alcényle en C₂ à C₂₀, un groupe alcynyle en C₂ à C₂₀, un groupe alcoxy en C₁ à C₂₀ ou un groupe alkylthio en C₁ à C₂₀ ;
un groupe représenté par l'une des Formules 9-1 à 9-61, 9-201 à 9-237, 10-1 à 10-129 ou 10-201 à 10-355 ;
un groupe représenté par l'une des Formules 9-1 à 9-61, 9-201 à 9-237, 10-1 à 10-129 ou 10-201 à 10-355, dans lesquelles au moins un hydrogène est substitué par au moins l'un parmi le deutérium, -F ou un groupe cyano ; ou
-Si(Q₁)(Q₂)(Q₃), -Ge(Q₁)(Q₂)(Q₃) ou -N(Q₄)(Q₅),
dans lequel Q₁ à Q₅ sont chacun tels que décrits dans la revendication 1 : 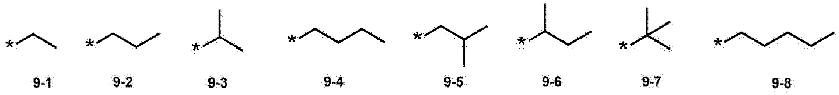 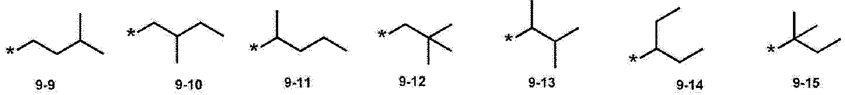 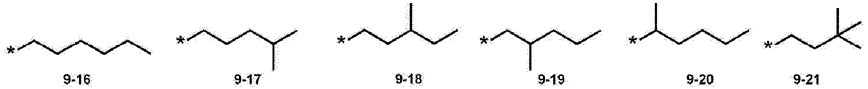 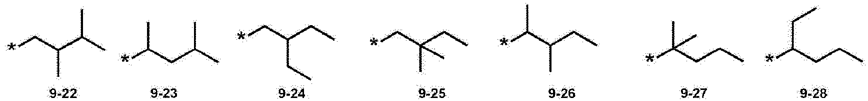 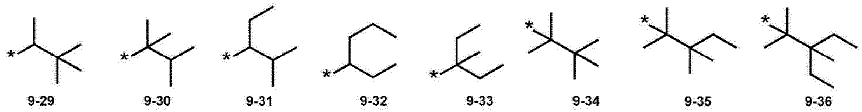 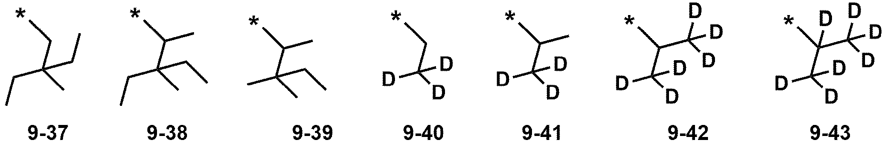 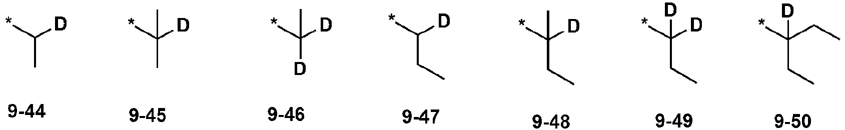 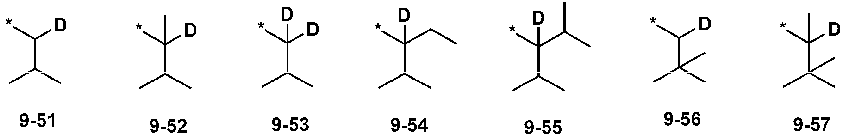 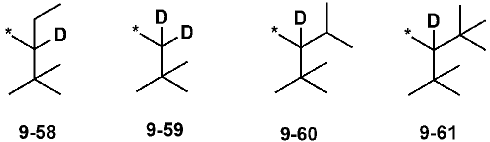 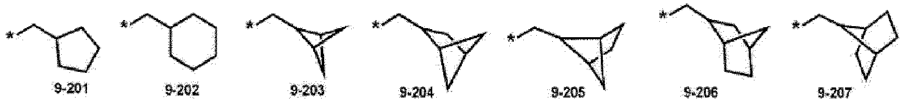 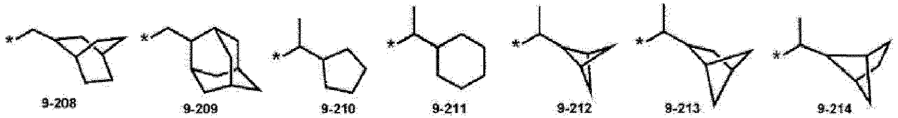 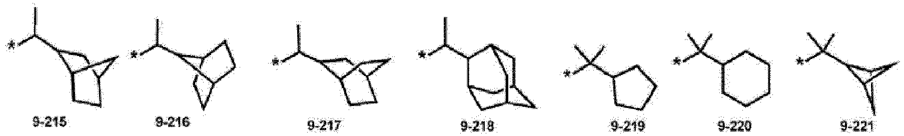 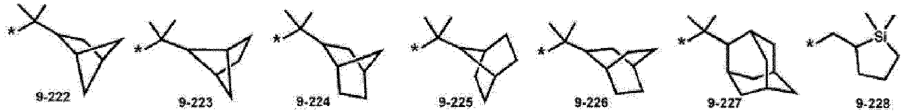 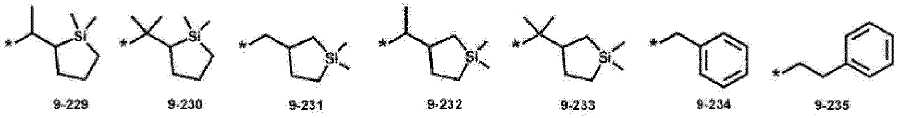 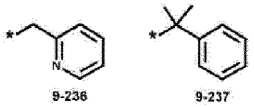 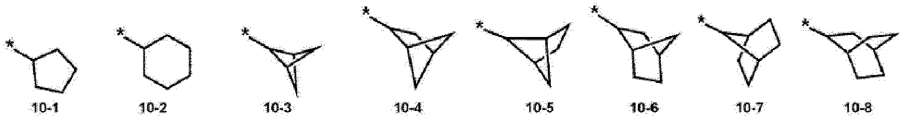 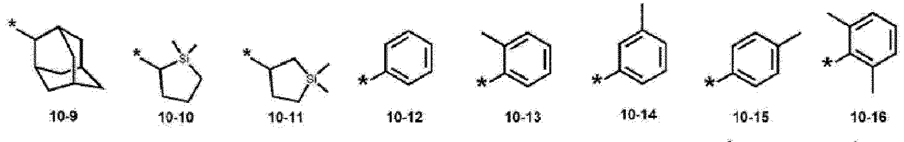 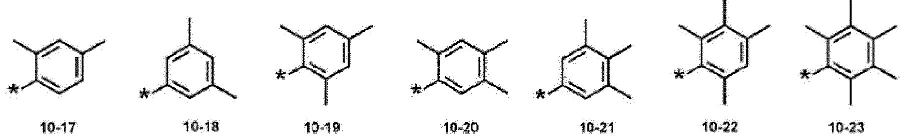 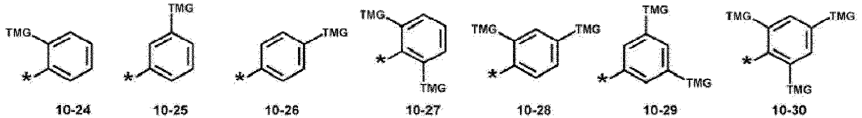 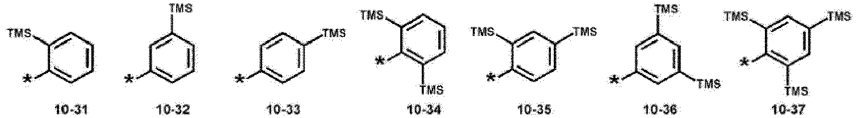 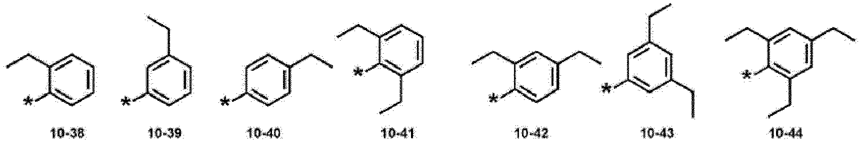 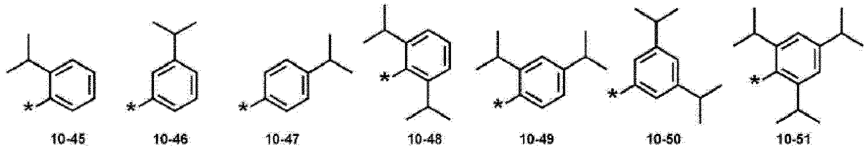 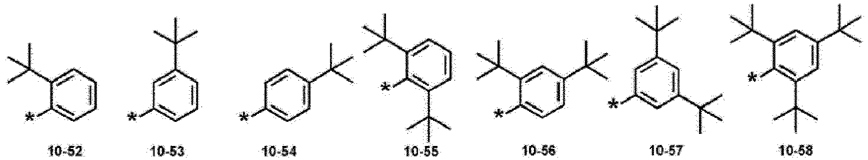 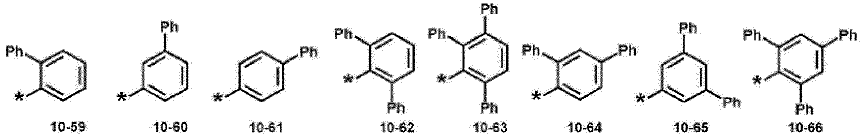 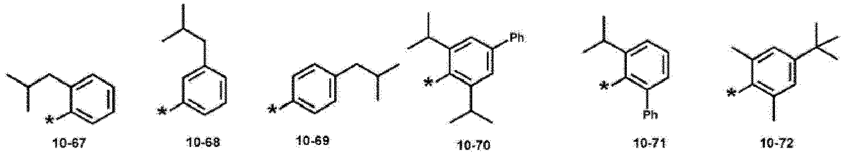 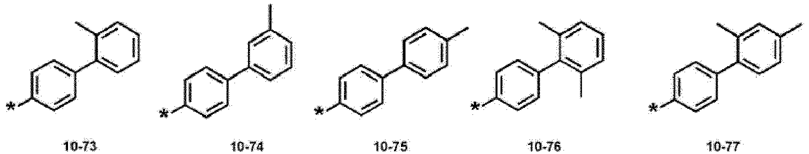 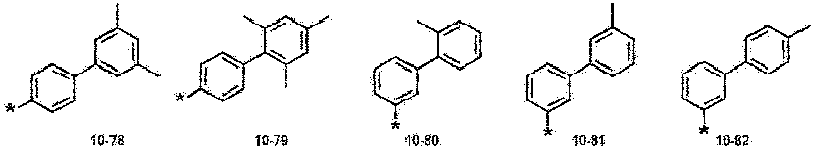 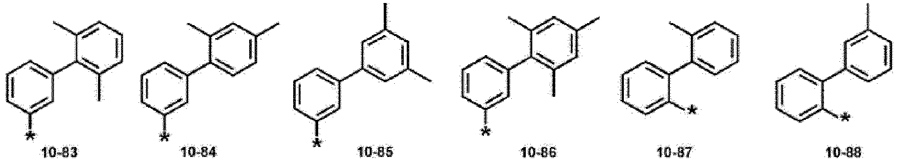 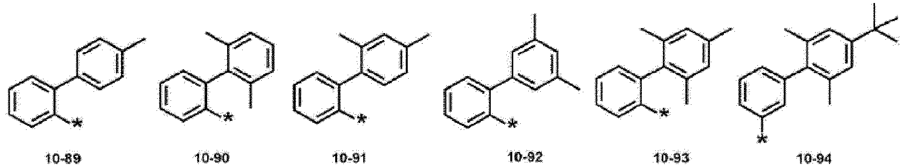 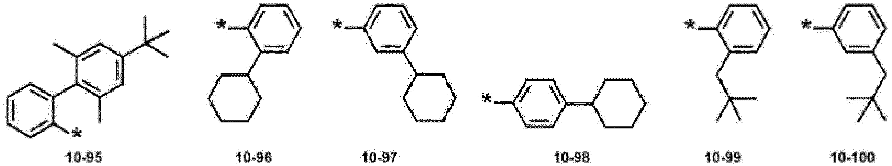 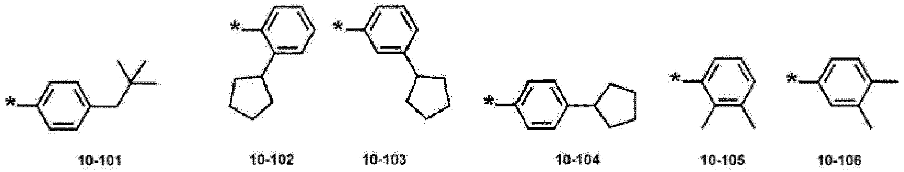 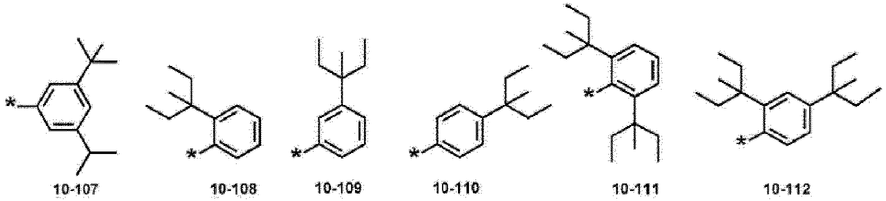 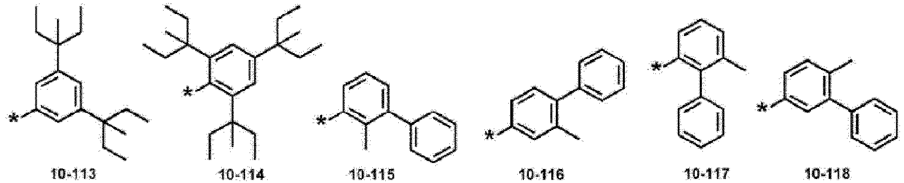 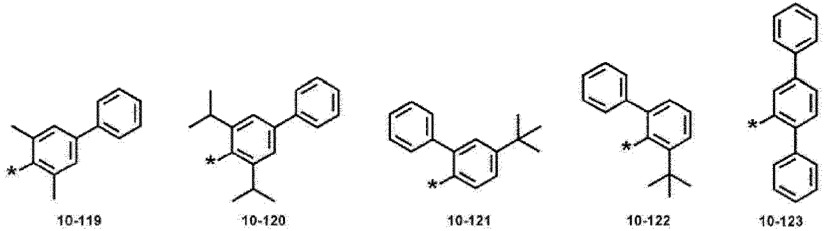 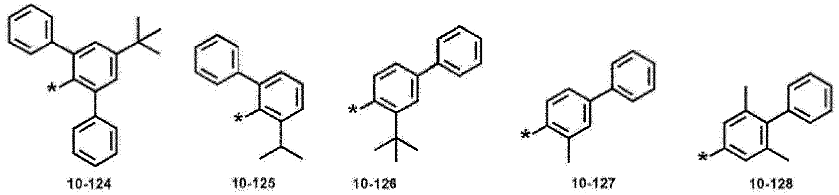 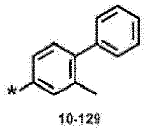 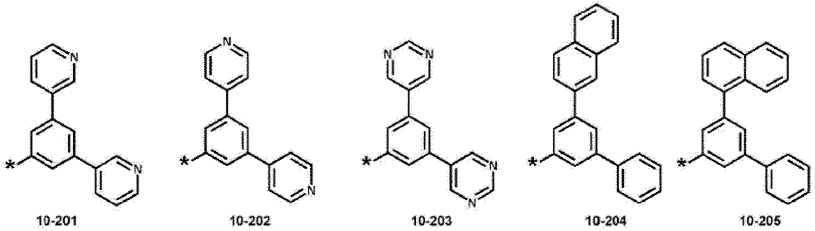 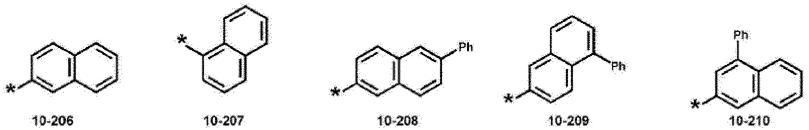 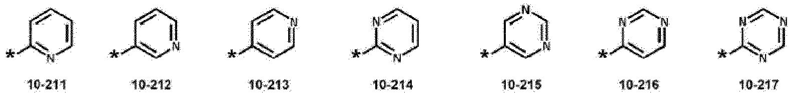 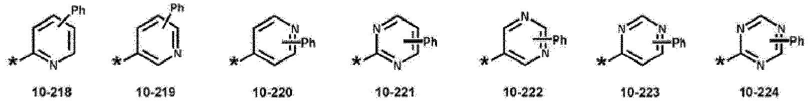 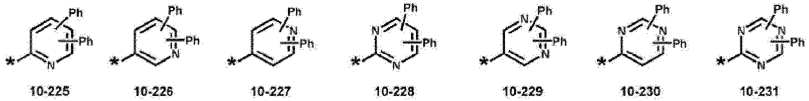 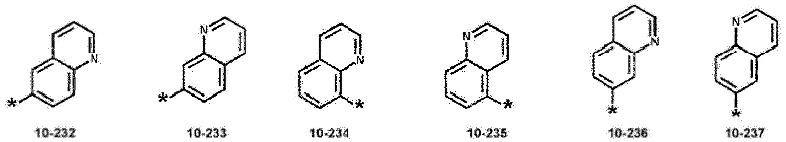 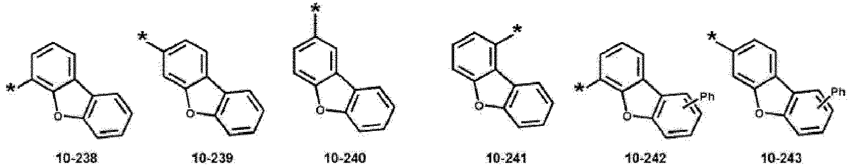 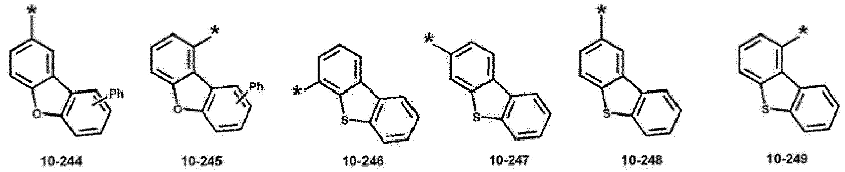 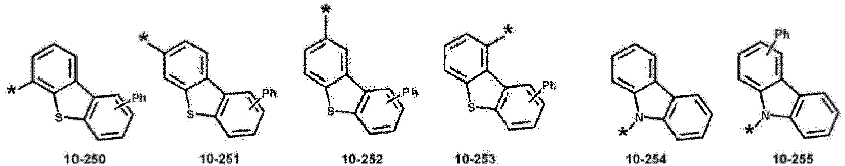 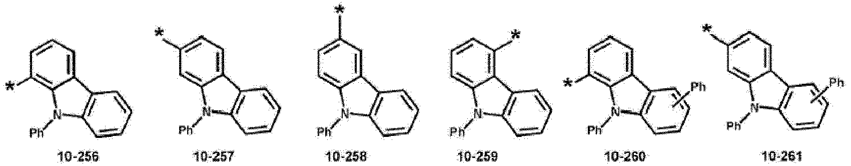 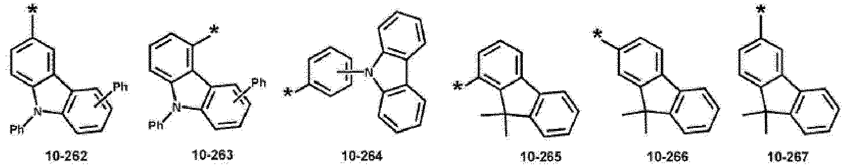 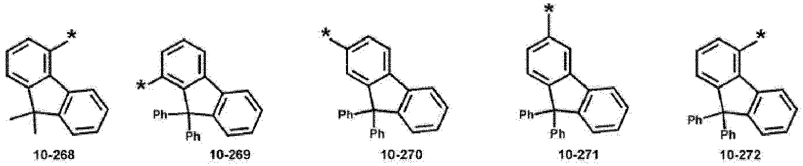 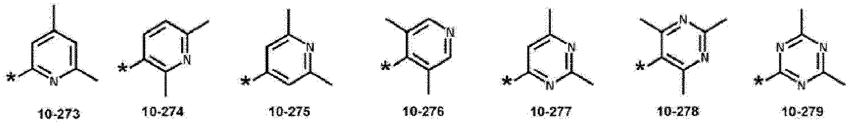 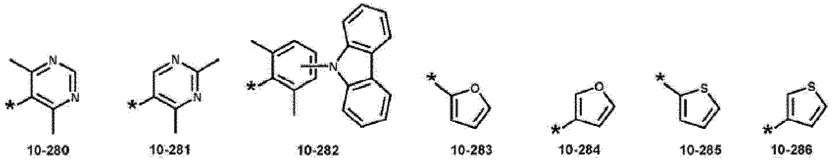 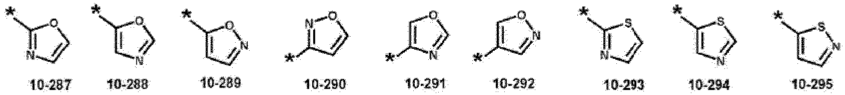 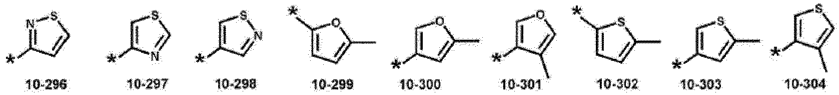 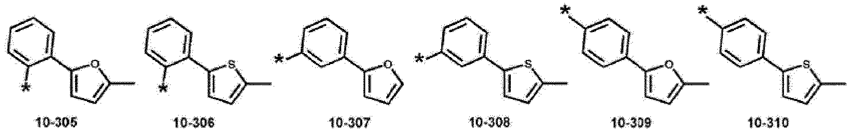 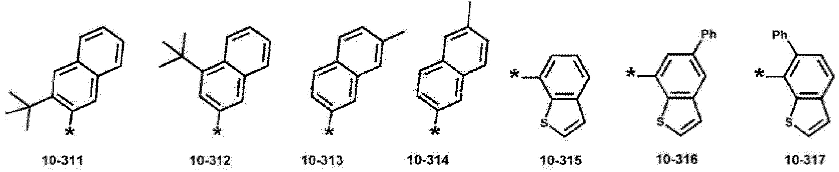 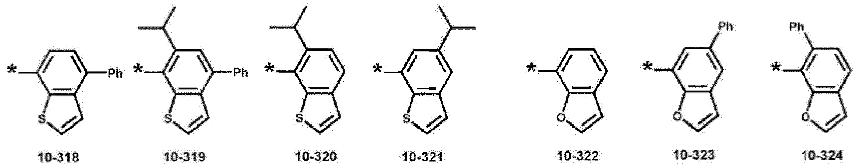 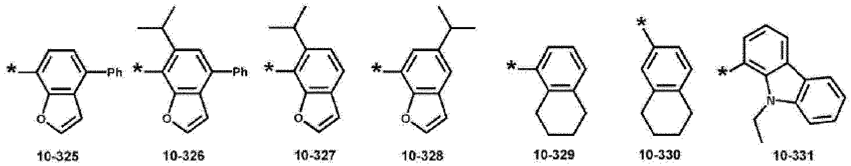 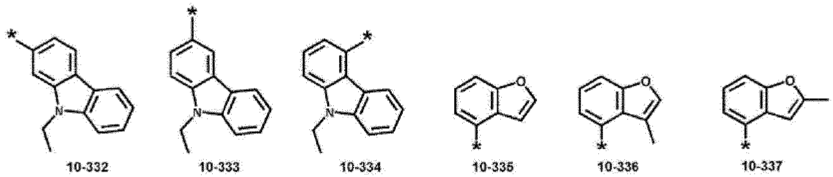 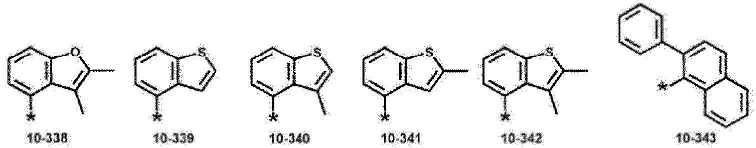 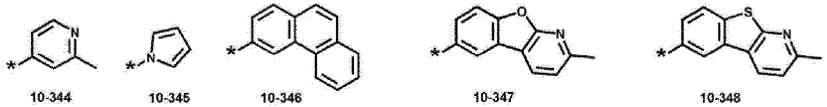 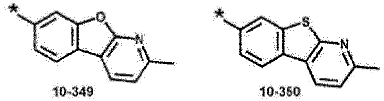 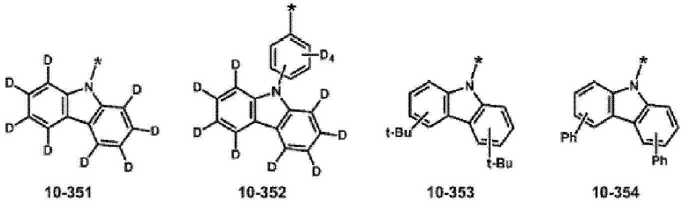 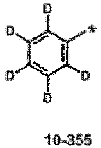
dans lequel, * dans les Formules 9-1 à 9-61, 9-201 à 9-237, 10-1 à 10-129 et 10-201 à 10-355 indique un site de liaison à un atome voisin, « Ph » est un groupe phényle, « TMS » est un groupe triméthylsilyle, « TMG » est un groupe triméthylgermyle et « t-Bu » est un groupe t-butyle.

7. Composé organométallique de l'une quelconque des revendications 1 à 6, dans lequel un groupe représenté par 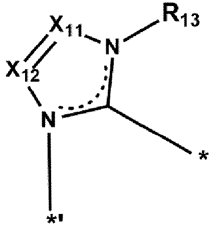 dans la Formule 1 est un groupe représenté par la Formule CY1-1 ou CY1-2 : 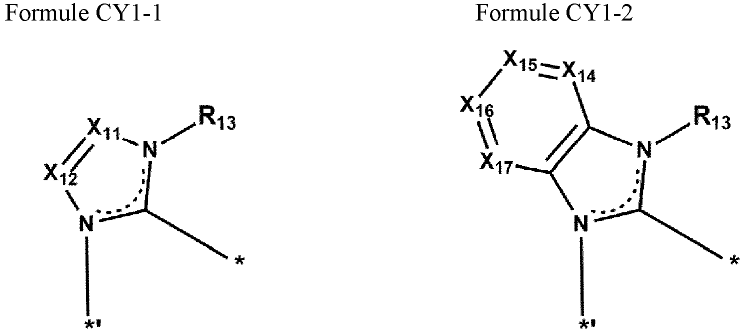 dans lequel, dans les Formules CY1-1 et CY1-2,
X₁₁, X₁₂ et R₁₃ sont chacun tels que décrits dans la revendication 1,
X₁₄ est N ou C(R₁₄),
X₁₅ est N ou C(R₁₅),
X₁₆ est N ou C(R₁₆),
X₁₇ est N ou C(R₁₇),
R₁₄ à R₁₇ sont chacun tels que définis pour R₁₁ dans la revendication 1,
* indique un site de liaison à M₁, et
*' indique un site de liaison à T₁.

8. Composé organométallique de l'une quelconque des revendications 1 à 7, dans lequel un groupe représenté par 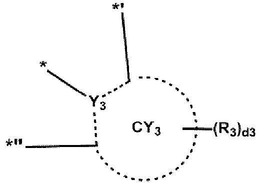 dans la Formule 1 est un groupe représenté par l'une des Formules 3-1 à 3-3 : 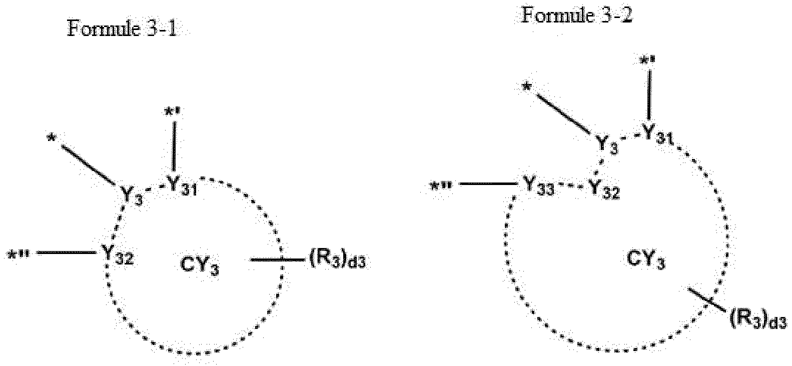 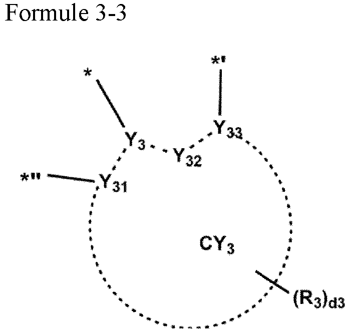 dans lequel, dans les Formules 3-1 à 3-3,
Y₃₁ à Y₃₃ sont chacun indépendamment C ou N,
Y₃₁ et Y₃, Y₃ et Y₃₂ et Y₃₂ et Y₃₃ sont liés chimiquement l'un à l'autre,
*' indique un site de liaison à T₃, *" indique un site de liaison à T₂, * indique un site de liaison à A₃ ou M₁, et
CY₃, Y₃, R₃ et d3 sont chacun tels que décrits dans la revendication 1.

9. Composé organométallique de l'une quelconque des revendications 1 à 8, dans lequel un groupe représenté par 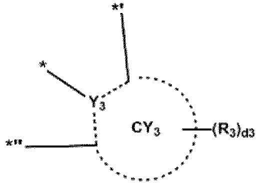 dans la Formule 1 est un groupe représenté par l'une des Formules CY3-1 à CY3-27 : 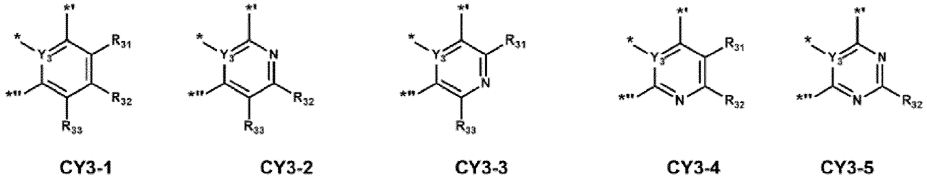 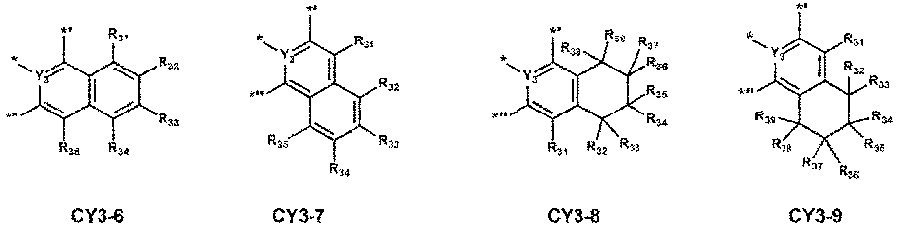 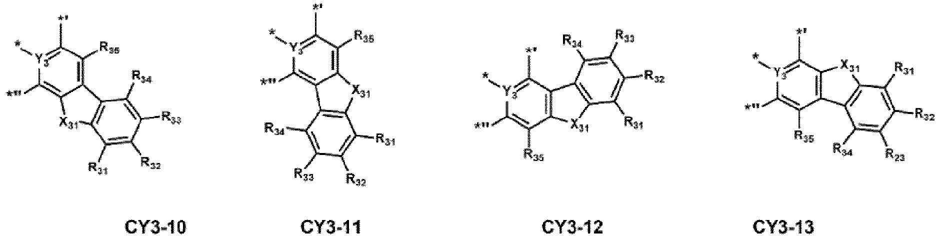 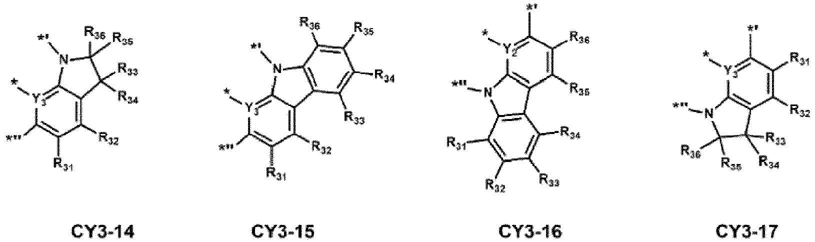 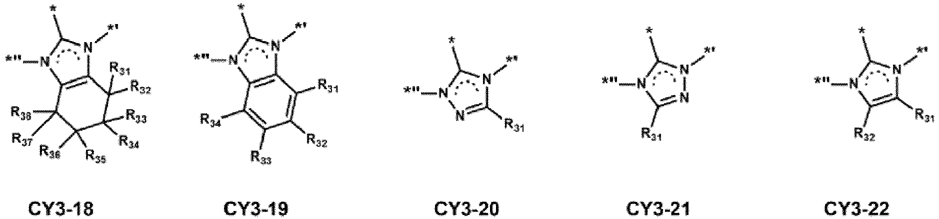 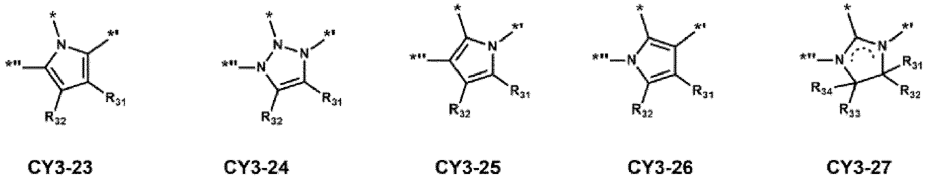 dans lequel, dans les Formules CY3-1 à CY3-27,
Y₃ est C ou N,
X₃₁ est N(R₃₁ₐ), O, Se, C(R₃₁ₐ)(R_{31b}) ou Si(R₃₁ₐ)(R_{31b}),
R₃₁ à R₃₉, R₃₁ₐ et R_{31b} sont chacun définis comme R₃ dans la revendication 1,
* indique un site de liaison à M₁ ou A₃, *' indique un site de liaison à T₃ et *" indique un site de liaison à T₂.

10. Composé organométallique de l'une quelconque des revendications 1 à 9, dans lequel un groupe représenté par 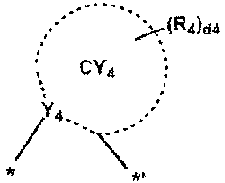 dans la Formule 1 est un groupe représenté par l'une des formules CY4-1 à CY4-18 : 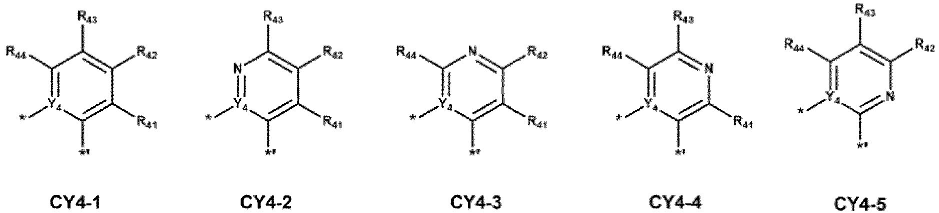 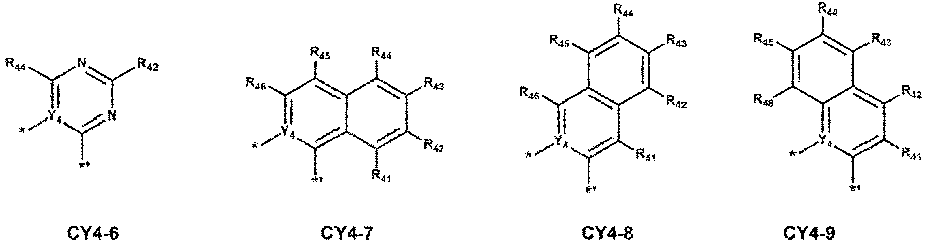 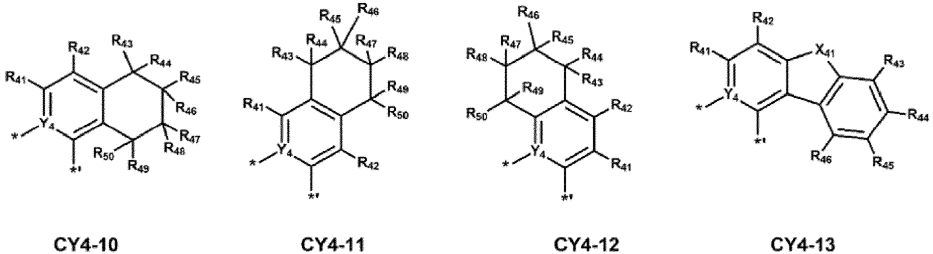 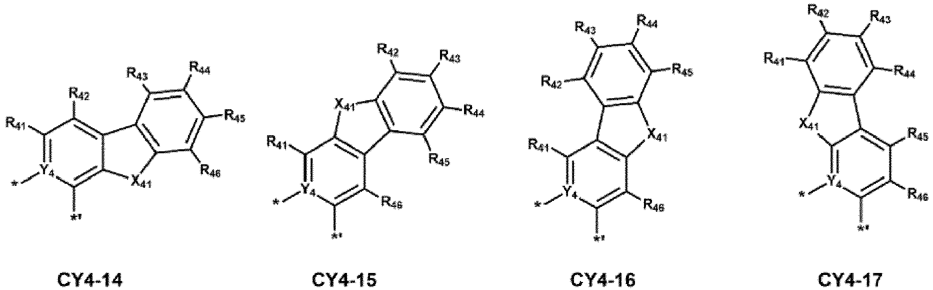 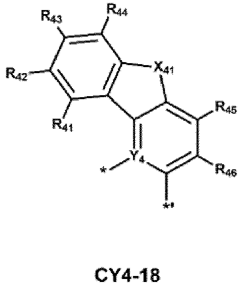 dans lequel, dans les Formules CY4-1 à CY4-18,
Y₄ est C ou N,
X₄₁ est N(R₄₁ₐ), O, Se, C(R₄₁ₐ)(R_{41b}) ou Si(R₄₁ₐ)(R_{41b}),
R₄₁ à R₅₀, R₄₁ₐ et R_{41b} sont chacun définis comme R₄ dans la revendication 1,
* indique un site de liaison à M₁ ou A₄, et
*' indique un site de liaison à T₃.

11. Composé organométallique de l'une quelconque des revendications 1 à 10, dans lequel le composé organométallique est représenté par les Formules 1-1 et 1-2 : 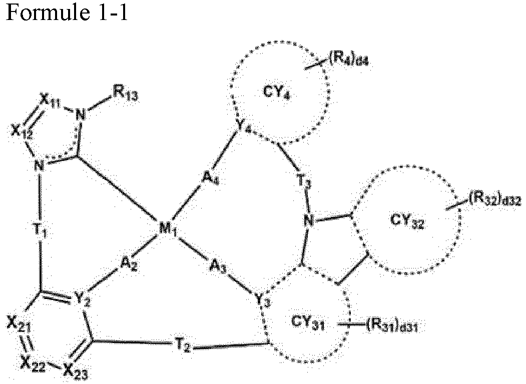 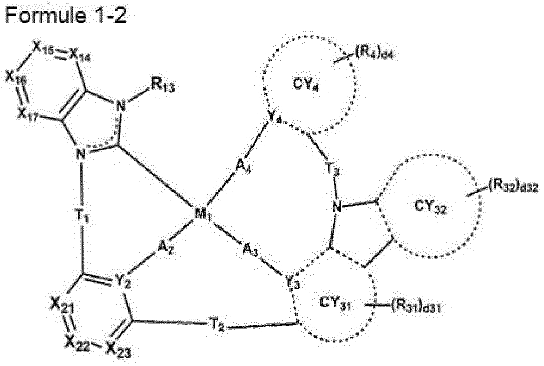 dans lequel, dans les Formules 1-1 et 1-2,
le cycle CY₃₁ et le cycle CY₃₂ sont chacun indépendamment un groupe carbocyclique en C₅ à C₃₀ ou un groupe hétérocyclique en C₁ à C₃₀,
R₃₁ et R₃₂ sont chacun définis comme R₃ dans la revendication 1,
d31 à d32 sont chacun indépendamment un nombre entier de 0 à 10,
X₁₄ est N ou C(R₁₄),
X₁₅ est N ou C(R₁₅),
X₁₆ est N ou C(R₁₆),
X₁₇ est N ou C(R₁₇),
R₁₄ à R₁₇ sont chacun définis comme R₁₁ dans la revendication 1, et
M₁, le cycle CY₄, Y₂ à Y₄, A₂ à A₄, T₁ à T₃, X₁₁, X₁₂, X₂₁ à X₂₃, R₄, d4 et R₁₃ sont chacun tels que décrits dans la revendication 1 ; et/ou
dans lequel la Formule 2 est représentée par l'une des Formules 2-1 à 2-16 : 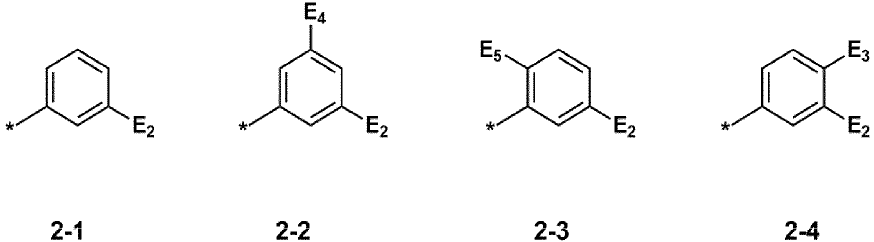 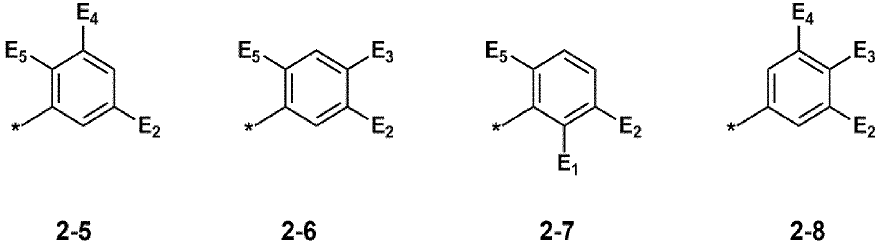 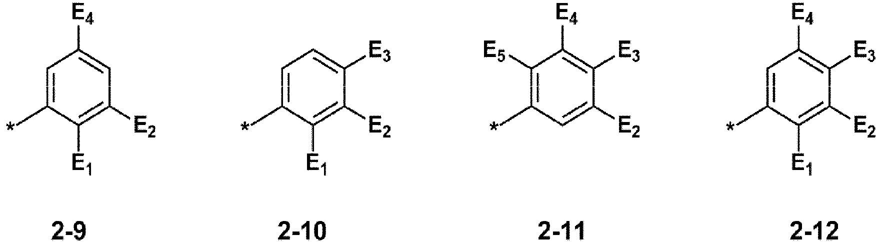 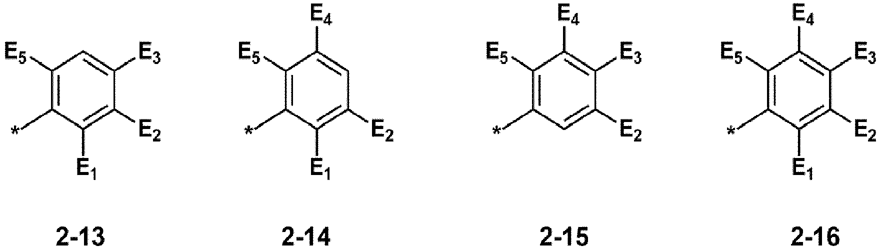 dans lequel, dans les Formules 2-1 à 2-16,
E₁ à E₅ sont chacun tels que décrits dans la revendication 1, à condition que chacun de E₁ à E₅ ne soit pas un hydrogène, et
* indique un site de liaison à un atome voisin.

12. Composé organométallique de la revendication 1, dans lequel le composé organométallique est représenté par l'un des composés 1 à 405 :

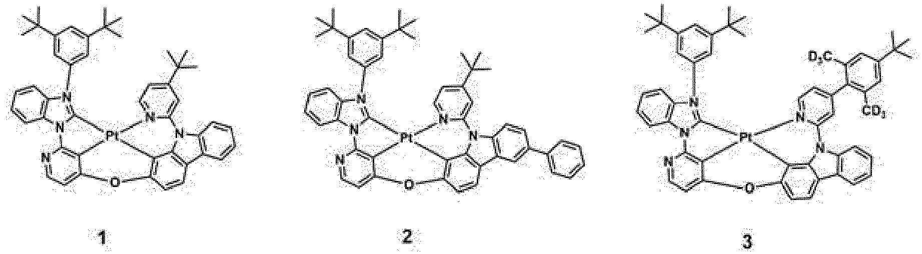

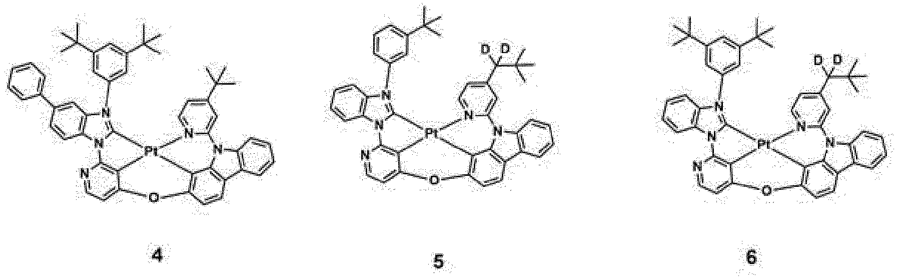

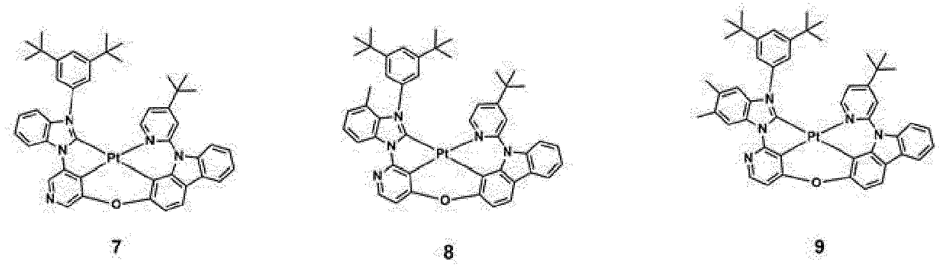

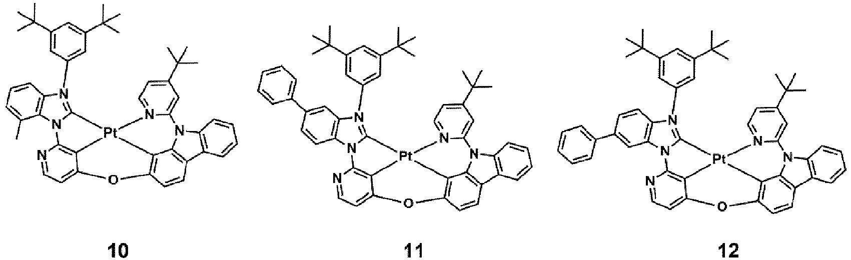

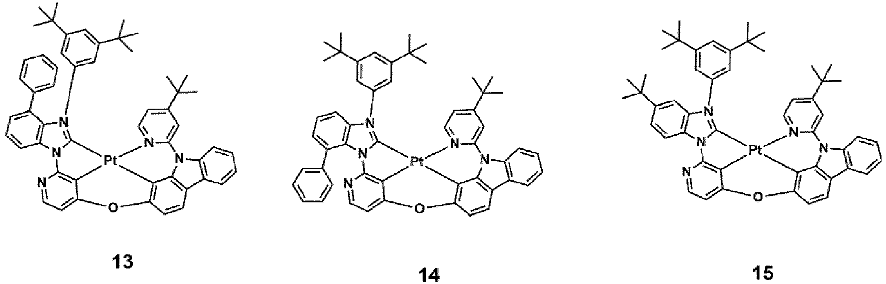

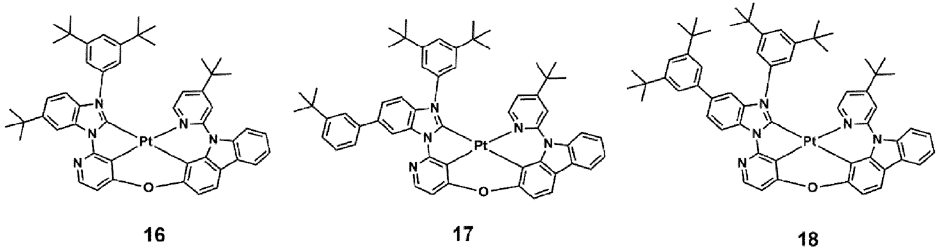

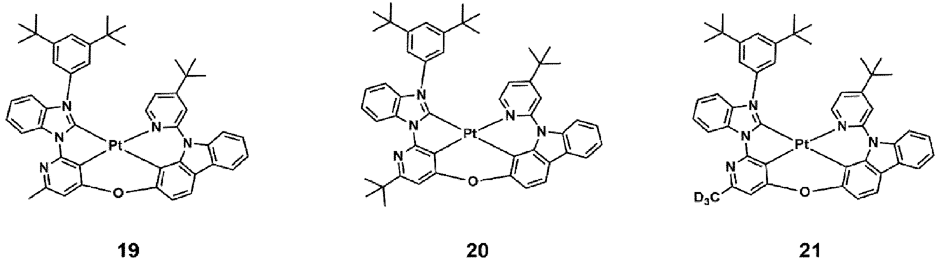

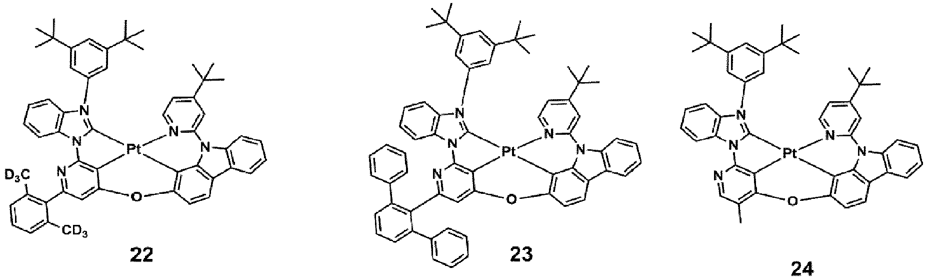

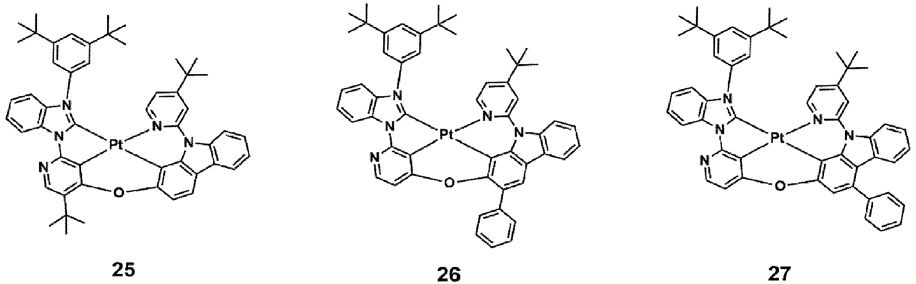

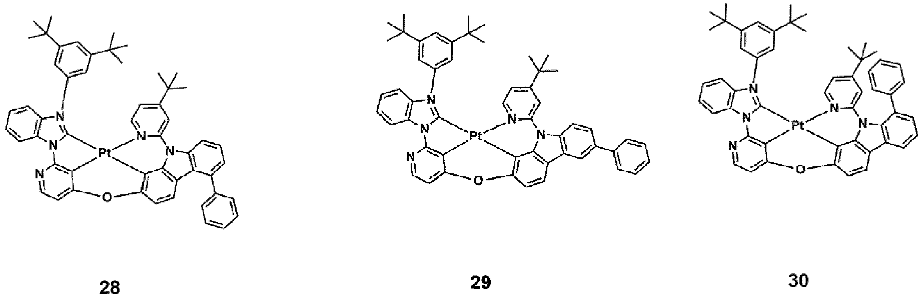

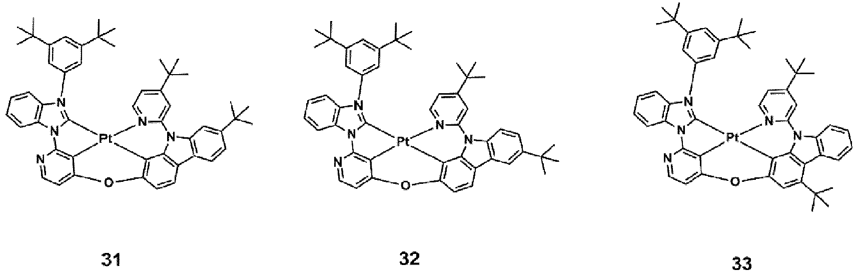

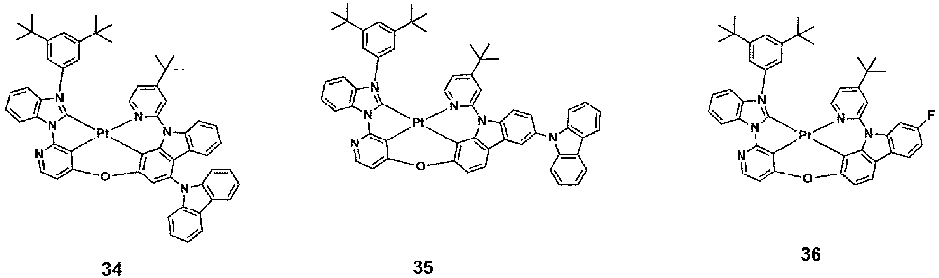

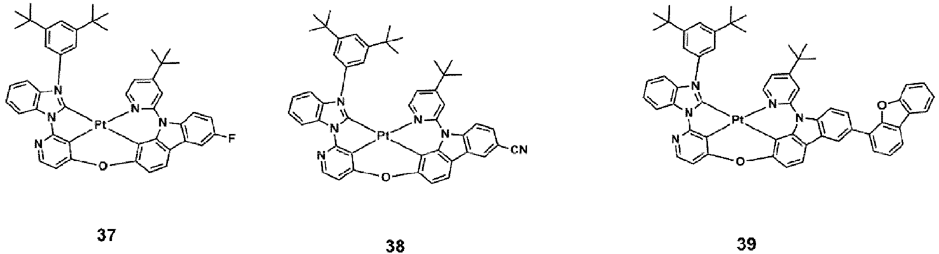

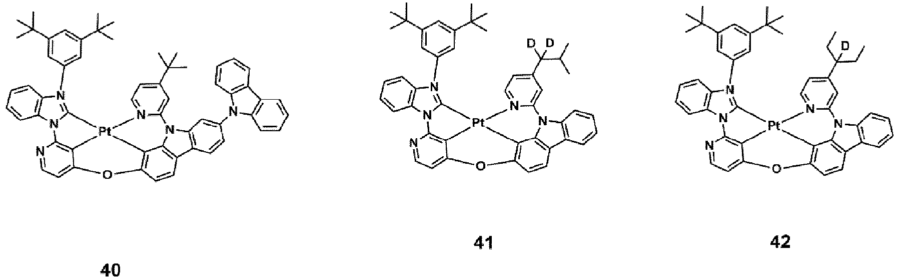

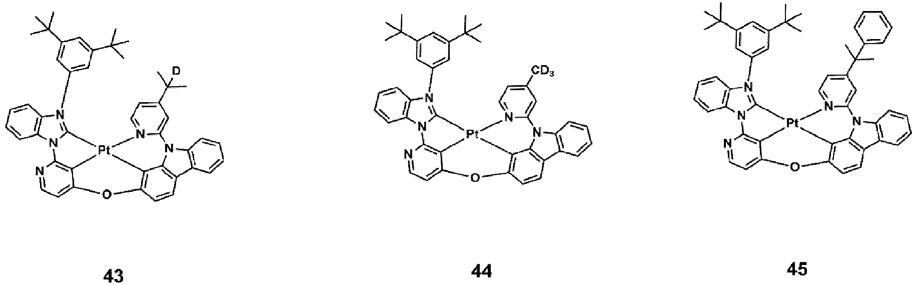

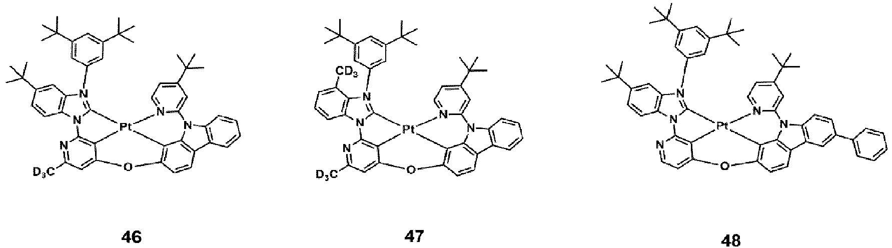

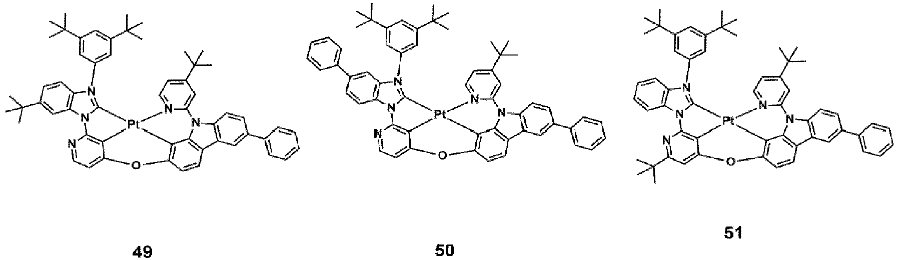

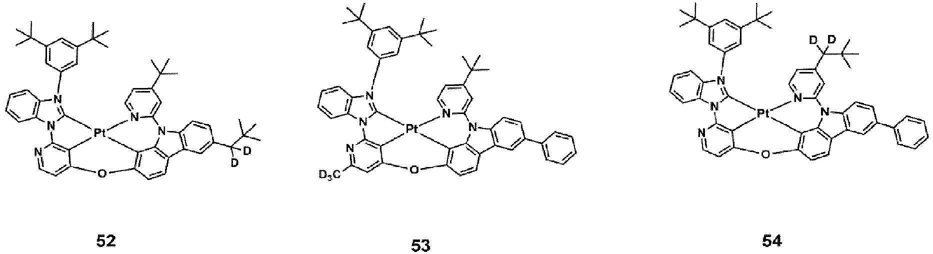

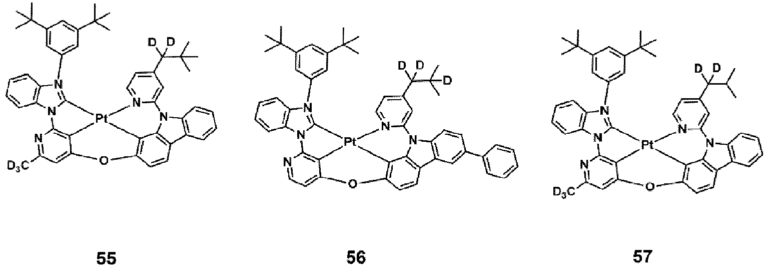

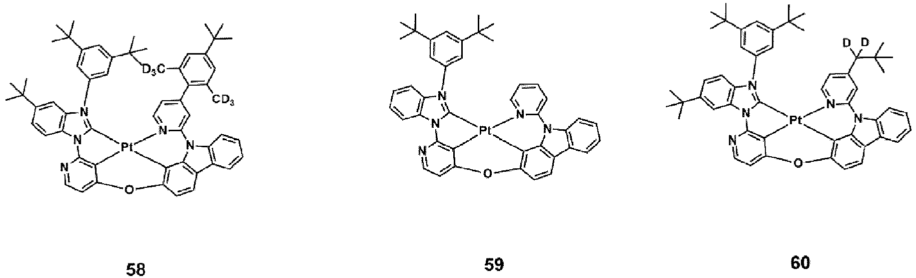

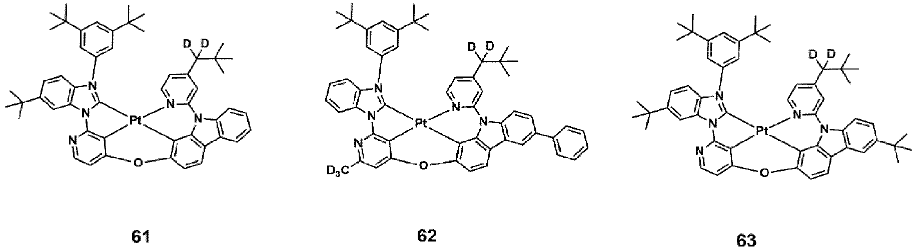

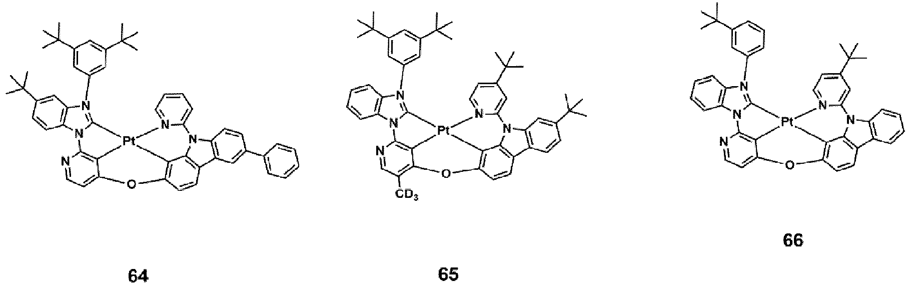

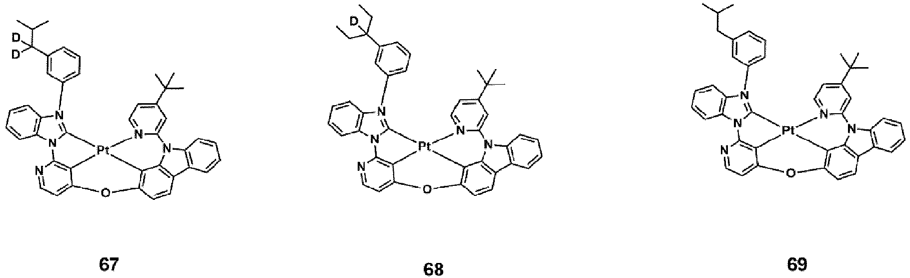

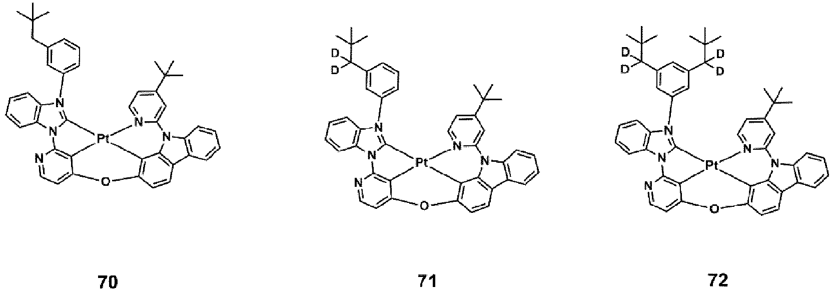

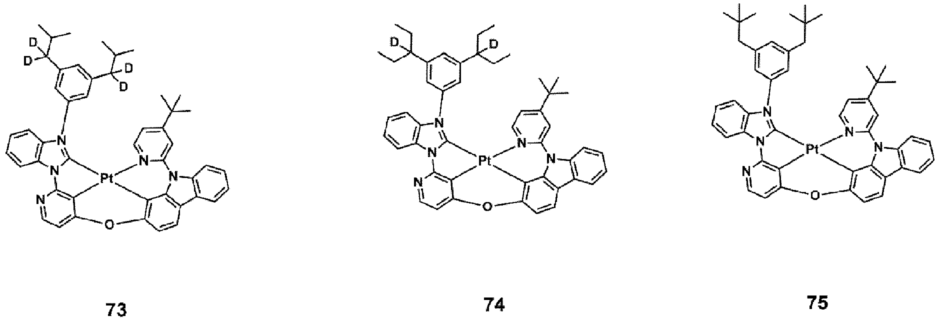

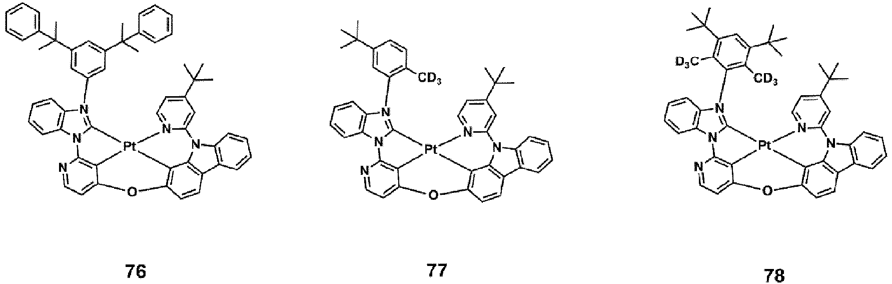

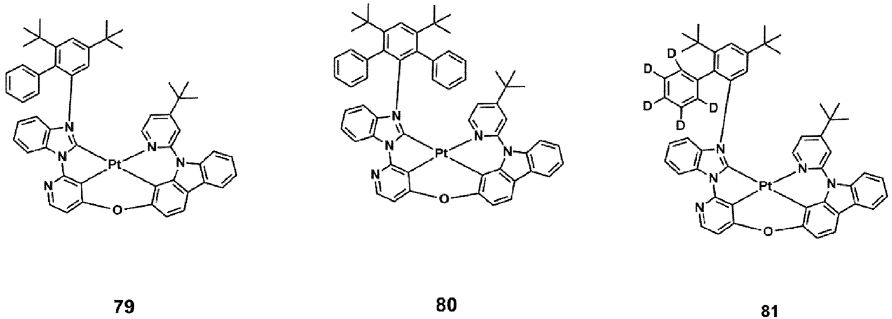

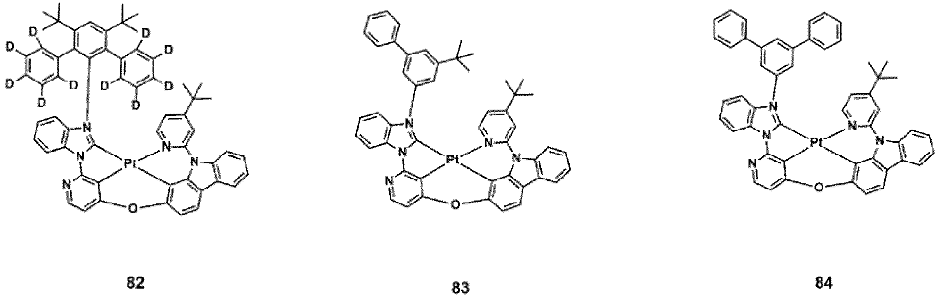

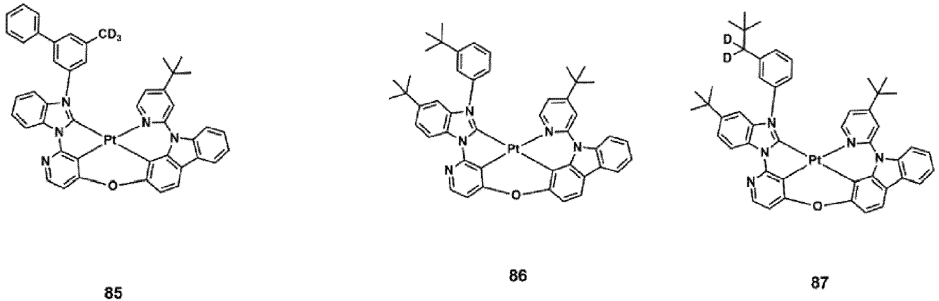

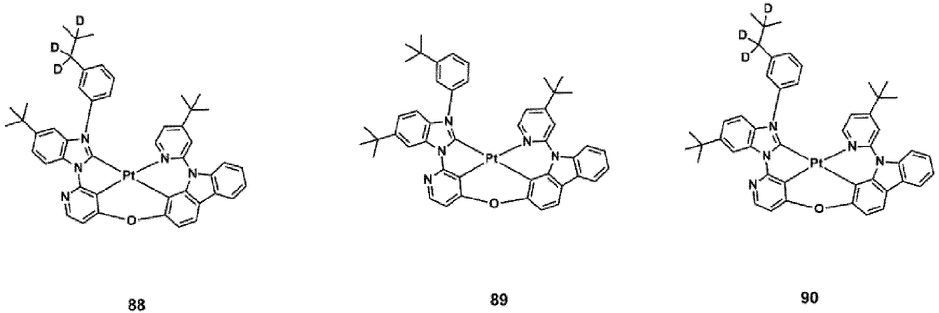

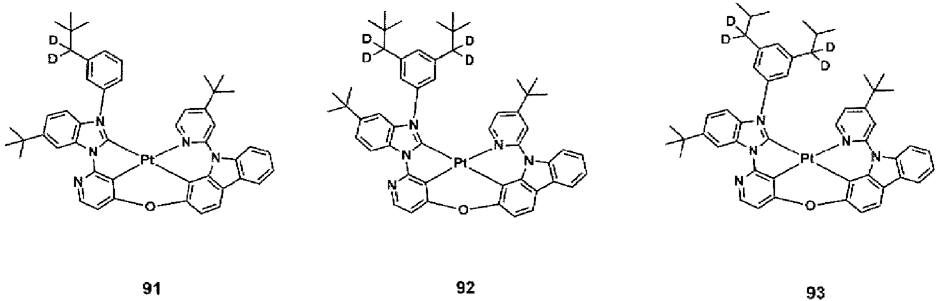

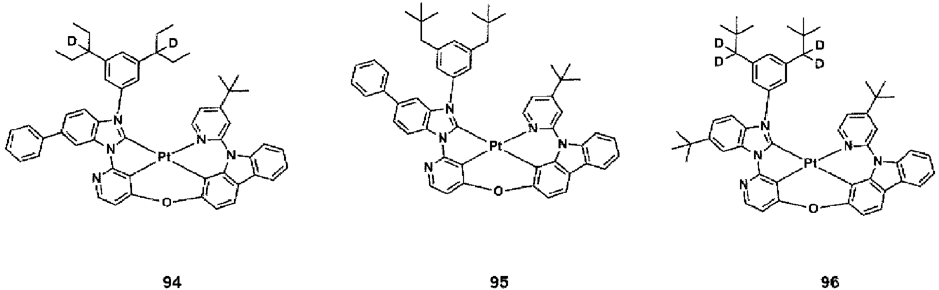

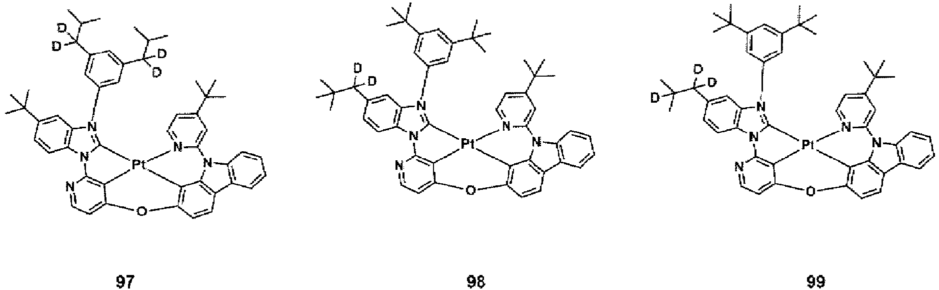

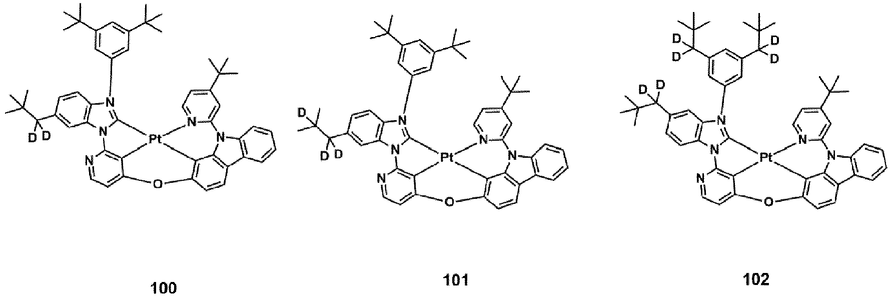

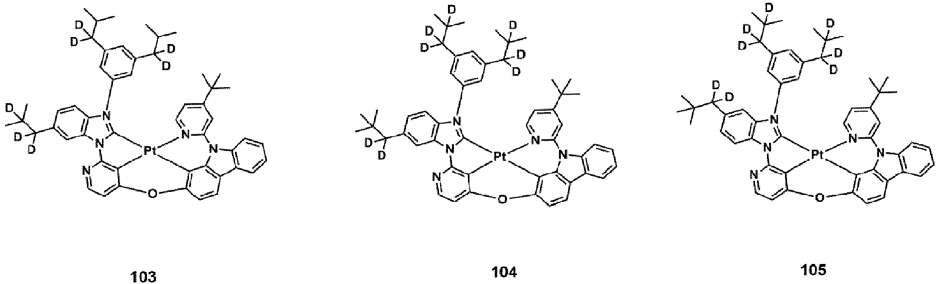

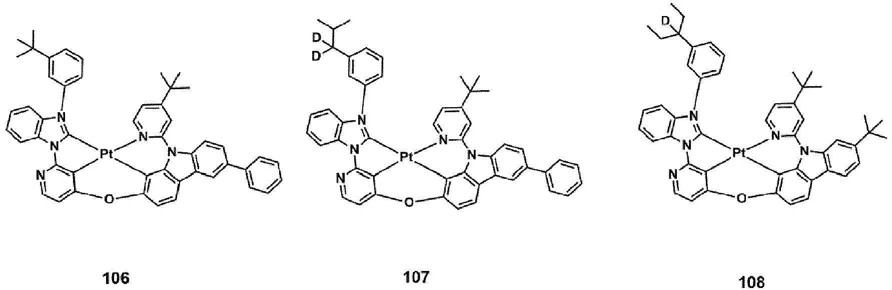

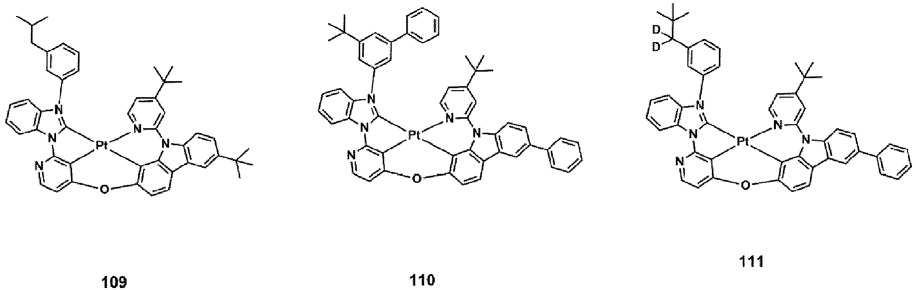

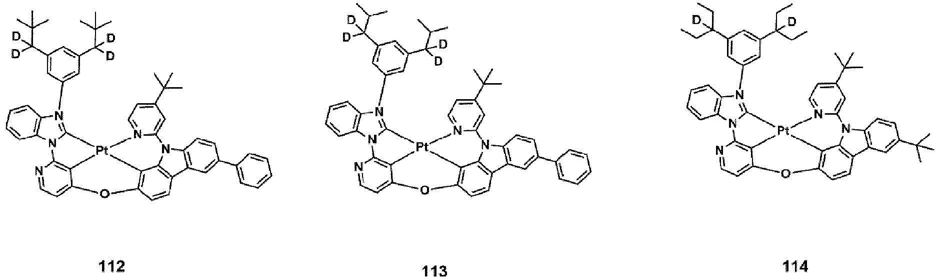

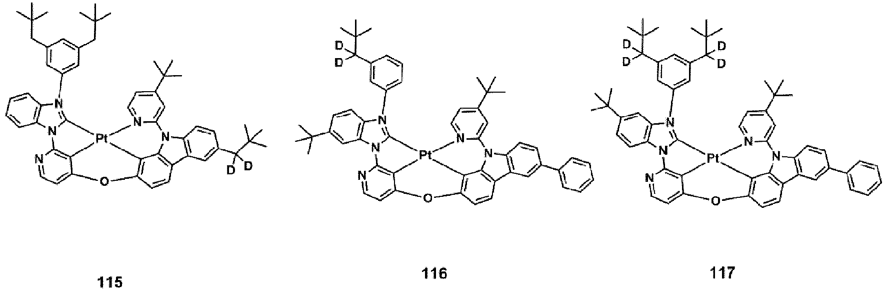

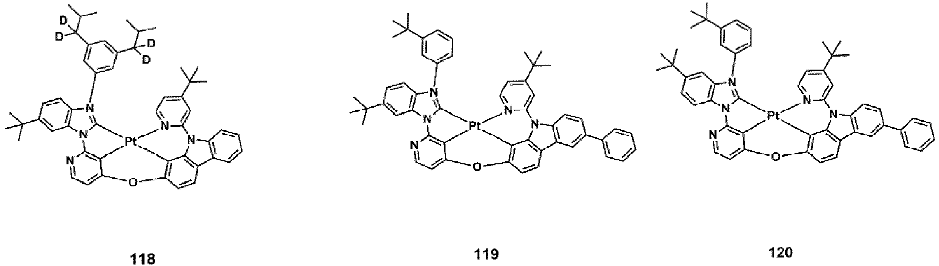

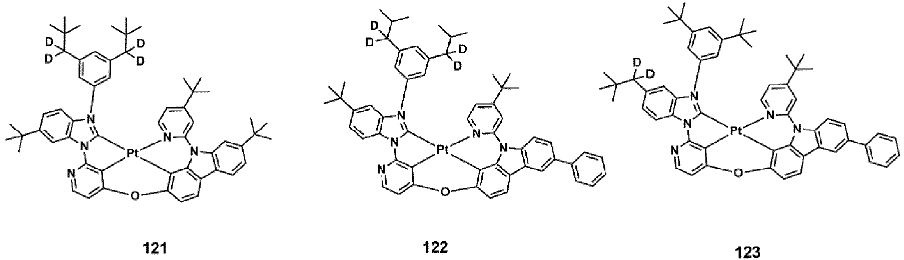

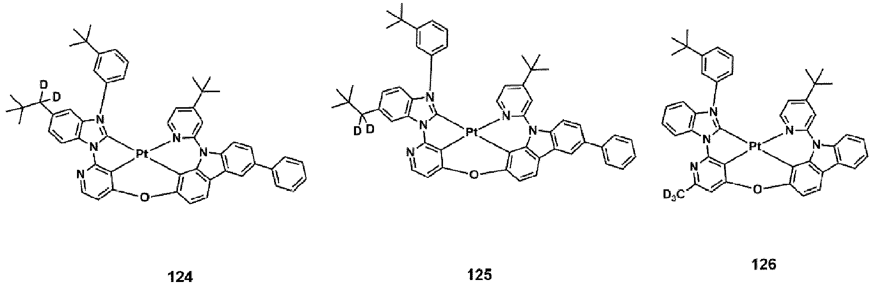

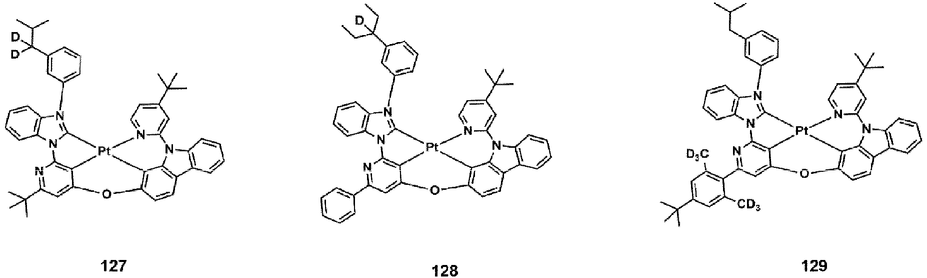

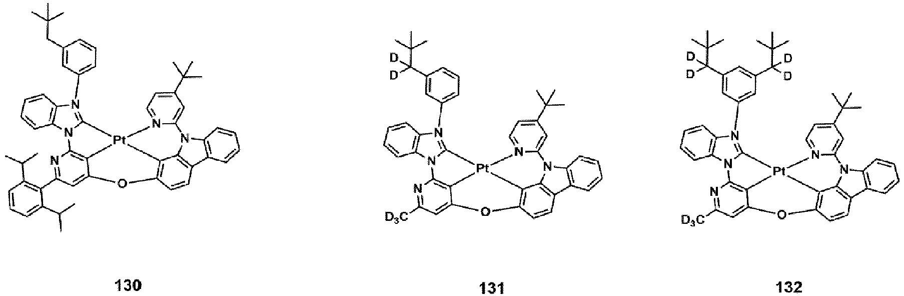

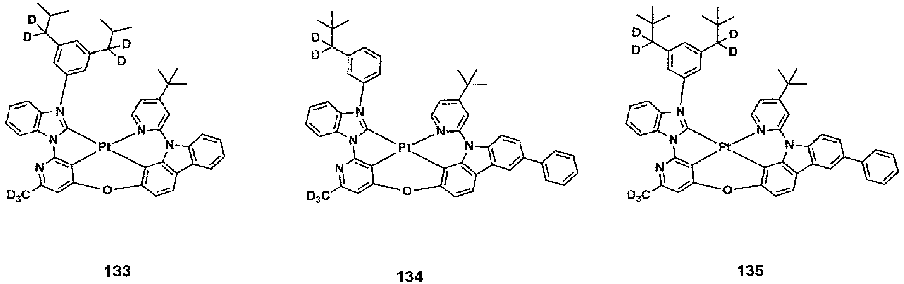

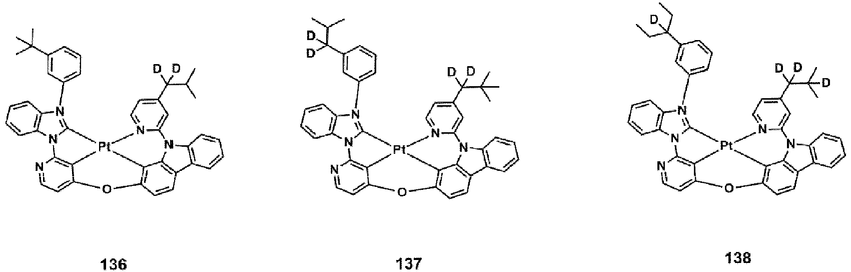

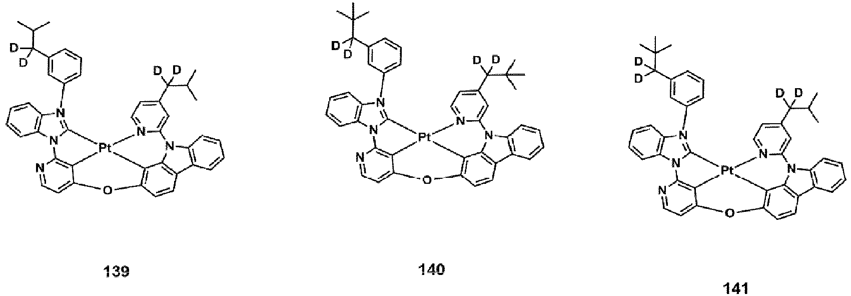

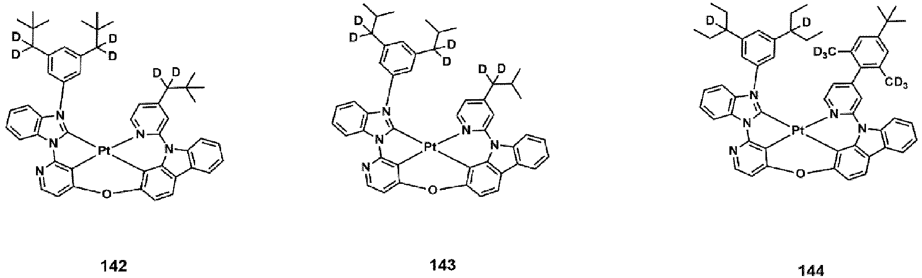

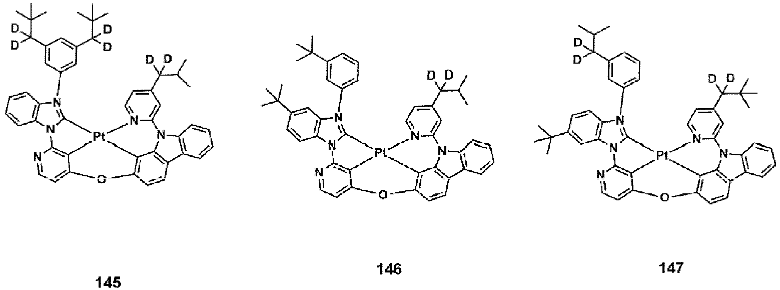

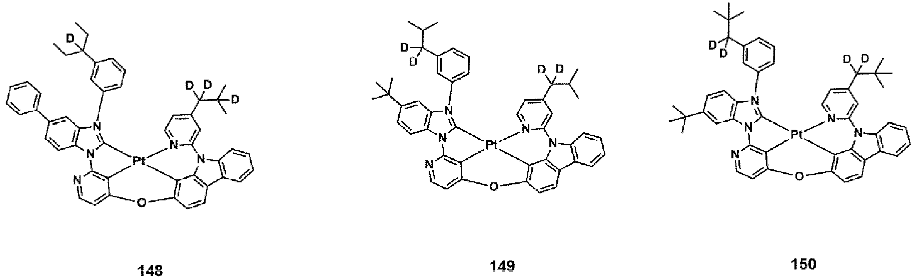

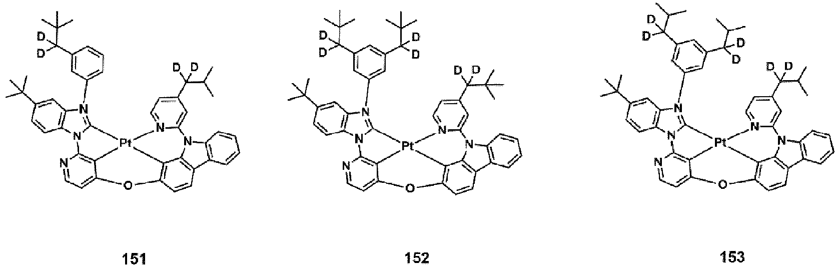

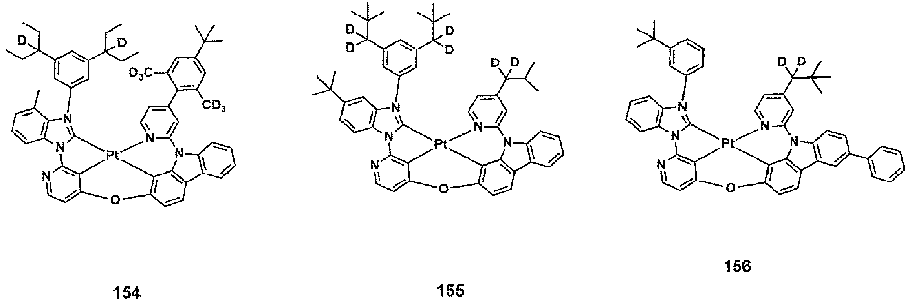

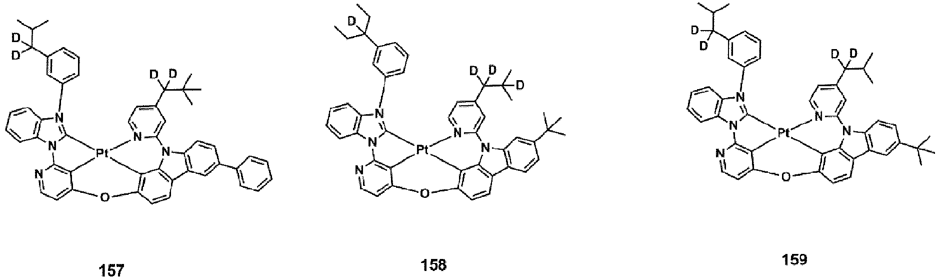

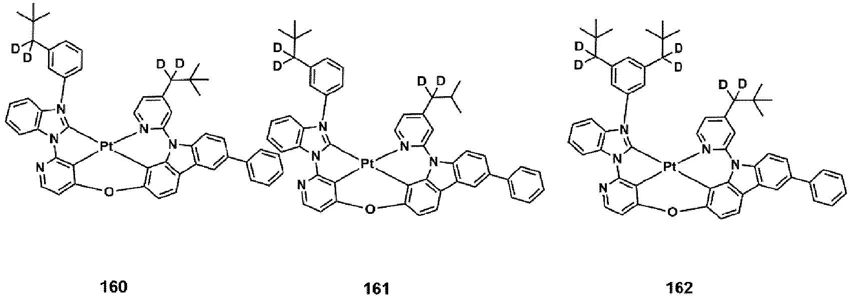

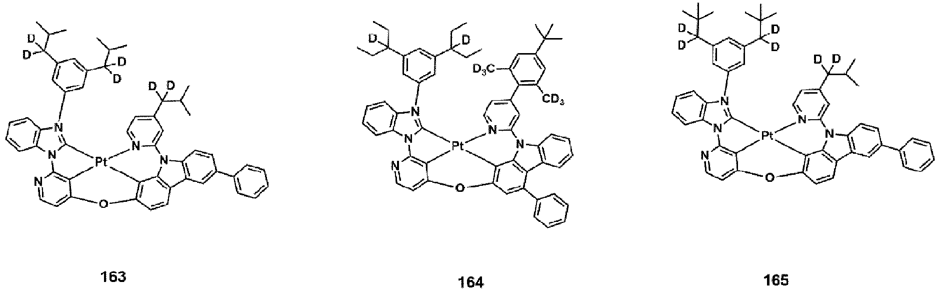

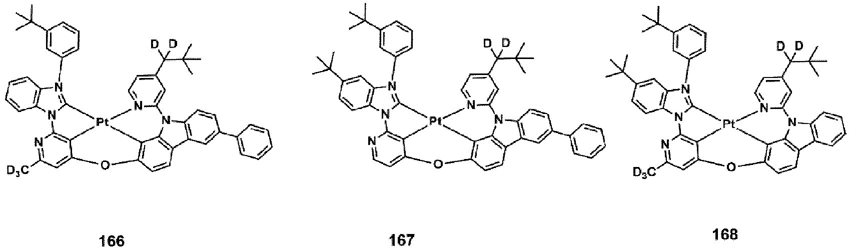

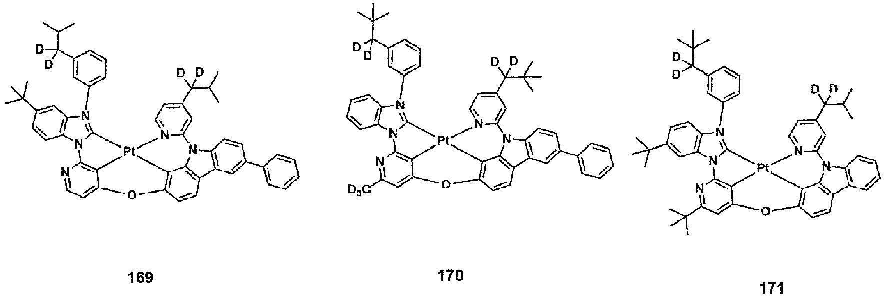

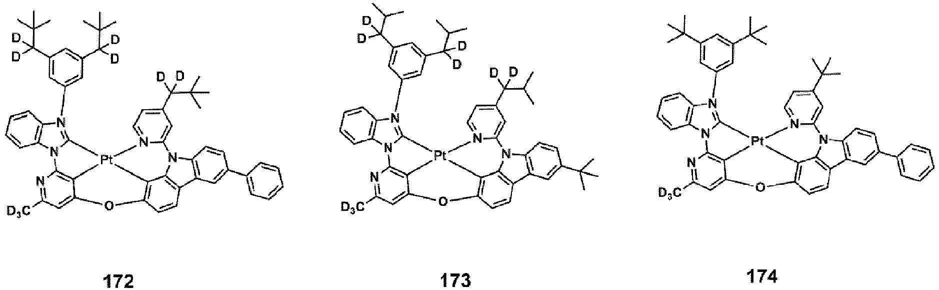

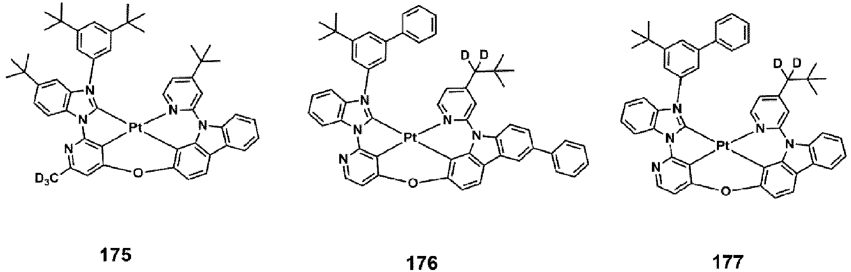

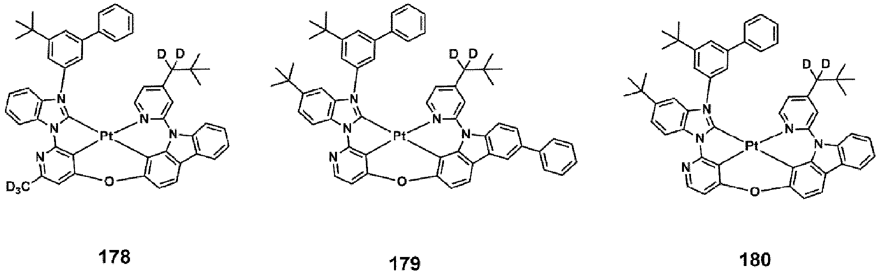

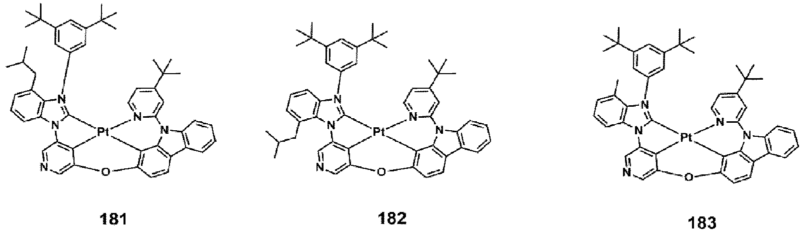

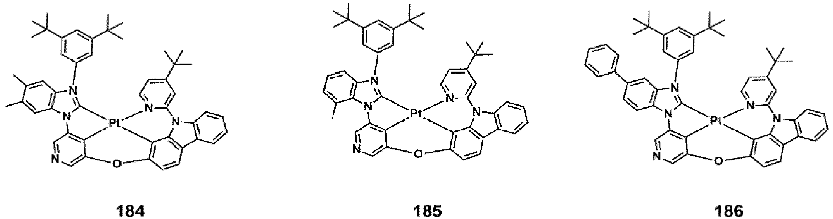

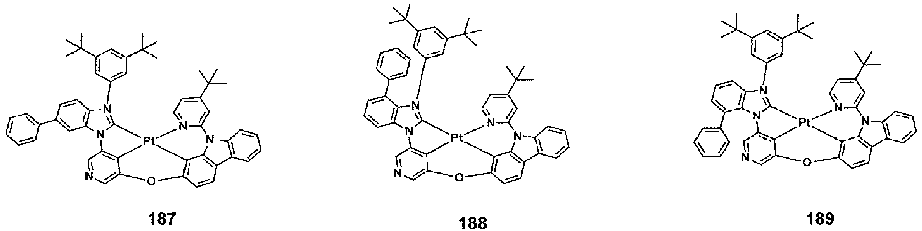

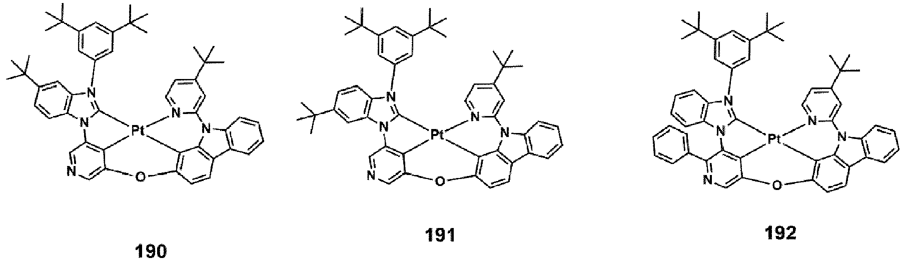

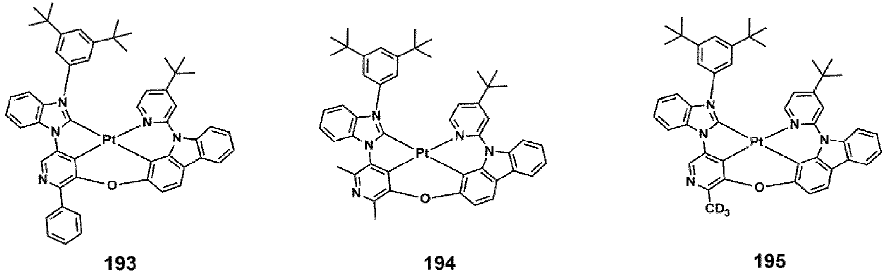

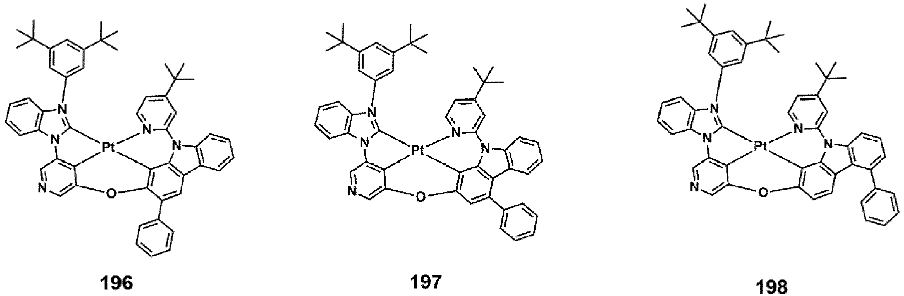

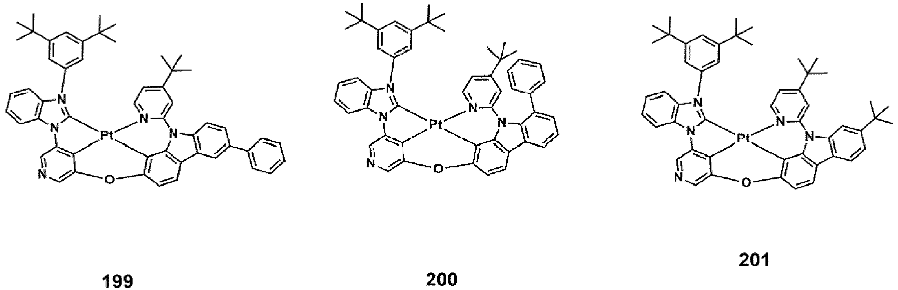

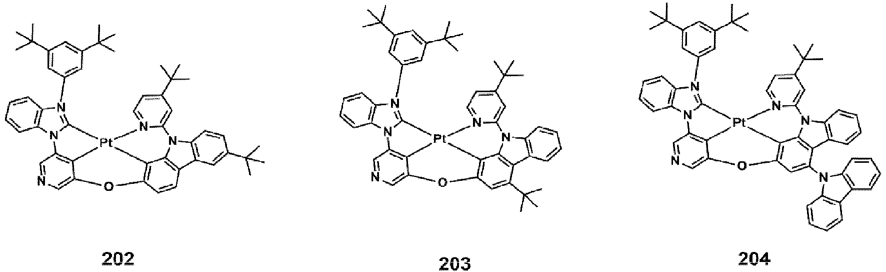

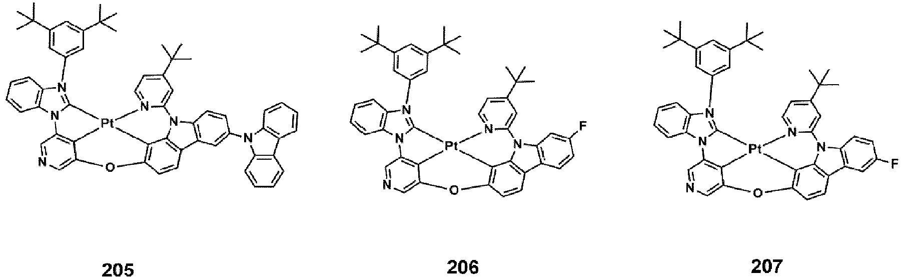

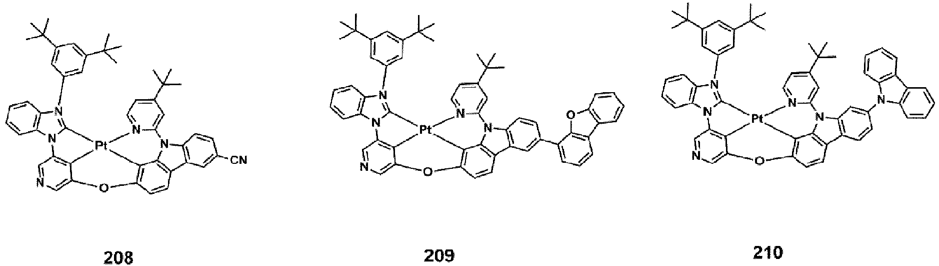

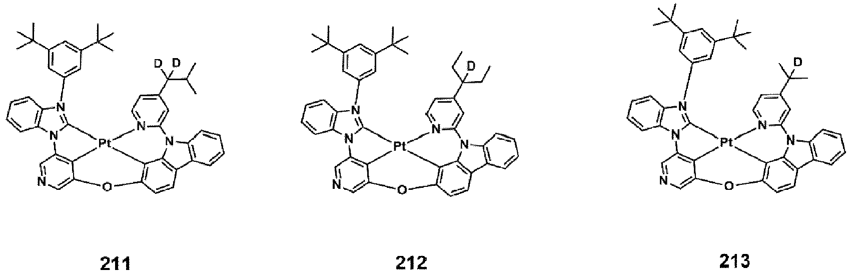

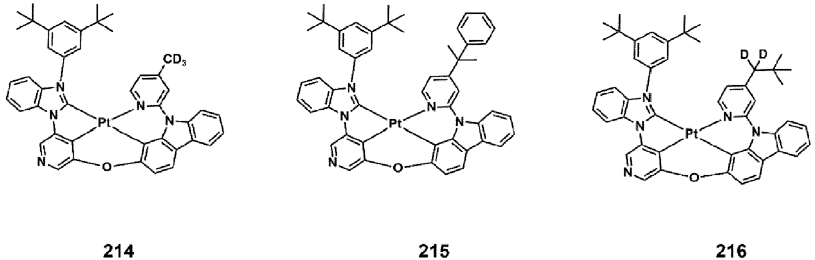

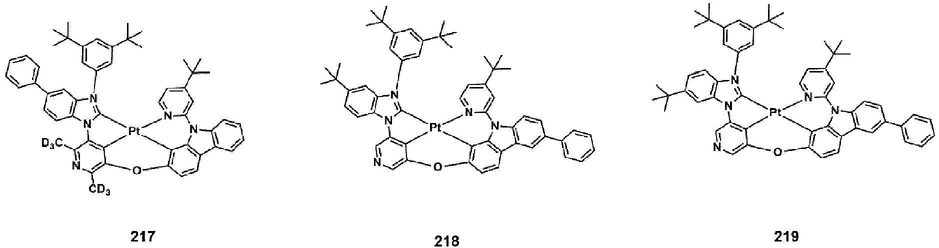

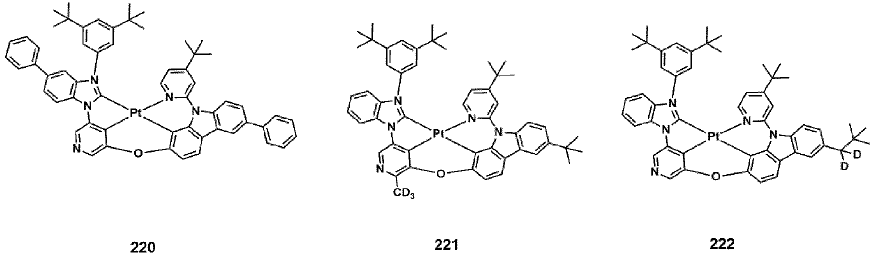

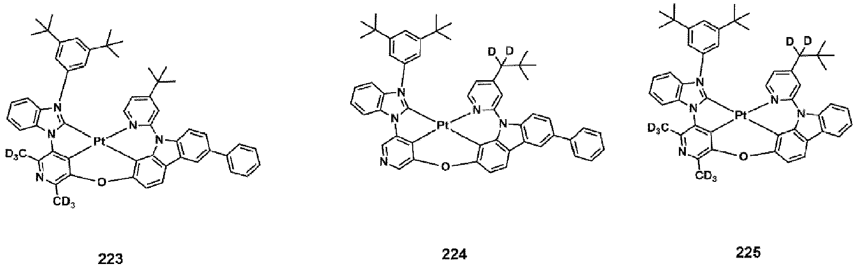

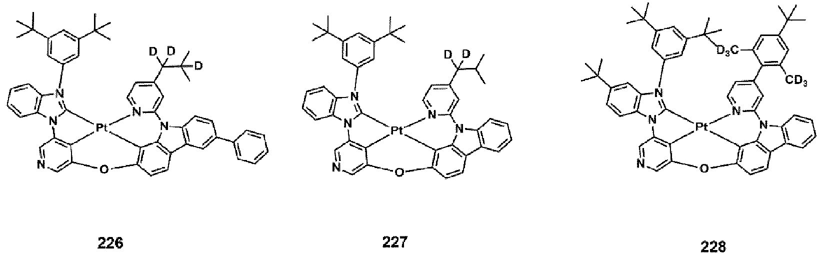

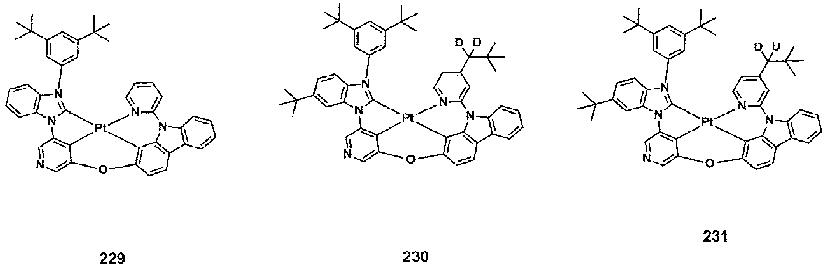

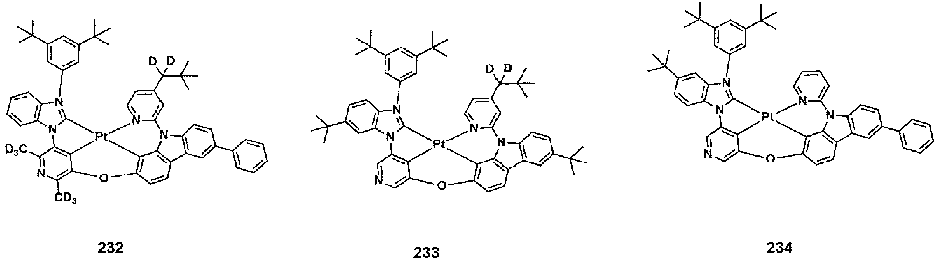

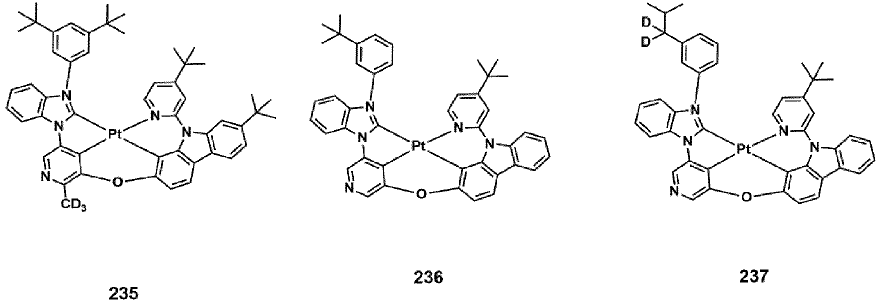

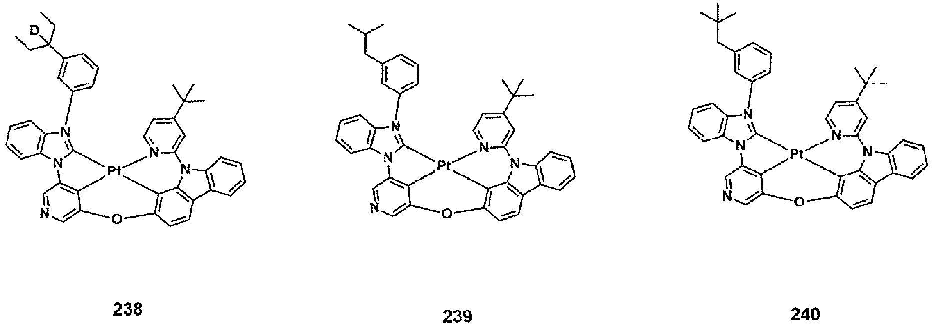

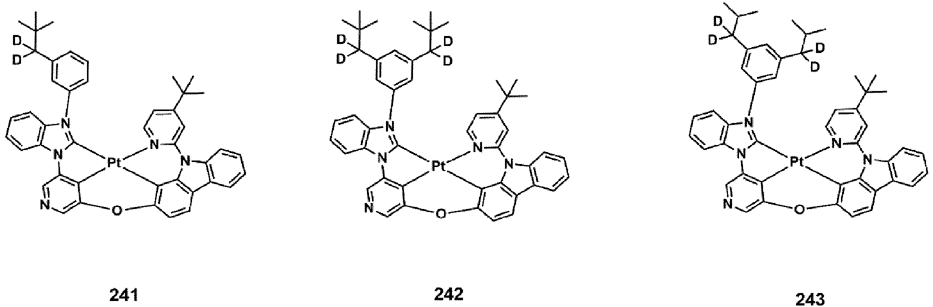

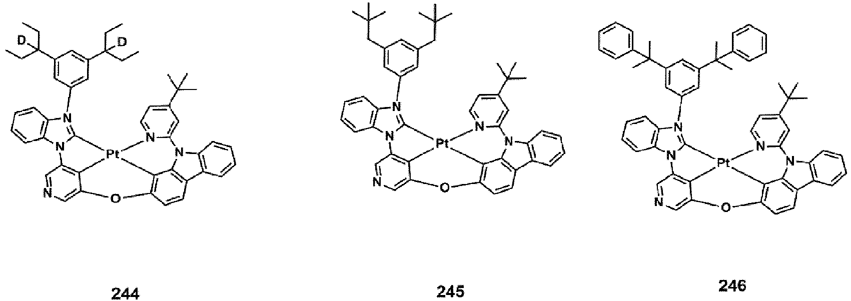

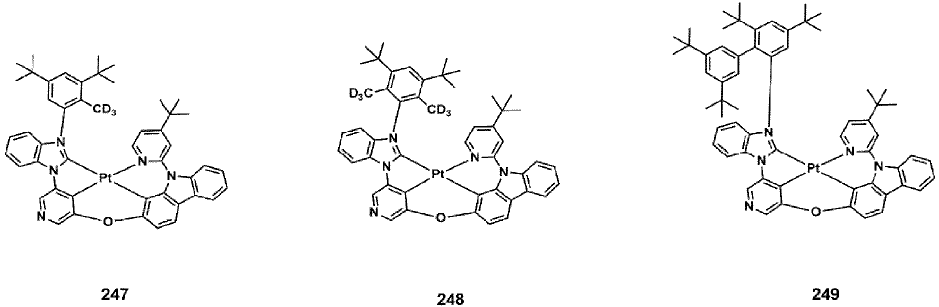

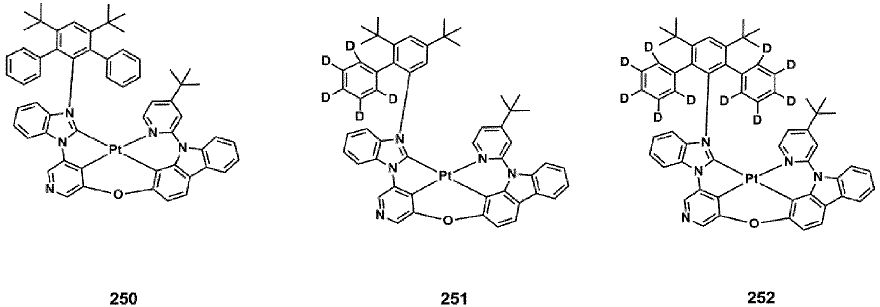

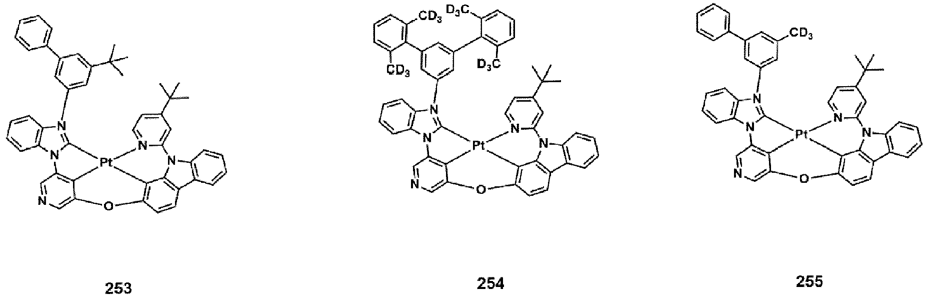

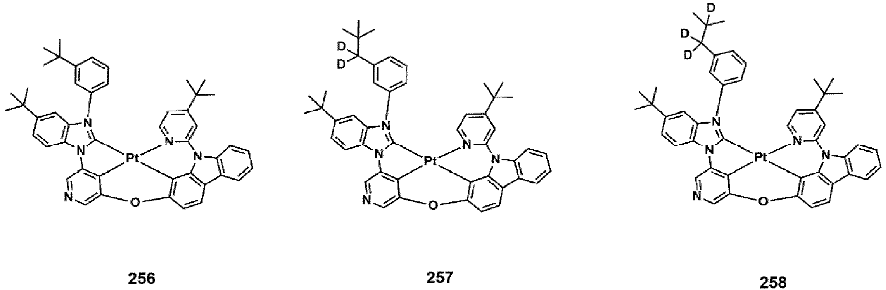

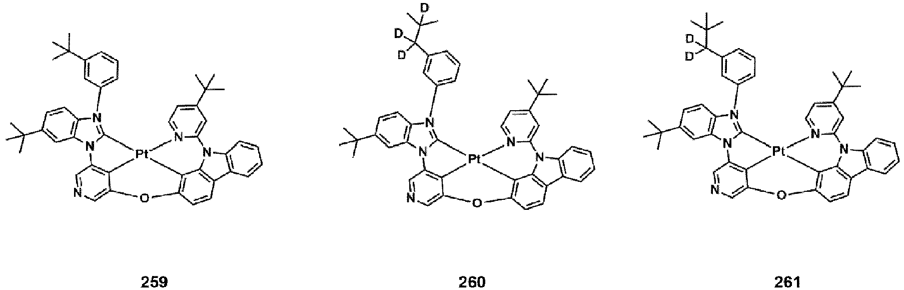

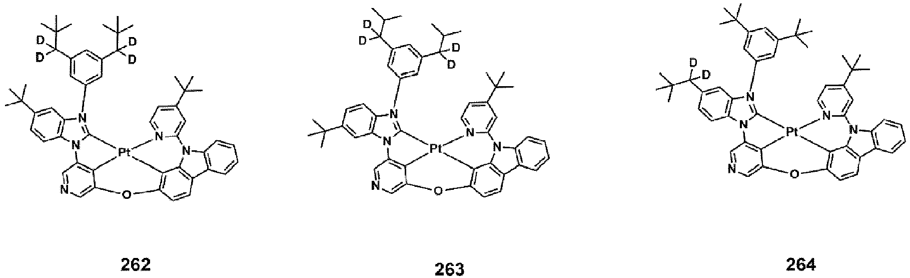

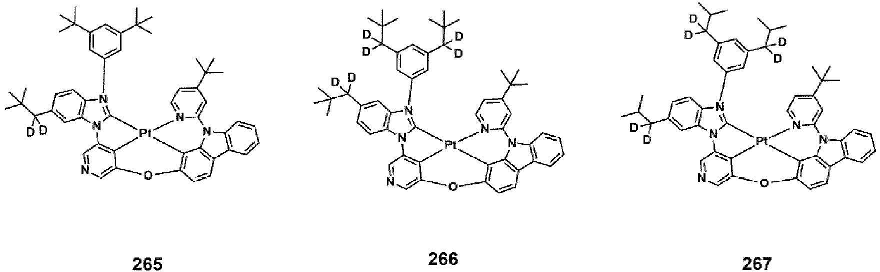

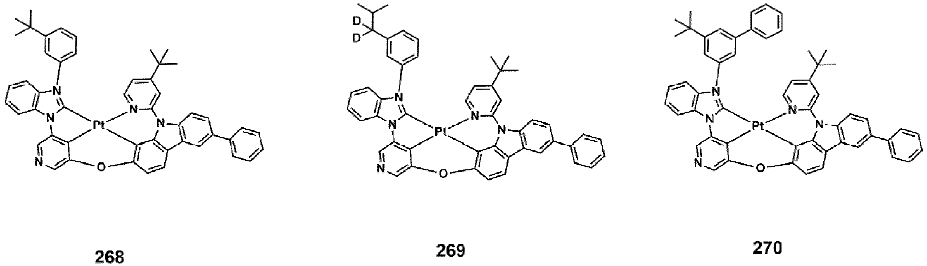

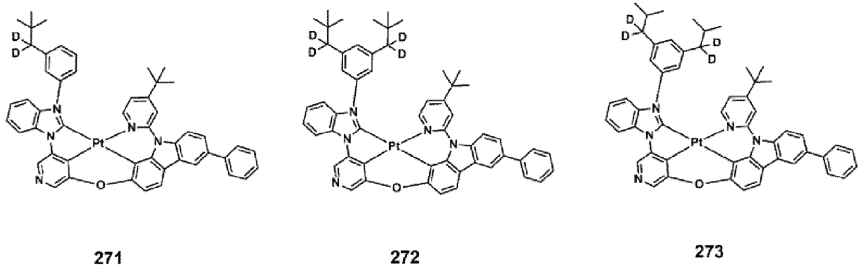

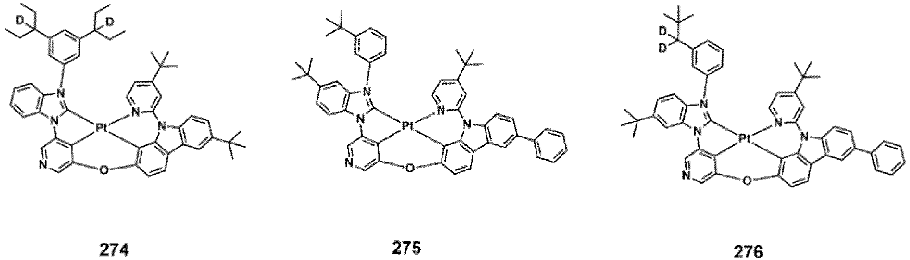

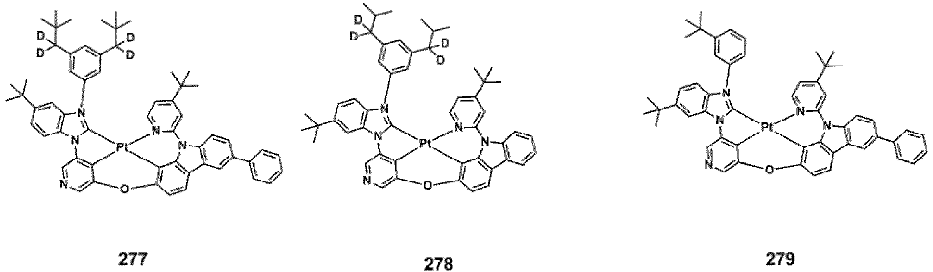

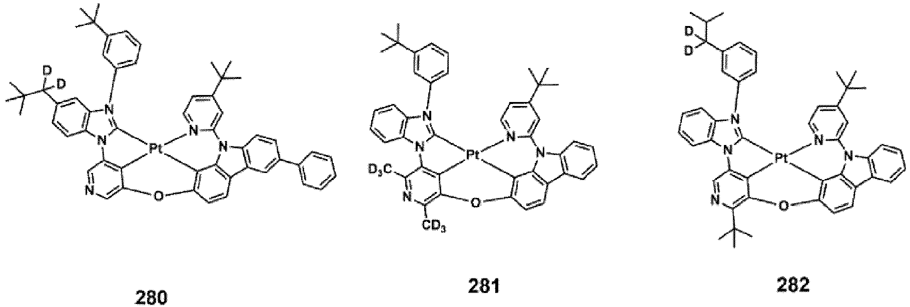

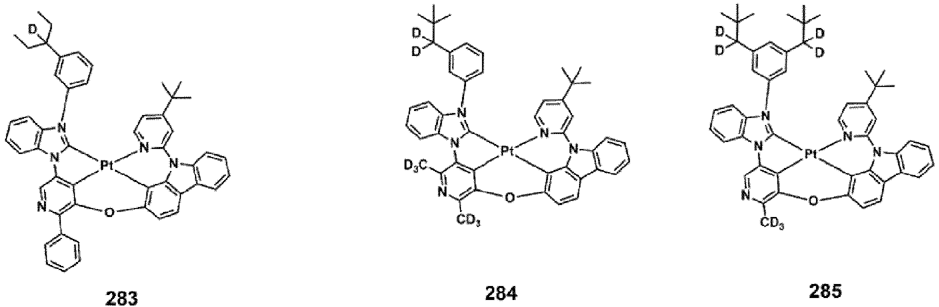

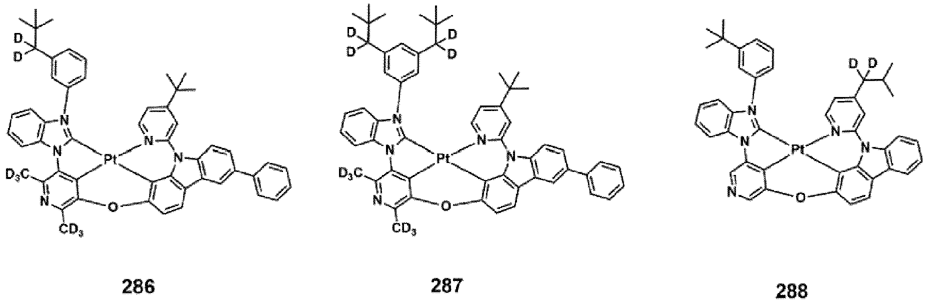

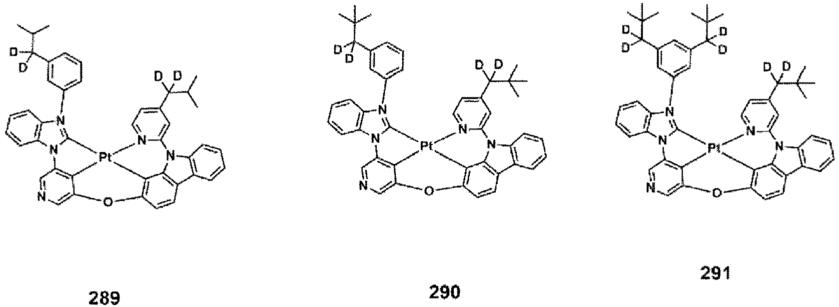

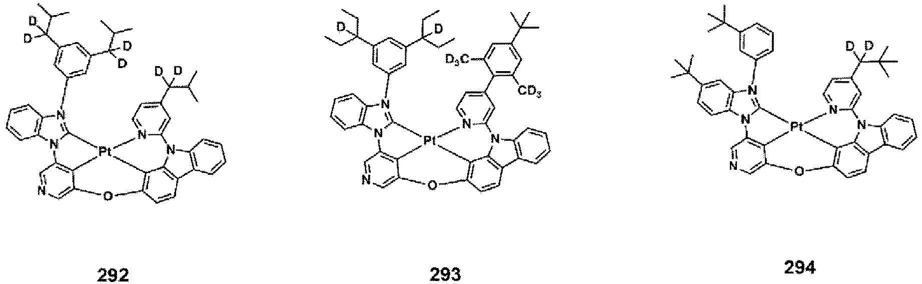

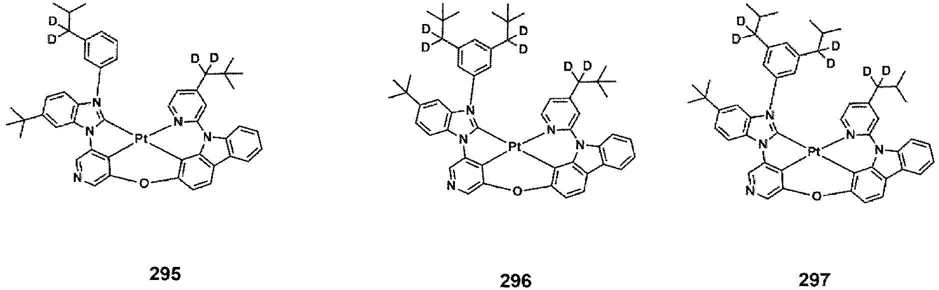

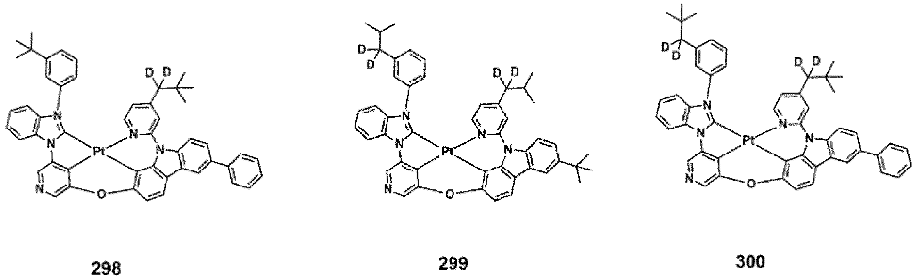

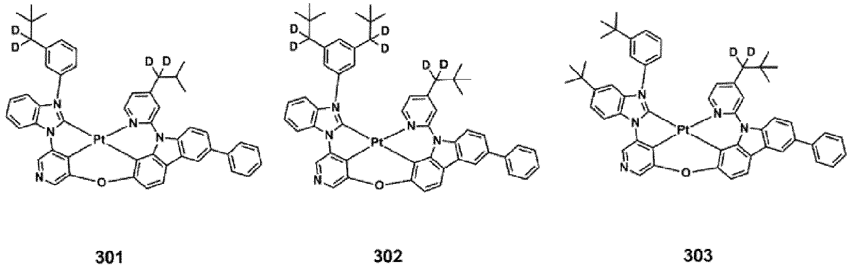

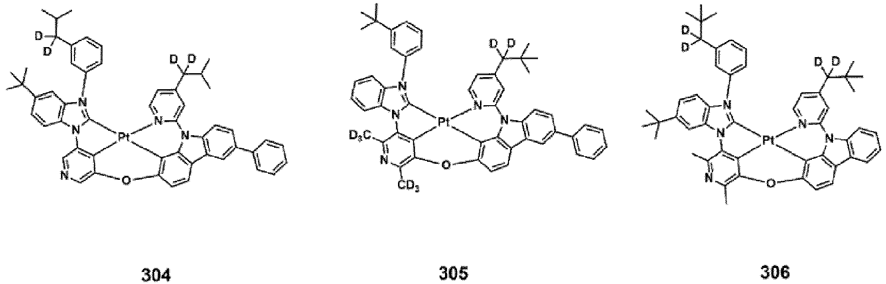

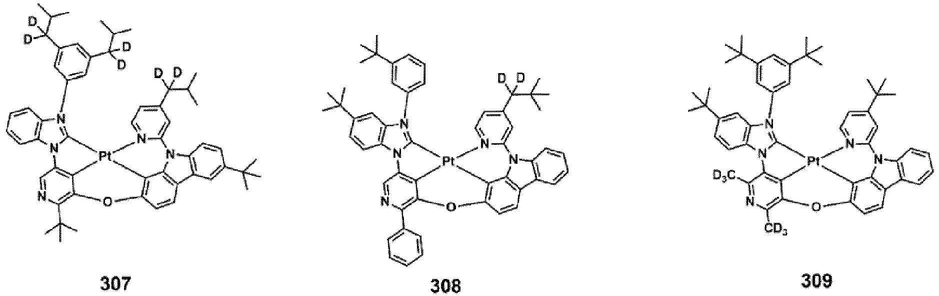

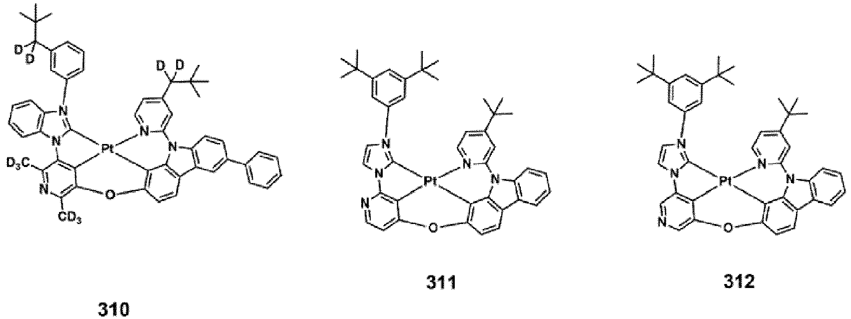

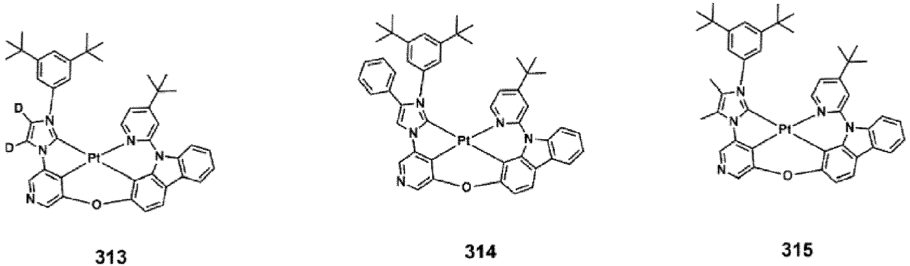

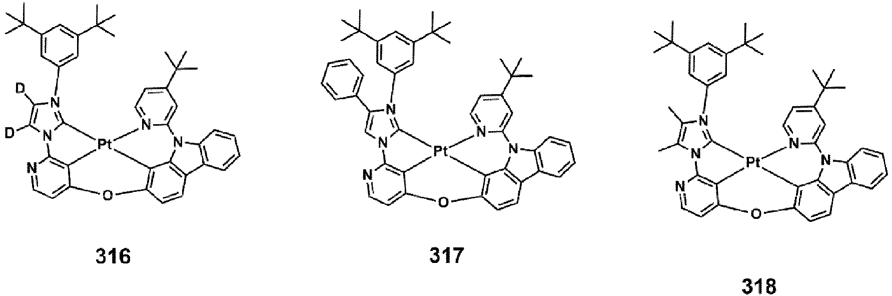

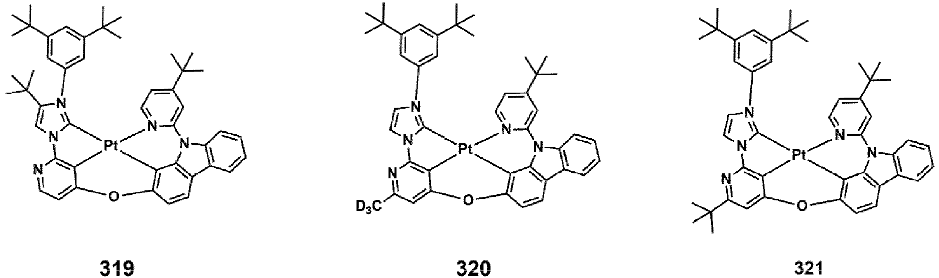

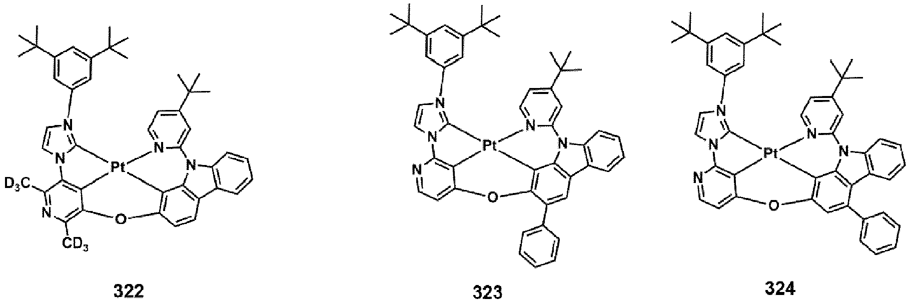

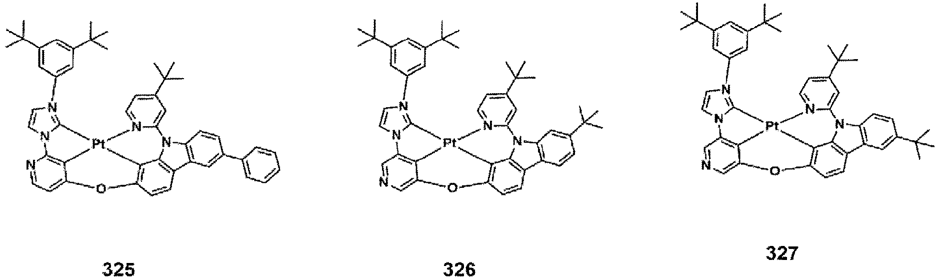

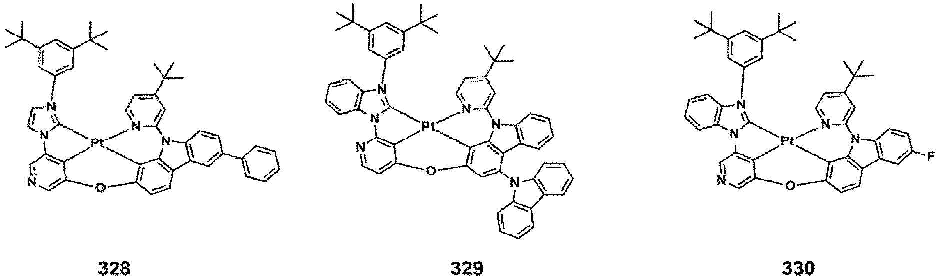

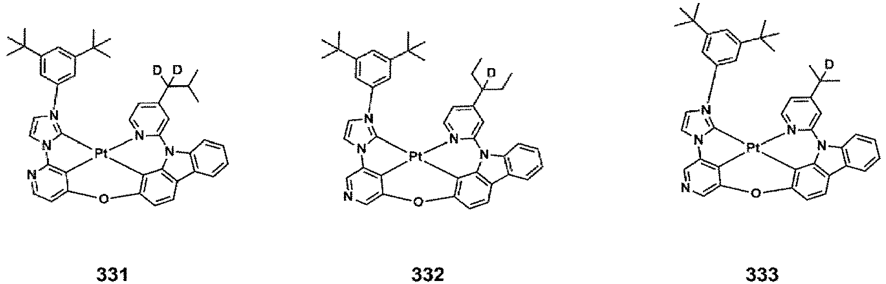

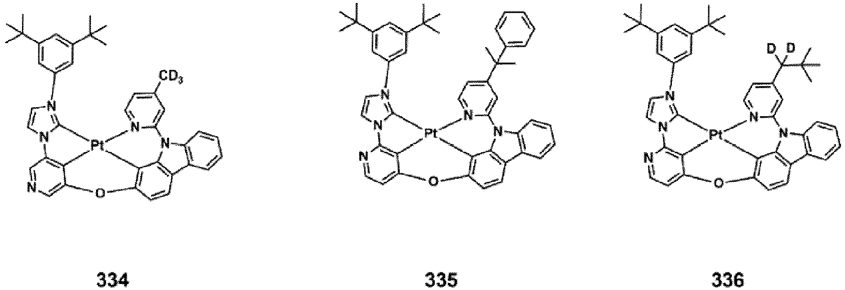

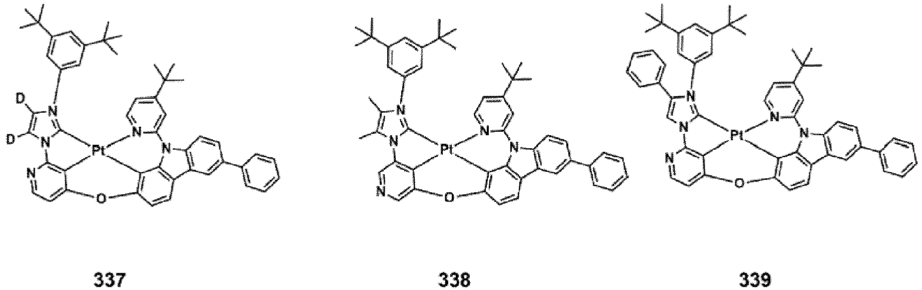

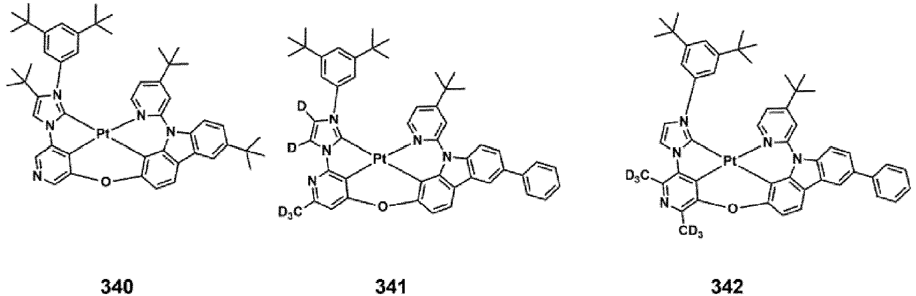

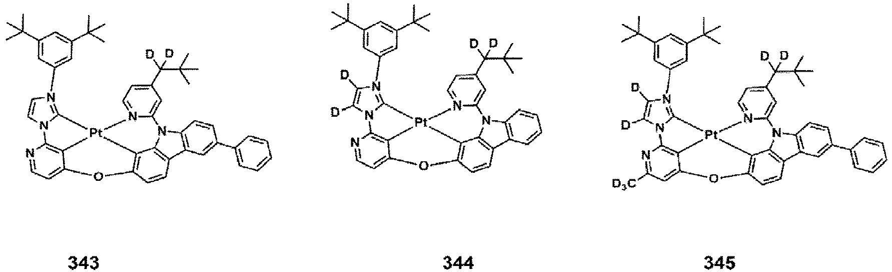

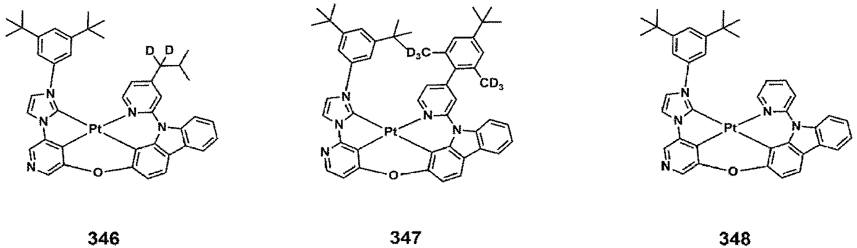

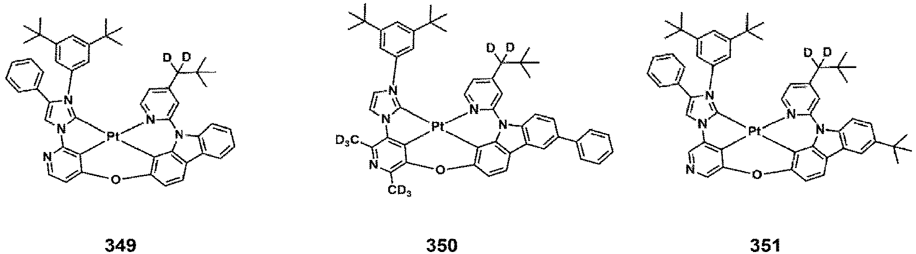

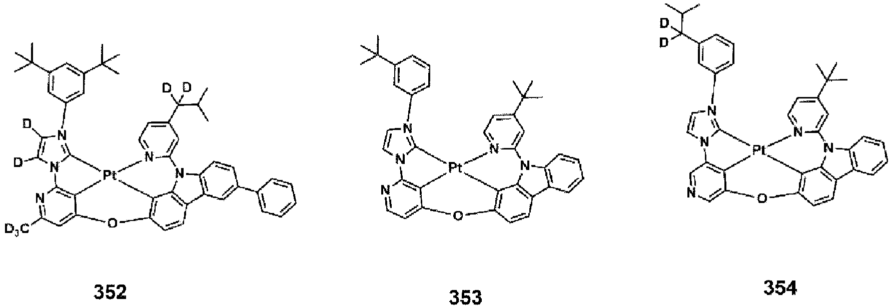

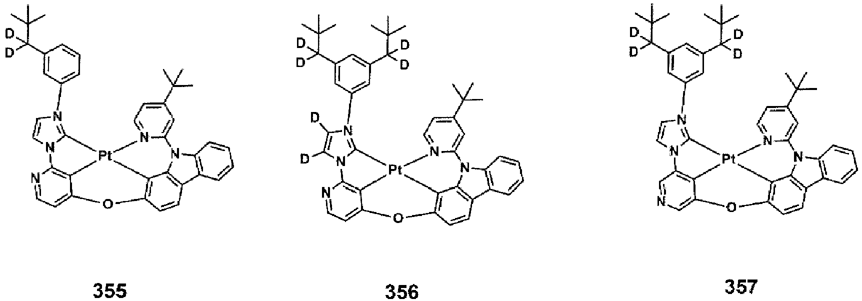

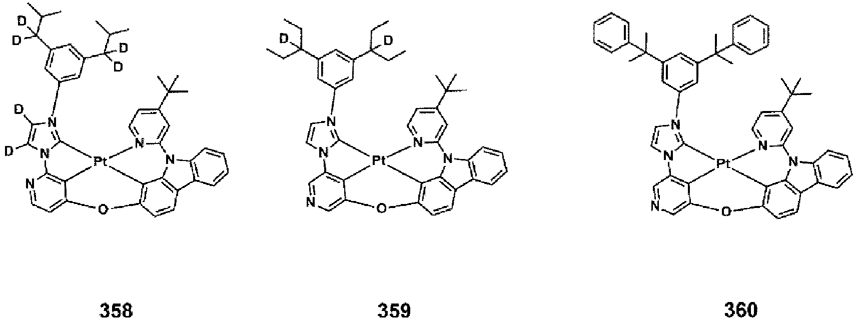

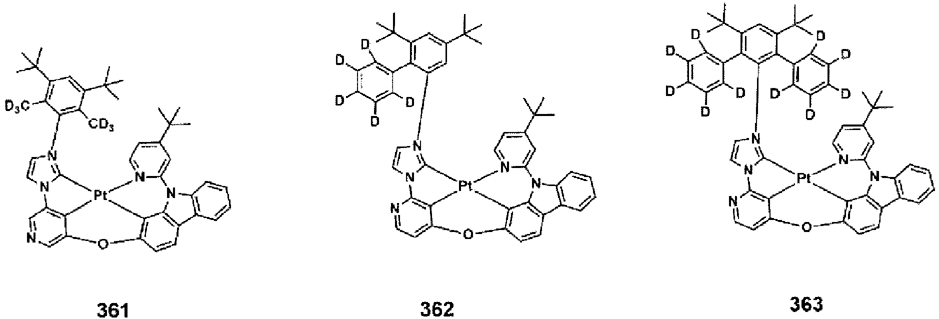

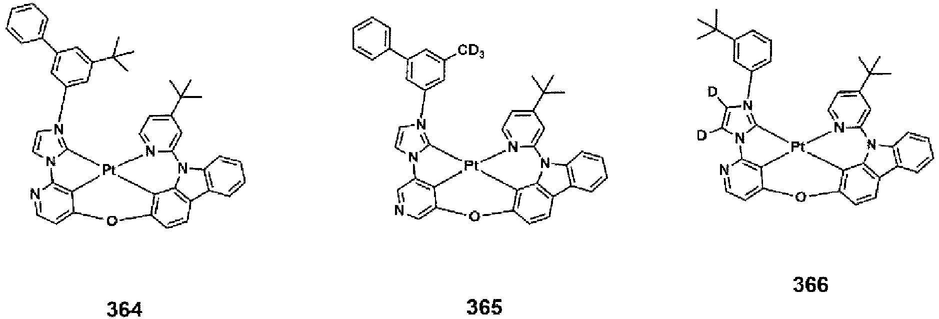

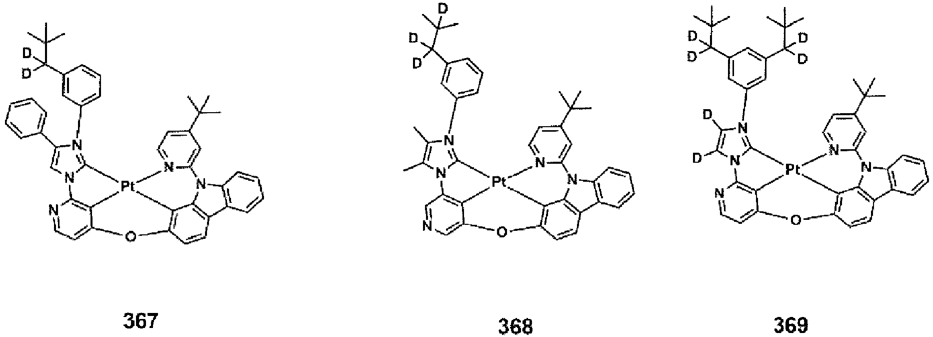

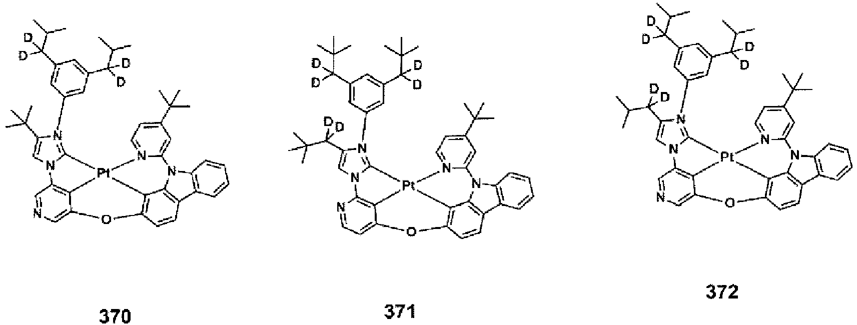

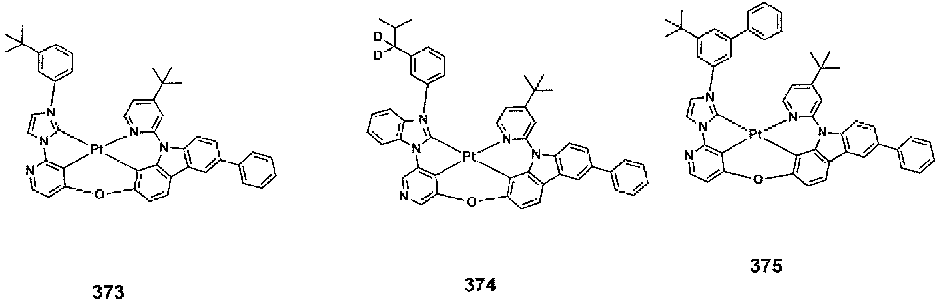

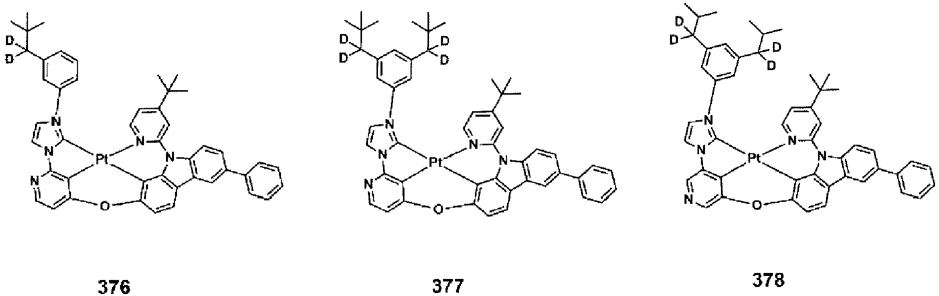

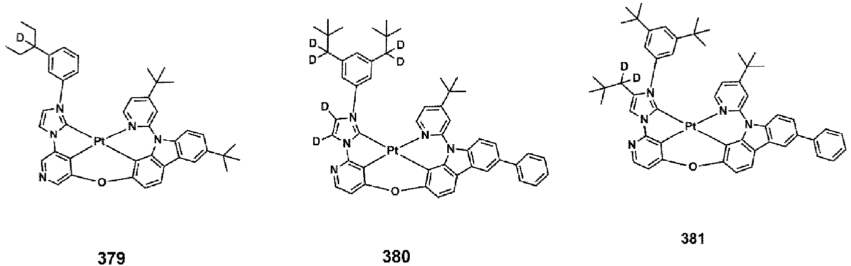

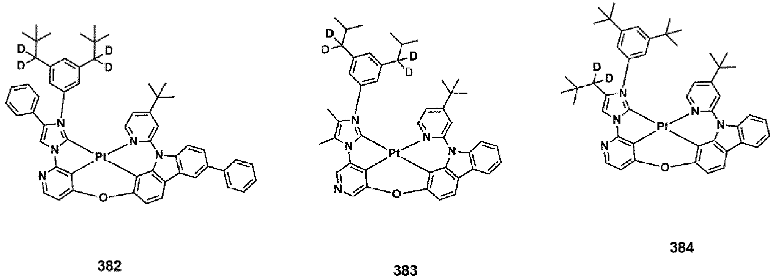

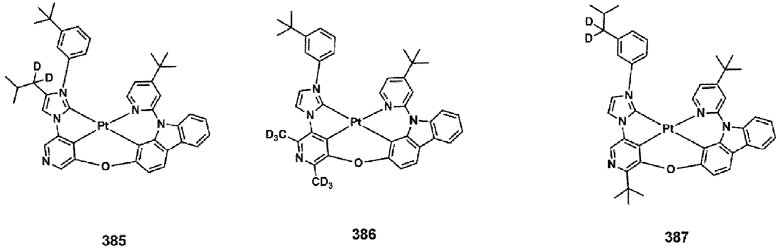

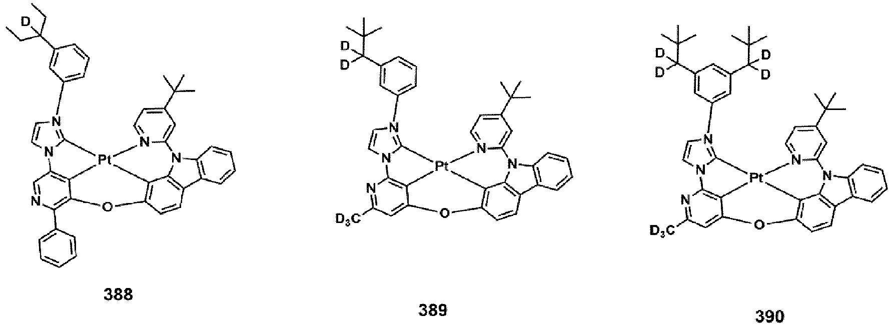

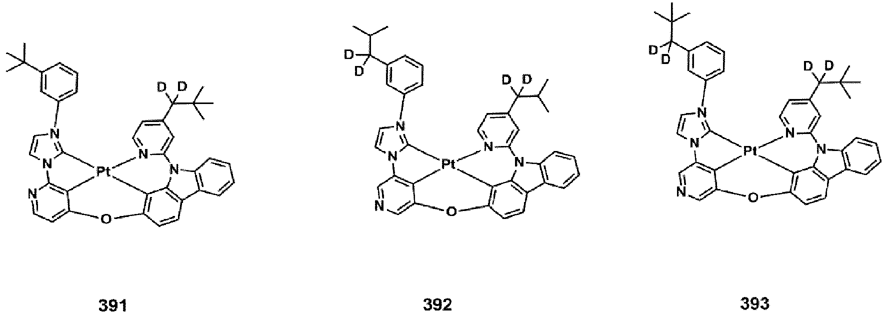

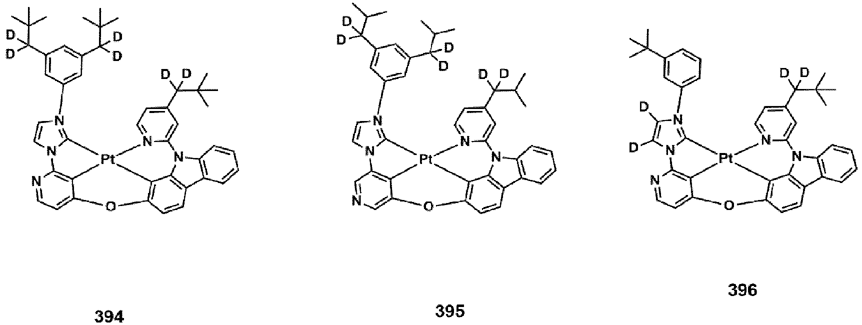

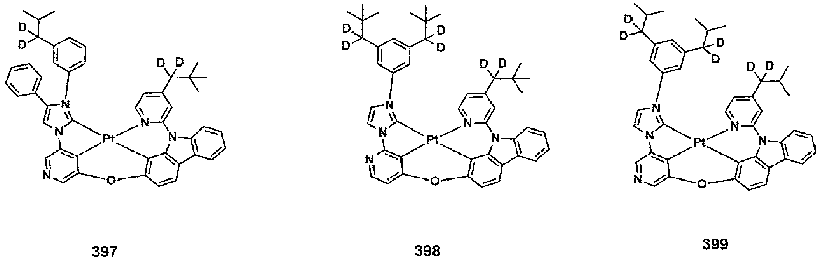

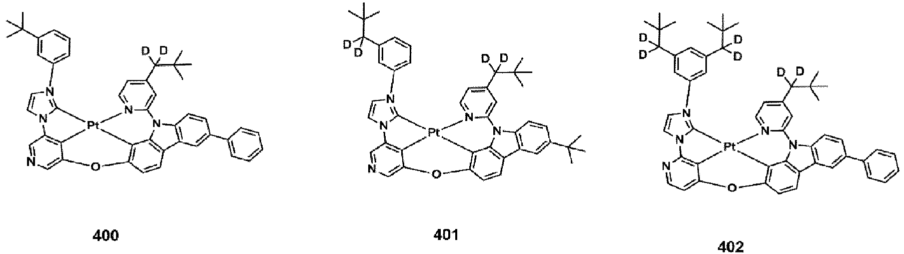

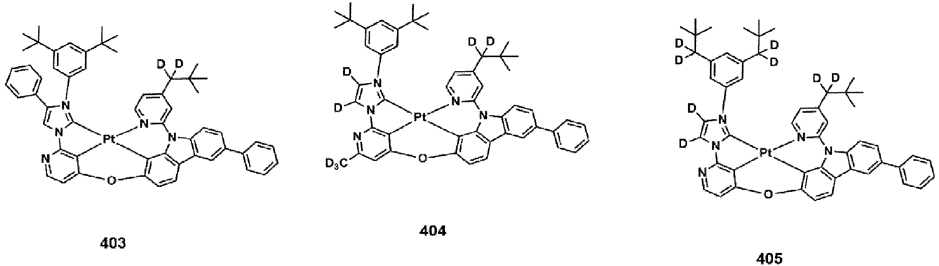

13. Dispositif électroluminescent organique, comprenant :
une première électrode ;
une seconde électrode ; et
une couche organique agencée entre la première électrode et la seconde électrode, dans lequel la couche organique comprend une couche d'émission, et
dans lequel la couche organique comprend en outre au moins l'un du composé organométallique de l'une quelconque des revendications 1 à 12 ;
de préférence dans lequel la couche d'émission comprend l'au moins un du composé organométallique ;
de préférence dans lequel la couche d'émission émet une lumière ayant une longueur d'onde d'émission maximale de 410 nanomètres à 490 nanomètres.

14. Dispositif électroluminescent de la revendication 13, dans lequel
la première électrode est une anode,
la seconde électrode est une cathode,
la couche organique comprend en outre une région de transport de trous agencée entre la première électrode et la couche d'émission et une région de transport d'électrons agencée entre la couche d'émission et la seconde électrode,
la région de transport de trous comprend une couche d'injection de trous, une couche de transport de trous, une couche de blocage d'électrons, une couche tampon, ou une combinaison de celles-ci, et
la région de transport d'électrons comprend une couche de blocage de trous, une couche de transport d'électrons, une couche d'injection d'électrons ou une combinaison de celles-ci.

15. Appareil électronique, comprenant le dispositif électroluminescent organique de l'une des revendications 13 ou 14.
